# EUROPEAN PATENT APPLICATION

(11) **EP 4 664 506 A1**
(43) Date of publication of application: **17.12.2025**
(21) Application number: 24753258.3
(22) Date of filing: 02.02.2024
(51) Int. Cl.: H01L 21/265, H01J 37/317, H01L 21/336, H01L 29/06, H01L 29/12, H01L 29/78, H01L 29/861, H01L 29/868, H01L 29/872

(54) **ION IMPLANTATION PROCESSING SYSTEM**

(30) Priority: 09.02.2023 JP 2023018714
(71) Applicant: Rohm Co., Ltd., Kyoto-shi, Kyoto 615-8585 (JP)
(72) Inventor: NAKANO, Yuki, Kyoto-shi, Kyoto 615-8585 (JP); YAMAMOTO, Kenji, Kyoto-shi, Kyoto 615-8585 (JP)
(74) Representative: Witte, Weller & Partner Patentanwälte mbB
(86) International application number: PCT/JP2024/003485
(87) International publication number: WO 2024/166815

(57) **Abstract**

In an ion implantation processing system including an ion implantation device, the ion implantation device acquires, from a server, off-angle data of a wafer that is an ion implantation processing target and controls an ion implantation angle with respect to the wafer based on the off-angle data.

## Description

### Technical Field

This application claims the benefit of priority to Japanese Patent Application No. 2023-018714 filed on February 9, 2023 and the entire contents of this application are hereby incorporated herein by reference. The present disclosure relates to an ion implantation processing system.

### Background Art

Patent Literature 1 (JP2005-149944 A) discloses an ion implantation device including a plane orientation measurement mechanism that measures a plane orientation of a silicon wafer with X-rays, and an ion implantation mechanism that performs alignment of the silicon wafer based on the plane orientation measured by the plane orientation measurement mechanism and implants ions into the silicon wafer.

### Citation List

### Patent Literature

Patent Literature 1: Japanese Patent Application Publication No. 2005-149944

### [Summary]

The present disclosure provides a novel ion implantation processing system.

The present disclosure provides an ion implantation processing system comprising an ion implantation device, wherein the ion implantation device acquires, from a server, off-angle data of a wafer that is an ion implantation processing target and controls an ion implantation angle with respect to the wafer based on the off-angle data.

The aforementioned or yet other objects, features, and effects will be clarified by the following description with reference to the accompanying drawings.

### Brief Description of Drawings

[FIG. 1] FIG. 1 is a plan view showing an SiC semiconductor device according to a first embodiment.
[FIG. 2A] FIG. 2A is a cross-sectional view taken along line IIA-IIA in FIG. 1.
[FIG. 2B] FIG. 2B is a cross-sectional view taken along line IIB-IIB in FIG. 1.
[FIG. 3A] FIG. 3A is a plan view showing a layout example of a chip (a first layer).
[FIG. 3B] FIG. 3B is a plan view showing a layout example of the chip (a second layer).
[FIG. 4A] FIG. 4A is a perspective view showing the chip together with an ornamental pattern according to a first configuration example.
[FIG. 4B] FIG. 4B is a perspective view showing the chip together with the ornamental pattern according to the first configuration example.
[FIG. 5] FIG. 5 is a perspective view of a main portion for showing the ornamental pattern.
[FIG. 6A] FIG. 6A is a perspective view showing the chip together with an ornamental pattern according to a second configuration example.
[FIG. 6B] FIG. 6B is a perspective view showing the chip together with an ornamental pattern according to a third configuration example.
[FIG. 6C] FIG. 6C is a perspective view showing the chip together with an ornamental pattern according to a fourth configuration example.
[FIG. 6D] FIG. 6D is a perspective view showing the chip together with an ornamental pattern according to a fifth configuration example.
[FIG. 7] FIG. 7 is a cross-sectional perspective view showing a first basic form of a column region.
[FIG. 8A] FIG. 8A is a plan view showing a first layout example of the first basic form.
[FIG. 8B] FIG. 8B is a plan view showing a second layout example of the first basic form.
[FIG. 9] FIG. 9 is a cross-sectional perspective view showing a second basic form of the column region.
[FIG. 10A] FIG. 10A is a plan view showing a first layout example of the second basic form.
[FIG. 10B] FIG. 10B is a plan view showing a second layout example of the second basic form.
[FIG. 11] FIG. 11 is a cross-sectional perspective view showing a third basic form of the column region.
[FIG. 12A] FIG. 12A is a plan view showing a first layout example of the third basic form.
[FIG. 12B] FIG. 12B is a plan view showing a second layout example of the third basic form.
[FIG. 12C] FIG. 12C is a plan view showing a third layout example of the third basic form.
[FIG. 13A] FIG. 13A is a graph showing an example of a concentration gradient of a second region (a first region).
[FIG. 13B] FIG. 13B is a graph showing an example of the concentration gradient of the second region (the first region).
[FIG. 13C] FIG. 13C is a graph showing an example of the concentration gradient of the second region (the first region).
[FIG. 13D] FIG. 13D is a graph showing an example of the concentration gradient of the second region (the first region).
[FIG. 13E] FIG. 13E is a graph showing an example of the concentration gradient of the second region (the first region).
[FIG. 14] FIG. 14 is a graph showing a comparative example of the concentration gradient of the second region (the first region).
[FIG. 15] FIG. 15 is a cross-sectional perspective view showing a column region according to a first configuration example.
[FIG. 16] FIG. 16 is a graph showing an example of a concentration gradient of the column region shown in FIG. 15.
[FIG. 17] FIG. 17 is a cross-sectional perspective view showing a column region according to a second configuration example.
[FIG. 18] FIG. 18 is a graph showing an example of a concentration gradient of the column region shown in FIG. 17.
[FIG. 19] FIG. 19 is a cross-sectional perspective view showing a column region according to a third configuration example.
[FIG. 20] FIG. 20 is a graph showing an example of a concentration gradient of the column region shown in FIG. 19.
[FIG. 21] FIG. 21 is a cross-sectional perspective view showing a column region according to a fourth configuration example.
[FIG. 22] FIG. 22 is a graph showing an example of a concentration gradient of the column region shown in FIG. 21.
[FIG. 23] FIG. 23 is a cross-sectional perspective view showing a column region according to a fifth configuration example.
[FIG. 24] FIG. 24 is a graph showing an example of a concentration gradient of the column region shown in FIG. 23.
[FIG. 25] FIG. 25 is a cross-sectional perspective view showing a column region according to a sixth configuration example.
[FIG. 26] FIG. 26 is a graph showing an example of a concentration gradient of the column region shown in FIG. 25.
[FIG. 27] FIG. 27 is a cross-sectional perspective view showing a column region according to a seventh configuration example.
[FIG. 28] FIG. 28 is a graph showing an example of a concentration gradient of the column region shown in FIG. 27.
[FIG. 29] FIG. 29 is a cross-sectional perspective view showing a column region according to an eighth configuration example.
[FIG. 30] FIG. 30 is a graph showing an example of a concentration gradient of the column region shown in FIG. 29.
[FIG. 31] FIG. 31 is a cross-sectional perspective view showing a column region according to a ninth configuration example.
[FIG. 32] FIG. 32 is a cross-sectional perspective view showing a column region according to a tenth configuration example.
[FIG. 33] FIG. 33 is a cross-sectional perspective view showing a column region according to an eleventh configuration example.
[FIG. 34] FIG. 34 is a cross-sectional perspective view showing a column region according to a twelfth configuration example.
[FIG. 35] FIG. 35 is a plan view showing a main portion of an active region.
[FIG. 36] FIG. 36 is a cross-sectional perspective view showing a gate structure according to a first configuration example.
[FIG. 37] FIG. 37 is a perspective view showing a configuration of an outer peripheral region.
[FIG. 38A] FIG. 38A is a cross-sectional view showing a main portion of the outer peripheral region.
[FIG. 38B] FIG. 38B is a cross-sectional view showing the main portion of the outer peripheral region.
[FIG. 39] FIG. 39 is a cross-sectional perspective view showing a gate structure according to a second configuration example.
[FIG. 40] FIG. 40 is a schematic view showing a wafer used in manufacturing an SiC semiconductor device.
[FIG. 41] FIG. 41 is a flowchart showing a manufacturing method example of the SiC semiconductor device.
[FIG. 42A] FIG. 42A is a cross-sectional perspective view showing the manufacturing method example of the SiC semiconductor device.
[FIG. 42B] FIG. 42B is a cross-sectional perspective view showing a step subsequent to that of FIG. 42A.
[FIG. 42C] FIG. 42C is a cross-sectional perspective view showing a step subsequent to that of FIG. 42B.
[FIG. 42D] FIG. 42D is a cross-sectional perspective view showing a step subsequent to that of FIG. 42C.
[FIG. 42E] FIG. 42E is a cross-sectional perspective view showing a step subsequent to that of FIG. 42D.
[FIG. 42F] FIG. 42F is a cross-sectional perspective view showing a step subsequent to that of FIG. 42E.
[FIG. 42G] FIG. 42G is a cross-sectional perspective view showing a step subsequent to that of FIG. 42F.
[FIG. 42H] FIG. 42H is a cross-sectional perspective view showing a step subsequent to that of FIG. 42G.
[FIG. 43] FIG. 43 is a plan view showing an SiC semiconductor device according to a second embodiment.
[FIG. 44A] FIG. 44A is a cross-sectional view taken along line XLIVA-XLIVA in FIG. 43.
[FIG. 44B] FIG. 44B is a cross-sectional view taken along line XLIVB-XLIVB in FIG. 43.
[FIG. 45A] FIG. 45A is a plan view showing a layout example of a chip (a first layer).
[FIG. 45B] FIG. 45B is a plan view showing a layout example of the chip (a second layer).
[FIG. 46] FIG. 46 is a perspective view showing the layout example of the chip.
[FIG. 47] FIG. 47 is a plan view showing a main portion of the active region.
[FIG. 48] FIG. 48 is a cross-sectional perspective view showing a gate structure according to a first configuration example.
[FIG. 49] FIG. 49 is a perspective view showing a configuration of an outer peripheral region.
[FIG. 50A] FIG. 50A is a cross-sectional view showing a main portion of the outer peripheral region.
[FIG. 50B] FIG. 50B is a cross-sectional view showing a main portion of the outer peripheral region.
[FIG. 51] FIG. 51 is a cross-sectional perspective view showing a gate structure according to a second configuration example.
[FIG. 52] FIG. 52 is a cross-sectional perspective view showing a gate structure according to a third configuration example.
[FIG. 53] FIG. 53 is a cross-sectional perspective view showing a gate structure according to a fourth configuration example.
[FIG. 54] FIG. 54 is a cross-sectional perspective view showing a gate structure according to a fifth configuration example.
[FIG. 55] FIG. 55 is a plan view showing an SiC semiconductor device according to a third embodiment.
[FIG. 56A] FIG. 56A is a cross-sectional view taken along line LVIA-LVIA in FIG. 55.
[FIG. 56B] FIG. 56B is a cross-sectional view taken along line LVIB-LVIB in FIG. 55.
[FIG. 57A] FIG. 57A is a plan view showing a layout example of a chip.
[FIG. 57B] FIG. 57B is a plan view showing a layout example of the chip.
[FIG. 58] FIG. 58 is a perspective view showing the layout example of the chip.
[FIG. 59] FIG. 59 is a perspective view showing a configuration of an outer peripheral region.
[FIG. 60] FIG. 60 is a cross-sectional perspective view showing a diode structure according to a first configuration example.
[FIG. 61] FIG. 61 is a cross-sectional perspective view showing a diode structure according to a second configuration example.
[FIG. 62] FIG. 62 is a cross-sectional perspective view showing a diode structure according to a third configuration example.
[FIG. 63] FIG. 63 is a cross-sectional perspective view showing a diode structure according to a fourth configuration example.
[FIG. 64] FIG. 64 is a cross-sectional perspective view showing a diode structure according to a fifth configuration example.
[FIG. 65] FIG. 65 is a perspective view showing the chip together with an ornamental pattern according to a first modification example.
[FIG. 66] FIG. 66 is a perspective view showing the chip together with an ornamental pattern according to a second modification example.
[FIG. 67] FIG. 67 is a perspective view showing the chip together with an ornamental pattern according to a third modification example.
[FIG. 68] FIG. 68 is a perspective view showing the chip together with an ornamental pattern according to a fourth modification example.
[FIG. 69] FIG. 69 is a cross-sectional perspective view showing a column region according to a modification example.
[FIG. 70] FIG. 70 is a cross-sectional view showing a main portion of the outer peripheral region.
[FIG. 71] FIG. 71 is a schematic diagram showing a configuration example of an ion implantation processing system used in manufacture of the SiC semiconductor devices according to the first to third embodiments.
[FIG. 72] FIG. 72 is a schematic diagram showing a configuration example of an off-angle transfer device shown in FIG. 71.
[FIG. 73] FIG. 73 is a schematic diagram showing a configuration example of an X-ray diffraction device shown in FIG. 72.
[FIG. 74] FIG. 74 is a flowchart showing a process example of the off-angle transfer device.
[FIG. 75] FIG. 75 is a schematic view showing a measurement example by the X-ray diffraction device shown in FIG. 73.
[FIG. 76] FIG. 76 is a graph showing a rocking curve.
[FIG. 77] FIG. 77 is a schematic diagram showing a configuration example of a channeling ion implantation device shown in FIG. 71.
[FIG. 78] FIG. 78 is a schematic diagram showing a configuration example of an ion implantation device shown in FIG. 76.
[FIG. 79] FIG. 79 is a flowchart showing a process example of the channeling ion implantation device.
[FIG. 80] FIG. 80 is a schematic view for illustrating an ion implantation step.
[FIG. 81] FIG. 81 is a schematic view for illustrating an ion implantation step.

### [Detailed Description]

Hereinafter, specific embodiments will be described in detail with reference to the accompanying drawings. All of the accompanying drawings are schematic views and thus are not precisely drawn and are not always matched in relative positional relationships, reduced scales, ratios, angles, etc. Identical reference signs are assigned to corresponding structures in the accompanying drawings, and redundant descriptions thereof will be omitted or simplified. Descriptions provided before the omission or simplification will be applied to the structures described in an omitted or simplified manner.

When the wording "substantially" is used in this Description, the wording includes a numerical value (shape) equal to a numerical value (shape) of the comparison target and also includes numerical errors (shape errors) in a range of ±10% on a basis of the numerical value (shape) of the comparison target. Although the wordings "first," "second," "third," etc., are used in the following description, these are symbols attached to names of respective structures in order to clarify the order of description and are not attached with an intention of restricting the names of the respective structures.

In the following descriptions, a "p-type" or an "n-type" is used to indicate a conductivity type of a semiconductor (impurities), however, the "p-type" may be referred to as a "first conductivity type," and the "n-type" may be referred to as a "second conductivity type." As a matter of course, the "n-type" may be referred to as a "first conductivity type," and the "p-type" may be referred to as a "second conductivity type." The "p-type" is a conductivity type due to a trivalent element, and the "n-type" is a conductivity type due to a pentavalent element. The trivalent element may be at least one type among boron, aluminum, gallium, and indium, unless otherwise specified. The pentavalent element is at least one type among nitrogen, phosphorus, arsenic, antimony, and bismuth, unless otherwise specified.

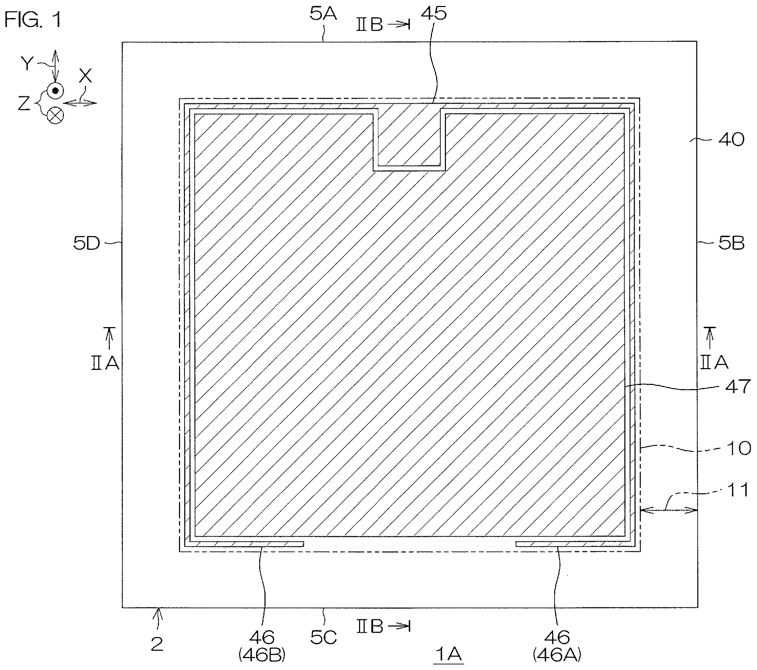

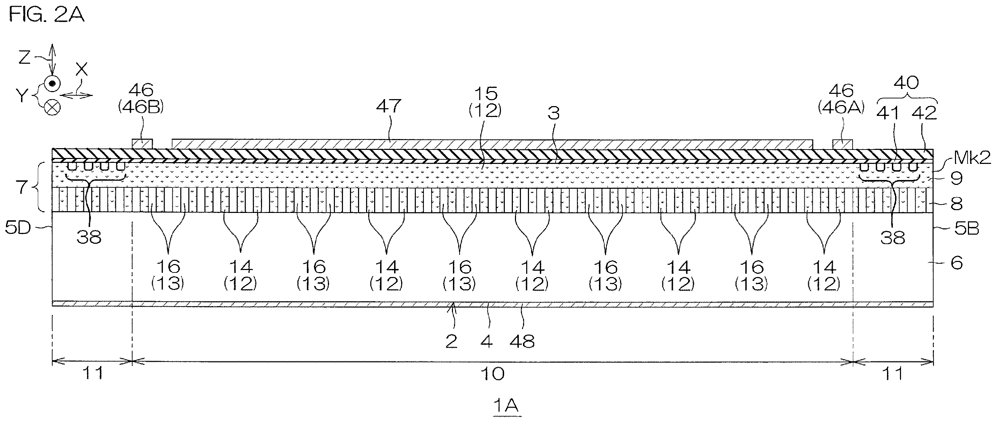

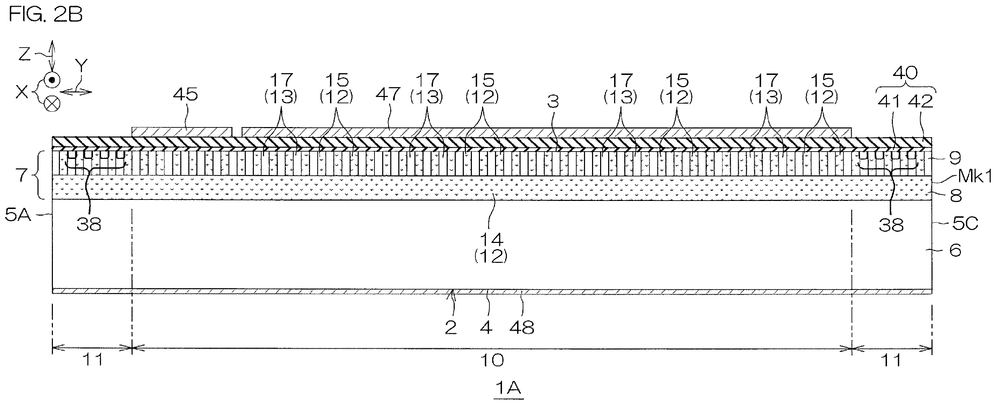

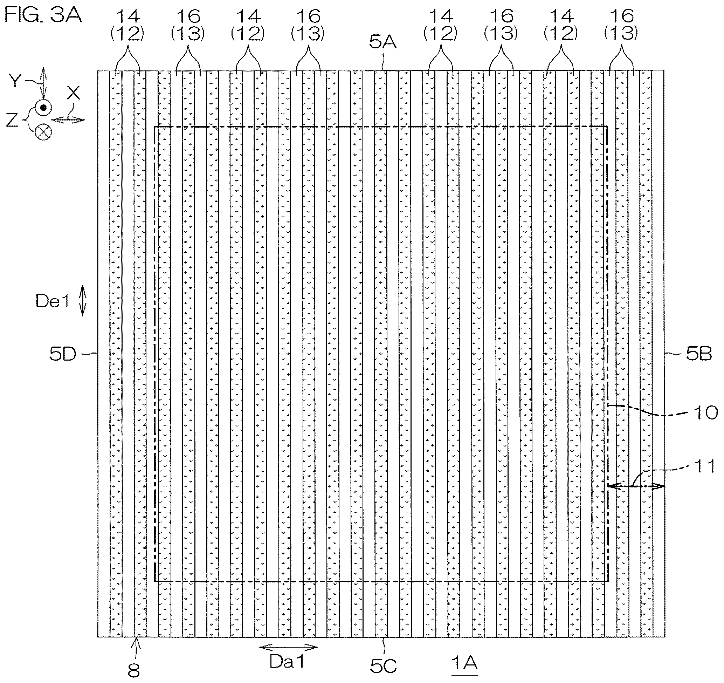

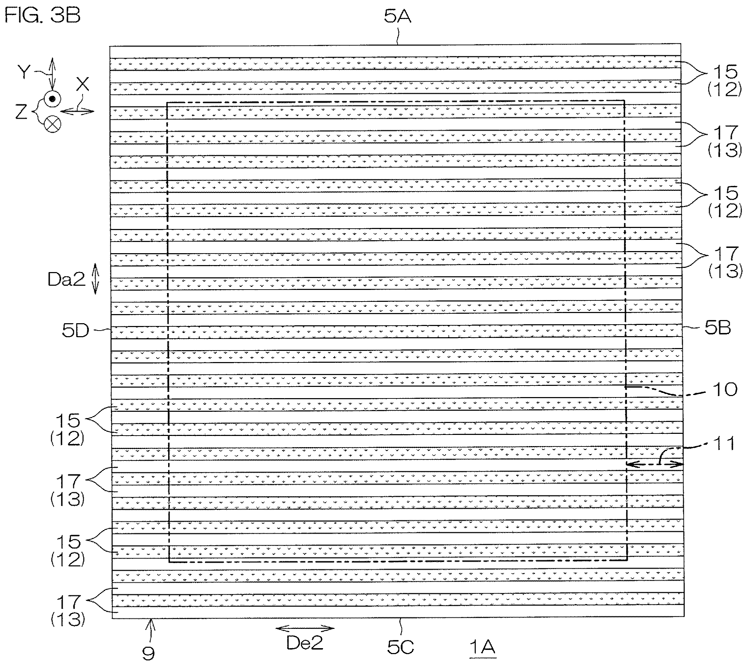

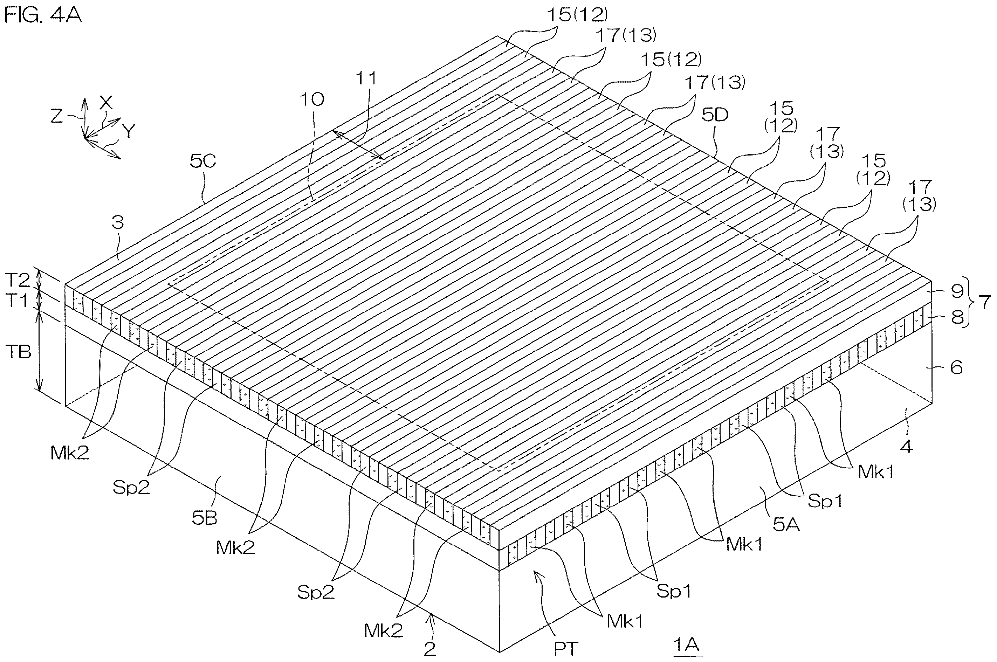

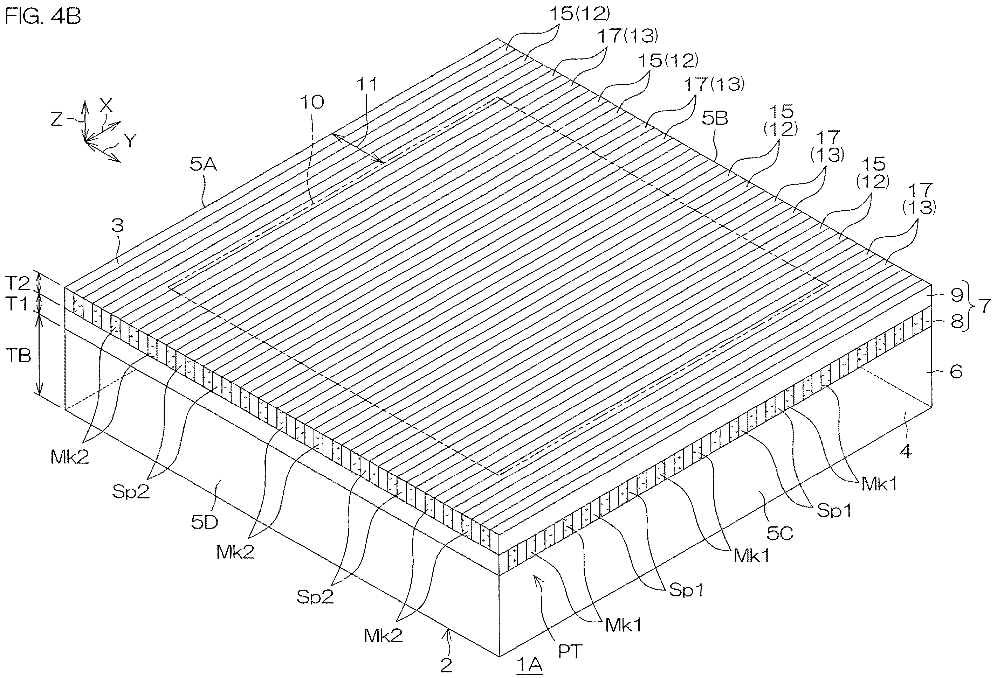

FIG. 1 is a plan view showing an SiC semiconductor device 1A according to a first embodiment. FIG. 2A is a cross-sectional view taken along line IIA-IIA in FIG. 1. FIG. 2B is a cross-sectional view taken along line IIB-IIB in FIG. 1. FIG. 3A is a plan view showing a layout example of a chip 2 (a first layer 8). FIG. 3B is a plan view showing a layout example of the chip 2 (a second layer 9). FIG. 4A is a perspective view showing the chip 2 together with an ornamental pattern PT according to a first configuration example. FIG. 4B is a perspective view showing the chip 2 together with the ornamental pattern PT according to the first configuration example.

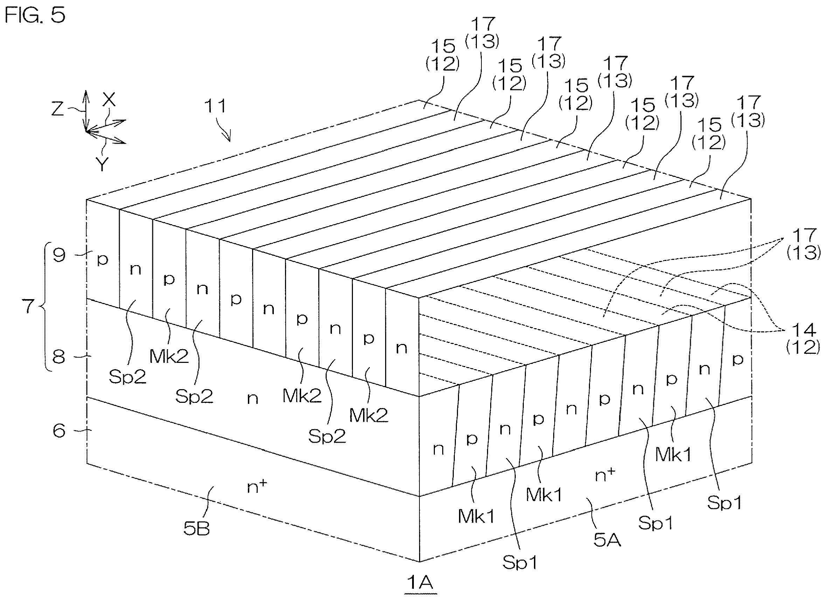

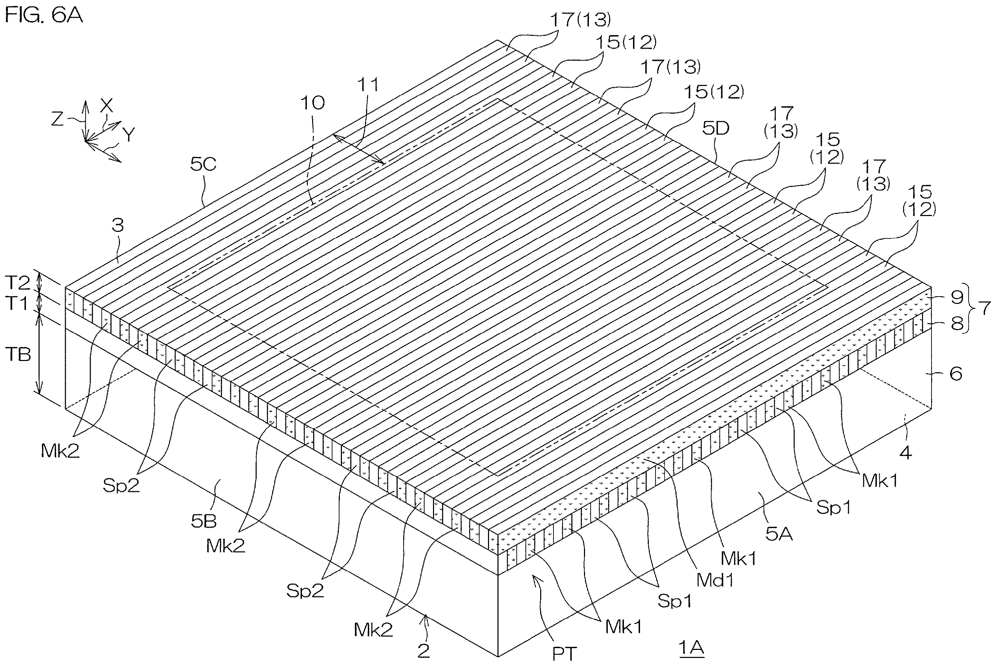

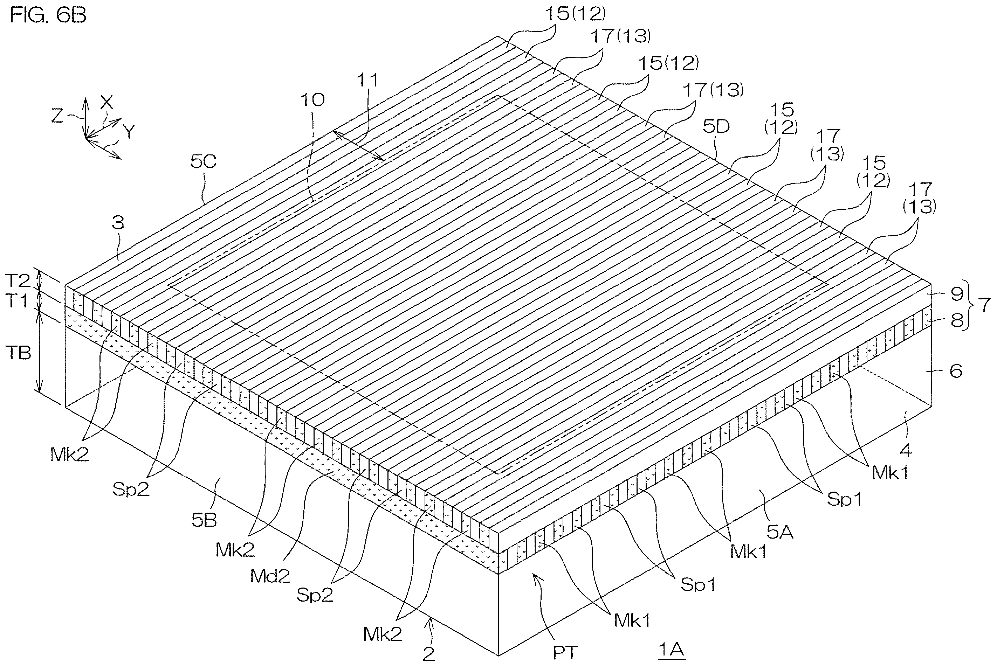

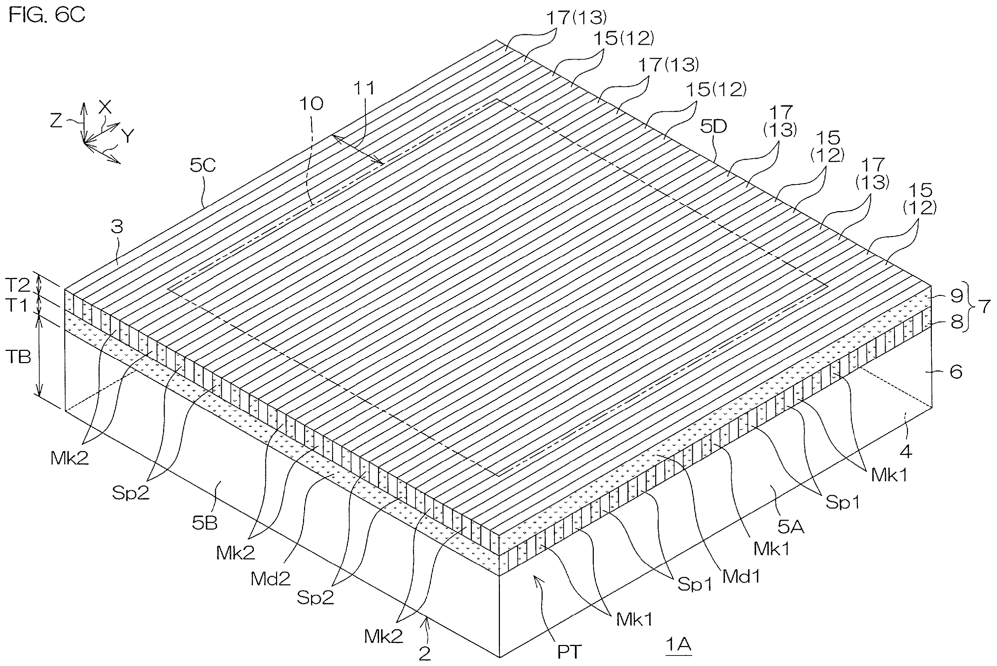

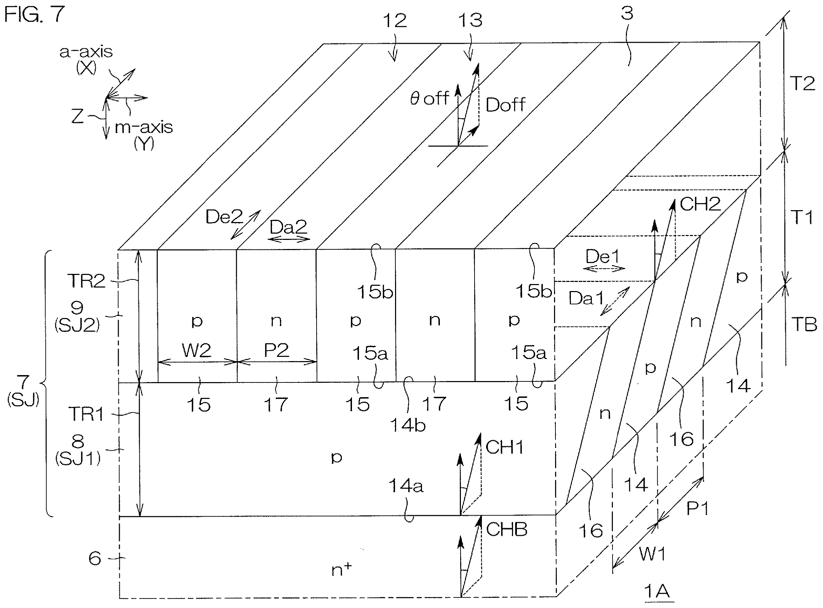

FIG. 5 is a perspective view of a main portion for showing the ornamental pattern PT. FIG. 6A is a perspective view showing the chip 2 together with the ornamental pattern PT according to a second configuration example. FIG. 6B is a perspective view showing the chip 2 together with the ornamental pattern PT according to a third configuration example. FIG. 6C is a perspective view showing the chip 2 together with the ornamental pattern PT according to a fourth configuration example. FIG. 7 is a cross-sectional perspective view showing a main portion of the chip 2 together with a first basic form of a column region 12.

With reference to FIGS. 1 to 7, the SiC semiconductor device 1A includes the chip 2 including an SiC monocrystal. The chip 2 may be referred to as an "SiC chip" or as a "semiconductor chip." In this embodiment, the chip 2 is constituted of a hexagonal SiC monocrystal and is formed in a rectangular parallelepiped shape. The hexagonal SiC monocrystal has a plurality of polytypes including a 2H (hexagonal)-SiC monocrystal, a 4H-SiC monocrystal, a 6H-SiC monocrystal, etc. In this embodiment, an example in which the chip 2 is constituted of the 4H-SiC monocrystal is described, but the chip 2 may be constituted of another polytype.

The chip 2 has a first main surface 3 on one side, a second main surface 4 on the other side, and first to fourth side surfaces 5A to 5D connecting the first main surface 3 and the second main surface 4. The first main surface 3 and the second main surface 4 are each formed in a quadrangular shape in plan view in a vertical direction Z (hereinafter, simply referred to as "plan view"). The vertical direction Z is also a thickness direction of the chip 2 or a normal direction to the first main surface 3 (the second main surface 4). The first main surface 3 and the second main surface 4 may each be formed in a square shape or a rectangular shape in plan view.

The first main surface 3 and the second main surface 4 are preferably formed of respective c-planes of the SiC monocrystal. In this case, preferably, the first main surface 3 is formed of a silicon surface (a (0001) surface) of the SiC monocrystal, and the second main surface 4 is formed of a carbon surface (a (000-1) surface) of the SiC monocrystal.

With regard to a circumferential direction (a clockwise direction in FIG. 1) of the chip 2 starting from the first side surface 5A, the second side surface 5B is connected to the first side surface 5A, the third side surface 5C is connected to the second side surface 5B, and the fourth side surface 5D is connected to the first side surface 5A and the third side surface 5C. The first side surface 5A and the third side surface 5C extend in a first direction X along the first main surface 3 and oppose each other in a second direction Y that intersects (specifically, is orthogonal to) the first direction X. The second side surface 5B and the fourth side surface 5D extend in the second direction Y and oppose each other in the first direction X.

In this embodiment, the first direction X is an a-axis direction (a [11-20] direction) of the SiC monocrystal, and the second direction Y is an m-axis direction (a [1-100] direction) of the SiC monocrystal. That is, the first side surface 5A and the third side surface 5C are respectively formed of m-planes ((1-100) planes) of the SiC monocrystal. Also, the second side surface 5B and the fourth side surface 5D are respectively formed of a-planes ((11-20) planes) of the SiC monocrystal.

The a-plane is a crystal plane orthogonal to the a-axis direction, and the m-plane is a crystal plane orthogonal to the m-axis direction. As a matter of course, the first direction X may be the m-axis direction of the SiC monocrystal, and the second direction Y may be the a-axis direction of the SiC monocrystal. Each of the first to fourth side surfaces 5A to 5D may be constituted of a ground surface. Each of the first to fourth side surfaces 5A to 5D may be constituted of a cleavage surface.

An XY plane including the first direction X and the second direction Y forms a horizontal plane orthogonal to the vertical direction Z. Hereinafter, an axis extending in the vertical direction Z may be referred to as a "vertical axis." Also, the first direction X and the second direction Y may be hereinafter referred to as a "horizontal direction." The horizontal direction may also be a direction extending along the first main surface 3.

With reference to FIG. 7, the chip 2 (the first main surface 3 and the second main surface 4) has an off angle θoff inclined at a predetermined angle in a predetermined off direction Doff with respect to the c-plane of the SiC monocrystal. That is, a c-axis (a (0001) axis) of the SiC monocrystal is inclined by the off angle θoff from the vertical axis toward the off direction Doff. Also, c-plane of the SiC monocrystal is also inclined by the off angle θoff with respect to the horizontal plane.

The off direction Doff is preferably the a-axis direction (that is, the first direction X) of the SiC monocrystal. The off angle θoff may exceed 0° and be not more than 10°. The off angle θoff may have a value falling within any one of ranges of exceeding 0° and not more than 1°, not less than 1° and not more than 2.5°, not less than 2.5° and not more than 5°, not less than 5° and not more than 7.5°, and not less than 7.5° and not more than 10°.

The off angle θoff is preferably not more than 5°. The off angle θoff is particularly preferably not less than 2° and not more than 4.5°. The off angle θoff is typically set in a range of 4° ± 0.1°. As a matter of course, this Description does not exclude a form in which the off angle θoff is 0° (that is, a form in which the first main surface 3 is a just surface with respect to the c-plane).

The chip 2 includes a base layer 6 of an n-type constituted of an SiC monocrystal. The base layer 6 may be referred to as a "base SiC layer," a "base region," etc. The base layer 6 extends in a layer shape in the horizontal direction and forms the second main surface 4 and a part of each of the first to fourth side surfaces 5A to 5D. In this embodiment, the base layer 6 is constituted of a substrate made of an SiC monocrystal (that is, an SiC substrate). The base layer 6 has the off direction Doff and the off angle θoff described above.

The base layer 6 has a base axis channel CHB oriented along a lamination direction. The base axis channel CHB is constituted of regions (channels) that are of comparatively wide interatomic distance (atomic interval) in the SiC monocrystal constituting the base layer 6 and are surrounded by atomic rows constituting a crystal axis extending in the lamination direction (crystal growth direction).

That is, the base axis channel CHB is constituted of regions that are sparse in atomic rows and extend in the lamination direction and are regions in which atomic rows (interatomic distance/atomic density) in the horizontal direction are sparse in plan view. The base axis channel CHB is preferably constituted of regions surrounded by atomic rows oriented along a low index crystal axis among crystal axes. A low index crystal axis is, in terms of Miller indices (a1, a2, a3, and c), a crystal axis expressed by absolute values of "a1," "a2," "a3," and "c" all being not more than 2 (preferably not more than 1) (the same applies hereinafter in this Description).

In this embodiment, the base axis channel CHB is constituted of regions surrounded by atomic rows oriented along the c-axis (the (0001) axis) of the SiC monocrystal. That is, the base axis channel CHB extends along the c-axis and has the off direction Doff and the off angle θoff described above. In other words, the base axis channel CHB is inclined by the off angle θoff from the vertical axis toward the off direction Doff.

The base layer 6 may have an n-type impurity concentration of not less than 1 x 10¹⁸ cm⁻³ and not more than 1 × 10²¹ cm⁻³ as a peak value. The base layer 6 preferably has a substantially constant n-type impurity concentration in the thickness direction. The n-type impurity concentration of the base layer 6 is preferably adjusted by a single type of pentavalent element. The n-type impurity concentration of the base layer 6 is particularly preferably adjusted by a pentavalent element other than phosphorus. In this embodiment, the n-type impurity concentration of the base layer 6 is adjusted by nitrogen.

The base layer 6 has a base thickness TB. The base thickness TB may be not less than 5 µm and not more than 300 µm. The base thickness TB may have a value falling within any one of ranges of not less than 5 µm and not more than 50 µm, not less than 50 µm and not more than 100 µm, not less than 100 µm and not more than 150 µm, not less than 150 µm and not more than 200 µm, not less than 200 µm and not more than 250 µm, and not less than 250 µm and not more than 300 µm. The base thickness TB is preferably not less than 50 µm and not more than 250 µm.

The chip 2 includes a laminated portion 7 laminated on the base layer 6. The laminated portion 7 may be referred to as a "semiconductor layer," an "SiC layer," an "SiC laminated portion," a "semiconductor laminated portion," etc. The laminated portion 7 has a laminated structure in which a plurality of (two or more) semiconductor layers constituted of the SiC monocrystal are laminated. In this embodiment, the plurality of semiconductor layers are provided as forming layers of a super junction structure SJ. The number of the plurality of laminated semiconductor layers (the super junction structure SJ) is arbitrary and is adjusted as appropriate in accordance with electrical characteristics to be achieved. Examples of electrical characteristics include a withstand voltage value (breakdown voltage), a resistance value, etc.

The number of the plurality of laminated semiconductor layers (the super junction structure SJ) is typically not less than two and not more than five (two, three, four, or five layers). In this embodiment, the laminated portion 7 has a two-layer structure including the first layer 8 of the n-type made of an SiC monocrystal and the second layer 9 of the n-type made of an SiC monocrystal. The first layer 8 may be referred to as a "first SiC layer," a "first semiconductor layer," etc. The second layer 9 may be referred to as a "second SiC layer," a "second semiconductor layer," etc.

The first layer 8 is laminated on the base layer 6. The first layer 8 extends in a layer shape in the horizontal direction and forms an intermediate portion of the chip 2 and a part of each of the first to fourth side surfaces 5A to 5D. The first layer 8 is constituted of an epitaxial layer (that is, an SiC epitaxial layer) that is crystal-grown with the base layer 6 as a starting point.

The first layer 8 has a lower end and an upper end. The lower end of the first layer 8 is a crystal growth starting point, and the upper end of the first layer 8 is a crystal growth end point. Since the first layer 8 is continuously crystal-grown from the base layer 6, the lower end of the first layer 8 is matched with an upper end of the base layer 6. A boundary portion between the base layer 6 and the first layer 8 is not necessarily visible and can be indirectly evaluated and/or determined from other configurations or elements. The first layer 8 has the off direction Doff and the off angle θoff that are substantially matched with the off direction Doff and the off angle θoff of the base layer 6.

The first layer 8 has a first axis channel CH1 oriented along the lamination direction. The first axis channel CH1 is constituted of regions (channels) that are of comparatively wide interatomic distance (atomic interval) in the SiC monocrystal constituting the first layer 8 and are surrounded by atomic rows constituting a crystal axis extending in the lamination direction (crystal growth direction).

That is, the first axis channel CH1 is constituted of the regions that are sparse in atomic rows and extend in the lamination direction and are the regions in which atomic rows (interatomic distance/atomic density) in the horizontal direction are sparse in plan view. The first axis channel CH1 is preferably constituted of the regions surrounded by atomic rows oriented along a low index crystal axis among crystal axes.

In this embodiment, the first axis channel CH1 is constituted of the regions surrounded by atomic rows oriented along the c-axis of the SiC monocrystal. That is, the first axis channel CH1 extends along the c-axis and has the off direction Doff and the off angle θoff. In other words, the first axis channel CH1 is inclined by the off angle θoff from the vertical axis toward the off direction Doff.

An n-type impurity concentration of the first layer 8 is preferably less than the n-type impurity concentration of the base layer 6. The first layer 8 may have an n-type impurity concentration of not less than 1 × 10¹⁵ cm⁻³ and not more than 1 × 10¹⁸ cm⁻³ as a peak value. The n-type impurity concentration of the first layer 8 may be substantially constant in the thickness direction. As a matter of course, the n-type impurity concentration of the first layer 8 may have a concentration gradient that gradually increases and/or gradually decreases in the lamination direction (the crystal growth direction).

The first layer 8 has an n-type impurity concentration adjusted by at least one type of pentavalent element. For example, the n-type impurity concentration of the first layer 8 may be adjusted by at least one type among nitrogen, phosphorus, arsenic, antimony, and bismuth. The first layer 8 preferably includes a pentavalent element other than phosphorus.

The n-type impurity concentration of the first layer 8 is preferably adjusted by at least nitrogen. In a case where the first layer 8 includes two or more types of pentavalent elements, the first layer 8 preferably includes nitrogen and a pentavalent element other than nitrogen. In this case, the first layer 8 preferably includes one or both of arsenic and antimony as a pentavalent element other than phosphorus and nitrogen.

The first layer 8 has a first thickness T1. The first thickness T1 is preferably less than the base thickness TB. The first thickness T1 is preferably not less than 1 µm. The first thickness T1 is preferably not more than 5 µm. The first thickness T1 may have a value falling within any one of ranges of not less than 1 µm and not more than 1.5 µm, not less than 1.5 µm and not more than 2 µm, not less than 2 µm and not more than 2.5 µm, not less than 2.5 µm and not more than 3 µm, not less than 3 µm and not more than 3.5 µm, not less than 3.5 µm and not more than 4 µm, not less than 4 µm and not more than 4.5 µm, and not less than 4.5 µm and not more than 5 µm.

The second layer 9 is laminated on the first layer 8. The second layer 9 extends in a layer shape in the horizontal direction and forms the first main surface 3 and a part of each of the first to fourth side surfaces 5A to 5D. The second layer 9 is constituted of an epitaxial layer (that is, an SiC epitaxial layer) that is crystal-grown with the first layer 8 as a starting point.

The second layer 9 has a lower end and an upper end. The lower end of the second layer 9 is a crystal growth starting point, and the upper end of the second layer 9 is a crystal growth end point. Since the second layer 9 is continuously crystal-grown from the first layer 8, the lower end of the second layer 9 is matched with the upper end of the first layer 8. A boundary portion between the first layer 8 and the second layer 9 is not necessarily visible and can be indirectly evaluated and/or determined from other configurations or elements. The second layer 9 has the off direction Doff and the off angle θoff that are substantially matched with the off direction Doff and the off angle θoff of the first layer 8.

The second layer 9 has a second axis channel CH2 oriented along the lamination direction. The second axis channel CH2 is constituted of regions (channels) that are of comparatively wide interatomic distance (atomic interval) in the SiC monocrystal constituting the second layer 9 and are surrounded by atomic rows constituting a crystal axis extending in the lamination direction (crystal growth direction).

That is, the second axis channel CH2 is constituted of the regions that are sparse in atomic rows and extend in the lamination direction and are the regions in which atomic rows (interatomic distance/atomic density) in the horizontal direction are sparse in plan view. The second axis channel CH2 is preferably constituted of the regions surrounded by atomic rows oriented along a low index crystal axis among crystal axes.

In this embodiment, the second axis channel CH2 is constituted of the regions surrounded by atomic rows oriented along the c-axis of the SiC monocrystal. That is, the second axis channel CH2 extends along the c-axis and has the off direction Doff and the off angle θoff. In other words, the second axis channel CH2 is inclined by the off angle θoff from the vertical axis toward the off direction Doff.

An n-type impurity concentration of the second layer 9 is preferably less than the n-type impurity concentration of the base layer 6. The second layer 9 may have an n-type impurity concentration of not less than 1 × 10¹⁵ cm⁻³ and not more than 1 × 10¹⁸ cm⁻³ as a peak value. The n-type impurity concentration of the second layer 9 may be substantially constant in the thickness direction. As a matter of course, the n-type impurity concentration of the second layer 9 may have a concentration gradient that gradually increases and/or gradually decreases in the lamination direction (the crystal growth direction).

The n-type impurity concentration of the second layer 9 is preferably substantially equal to the n-type impurity concentration of the first layer 8. As a matter of course, the n-type impurity concentration of the second layer 9 may be different from the n-type impurity concentration of the first layer 8. In this case, the n-type impurity concentration (the peak value) of the second layer 9 may be higher than the n-type impurity concentration (the peak value) of the first layer 8 or may be less than the n-type impurity concentration (the peak value) of the first layer 8.

The second layer 9 has an n-type impurity concentration adjusted by at least one type of pentavalent element. For example, the n-type impurity concentration of the second layer 9 may be adjusted by at least one type among nitrogen, phosphorus, arsenic, antimony, and bismuth. The second layer 9 preferably includes a pentavalent element other than phosphorus.

The n-type impurity concentration of the second layer 9 is preferably adjusted by at least nitrogen. In a case where the second layer 9 includes two or more types of pentavalent elements, the second layer 9 preferably includes nitrogen and a pentavalent element other than nitrogen. In this case, the second layer 9 preferably includes one or both of arsenic and antimony as a pentavalent element other than phosphorus and nitrogen.

The second layer 9 has a second thickness T2. The second thickness T2 is preferably less than the base thickness TB. The second thickness T2 may be substantially equal to the first thickness T1 or may be different from the first thickness T1. The second thickness T2 may be larger than the first thickness T1 or may be less than the first thickness T1.

The second thickness T2 is preferably not less than 1 µm. The second thickness T2 is preferably not more than 5 µm. The second thickness T2 may have a value falling within any one of ranges of not less than 1 µm and not more than 1.5 µm, not less than 1.5 µm and not more than 2 µm, not less than 2 µm and not more than 2.5 µm, not less than 2.5 µm and not more than 3 µm, not less than 3 µm and not more than 3.5 µm, not less than 3.5 µm and not more than 4 µm, not less than 4 µm and not more than 4.5 µm, and not less than 4.5 µm and not more than 5 µm.

The SiC semiconductor device 1A includes an active region 10 set in the chip 2. The active region 10 is set in an inner portion of the chip 2 at intervals from peripheral edges (the first to fourth side surfaces 5A to 5D) of the chip 2 in plan view. The active region 10 is set in a polygonal shape (a quadrangular shape in this embodiment) having four sides parallel to the peripheral edges of the chip 2 in plan view. A plane area of the active region 10 is preferably not less than 50% and not more than 90% of a plane area of the first main surface 3.

The SiC semiconductor device 1A includes an outer peripheral region 11 set outside the active region 10 in the chip 2. The outer peripheral region 11 is provided in a region between the peripheral edges of the chip 2 and the active region 10 in plan view. The outer peripheral region 11 extends as a band along the active region 10 in plan view and is set in a polygonal annular shape (a quadrangular annular shape in this embodiment) surrounding the active region 10.

With reference to FIGS. 4A, 4B, and 5, the SiC semiconductor device 1A includes the ornamental pattern PT according to a first configuration example formed in at least one of the first to fourth side surfaces 5A to 5D. The ornamental pattern PT facilitates, from the external appearance of the chip 2, identification or estimation of a configuration inside the device, discrimination between own and other products, etc., and enhances convenience of the SiC semiconductor device 1A. For example, the ornamental pattern PT may be identified by nondestructive inspection (appearance inspection) of the chip 2.

In this embodiment, the ornamental pattern PT includes at least one first mark Mk1 (in this embodiment, a plurality of first marks Mk1) and at least one second mark Mk2 (in this embodiment, a plurality of second marks Mk2). The ornamental pattern PT does not necessarily include both the first mark Mk1 and the second mark Mk2 at the same time, and may include only one of the first mark Mk1 and the second mark Mk2.

The plurality of first marks Mk1 are formed in at least one of the first to fourth side surfaces 5A to 5D. In this embodiment, the plurality of first marks Mk1 are formed in one or both (in this embodiment, both) of the first side surface 5A and the third side surface 5C extending in the first direction X. Since a configuration on the third side surface 5C side is identical to a configuration on the first side surface 5A side, the configuration on the first side surface 5A side will be described below. The configuration on the third side surface 5C side can be obtained by replacing the "first side surface 5A" with the "third side surface 5C" in the following description.

In this embodiment, each of the plurality of first marks Mk1 is constituted of an impurity region of the p-type that is exposed from the first side surface 5A. Each of the plurality of first marks Mk1 is formed in a portion of the first side surface 5A that is constituted of the laminated portion 7. Specifically, the plurality of first marks Mk1 are formed in a region on the side of the laminated portion 7 with respect to the base layer 6 and expose the base layer 6 from the first side surface 5A.

The plurality of first marks Mk1 are formed in the first side surface 5A such as to be unevenly distributed in a lower range of the laminated portion 7 on a lower side in a thickness direction with respect to an upper range of the laminated portion 7 on an upper side in the thickness direction. In a case where the upper range is defined as a first thickness range, the lower range is defined as a second thickness range. In a case where the lower range is defined as a first thickness range, the upper range is defined as a second thickness range. The upper range is a portion of each of the first to fourth side surfaces 5A to 5D that is constituted of the second layer 9, and the lower range is a portion of each of the first to fourth side surfaces 5A to 5D that is constituted of the first layer 8.

In this embodiment, the plurality of first marks Mk1 are arrayed at intervals in the first direction X in the lower range and define a plurality of first spaces Sp1 of the n-type that are each constituted of a part of the laminated portion 7. That is, each of the plurality of first marks Mk1 is formed in a portion in the first side surface 5A that is constituted of the first layer 8, and each of the plurality of first spaces Sp1 is constituted of a part of the first layer 8. The plurality of first marks Mk1 form pn-junction portions with the plurality of first spaces Sp1.

The plurality of first marks Mk1 have electrical characteristics (impurities = a trivalent element) different from electrical characteristics (impurities = a pentavalent element) of the plurality of first spaces Sp1. Therefore, the plurality of first marks Mk1 and the plurality of first spaces Sp1 are identified by measuring the electrical characteristics (impurities, concentrations, resistance values, etc.) of the plurality of first marks Mk1 and the plurality of first spaces Sp1. For example, the plurality of first marks Mk1 and the plurality of first spaces Sp1 can be identified using an electron microscope such as an SEM (scanning electron microscope) or a TEM (transmission electron microscope), etc., and/or EBIC (electron beam induced current) analysis, etc.

The plurality of first marks Mk1 are formed in a region on the side of the first layer 8 (the lower range) with respect to the second layer 9 (the upper range). Therefore, the plurality of first marks Mk1 expose the portions in the first side surface 5A that are constituted of the second layer 9 and oppose the first main surface 3 across the second layer 9. The plurality of first marks Mk1 expose the entire region of the portions in the first side surface 5A that are constituted of the second layer 9. That is, the plurality of first marks Mk1 are not formed in the second layer 9. Meanwhile, the plurality of first spaces Sp1 are connected to the portions in the first side surface 5A that are constituted of the second layer 9.

The plurality of first marks Mk1 extend individually in a vertically long columnar shape along the lamination direction and form stripe marks extending in the lamination direction along with the plurality of first spaces Sp1 in the first side surface 5A. The plurality of first marks Mk1 extend along the first axis channel CH1 in a surface layer portion of the first side surface 5A.

Each of the plurality of first marks Mk1 has a lower end portion on the lower end side of the first layer 8 and an upper end portion on the upper end side of the first layer 8. The lower end portion of each of the plurality of first marks Mk1 is positioned in a region on the lower end side of the first layer 8 with respect to a thickness range intermediate portion of the first layer 8, and the upper end portion of each of the plurality of first marks Mk1 is positioned in a region on the upper end side of the first layer 8 with respect to the thickness range intermediate portion of the first layer 8. That is, the plurality of first marks Mk1 are each constituted of a single impurity region having a thickness (a depth) that crosses an intermediate portion of the first layer 8 along the thickness direction.

The lower end portions of the plurality of first marks Mk1 may be formed at intervals from the lower end to the upper end side of the first layer 8 and may oppose the base layer 6 across a part (the lower end portion) of the first layer 8. That is, the plurality of first marks Mk1 may expose the entire region of the portions in the first side surface 5A that are constituted of the base layer 6. The lower end portions of the plurality of first marks Mk1 may be substantially matched with the lower end of the first layer 8 and may be connected to the base layer 6.

Each of the lower end portions of the plurality of first marks Mk1 may have an extension portion that crosses a boundary portion between the base layer 6 and the first layer 8 and is positioned in the base layer 6. In this case, it is preferable that the extension portions of the plurality of first marks Mk1 are positioned in a surface layer portion on the upper end side of the base layer 6 and expose substantially the entire region of the portions in the first side surface 5A that are constituted of the base layer 6. It is preferable that the extension portions of the plurality of first marks Mk1 are formed closer to the laminated portion 7 than a thickness range intermediate portion of the base layer 6.

The upper end portion of the first mark Mk1 may be formed at an interval from the upper end (that is, the second layer 9) toward the lower end side of the first layer 8 and may oppose the upper end of the first layer 8 across a part (the upper end portion) of the first layer 8. The upper end portion of the first mark Mk1 may be substantially matched with the upper end of the first layer 8 and may be connected to the second layer 9.

The plurality of second marks Mk2 are formed in at least one side surface of the first to fourth side surfaces 5A to 5D which is different from the side surface in which the plurality of first marks Mk1 are formed. In this embodiment, the plurality of second marks Mk2 are formed in one or both (in this embodiment, both) of the second side surface 5B and the fourth side surface 5D extending in the second direction Y. Since a configuration on the fourth side surface 5D side is identical to a configuration on the second side surface 5B side, the configuration on the second side surface 5B side will be described below. The configuration on the fourth side surface 5D side can be obtained by replacing the "second side surface 5B" with the "fourth side surface 5D" in the following description.

In this embodiment, each of the plurality of second marks Mk2 is constituted of an impurity region of the p-type that is exposed from the second side surface 5B. Each of the plurality of second marks Mk2 is formed in a portion of the second side surface 5B that is constituted of the laminated portion 7. Specifically, the plurality of second marks Mk2 are formed in a region on the side of the laminated portion 7 with respect to the base layer 6 and expose the base layer 6 from the second side surface 5B.

The plurality of second marks Mk2 are formed such as to be unevenly distributed in the upper range with respect to the lower range in the second side surface 5B. In this embodiment, the plurality of second marks Mk2 are arrayed at intervals in the second direction Y in the upper range and define a plurality of second spaces Sp2 of the n-type that are each constituted of a part of the laminated portion 7. That is, each of the plurality of second marks Mk2 is formed in a portion in the second side surface 5B that is constituted of the second layer 9, and each of the plurality of second spaces Sp2 is constituted of a part of the second layer 9. The plurality of second marks Mk2 form pn-junction portions with the plurality of second spaces Sp2.

The plurality of second marks Mk2 are formed in an array direction different from an array direction of the plurality of first marks Mk1, in a thickness range different from a thickness range of the plurality of first marks Mk1. The plurality of second spaces Sp2 are formed in an array direction different from an array direction of the plurality of first spaces Sp1, in a thickness range different from a thickness range of the plurality of first spaces Sp1.

The plurality of second marks Mk2 have electrical characteristics (impurities = a trivalent element) different from electrical characteristics (impurities = a pentavalent element) of the plurality of second spaces Sp2. Therefore, the plurality of second marks Mk2 and the plurality of second spaces Sp2 are identified by measuring the electrical characteristics (impurities, concentrations, resistance values, etc.) of the plurality of second marks Mk2 and the plurality of second spaces Sp2. For example, the plurality of second marks Mk2 and the plurality of second spaces Sp2 can be identified using an electron microscope such as an SEM or a TEM, etc., and/or EBIC analysis, etc.

The plurality of second marks Mk2 are formed in a region on the side of the second layer 9 (the upper range) with respect to the first layer 8 (the lower range) and oppose the base layer 6 across the first layer 8. The plurality of second marks Mk2 expose portions in the second side surface 5B that are constituted of the first layer 8. The plurality of second spaces Sp2 are respectively connected to the portions in the second side surface 5B that are constituted of the first layer 8.

The plurality of second marks Mk2 extend individually in a vertically long columnar shape along the lamination direction and form stripe marks extending in the lamination direction along with the plurality of second spaces Sp2 in the second side surface 5B. The plurality of second marks Mk2 extend along the second axis channel CH2 in a surface layer portion of the second side surface 5B.

Each of the plurality of second marks Mk2 has a lower end portion on the lower end side of the second layer 9 and an upper end portion on the upper end side of the second layer 9. The lower end portion of each of the plurality of second marks Mk2 is positioned in a region on the lower end side of the second layer 9 with respect to a thickness range intermediate portion of the second layer 9, and the upper end portion of each of the plurality of second marks Mk2 is positioned in a region on the upper end side of the second layer 9 with respect to the thickness range intermediate portion of the second layer 9. That is, the plurality of second marks Mk2 are each constituted of a single impurity region having a thickness (a depth) that crosses an intermediate portion of the second layer 9 along the thickness direction.

The lower end portion of the second mark Mk2 may be formed at an interval from the lower end to the upper end side of the second layer 9 and may oppose the first layer 8 across a part (the lower end portion) of the second layer 9. That is, the plurality of second marks Mk2 may expose the entire region of the portions in the second side surface 5B that are constituted of the first layer 8. The lower end portion of the second mark Mk2 may be substantially matched with the lower end of the first layer 8 and may be connected to the first layer 8.

The lower end portion of the second mark Mk2 may have an extension portion that crosses the boundary portion between the first layer 8 and the second layer 9 and is positioned in the first layer 8. In this case, it is preferable that the extension portions of the plurality of second marks Mk2 are positioned in a surface layer portion on the upper end side of the first layer 8 and expose substantially the entire region of the portions in the second side surface 5B that are constituted of the first layer 8.

The upper end portion of the second mark Mk2 may be formed at an interval from the upper end (that is, the first main surface 3) toward the lower end side of the second layer 9 and may oppose the upper end of the second layer 9 across a part (the upper end portion) of the second layer 9. The upper end portion of the second mark Mk2 may be exposed from the upper end (that is, the first main surface 3) of the second layer 9.

With reference to FIG. 6A, the SiC semiconductor device 1A may include the ornamental pattern PT according to a second configuration example formed in at least one of the first to fourth side surfaces 5A to 5D. The ornamental pattern PT according to the second configuration example includes a first difference mark Md1 in addition to the configuration according to the first configuration example.

The first difference mark Md1 is formed in a thickness range different from that of the first marks Mk1, in a layout different from that of the first marks Mk1, in one or both of the first side surface 5A and the third side surface 5C. FIG. 6A shows an example in which the first difference mark Md1 is formed in the first side surface 5A. The configuration on the third side surface 5C side can be obtained by replacing the "first side surface 5A" with the "third side surface 5C" in the following description.

In this embodiment, the first difference mark Md1 is constituted of the p-type impurity region that is exposed from the first side surface 5A. The first difference mark Md1 is formed in a portion of the first side surface 5A that is constituted of the laminated portion 7. Specifically, the first difference mark Md1 is formed in a region on the side of laminated portion 7 with respect to the base layer 6 and expose the base layer 6 from the first side surface 5A.

More specifically, the first difference mark Md1 is formed in the upper range with respect to the lower range and overlaps at least one of the first marks Mk1 in the thickness direction. In this embodiment, the first difference mark Md1 extends as a band in the first direction X in the upper range and overlaps the plurality of first marks Mk1 in the thickness direction.

In this embodiment, the first difference mark Md1 extends from a corner portion on one side of the first side surface 5A to a corner portion on the other side of the first side surface 5A in the first direction X and is exposed from the corner portion on the one side and the corner portion on the other side of the first side surface 5A. That is, the first difference mark Md1 overlaps all of the first marks Mk1 in the thickness direction.

The first difference mark Md1 has a portion exposed from the corner portion of the second side surface 5B and a corner portion of the fourth side surface 5D. The first difference mark Md1 is formed at the corner portion of the second side surface 5B (the fourth side surface 5D) at an interval in the second direction Y from the outermost second mark Mk2 and opposes the outermost second mark Mk2 in the second direction Y. The first difference mark Md1 is formed in a portion in the first side surface 5A that is constituted of the second layer 9 and defines, together with the plurality of first marks Mk1, the plurality of first spaces Sp1.

The first difference mark Md1 has electrical characteristics (impurities = a trivalent element) different from the electrical characteristics (impurities = a pentavalent element) of the plurality of first spaces Sp1. Therefore, the plurality of first difference marks Md1 and the plurality of first spaces Sp1 are identified by measuring the electrical characteristics (impurities, concentrations, resistance values, etc.) of the first difference mark Md1 and the plurality of first spaces Sp1. For example, the first difference mark Md1 and the plurality of first spaces Sp1 can be identified using an electron microscope such as an SEM or a TEM, etc., and/or EBIC analysis, etc.

The first difference mark Md1 has a lower end portion on the lower end side of the second layer 9 and an upper end portion on the upper end side of the second layer 9. The lower end portion of the first difference mark Md1 is positioned in a region on the lower end side of the second layer 9 with respect to the thickness range intermediate portion of the second layer 9, and the upper end portion of the first difference mark Md1 is positioned in a region on the upper end side of the second layer 9 with respect to the thickness range intermediate portion of the second layer 9. That is, the first difference mark Md1 is constituted of a single impurity region having a thickness (a depth) that crosses the intermediate portion of the second layer 9 along the thickness direction.

The lower end portion of the first difference mark Md1 may be formed at an interval from the plurality of first marks Mk1 toward the upper end (the first main surface 3) side of the second layer 9 and may oppose the plurality of first marks Mk1 (the plurality of first spaces Sp1) across a part (the lower end portion) of the second layer 9. The lower end portion of the first difference mark Md1 may be substantially matched with the lower end of the first layer 8.

In this case, the lower end portion of the first difference mark Md1 may be formed at an interval from the upper end portions of the plurality of first marks Mk1 toward the upper end side of the second layer 9 and may oppose the plurality of first marks Mk1 across a part (the lower end portion) of the second layer 9. As a matter of course, the lower end portion of the plurality of first difference marks Md1 may be connected to the upper end portions of the plurality of first marks Mk1 (the plurality of first spaces Sp1).

The lower end portion of the first difference mark Md1 may have an extension portion that crosses the boundary portion between the first layer 8 and the second layer 9 and is positioned in the first layer 8. In this case, the lower end portion (the extension portion) of the first difference mark Md1 may be connected to the plurality of first marks Mk1 in the first layer 8. As a matter of course, the lower end portion (the extension portion) of the first difference mark Md1 may be formed at an interval from the plurality of first marks Mk1 to the upper end side of the second layer 9.

The upper end portion of the first difference mark Md1 may be formed at an interval from the upper end (that is, the first main surface 3) toward the lower end side of the second layer 9 and may oppose the upper end of the second layer 9 across a part (the upper end portion) of the second layer 9. The upper end portion of the first difference mark Md1 may be exposed from the upper end (that is, the first main surface 3) of the second layer 9.

With reference to FIG. 6B, the SiC semiconductor device 1A may include the ornamental pattern PT according to a third configuration example formed in at least one of the first to fourth side surfaces 5A to 5D. The ornamental pattern PT according to the third configuration example includes a second difference mark Md2 in addition to the configuration according to the first configuration example.

The second difference mark Md2 is formed in a thickness range different from that of the second marks Mk2, in a layout different from that of the second marks Mk2, in one or both of the second side surface 5B and the fourth side surface 5D. FIG. 6B shows an example in which the second difference mark Md2 is formed in the second side surface 5B. The configuration on the fourth side surface 5D side can be obtained by replacing the "second side surface 5B" with the "fourth side surface 5D" in the following description.

In this embodiment, the second difference mark Md2 is constituted of the p-type impurity region that is exposed from the second side surface 5B. The second difference mark Md2 is formed in a portion of the second side surface 5B that is constituted of the laminated portion 7. Specifically, the second difference mark Md2 is formed in a region on the side of laminated portion 7 with respect to the base layer 6 and expose the base layer 6 from the second side surface 5B.

More specifically, the second difference mark Md2 is formed in the lower range with respect to the upper range and overlaps at least one of the second marks Mk2 in the thickness direction. In this embodiment, the second difference mark Md2 extends as a band in the second direction Y in the lower range and overlaps the plurality of second marks Mk2 in the thickness direction.

In this embodiment, the second difference mark Md2 extends from a corner portion on one side of the second side surface 5B to a corner portion on the other side of the second side surface 5B in the second direction Y and is exposed from the corner portion on the one side and the corner portion on the other side of the second side surface 5B. That is, the second difference mark Md2 overlaps all of the second marks Mk2 in the thickness direction.

The second difference mark Md2 has a portion exposed from the corner portion of the first side surface 5A and a corner portion of the third side surface 5C. The second difference mark Md2 is formed at the corner portion of the first side surface 5A (the third side surface 5C) at an interval in the first direction X from the outermost first mark Mk1 and opposes the outermost first mark Mk1 in the first direction X. The second difference mark Md2 is formed in a portion in the second side surface 5B that is constituted of the first layer 8 and defines, together with the plurality of second marks Mk2, the plurality of second spaces Sp2.

The second difference mark Md2 has electrical characteristics (impurities = a trivalent element) different from the electrical characteristics (impurities = a pentavalent element) of the plurality of second spaces Sp2. Therefore, the plurality of second difference marks Md2 and the plurality of second spaces Sp2 are identified by measuring the electrical characteristics (impurities, concentrations, resistance values, etc.) of the second difference mark Md2 and the plurality of second spaces Sp2. For example, the second difference mark Md2 and the plurality of second spaces Sp2 can be identified using an electron microscope such as an SEM or a TEM, etc., and/or EBIC analysis, etc.

The second difference mark Md2 has a lower end portion on the lower end side of the first layer 8 and an upper end portion on the upper end side of the first layer 8. The lower end portion of the second difference mark Md2 is positioned in a region on the lower end side of the first layer 8 with respect to the thickness range intermediate portion of the first layer 8, and the upper end portion of the second difference mark Md2 is positioned in a region on the upper end side of the first layer 8 with respect to the thickness range intermediate portion of the first layer 8. That is, the second difference mark Md2 is constituted of a single impurity region having a thickness (a depth) that crosses the intermediate portion of the first layer 8 along the first axis channel CH1.

The lower end portion of the second difference mark Md2 may be formed at an interval from the lower end (that is, the base layer 6) of the first layer 8 to the upper end (the second layer 9) side of the first layer 8 and may oppose the base layer 6 across a part (the lower end portion) of the first layer 8. The lower end portion of the second difference mark Md2 may be substantially matched with the lower end of the first layer 8 and may be connected to the base layer 6. The lower end portion of the second difference mark Md2 may have an extension portion that crosses the boundary portion between the base layer 6 and the first layer 8 and is positioned in the base layer 6.

The upper end portion of the second difference mark Md2 may be formed at an interval from the upper end (that is, the second layer 9) to the lower end side of the first layer 8 and may oppose the plurality of second marks Mk2 across a part (the upper end portion) of the first layer 8. The upper end portion of the second difference mark Md2 may be exposed from the upper end (that is, the first main surface 3) of the first layer 8.

In this case, the upper end portion of the second difference mark Md2 may be connected to the lower end portions of the plurality of second marks Mk2. As a matter of course, the upper end portion of the second difference mark Md2 may be formed at an interval from the lower end portions of the plurality of second marks Mk2 to the lower end side of the first layer 8 and may oppose the plurality of second marks Mk2 across a part (the lower end portion) of the first layer 8.

With reference to FIG. 6C, the SiC semiconductor device 1A may include the ornamental pattern PT according to a fourth configuration example formed in at least one of the first to fourth side surfaces 5A to 5D. The ornamental pattern PT according to the fourth configuration example includes the first difference mark Md1 according to the second configuration example and the second difference mark Md2 according to the third configuration example, in addition to the configuration according to the first configuration example. The second difference mark Md2 extends in an extension direction different from an extension direction of the first difference mark Md1, in a thickness range different from the thickness range of the first difference mark Md1.

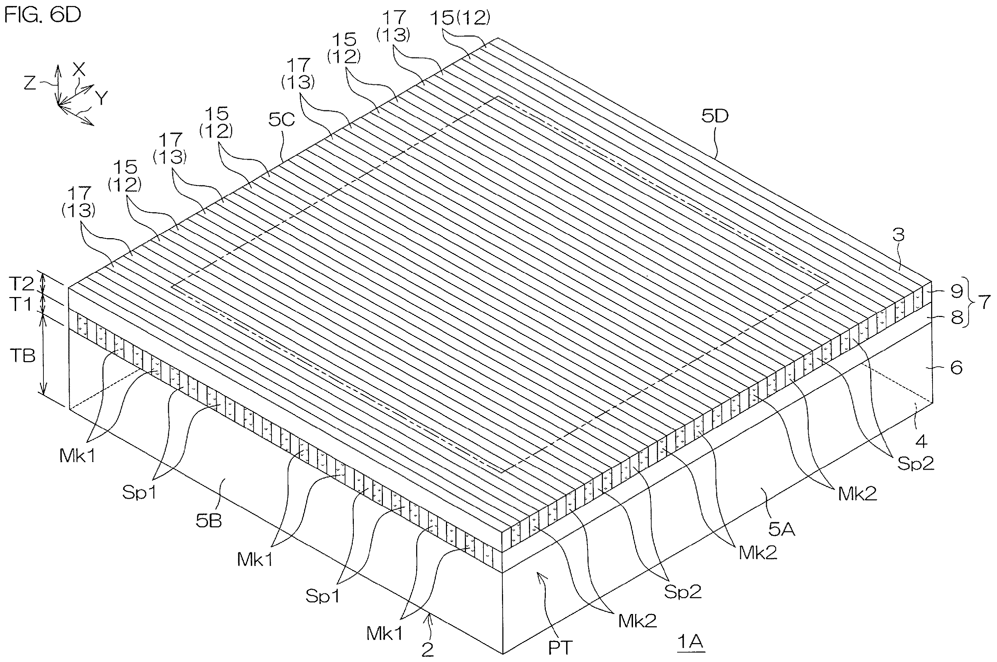

With reference to FIG. 6D, the SiC semiconductor device 1A may include the ornamental pattern PT according to a fifth configuration example formed in at least one of the first to fourth side surfaces 5A to 5D. The ornamental pattern PT according to the fifth configuration example has a configuration in which positional relationships between the plurality of first marks Mk1 and the plurality of second marks Mk2 are interchanged.

Specifically, the plurality of first marks Mk1 are arrayed at intervals in the second direction Y in the lower range of the second side surface 5B and define the plurality of n-type first spaces Sp1 that are each constituted of a part of the laminated portion 7. Each of the plurality of first marks Mk1 is formed in a portion in the second side surface 5B that is constituted of the first layer 8, and each of the plurality of first spaces Sp1 is constituted of a part of the first layer 8. Besides the above, the configuration of the first marks Mk1 (the first spaces Sp1) according to the fifth configuration example is identical to the configuration of the first marks Mk1 (the first spaces Sp1) according to the first configuration example except that the first marks Mk1 (the first spaces Sp1) are formed in the second side surface 5B.

Meanwhile, the plurality of second marks Mk2 are arrayed at intervals in the first direction X in the upper range of the first side surface 5A and define the plurality of n-type second spaces Sp2 that are each constituted of a part of the laminated portion 7. Each of the plurality of second marks Mk2 is formed in a portion in the first side surface 5A that is constituted of the second layer 9, and each of the plurality of second spaces Sp2 is constituted of a part of the second layer 9. Besides the above, the configuration of the second marks Mk2 (the second spaces Sp2) according to the fifth configuration example is identical to the configuration of the second marks Mk2 (the second spaces Sp2) according to the first configuration example except that the second marks Mk2 (the second spaces Sp2) are formed in the first side surface 5A.

As a matter of course, the configurations of the ornamental patterns PT according to the second to fourth configuration examples described above can also be applied to the ornamental pattern PT according to the fifth configuration example. In this case, the first difference mark Md1 described above is formed in the upper range of the second side surface 5B. Also, the second difference mark Md2 described above is formed in the lower range of the first side surface 5.

With reference to FIGS. 2 to 7, the SiC semiconductor device 1A includes the column region 12 of the p-type formed at least in the laminated portion 7 in the active region 10. The column region 12 may be referred to as a "column layer," a "pillar layer (region)," a "p-type layer (region)," a "p-type zone," etc. The column region 12 is formed in a three-dimensional lattice shape in the laminated portion 7 and defines three-dimensional lattice-shaped drift region 13 of the n-type which is constituted of a part of the laminated portion 7.

The column region 12 is formed in at least one semiconductor layer among the plurality of semiconductor layers constituting the laminated portion 7 and form a super junction structure SJ with the drift region 13 in the laminated portion 7. In this embodiment, the column region 12 has a laminated structure including a plurality of first regions 14 of the p-type and a plurality of second regions 15 of the p-type.

The plurality of first regions 14 are formed at intervals in the horizontal direction in the first layer 8 and define a plurality of first drift regions 16 of the n-type that are each constituted of a part of the first layer 8. The plurality of first regions 14 form a plurality of first pn-junction portions having charge balance together with the plurality of first drift regions 16.

That is, the plurality of first regions 14 constitute a first super junction structure SJ1 with the plurality of first drift regions 16. The state of having the charge balance means a state in which, regarding the plurality of first regions 14 adjacent to each other, a depletion layer expanding from one first pn-junction portion and a depletion layer expanding from the other first pn-junction portion are connected in the plurality of first drift regions 16.

The plurality of first regions 14 are arrayed at intervals in a first array direction Da1 in the first layer 8 and are each formed as a band extending in a first extension direction De1. The first extension direction De1 is a direction intersecting or orthogonal to the first array direction Da1. That is, the plurality of first regions 14 are formed as stripes extending in the first extension direction De1, and the plurality of first drift regions 16 are formed as stripes extending in the first extension direction De1.

In this embodiment, the plurality of first regions 14 are led out from the active region 10 to the outer peripheral region 11 (see FIG. 3A). That is, the plurality of first regions 14 are led out from a portion of the first layer 8 positioned in the active region 10 to a portion of the first layer 8 positioned in the outer peripheral region 11. The plurality of first regions 14 are arrayed at intervals in the first array direction Da1 also in the outer peripheral region 11 and are each formed as a band extending in the first extension direction De1.

Further, the plurality of first regions 14 extend from the outer peripheral region 11 toward one or both (in this embodiment, both) of the first side surface 5A and the third side surface 5C and respectively have portions exposed from one or both (in this embodiment, both) of the first side surface 5A and the third side surface 5C.

The portions of the plurality of first regions 14 exposed from the first side surface 5A form the plurality of first marks Mk1 in the first side surface 5A, and the portions of the plurality of first regions 14 exposed from the third side surface 5C form the plurality of first marks Mk1 in the third side surface 5C. That is, the plurality of first regions 14 include one or both of the plurality of first marks Mk1 as exposed portions exposed from the first side surface 5A and the plurality of first marks Mk1 as exposed portions exposed from the third side surface 5C.

In other words, each of the plurality of first marks Mk1 is formed using a part (an exposed portion) of each of the plurality of first regions 14. The layout (exposed locations or the array direction) of the plurality of first marks Mk1 with respect to the first side surface 5A (the third side surface 5C) is appropriately adjusted by the layout (the first array direction Da1 or the first extension direction De1) of the plurality of first regions 14.

The plurality of first marks Mk1 are not necessarily formed continuously from main body portions of the plurality of first regions 14 and may be formed as separated portions separated from the main body portions of the plurality of first regions 14. In this case, the plurality of first marks Mk1 are preferably separated from the main body portions of the plurality of first regions 14 in the outer peripheral region 11. The description for the first regions 14 is also applied to the first marks Mk1 (portions of the first regions 14 that are exposed from the first side surface 5A/the third side surface 5C).

The plurality of first regions 14 are constituted of channeling regions (first channeling regions) extending along the first axis channel CH1 in the first layer 8 in cross-sectional view. That is, the first region 14 is an impurity region introduced parallel to or substantially parallel to the regions (the first axis channel CH1) surrounded by atomic rows oriented along the low index crystal axis in the first layer 8 and inclinedly extends with respect to the first main surface 3.

Therefore, each of the plurality of first regions 14 has the off direction Doff and the off angle θoff that are substantially matched with the off direction Doff and the off angle θoff of the first axis channel CH1. In other words, each of the plurality of first regions 14 is inclined by the off angle θoff from the vertical axis toward the off direction Doff.

Each of the plurality of first regions 14 has a first lower end portion 14a on a lower end side of the first layer 8 and a first upper end portion 14b on an upper end side of the first layer 8. The first lower end portion 14a is positioned in a region on the lower end side of the first layer 8 with respect to a thickness range intermediate portion of the first layer 8, and the first upper end portion 14b is positioned in a region on the upper end side of the first layer 8 with respect to the thickness range intermediate portion of the first layer 8. That is, the plurality of first regions 14 are each constituted of a single impurity region having a thickness (a depth) that crosses an intermediate portion of the first layer 8 along the first axis channel CH1.

The first lower end portion 14a may be formed at an interval from the lower end to the upper end side of the first layer 8 and may oppose the base layer 6 across a part (a lower end portion) of the first layer 8. The first lower end portion 14a may be substantially matched with the lower end of the first layer 8 and be connected to the base layer 6. A distance between the lower end of the first layer 8 and the first lower end portion 14a may be not less than 0 µm and not more than 2 µm. The distance between the lower end of the first layer 8 and the first lower end portion 14a may have a value falling within any one of ranges of not less than 0 µm and not more than 0.5 µm, not less than 0.5 µm and not more than 1 µm, not less than 1 µm and not more than 1.5 µm, and not less than 1.5 µm and not more than 2 µm.

The first lower end portion 14a may have an extension portion that crosses the boundary portion between the base layer 6 and the first layer 8 and is positioned in the base layer 6. In this case, a thickness of the extension portion of the first lower end portion 14a on the basis of the upper end of the base layer 6 may exceed 0 µm and be not more than 2 µm. The thickness of the extension portion of the first lower end portion 14a may have a value falling within any one of ranges of exceeding 0 µm and not more than 0.5 µm, not less than 0.5 µm and not more than 1 µm, not less than 1 µm and not more than 1.5 µm, and not less than 1.5 µm and not more than 2 µm.

The first upper end portion 14b may be formed at an interval from the upper end (that is, the second layer 9) toward the lower end side of the first layer 8 and may oppose the upper end of the first layer 8 across a part (an upper end portion) of the first layer 8. The first upper end portion 14b may be substantially matched with the upper end of the first layer 8 and may be connected to the second layer 9.

A distance between the upper end of the first layer 8 and the first upper end portion 14b may be not less than 0 µm and not more than 1 µm. The distance between the upper end of the first layer 8 and the first upper end portion 14b may have a value falling within any one of ranges of not less than 0 µm and not more than 0.25 µm, not less than 0.25 µm and not more than 0.5 µm, not less than 0.5 µm and not more than 0.75 µm, and not less than 0.75 µm and not more than 1 µm.

The plurality of first regions 14 may have a p-type impurity concentration of not less than 1 × 10¹⁵ cm⁻³ and not more than 1 × 10¹⁸ cm⁻³ as a peak value. The p-type impurity concentration of the first region 14 is preferably adjusted by at least one type of trivalent element. The p-type impurity concentration of the first region 14 is particularly preferably adjusted by a trivalent element belonging to heavy elements heavier than carbon. That is, the first region 14 preferably includes a trivalent element other than boron (at least one type among aluminum, gallium, and indium). In this embodiment, the p-type impurity concentration of the first region 14 is adjusted by aluminum.

Each of the plurality of first regions 14 has a first width W1. The first width W1 is a width along the first array direction Da1 of the first regions 14. The first width W1 is preferably less than the first thickness T1 of the first layer 8. As a matter of course, the first width W1 may be not less than the first thickness T1. The first width W1 is preferably less than the second thickness T2 of the second layer 9. As a matter of course, the first width W1 may be not less than the second thickness T2.

The first width W1 may be not less than 0.1 µm and not more than 5 µm. The first width W1 may have a value falling within any one of ranges of not less than 0.1 µm and not more than 0.25 µm, not less than 0.25 µm and not more than 0.5 µm, not less than 0.5 µm and not more than 0.75 µm, not less than 0.75 µm and not more than 1 µm, not less than 1 µm and not more than 1.5 µm, not less than 1.5 µm and not more than 2 µm, not less than 2 µm and not more than 2.5 µm, not less than 2.5 µm and not more than 3 µm, not less than 3 µm and not more than 3.5 µm, not less than 3.5 µm and not more than 4 µm, not less than 4 µm and not more than 4.5 µm, and not less than 4.5 µm and not more than 5 µm. The first width W1 is preferably not less than 0.5 µm and not more than 1.5 µm.

Each of the plurality of first regions 14 has a first region thickness TR1 (a first region depth). The first region thickness TR1 may be less than the first thickness T1 of the first layer 8. The first region thickness TR1 may be larger than the first thickness T1. The first region thickness TR1 may be substantially equal to the first thickness T1. The first region thickness TR1 may be less than the second thickness T2 of the second layer 9. The first region thickness TR1 may be larger than the second thickness T2. The first region thickness TR1 may be substantially equal to the second thickness T2.

The first region thickness TR1 is preferably not less than 1 µm. The first region thickness TR1 is preferably not more than 5 µm. The first region thickness TR1 may have a value falling within any one of ranges of not less than 1 µm and not more than 1.5 µm, not less than 1.5 µm and not more than 2 µm, not less than 2 µm and not more than 2.5 µm, not less than 2.5 µm and not more than 3 µm, not less than 3 µm and not more than 3.5 µm, not less than 3.5 µm and not more than 4 µm, not less than 4 µm and not more than 4.5 µm, and not less than 4.5 µm and not more than 5 µm.

Preferably, the first width W1 is less than the first thickness T1 of the first layer 8, and the first region thickness TR1 is larger than the first width W1. That is, each of the plurality of first regions 14 preferably has a first aspect ratio TR1/W1 extending in a vertically long columnar shape along the first axis channel CH1. The first aspect ratio TR1/W1 is a ratio of the first region thickness TR1 to the first width W1. In this case, the first region thickness TR1 is particularly preferably larger than the first thickness T1. For example, the first aspect ratio TR1/W1 may exceed 1 and be not more than 100.

The plurality of first regions 14 are formed at intervals of a first pitch P1 in the first array direction Da1. The first pitch P1 is preferably less than the first thickness T1 of the first layer 8. As a matter of course, the first pitch P1 may be not less than the first thickness T1. The first pitch P1 is preferably less than the second thickness T2 of the second layer 9. As a matter of course, the first pitch P1 may be not less than the second thickness T2.

The first pitch P1 may be not less than 0.1 µm and not more than 5 µm. The first pitch P1 may have a value falling within any one of ranges of not less than 0.1 µm and not more than 0.25 µm, not less than 0.25 µm and not more than 0.5 µm, not less than 0.5 µm and not more than 0.75 µm, not less than 0.75 µm and not more than 1 µm, not less than 1 µm and not more than 1.5 µm, not less than 1.5 µm and not more than 2 µm, not less than 2 µm and not more than 2.5 µm, not less than 2.5 µm and not more than 3 µm, not less than 3 µm and not more than 3.5 µm, not less than 3.5 µm and not more than 4 µm, not less than 4 µm and not more than 4.5 µm, and not less than 4.5 µm and not more than 5 µm. The first pitch P1 is preferably not less than 0.5 µm and not more than 1.5 µm.

The plurality of second regions 15 are formed at intervals in the horizontal direction in the second layer 9 and define a plurality of second drift regions 17 of the n-type that are each constituted of a part of the second layer 9. The plurality of second regions 15 form a plurality of second pn-junction portions having the charge balance together with the plurality of second drift regions 17.

That is, the plurality of second regions 15 constitute a second super junction structure SJ2 with the second layer 9. The state of having the charge balance means a state in which, regarding the plurality of second regions 15 adjacent to each other, a depletion layer expanding from one second pn-junction portion and a depletion layer expanding from the other second pn-junction portion are connected in the plurality of second drift regions 17.

The plurality of second regions 15 are formed in the second layer 9 such as to overlap the plurality of first regions 14 in the lamination direction. Specifically, the plurality of second regions 15 are arrayed at intervals in a second array direction Da2 different from the first array direction Da1 in the second layer 9 and are each formed as a band extending in a second extension direction De2 different from the first extension direction De1.

The second array direction Da2 is a direction intersecting the first array direction Da1, and the second extension direction De2 is a direction intersecting the first extension direction De1. The second extension direction De2 is a direction intersecting or orthogonal to the second array direction Da2. That is, the plurality of second regions 15 are formed as stripes extending in the second extension direction De2, and the plurality of second drift regions 17 are formed as stripes extending in the second extension direction De2.

The plurality of second regions 15 intersect the plurality of first regions 14 in plan view. That is, the plurality of second drift regions 17 are connected in a lattice shape to the plurality of first drift regions 16 at the boundary portion between the first layer 8 and the second layer 9 and form the single drift region 13 in a three-dimensional lattice shape together with the plurality of first drift regions 16. The plurality of second drift regions 17 form three-dimensional lattice-shaped current paths together with the plurality of first drift regions 16.

In this embodiment, the plurality of second regions 15 are led out from the active region 10 to the outer peripheral region 11 (see FIG. 3B). That is, the plurality of second regions 15 are led out from a portion of the second layer 9 positioned in the active region 10 to a portion of the second layer 9 positioned in the outer peripheral region 11. The plurality of second regions 15 are arrayed at intervals in the second array direction Da2 also in the outer peripheral region 11 and are each formed as a band extending in the second extension direction De2. That is, the plurality of second regions 15 intersect the plurality of first regions 14 also in the outer peripheral region 11.

Further, the plurality of second regions 15 extend from the outer peripheral region 11 toward one or both (in this embodiment, both) of the second side surface 5B and the fourth side surface 5D and respectively have portions exposed from one or both (in this embodiment, both) of the second side surface 5B and the fourth side surface 5D.

The portions of the plurality of second regions 15 exposed from the second side surface 5B form the plurality of second marks Mk2 in the second side surface 5B, and the portions of the plurality of second regions 15 exposed from the fourth side surface 5D form the plurality of second marks Mk2 in the fourth side surface 5D. That is, the plurality of second regions 15 include one or both of the plurality of second marks Mk2 as exposed portions exposed from the second side surface 5B and the plurality of second marks Mk2 as exposed portions exposed from the fourth side surface 5D.

In other words, each of the plurality of second marks Mk2 is formed using a part (an exposed portion) of each of the plurality of second regions 15. The layout (exposed locations or the array direction) of the plurality of second marks Mk2 with respect to the second side surface 5B (the fourth side surface 5D) is appropriately adjusted by the layout (the second array direction Da2 or the second extension direction De2) of the plurality of second regions 15.

The plurality of second marks Mk2 are not necessarily formed continuously from main body portions of the plurality of second regions 15 and may be formed as separated portions separated from the main body portions of the plurality of second regions 15. In this case, the plurality of second marks Mk2 are preferably separated from the main body portions of the plurality of second regions 15 in the outer peripheral region 11. The description for the second regions 15 is also applied to the second marks Mk2 (portions of the second regions 15 that are exposed from the second side surface 5B/the fourth side surface 5D).

The plurality of second regions 15 are constituted of channeling regions (second channeling regions) extending along the second axis channel CH2 in the second layer 9 in cross-sectional view. That is, the second region 15 is an impurity region introduced parallel to or substantially parallel to the regions (the second axis channel CH2) surrounded by atomic rows oriented along the low index crystal axis in the second layer 9 and inclinedly extends with respect to the first main surface 3.

Therefore, each of the plurality of second regions 15 has the off direction Doff and the off angle θoff that are substantially matched with the off direction Doff and the off angle θoff of the second axis channel CH2. In other words, each of the plurality of second regions 15 is inclined by the off angle θoff from the vertical axis toward the off direction Doff.

Each of the plurality of second regions 15 has a second lower end portion 15a on a lower end side of the second layer 9 and a second upper end portion 15b on an upper end side of the second layer 9. The second lower end portion 15a is positioned in a region on the lower end side of the second layer 9 with respect to a thickness range intermediate portion of the second layer 9, and the second upper end portion 15b is positioned in a region on the upper end side of the second layer 9 with respect to the thickness range intermediate portion of the second layer 9. That is, the plurality of second regions 15 are each constituted of a single impurity region having a thickness (a depth) that crosses an intermediate portion of the second layer 9 along the second axis channel CH2.

The second lower end portion 15a may be formed at an interval from the lower end toward the upper end side of the second layer 9 and may oppose the first layer 8 (the plurality of first regions 14) across a part (a lower end portion) of the second layer 9. The second lower end portion 15a may be substantially matched with the lower end of the second layer 9 and may be connected to the first layer 8. A distance between the lower end of the second layer 9 and the second lower end portion 15a may be not less than 0 µm and not more than 2 µm. The distance between the lower end of the second layer 9 and the second lower end portion 15a may have a value falling within any one of ranges of not less than 0 µm and not more than 0.5 µm, not less than 0.5 µm and not more than 1 µm, not less than 1 µm and not more than 1.5 µm, and not less than 1.5 µm and not more than 2 µm.

The second lower end portion 15a may have an extension portion that crosses the boundary portion between the first layer 8 and the second layer 9 and is positioned in the first layer 8. In this case, a thickness of the extension portion of the second lower end portion 15a on the basis of the upper end of the first layer 8 may exceed 0 µm and be not more than 2 µm. The thickness of the extension portion of the second lower end portion 15a may have a value falling within any one of ranges of exceeding 0 µm and not more than 0.5 µm, not less than 0.5 µm and not more than 1 µm, not less than 1 µm and not more than 1.5 µm, and not less than 1.5 µm and not more than 2 µm.

The second upper end portion 15b may be formed at an interval from the upper end (that is, the first main surface 3) toward the lower end side of the second layer 9 and may oppose the upper end of the second layer 9 across a part (an upper end portion) of the second layer 9. In this case, a space between the first main surface 3 and the second upper end portion 15b in the second layer 9 may be used as a region for forming a device structure (another impurity region, etc.). As a matter of course, the second upper end portion 15b may be exposed from the upper end (that is, the first main surface 3) of the second layer 9.

A distance between the upper end of the second layer 9 and the second upper end portion 15b may be not less than 0 µm and not more than 1 µm. The distance between the upper end of the second layer 9 and the second upper end portion 15b may have a value falling within any one of ranges of not less than 0 µm and not more than 0.25 µm, not less than 0.25 µm and not more than 0.5 µm, not less than 0.5 µm and not more than 0.75 µm, and not less than 0.75 µm and not more than 1 µm.

The plurality of second regions 15 may have a p-type impurity concentration of not less than 1 × 10¹⁵ cm⁻³ and not more than 1 × 10¹⁸ cm⁻³ as a peak value. The p-type impurity concentration (a peak value) of the second region 15 may be not less than the p-type impurity concentration (the peak value) of the first region 14. The p-type impurity concentration (the peak value) of the second region 15 may be less than the p-type impurity concentration (the peak value) of the first region 14. The p-type impurity concentration (the peak value) of the second region 15 may be substantially equal to the p-type impurity concentration (the peak value) of the first region 14.

The p-type impurity concentration of the second region 15 is preferably adjusted by at least one type of trivalent element. The p-type impurity concentration of the second region 15 is particularly preferably adjusted by a trivalent element belonging to heavy elements heavier than carbon. That is, the second region 15 preferably includes a trivalent element other than boron (at least one type among aluminum, gallium, and indium). In this embodiment, the p-type impurity concentration of the second region 15 is adjusted by aluminum.

Each of the plurality of second regions 15 has a second width W2. The second width W2 is a width along the second array direction Da2 of the second regions 15. The second width W2 is preferably less than the second thickness T2 of the second layer 9. As a matter of course, the second width W2 may be not less than the second thickness T2.

The second width W2 is preferably less than the first thickness T1 of the first layer 8. As a matter of course, the second width W2 may be not less than the first thickness T1. The second width W2 is preferably substantially equal to the first width W1 of the first region 14. As a matter of course, the second width W2 may be not less than the first width W1 or may be less than the first width W1.

The second width W2 may be not less than 0.1 µm and not more than 5 µm. The second width W2 may have a value falling within any one of ranges of not less than 0.1 µm and not more than 0.25 µm, not less than 0.25 µm and not more than 0.5 µm, not less than 0.5 µm and not more than 0.75 µm, not less than 0.75 µm and not more than 1 µm, not less than 1 µm and not more than 1.5 µm, not less than 1.5 µm and not more than 2 µm, not less than 2 µm and not more than 2.5 µm, not less than 2.5 µm and not more than 3 µm, not less than 3 µm and not more than 3.5 µm, not less than 3.5 µm and not more than 4 µm, not less than 4 µm and not more than 4.5 µm, and not less than 4.5 µm and not more than 5 µm. The second width W2 is preferably not less than 0.5 µm and not more than 1.5 µm.

Each of the plurality of second regions 15 has a second region thickness TR2 (a region depth). The second region thickness TR2 may be less than the second thickness T2 of the second layer 9. The second region thickness TR2 may be larger than the second thickness T2. The second region thickness TR2 may be substantially equal to the second thickness T2.

The second region thickness TR2 may be less than the first thickness T1 of the first layer 8. The second region thickness TR2 may be larger than the first thickness T1. The second region thickness TR2 may be substantially equal to the first thickness T1. The second region thickness TR2 may be less than the first region thickness TR1 of the first region 14. The second region thickness TR2 may be larger than the first region thickness TR1. The second region thickness TR2 may be substantially equal to the first region thickness TR1.

The second region thickness TR2 is preferably not less than 1 µm. The second region thickness TR2 is preferably not more than 5 µm. The second region thickness TR2 may have a value falling within any one of ranges of not less than 1 µm and not more than 1.5 µm, not less than 1.5 µm and not more than 2 µm, not less than 2 µm and not more than 2.5 µm, not less than 2.5 µm and not more than 3 µm, not less than 3 µm and not more than 3.5 µm, not less than 3.5 µm and not more than 4 µm, not less than 4 µm and not more than 4.5 µm, and not less than 4.5 µm and not more than 5 µm.

Preferably, the second width W2 is less than the second thickness T2 of the second layer 9, and the second region thickness TR2 is larger than the second width W2. That is, each of the plurality of second regions 15 preferably has a second aspect ratio TR2/W2 extending in a vertically long columnar shape along the second axis channel CH2. The second aspect ratio TR2/W2 is a ratio of the second region thickness TR2 to the second width W2. In this case, the second region thickness TR2 is particularly preferably larger than the second thickness T2. For example, the second aspect ratio TR2/W2 may exceed 1 and be not more than 100.

The plurality of second regions 15 are formed at intervals of a second pitch P2 in the second array direction Da2. The second pitch P2 is preferably less than the second thickness T2 of the second layer 9. As a matter of course, the second pitch P2 may be not less than the second thickness T2 of the second layer 9. The second pitch P2 is preferably less than the first thickness T1 of the first layer 8. As a matter of course, the second pitch P2 may be not less than the first thickness T1.

The second pitch P2 may be substantially equal to the first pitch P1 or may be different from the first pitch P1. The second pitch P2 may be larger than the first pitch P1 or may be smaller than the first pitch P1.

The second pitch P2 may be not less than 0.1 µm and not more than 5 µm. The second pitch P2 may have a value falling within any one of ranges of not less than 0.1 µm and not more than 0.25 µm, not less than 0.25 µm and not more than 0.5 µm, not less than 0.5 µm and not more than 0.75 µm, not less than 0.75 µm and not more than 1 µm, not less than 1 µm and not more than 1.5 µm, not less than 1.5 µm and not more than 2 µm, not less than 2 µm and not more than 2.5 µm, not less than 2.5 µm and not more than 3 µm, not less than 3 µm and not more than 3.5 µm, not less than 3.5 µm and not more than 4 µm, not less than 4 µm and not more than 4.5 µm, and not less than 4.5 µm and not more than 5 µm. The second pitch P2 is preferably not less than 0.5 µm and not more than 1.5 µm.

In this embodiment, the super junction structure SJ having a two-layer structure was described. However, the super junction structure SJ having a laminated structure of three or more layers may be employed. That is, the laminated portion 7 having the laminated structure of three or more layers may be formed, and the column region 12 having the laminated structure of three or more layers may be formed.

In this case, the third and subsequent semiconductor layers in the laminated portion 7 are formed to have a configuration identical to that of the second layer 9. Meanwhile, a region formed in a semiconductor layer of an odd number (2n + 1: n is a natural number of not less than 1) layer in the column region 12 is formed to have a configuration identical to that of the first region 14 (the first mark Mk1), and a region formed in a semiconductor layer of an even number (2n + 2) layer is formed to have a configuration identical to that of the second region 15 (the second mark Mk2). Of the column region 12, a region in an (n + 2)-th layer is formed in the (n + 2)-th semiconductor layer in a relationship identical to a relationship of a region in an (n + 1)-th layer with respect to a region in an n-th layer.

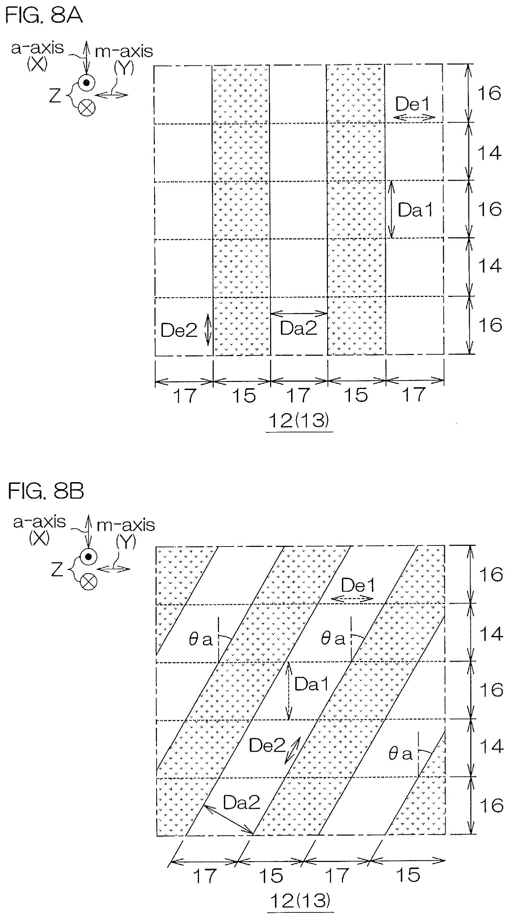

Hereinafter, a layout example of the first regions 14 and the second regions 15 will be described with reference to FIGS. 7, 8A, and 8B. The ornamental pattern PT (the plurality of first marks Mk1 and the plurality of second marks Mk2) is formed in a layout corresponding to the layout examples of the first regions 14 and the second regions 15 to be described below.

FIG. 8A is a plan view showing a first layout example of the column region 12 according to the first basic form. FIG. 8B is a plan view showing a second layout example of the column region 12 according to the first basic form. In FIGS. 8A and 8B, the first region 14 is shown by a broken line, and the second region 15 is shown by hatching.

With reference to FIGS. 7, 8A, and 8B, the first array direction Da1 of the first regions 14 may be the a-axis direction (the first direction X), and the first extension direction De1 of the first regions 14 may be the m-axis direction (the second direction Y). In this case, since the first extension direction De1 intersects (specifically, is orthogonal to) the off direction Doff of the first layer 8, the plurality of first regions 14 are inclined by substantially the off angle θoff from the vertical axis toward the off direction Doff in cross-sectional view from an m-plane ((1-100) plane) of the SiC monocrystal. The m-plane of the SiC monocrystal is a crystal plane orthogonal to the m-axis direction.

Meanwhile, with reference to FIGS. 7 and 8A, the plurality of second regions 15 may be orthogonal to the plurality of first regions 14 in plan view. That is, the second array direction Da2 of the second regions 15 may be the m-axis direction (the second direction Y), and the second extension direction De2 of the second regions 15 may be the a-axis direction (the first direction X). In this case, the second array direction Da2 is matched with the first extension direction De1 and is orthogonal to the first array direction Da1. Also, the second extension direction De2 is matched with the first array direction Da1 and is orthogonal to the first extension direction De1.

In this case, since the second extension direction De2 is matched with the off direction Doff of the second layer 9, the plurality of second regions 15 extend substantially in the vertical direction Z in cross-sectional view from an a-plane ((11-20) plane) of the SiC monocrystal. The a-plane of the SiC monocrystal is in a direction orthogonal to the a-axis direction. The plurality of second regions 15 are inclined by substantially the off angle θoff from the vertical axis toward the off direction Doff in cross-sectional view from the m-plane of the SiC monocrystal.

As a matter of course, with reference to FIG. 8B, the plurality of second regions 15 may non-orthogonally intersect the plurality of first regions 14 in plan view. That is, the second array direction Da2 of the second regions 15 may be a direction other than the m-axis direction and the a-axis direction, and the second extension direction De2 of the second regions 15 may be a direction other than the m-axis direction and the a-axis direction. In this case, the second array direction Da2 intersects both the first array direction Da1 and the first extension direction De1, and the second extension direction De2 intersects both the first array direction Da1 and the first extension direction De1. Also, the second extension direction De2 intersects with the off direction Doff of the second layer 9.

The second extension direction De2 may be inclined from the a-axis toward one side (the left side of the sheet surface) or the other side (the right side of the sheet surface) of the m-axis in plan view. The plurality of second regions 15 have the second extension direction De2 that forms an extension angle θa with the a-axis when the a-axis is a reference (0°).

An absolute value of the extension angle θa may exceed 0° and be less than 90°. The extension angle θa may have a value falling within any one of ranges of exceeding 0° and not more than 18°, not less than 18° and not more than 36°, not less than 36° and not more than 54°, not less than 54° and not more than 72°, and not less than 72° and less than 90°. The absolute value of the extension angle θa is typically set to a value falling within any one of ranges of 30° ± 5°, 45° ± 5°, and 60° ± 5°.

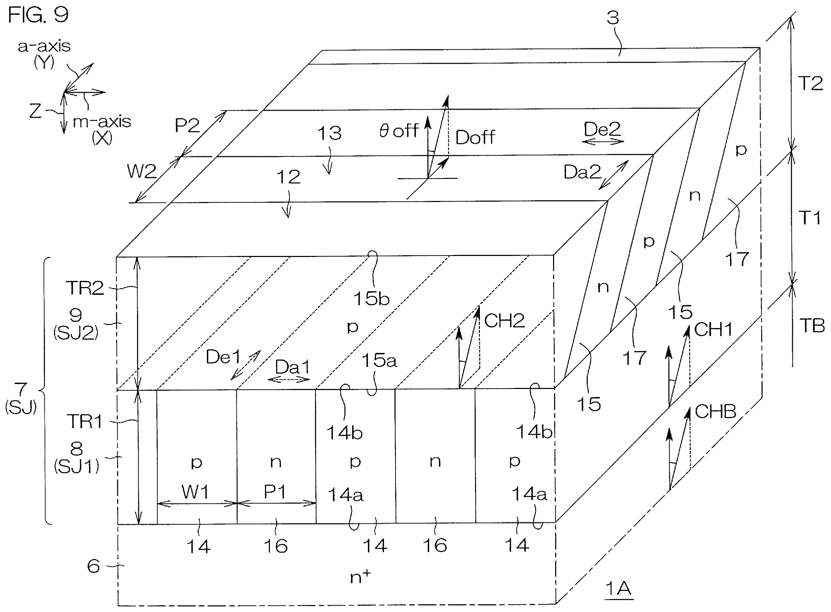

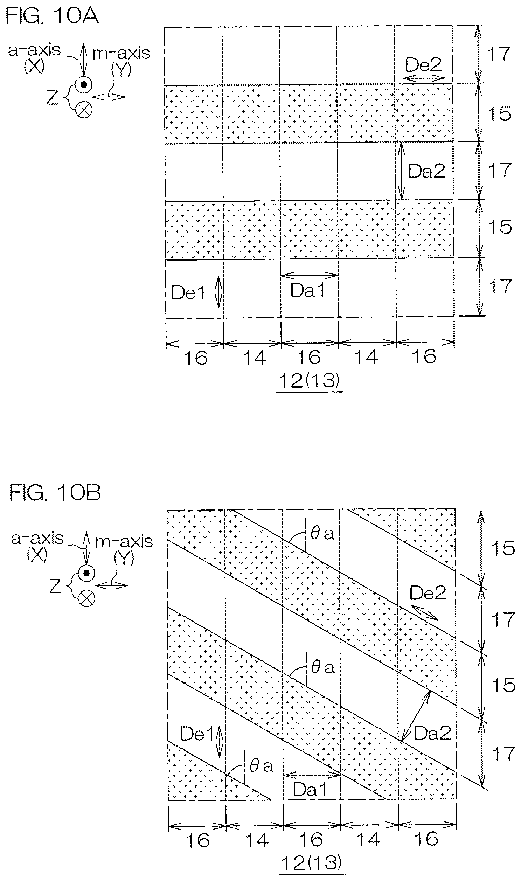

The column region 12 may have a form shown in FIGS. 9, 10A, and 10B. FIG. 9 is a cross-sectional perspective view showing a second basic form of the column region 12. FIGS. 10A and 10B are plan views showing a first layout example and a second layout example of the column region 12, respectively, according to the second basic form. In FIGS. 10A and 10B, the first region 14 is shown by a broken line, and the second region 15 is shown by hatching.

With reference to FIGS. 9, 10A, and 10B, the first array direction Da1 of the first regions 14 may be the m-axis direction (the first direction X), and the first extension direction De1 of the first regions 14 may be the a-axis direction (the second direction Y). In this case, since the first extension direction De1 is matched with the off direction Doff of the first layer 8, the plurality of first regions 14 extend substantially in the vertical direction Z in cross-sectional view from the a-plane of the SiC monocrystal. The plurality of first regions 14 have respective end portions inclined by substantially the off angle θoff from the vertical axis toward the off direction Doff in cross-sectional view from the m-plane of the SiC monocrystal.

Meanwhile, with reference to FIGS. 9 and 10A, the plurality of second regions 15 may be orthogonal to the plurality of first regions 14 in plan view. That is, the second array direction Da2 of the second regions 15 may be the a-axis direction (the second direction Y), and the second extension direction De2 of the second regions 15 may be the m-axis direction (the first direction X). In this case, the second array direction Da2 is matched with the first extension direction De1 and is orthogonal to the first array direction Da1. Also, the second extension direction De2 is matched with the first array direction Da1 and is orthogonal to the first extension direction De1.

In this case, since the second extension direction De2 intersects (specifically, is orthogonal to) the off direction Doff of the second layer 9, the plurality of second regions 15 are inclined by substantially the off angle θoff from the vertical axis toward the off direction Doff in cross-sectional view from the m-plane of the SiC monocrystal.

As a matter of course, with reference to FIG. 10B, the plurality of second regions 15 may non-orthogonally intersect the plurality of first regions 14 in plan view. That is, the second array direction Da2 of the second regions 15 may be a direction other than the a-axis direction and the m-axis direction, and the second extension direction De2 of the second regions 15 may be a direction other than the a-axis direction and the m-axis direction. In this case, the second array direction Da2 intersects both the first array direction Da1 and the first extension direction De1, and the second extension direction De2 intersects both the first array direction Da1 and the first extension direction De1. Also, the second extension direction De2 intersects with the off direction Doff of the second layer 9.

The second extension direction De2 may be inclined from the a-axis toward one side (the left side of the sheet surface) or the other side (the right side of the sheet surface) of the m-axis in plan view. The plurality of second regions 15 have the second extension direction De2 that forms an extension angle θa with the a-axis when the a-axis is a reference (0°).

An absolute value of the extension angle θa may exceed 0° and be less than 90°. The extension angle θa may have a value falling within any one of ranges of exceeding 0° and not more than 18°, not less than 18° and not more than 36°, not less than 36° and not more than 54°, not less than 54° and not more than 72°, and not less than 72° and less than 90°. The absolute value of the extension angle θa is typically set to a value falling within any one of ranges of 30° ± 5°, 45° ± 5°, and 60° ± 5°.

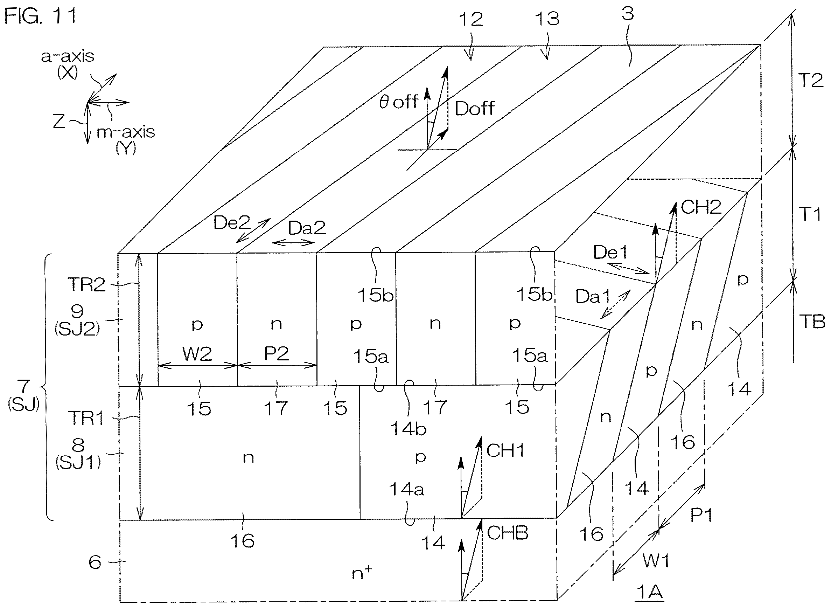

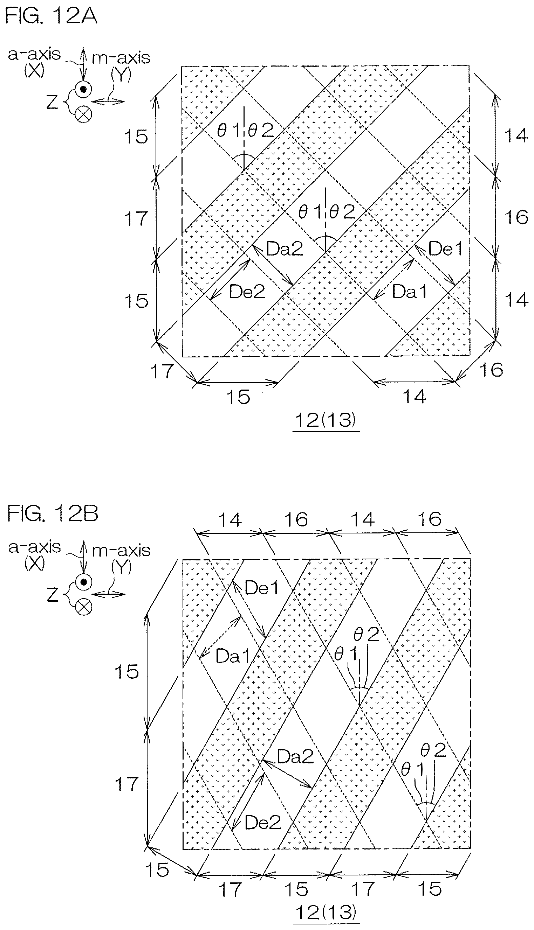

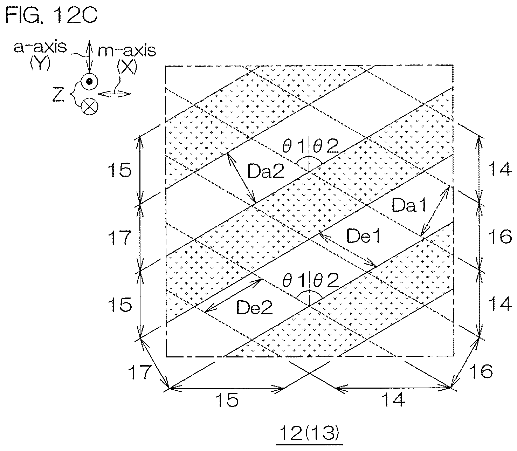

The column region 12 may have a form shown in FIGS. 11, 12A, 12B, and 12C. FIG. 11 is a cross-sectional perspective view showing a third basic form of the column region 12. FIGS. 12A, 12B, and 12C are plan views showing a first layout example, a second layout example, and a third layout example of the column region 12, respectively, according to the third basic form. In FIGS. 12A to 12C, the first region 14 is shown by a broken line, and the second region 15 is shown by hatching.

With reference to FIGS. 11 and 12A to 12C, the first array direction Da1 of the first regions 14 may be a direction other than the a-axis direction (the first direction X) and the m-axis direction (the second direction Y), and the first extension direction De1 of the first regions 14 may be a direction other than the a-axis direction and the m-axis direction. That is, the plurality of first regions 14 may intersect both the a-axis direction and the m-axis direction. FIGS. 12A to 12C show examples in which the first regions 14 are inclined toward one side (the left side of the sheet surface) of the m-axis on the basis of the a-axis.

In this case, since the first extension direction De1 intersects the off direction Doff, the plurality of first regions 14 are inclined by substantially the off angle θoff from the vertical axis toward the off direction Doff in cross-sectional view from the a-plane of the SiC monocrystal and cross-sectional view from the m-plane of the SiC monocrystal.

The first extension direction De1 forms a first extension angle θ1 with the a-axis when the a-axis is set as a reference (0°). An absolute value of the first extension angle θ1 may exceed 0° and be less than 90°. The first extension angle θ1 may have a value falling within any one of ranges of exceeding 0° and not more than 18°, not less than 18° and not more than 36°, not less than 36° and not more than 54°, not less than 54° and not more than 72°, and not less than 72° and less than 90°.

The absolute value of the first extension angle θ1 is typically set to a value falling within any one of ranges of 30° ± 5°, 45° ± 5°, and 60° ± 5°. FIG. 12A shows a layout example in which the absolute value of the first extension angle θ1 is substantially 45°, FIG. 12B shows a layout example in which the absolute value of the first extension angle θ1 is substantially 30°, and FIG. 12C shows a layout example in which the absolute value of the first extension angle θ1 is substantially 60°.

Meanwhile, with reference to FIGS. 11 and 12A to 12C, the first array direction Da1 of the second regions 15 may be a direction other than the a-axis direction (the first direction X) and the m-axis direction (the second direction Y), and the first extension direction De1 of the second regions 15 may be a direction other than the a-axis direction and the m-axis direction. That is, the plurality of second regions 15 may intersect both the a-axis direction and the m-axis direction. In this example, the second regions 15 are inclined toward the other side (the right side of the sheet surface) of the m-axis on the basis of the a-axis.

In this case, since the second extension direction De2 intersects the off direction Doff, the plurality of second regions 15 are inclined by substantially the off angle θoff from the vertical axis toward the off direction Doff in cross-sectional view from the a-plane of the SiC monocrystal and cross-sectional view from the m-plane of the SiC monocrystal.

The second extension direction De2 forms a second extension angle θ2 with the a-axis when the a-axis is set as a reference (0°). In a case where the first extension angle θ1 is defined as a "positive value," the second extension angle θ2 is set to a "negative value." Meanwhile, in a case where the first extension angle θ1 is defined as a "negative value," the second extension angle θ2 is set to a "positive value."

An absolute value of the second extension angle θ2 may exceed 0° and be less than 90°. The second extension angle θ2 may have a value falling within any one of ranges of exceeding 0° and not more than 18°, not less than 18° and not more than 36°, not less than 36° and not more than 54°, not less than 54° and not more than 72°, and not less than 72° and less than 90°.

The absolute value of the second extension angle θ2 is typically set to a value falling within any one of ranges of 30° ± 5°, 45° ± 5°, and 60° ± 5°. The absolute value of the second extension angle θ2 is preferably substantially equal to the absolute value of the first extension angle θ1. That is, it is preferable that the plurality of second regions 15 have a layout that is substantially line-symmetric with respect to the plurality of first regions 14 on the basis of the a-axis in plan view per unit area (that is, partial plan view). In other words, it is preferable that the plurality of second regions 15 have a layout that is substantially point symmetry with respect to the plurality of first regions 14 on the basis of the vertical axis in plan view per unit area (that is, partial plan view).

FIG. 12A shows the layout example in which the absolute value of the second extension angle θ2 is substantially 45° (≈ θ1), FIG. 12B shows the layout example in which the absolute value of the second extension angle θ2 is approximately 30° (≈ θ1), and FIG. 12C shows the layout example in which the absolute value of the second extension angle θ2 is substantially 60° (≈ θ1).

That is, in the layout example of FIG. 12A, the plurality of second regions 15 extend in a direction intersecting both the a-axis direction and the m-axis direction and are orthogonal to the plurality of first regions 14. A sum of the absolute value of the first extension angle θ1 and the absolute value of the second extension angle θ2 is substantially a right angle (substantially 90°).

On the one hand, in the layout example of FIG. 12B, the plurality of second regions 15 extend in a direction intersecting both the a-axis direction and the m-axis direction and non-orthogonally intersect the plurality of first regions 14. A sum of the absolute value of the first extension angle θ1 and the absolute value of the second extension angle θ2 is substantially an acute angle (substantially 60°). On the other hand, in the layout example of FIG. 12C, the plurality of second regions 15 extend in a direction intersecting both the a-axis direction and the m-axis direction and non-orthogonally intersect the plurality of first regions 14. A sum of the absolute value of the first extension angle θ1 and the absolute value of the second extension angle θ2 is substantially an obtuse angle (substantially 120°).

As a matter of course, the absolute value of the second extension angle θ2 may be larger than the absolute value of the first extension angle θ1 or may be less than the absolute value of the first extension angle θ1. That is, the plurality of second regions 15 may have a layout that is not line-symmetric with respect to the plurality of first regions 14 on the basis of the a-axis in plan view per unit area (that is, partial plan view). In other words, the plurality of second regions 15 may have a layout that is not point symmetry with respect to the plurality of first regions 14 on the basis of the vertical axis in plan view per unit area (that is, partial plan view).

Hereinafter, a concentration gradient of the p-type impurity concentration of the first region 14 and a concentration gradient of the p-type impurity concentration of the second region 15 will be specifically described. Since the concentration gradient of the first region 14 and the concentration gradient of the second region 15 are substantially the same, the concentration gradient of the second region 15 will be exemplified below.

The description of the concentration gradient of the first region 14 is obtained by replacing the "first layer 8" with the "base layer 6," replacing the "second layer 9" with the "first layer 8," replacing the "second region 15 (the second lower end portion 15a and the second upper end portion 15b)" with the "first region 14 (the first lower end portion 14a and the first upper end portion 14b)," and replacing the "second axis channel CH2" with the "first axis channel CH1" as necessary in the following description. That is, a relative or absolute positional relationship of the second region 15 with respect to the first layer 8 and the second layer 9 is applied to a relative or absolute positional relationship of the first region 14 with respect to the base layer 6 and the first layer 8.

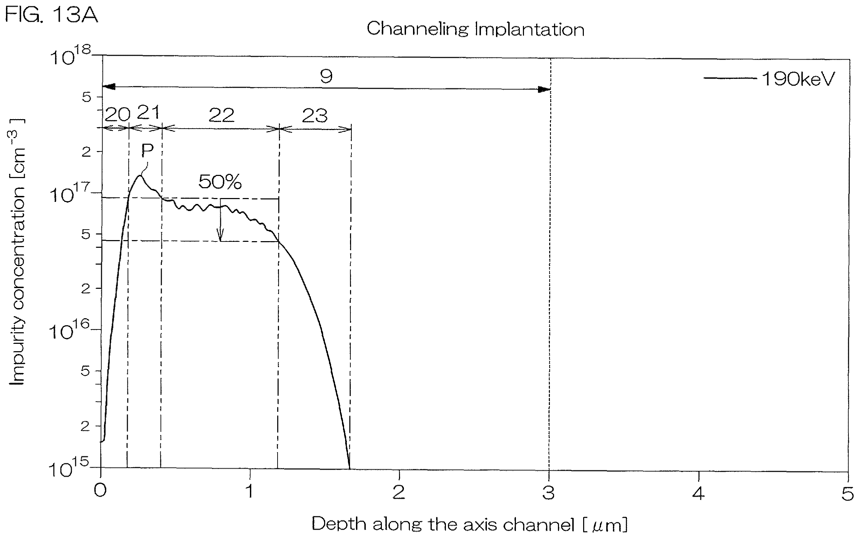

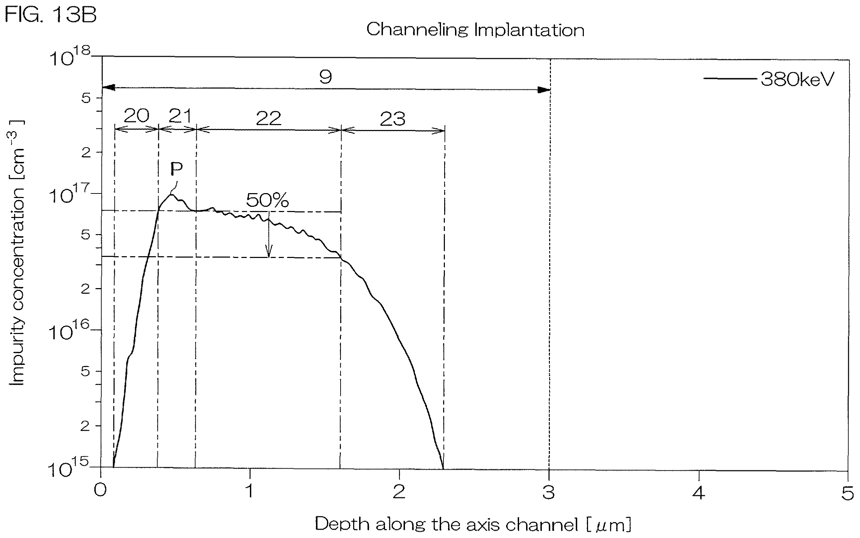

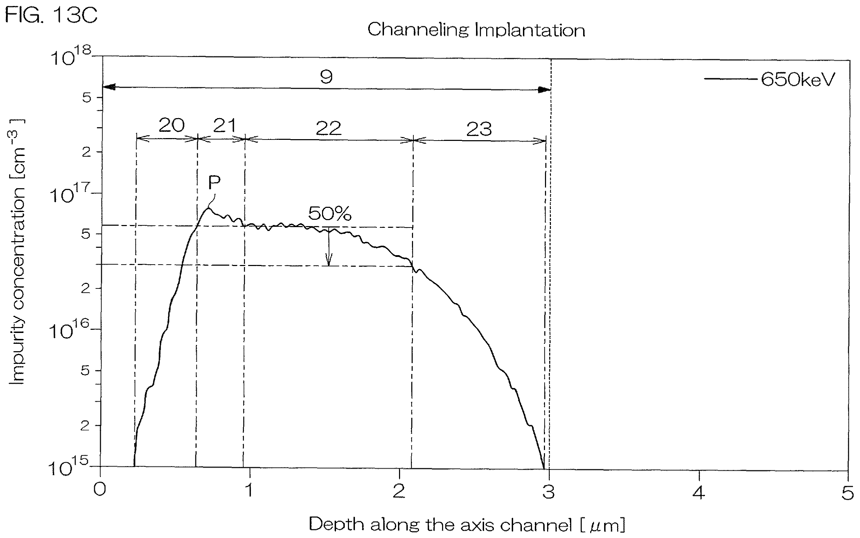

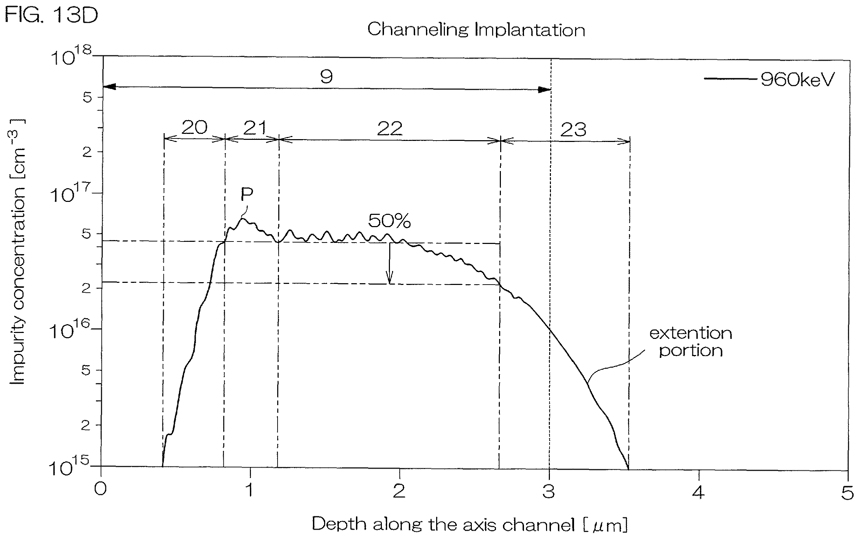

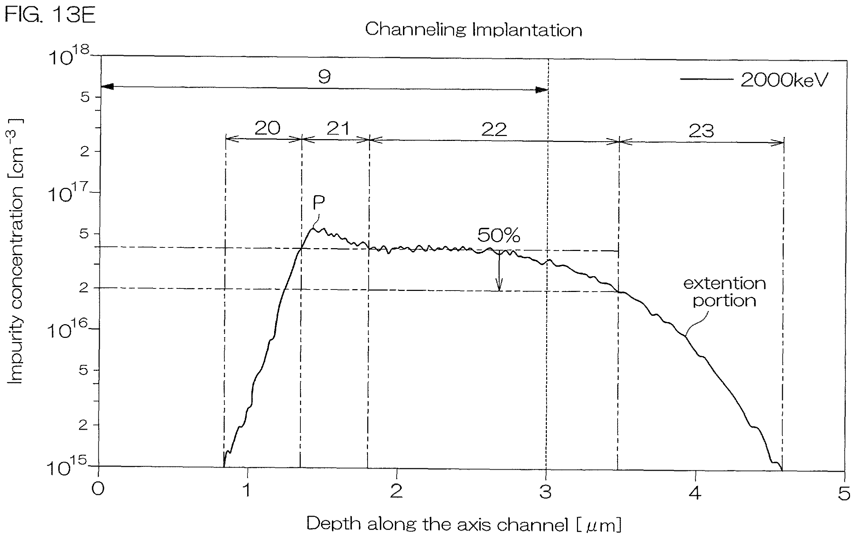

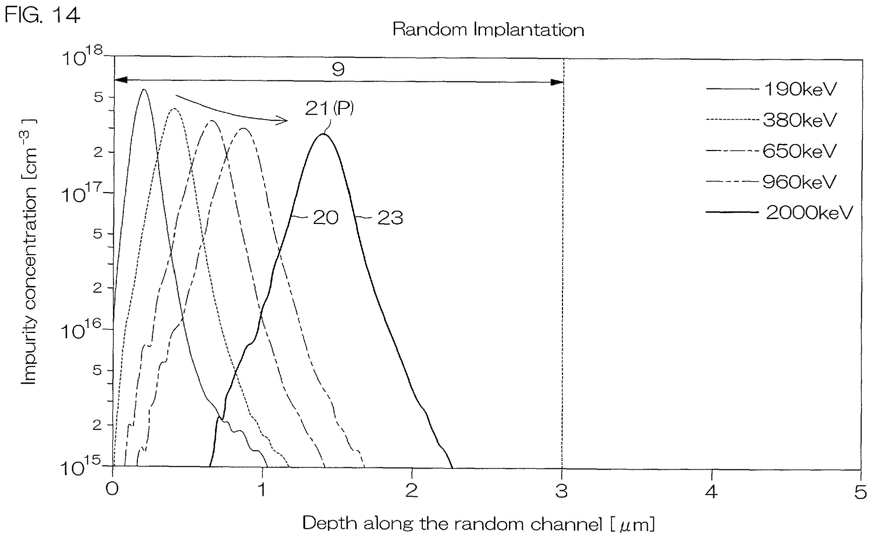

FIGS. 13A to 13E are graphs showing an example of the concentration gradient of the second region 15 (the first region 14). FIG. 14 is a graph showing a comparative example of the concentration gradient of the second region 15 (the first region 14). In FIGS. 13 and 14, the ordinate represents the p-type impurity concentration of the second region 15, and the abscissa represents a depth along the second axis channel CH2 on the basis of the upper end of the second layer 9 (the first main surface 3) (a zero point).

In FIGS. 13A to 13E and 14, a region having a p-type impurity concentration of not less than 1 × 10¹⁵ cm⁻³ is defined as the second region 15 and is shown as a graph. Numerical values of the impurity concentration, the thickness, etc., provided hereinafter are an example for describing a basic configuration of the second region 15 on the basis of the concentration gradient and are not provided with an intention of uniquely limiting the configuration of the second region 15. The impurity concentration, the thickness, etc., are adjusted to various values in accordance with an implantation condition (a dose amount, an implantation temperature, implantation energy, etc.) of a trivalent element, etc.

FIGS. 13A to 13E are graphs in cases where the second region 15 is formed by a channeling implantation method, respectively. FIGS. 13A to 13E show concentration gradients of the second region 15 when a predetermined trivalent element (here, aluminum) is introduced, into the second layer 9, parallel to or substantially parallel to the second axis channel CH2 with an implantation energy of 190 KeV (FIG. 13A), 380 KeV (FIG. 13B), 650 KeV (FIG. 13C), 960 KeV (FIG. 13D), or 2000 KeV (FIG. 13E). The second thickness T2 of the second layer 9 is approximately 3 µm, and the dose amount of the trivalent element is 1 × 10¹³ cm⁻².

Meanwhile, FIG. 14 is a graph in a case where the second region 15 is formed by a random implantation method. FIG. 14 shows a concentration gradient of the second region 15 when the predetermined trivalent element (here, aluminum) is introduced in the second layer 9 in a random direction with an implantation energy of 190 KeV, 380 KeV, 650 KeV, 960 KeV, or 2000 KeV. The random direction is a direction that is not parallel (substantially parallel) to the second axis channel CH2 (for example, the vertical direction Z). The second thickness T2 of the second layer 9 is approximately 3 µm, and the dose amount of the trivalent element is 1 × 10¹³ cm⁻².

With reference to FIG. 13A, the second region 15 (190 KeV) has the second region thickness TR2 of not less than 1.5 µm and not more than 1.8 µm and has the second lower end portion 15a separated from the lower end toward the upper end side of the second layer 9 and the second upper end portion 15b exposed from the upper end (the first main surface 3) of the second layer 9. A distance between the lower end of the second layer 9 and the second lower end portion 15a may be not less than 1.2 µm and not more than 1.5 µm.

The p-type impurity concentration of the second region 15 has a concentration gradient including a gradual increase portion 20, a peak portion 21, a gentle gradient portion 22, and a gradual decrease portion 23 from the upper end to the lower end of the second layer 9. The gradual increase portion 20 is a portion that forms the second upper end portion 15b of the second region 15 and is a portion where the p-type impurity concentration gradually increases from the second upper end portion 15b toward the lower end side of the second layer 9 up to the peak portion 21 at a relatively steep increase rate.

The peak portion 21 is a portion having a peak value P (a maximum value) of the p-type impurity concentration. The peak portion 21 may also be a main concentration transition portion having a projecting shape which includes a series of concentration changes (inflection points) in which the p-type impurity concentration turns from an increase (an increasing tendency) to a decrease (a decreasing tendency). A depth position of the peak portion 21 is not less than 0.1 µm and not more than 0.5 µm.

The gentle gradient portion 22 is formed in a region closer to the second lower end portion 15a than the peak portion 21 and is a portion where the impurity concentration gently decreases at a relatively gentle decrease rate. That is, the gentle gradient portion 22 is a portion, where a constant p-type impurity concentration is maintained in a constant depth range, and forms a main body portion of the second region 15. The p-type impurity concentration of the gentle gradient portion 22 gently decreases in a concentration range less than the p-type impurity concentration of the peak portion 21.

The gentle gradient portion 22 is defined by a portion having a concentration decrease rate of not more than 50% in a thickness range of at least 0.5 µm. In this example, the gentle gradient portion 22 has a thickness of not less than 0.7 µm and not more than 0.8 µm and has the concentration decrease rate of not more than 50% in this thickness range. In this example, the p-type impurity concentration of the gentle gradient portion 22 falls within a concentration range of not less than 4.5 × 10¹⁶ cm⁻³ and not more than 9 × 10¹⁶ cm^{-3.}

The gradual decrease portion 23 is a portion that forms the second lower end portion 15a of the second region 15. The gradual decrease portion 23 has a concentration decrease rate larger than the concentration decrease rate in the gentle gradient portion 22 and is a portion where the p-type impurity concentration gradually decreases from the gentle gradient portion 22 toward the lower end of the second layer 9. The concentration decrease rate per unit thickness of the gradual decrease portion 23 is higher than the concentration decrease rate per unit thickness of the gentle gradient portion 22. The p-type impurity concentration of the gradual decrease portion 23 gradually decreases from the gentle gradient portion 22 to 1 × 10¹⁵ cm⁻³.

With reference to FIG. 13B, the second region 15 (380 KeV) has the second region thickness TR2 of not less than 2.2 µm and not more than 2.4 µm and has the second lower end portion 15a separated from the lower end toward the upper end side of the second layer 9 and the second upper end portion 15b separated from the upper end (the first main surface 3) toward the lower end side (the first layer 8 side) of the second layer 9. A distance between the lower end of the second layer 9 and the second lower end portion 15a is not less than 0.5 µm and not more than 0.8 µm. A distance between the upper end of the second layer 9 and the second upper end portion 15b of the second region 15 is not less than 0.01 µm and not more than 0.2 µm.

As in the example in FIG. 13A, the p-type impurity concentration of the second region 15 has a concentration gradient including the gradual increase portion 20, the peak portion 21, the gentle gradient portion 22, and the gradual decrease portion 23 from the upper end to the lower end of the second layer 9. Also in this example, the gradual increase portion 20 gradually increases from the second upper end portion 15b toward the lower end side of the second layer 9 at a relatively steep increase rate up to the peak portion 21. A depth position of the peak portion 21 is not less than 0.3 µm and not more than 0.7 µm.

The gentle gradient portion 22 has a thickness of not less than 0.8 µm and not more than 1.1 µm and has the concentration decrease rate of not more than 50% in this thickness range. In this example, the p-type impurity concentration of the gentle gradient portion 22 falls within a concentration range of not less than 3.5 × 10¹⁶ cm⁻³ and not more than 7 × 10¹⁶ cm⁻³. The p-type impurity concentration of the gradual decrease portion 23 gradually decreases from the gentle gradient portion 22 to 1 × 10¹⁵ cm⁻³.

With reference to FIG. 13C, the second region 15 (650 KeV) has the second region thickness TR2 of not less than 2.5 µm and not more than 2.8 µm and has the second lower end portion 15a separated from the lower end toward the upper end side of the second layer 9 and the second upper end portion 15b separated from the upper end (the first main surface 3) toward the lower end side (the first layer 8 side) of the second layer 9. A distance between the lower end of the second layer 9 and the second lower end portion 15a is not less than 0.01 µm and not more than 0.1 µm. A distance between the upper end of the second layer 9 and the second upper end portion 15b of the second region 15 is not less than 0.1 µm and not more than 0.4 µm.

As in the example in FIG. 13A, the p-type impurity concentration of the second region 15 has a concentration gradient including the gradual increase portion 20, the peak portion 21, the gentle gradient portion 22, and the gradual decrease portion 23 from the second upper end portion 15b toward the second lower end portion 15a. Also in this example, the gradual increase portion 20 gradually increases from the second upper end portion 15b of the second region 15 to the peak portion 21 at a relatively steep increase rate. A depth position of the peak portion 21 is not less than 0.6 µm and not more than 1 µm.

The gentle gradient portion 22 has a thickness of not less than 1 µm and not more than 1.3 µm and has the concentration decrease rate of not more than 50% in this thickness range. In this example, the p-type impurity concentration of the gentle gradient portion 22 falls within a concentration range of not less than 3 × 10¹⁶ cm⁻³ and not more than 6 × 10¹⁶ cm⁻³. The p-type impurity concentration of the gradual decrease portion 23 gradually decreases from the gentle gradient portion 22 to 1 × 10¹⁵ cm^{-3.}

With reference to FIG. 13D, the second region 15 (960 KeV) has the second region thickness TR2 of not less than 3.1 µm and not more than 3.3 µm and has the second upper end portion 15b separated from the upper end (the first main surface 3) toward the lower end side (the first layer 8 side) of the second layer 9 and the second lower end portion 15a positioned in the first layer 8. That is, the second region 15 has the second region thickness TR2 larger than the second thickness T2 (= 3 µm) of the second layer 9.

Also, the second lower end portion 15a has an extension portion that crosses a boundary between the first layer 8 and the second layer 9 and extends in the first layer 8. The extension portion of the second lower end portion 15a has a thickness of not less than 0.4 µm and not more than 0.7 µm on the basis of the upper end of the first layer 8. A distance between the upper end of the second layer 9 and the second upper end portion 15b of the second region 15 is not less than 0.3 µm and not more than 0.6 µm.

As in the example in FIG. 13A, the p-type impurity concentration of the second region 15 has a concentration gradient including the gradual increase portion 20, the peak portion 21, the gentle gradient portion 22, and the gradual decrease portion 23 from the second upper end portion 15b toward the second lower end portion 15a. Also in this example, the gradual increase portion 20 gradually increases from the second upper end portion 15b of the second region 15 to the peak portion 21 at a relatively steep increase rate. A depth position of the peak portion 21 is not less than 0.7 µm and not more than 1.3 µm.

The gentle gradient portion 22 has a thickness of not less than 1.3 µm and not more than 1.7 µm and has the concentration decrease rate of not more than 50% in this thickness range. In this example, the p-type impurity concentration of the gentle gradient portion 22 falls within a concentration range of not less than 2.2 × 10¹⁶ cm⁻³ and not more than 4.5 × 10¹⁶ cm⁻³. The p-type impurity concentration of the gradual decrease portion 23 gradually decreases from the gentle gradient portion 22 to 1 × 10¹⁵ cm^{-3.}

With reference to FIG. 13E, the second region 15 (2000 KeV) has the second region thickness TR2 of not less than 3.5 µm and not more than 3.8 µm and has the second upper end portion 15b separated from the upper end (the first main surface 3) toward the lower end side (the first layer 8 side) of the second layer 9 and the second lower end portion 15a positioned in the first layer 8. That is, the second region 15 has the second region thickness TR2 larger than the second thickness T2 (= 3 µm) of the second layer 9.

Also, the second lower end portion 15a has an extension portion that crosses a boundary between the first layer 8 and the second layer 9 and extends in the first layer 8. The extension portion of the second lower end portion 15a has a thickness of not less than 1.4 µm and not more than 1.8 µm on the basis of the upper end of the first layer 8. A distance between the upper end of the second layer 9 and the second upper end portion 15b of the second region 15 is not less than 0.7 µm and not more than 1 µm.

As in the example in FIG. 13A, the p-type impurity concentration of the second region 15 has a concentration gradient including the gradual increase portion 20, the peak portion 21, the gentle gradient portion 22, and the gradual decrease portion 23 from the second upper end portion 15b toward the second lower end portion 15a. Also in this example, the gradual increase portion 20 gradually increases from the second upper end portion 15b of the second region 15 to the peak portion 21 at a relatively steep increase rate. A depth position of the peak portion 21 is not less than 1.3 µm and not more than 1.9 µm.

The gentle gradient portion 22 has a thickness of not less than 1.5 µm and not more than 1.8 µm and has the concentration decrease rate of not more than 50% in this thickness range. In this example, the gentle gradient portion 22 crosses the boundary between the first layer 8 and the second layer 9 and is positioned in the first layer 8. That is, the extension portion of the second region 15 includes a part of the gentle gradient portion 22. In this example, the p-type impurity concentration of the gentle gradient portion 22 falls within a concentration range of not less than 2 × 10¹⁶ cm⁻³ and not more than 4 × 10¹⁶ cm⁻³. The p-type impurity concentration of the gradual decrease portion 23 gradually decreases from the gentle gradient portion 22 to 1 × 10¹⁵ cm⁻³.

With reference to FIGS. 13A to 13E, the p-type impurity concentration of the second region 15 has the gradual increase portion 20, the peak portion 21, the gentle gradient portion 22, and the gradual decrease portion 23 with any implantation energy. Also, the second region thickness TR2 (the depth) of the second region 15 increases as the implantation energy increases. Also, a depth position of the second upper end portion 15b of the second region 15 with respect to the upper end of the second layer 9 increases as the implantation energy increases.

The thickness of the gradual increase portion 20, the thickness of the peak portion 21, the thickness of the gentle gradient portion 22, and the thickness of the gradual decrease portion 23 all increase as the implantation energy increases. Meanwhile, the peak value P of the second region 15 decreases as the implantation energy increases. This is because the trivalent element is introduced into a deep region as the implantation energy increases, and the p-type impurity concentration of this deep region increases.

The gentle gradient portion 22 accounts for a thickness range of not less than 1/4 of the second region 15 (the second region thickness TR2) and is positioned in the second layer 9. Specifically, a ratio of the gentle gradient portion 22 to the second region 15 is not less than 1/3. The ratio of the gentle gradient portion 22 to the second region 15 is typically not more than 1/2 (less than 1/2). The ratio of the gentle gradient portion 22 to the second region 15 may be not less than 1/2.

Meanwhile, with reference to FIG. 14, in the case of the random implantation method, the second region 15 has the gradual increase portion 20, the peak portion 21 (the peak value P), and the gradual decrease portion 23 in a range of 0.5 µm, but did not have the gentle gradient portion 22 having a thickness of not less than 0.5 µm. Also, in the case of the random implantation method, a depth position of the peak portion 21 (the peak value P) with respect to the upper end of the second layer 9 increased as the implantation energy increased, but the second region thickness TR2 of the second region 15 was less than 2 µm with any implantation energy. That is, even when the implantation energy was increased, the second region thickness TR2 did not significantly vary.

This leads to an understanding that, in the case of the random implantation method, it is difficult to enhance accuracy of the charge balance by, with respect to the second layer 9 having the relatively large second thickness T2 (for example, the second thickness T2 of not less than 1 µm), the second region 15 that is constituted of a single impurity region. Unlike an Si monocrystal, the SiC monocrystal has physical properties that make it difficult for impurities to diffuse. Therefore, the problem described above is generally solved by a multi-epitaxial growth method or a multi-stage random implantation method.

In the multi-epitaxial growth method, a step of introducing a trivalent element into an epitaxial layer having a relatively small thickness (for example, a thickness of less than 1 µm) by a random implantation method is repeated a plurality of times. In the case of this step, since the number of steps of epitaxial growth and the number of steps of the random implantation method increase, a manufacturing process becomes complicated.

In the multi-stage random implantation method, a step of introducing trivalent elements into different depth positions with a plurality of implantation energies in multiple stages is performed. For example, according to the example in FIG. 14, in a case where the second layer 9 of 1 µm is formed, trivalent elements are introduced into the second layer 9 with implantation energies in five stages (190 KeV, 380 KeV, 650 KeV and 960 KeV). In the case of this step, the trivalent elements can be introduced into a target depth position, but the depth position to which the trivalent element can be introduced is shallow. Hence, the number of steps of epitaxial growth and the number of steps of the random implantation method need to be increased, and a problem similar to that in the multi-epitaxial growth method arises.

On the other hand, in the case of the channeling implantation method, the second region 15 including the gentle gradient portion 22 having a thickness of not less than 0.5 µm and 2 µm is formed with respect to the second layer 9 having a relatively large thickness (for example, a thickness of not less than 1 µm and not more than 5 µm). Therefore, the second region 15 having the charge balance is formed with fewer man-hours than the man-hours in the case of employing the random implantation method.

As a matter of course, this Description does not exclude a technical idea of forming the single second region 15 by introducing the plurality of second regions 15 into different depth positions in multiple stages by the channeling implantation method using a plurality of implantation energies. In this case, each of the second regions 15 is constituted of an integrated region of a plurality of impurity regions (the second regions 15) which are respectively formed in the second layer 9 along the second axis channel CH2 such as to cross the intermediate portion of the second layer 9.

In this case, the p-type impurity concentration (the concentration gradient) of each of the second regions 15 is an added value of p-type impurity concentrations (concentration gradients) of the plurality of impurity regions (the second regions 15). For example, the p-type impurity concentrations of the respective second regions 15 have a concentration gradient (added concentration gradient) obtained by superimposing at least two of the five graphs shown in FIGS. 13A to 13E.

In the examples in FIGS. 13A to 13E, an upper limit of the implantation energy of the channeling implantation method is 2000 KeV, but the second region 15 can also be formed with an implantation energy higher than 2000 KeV. In this case, the relatively thick second region 15 is formed at a position deeper than the concentration gradient shown in FIG. 13E.

However, in a case where the implantation energy higher than 2000 KeV is realized, a design difficulty of the column region 12 increases since the amount of the trivalent elements passing the upper end portion of the second layer 9 increases and a range of an empty region on this upper end portion side (that is, a distance between the first main surface 3 and the second region 15) increases. Also, in the case where the implantation energy higher than 2000 KeV is realized, it is assumed that the implantation energy is not realistic from the viewpoint of cost effectiveness (an installation location or capital investment) since a size of an ion accelerator can reach several tens of meters.

Therefore, in a case where the relatively thick column region 12 is formed by the channeling implantation method, it is preferable to limit the implantation energy to not more than 2000 KeV and increase the number of laminated layers of the laminated portion 7 (the number of laminated layers of the super junction structure SJ).

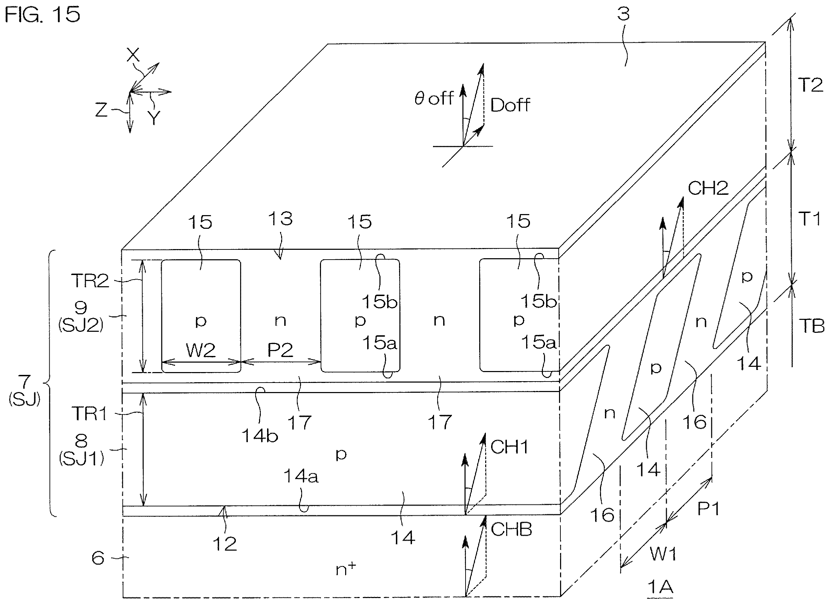

Hereinafter, first to twelfth configuration examples of the column region 12 will be described with reference to FIGS. 15 to 35. The column region 12 according to first to third basic forms may have at least one of a plurality of features described in the first to twelfth configuration examples. The column region 12 according to first to third basic forms may have a feature obtained by combining the plurality of (two or more) features described in the first to twelfth configuration examples.

Hereinafter, the "gradual increase portion 20," the "peak portion 21 (the peak value P)," the "gentle gradient portion 22," and the "gradual decrease portion 23" of the first region 14 are referred to as a "first gradual increase portion 20A," a "first peak portion 21A (a first peak value PA)," a "first gentle gradient portion 22A," and a "first gradual decrease portion 23A." Also, hereinafter, the "gradual increase portion 20," the "peak portion 21 (the peak value P)," the "gentle gradient portion 22," and the "gradual decrease portion 23" of the second region 15 are referred to as a "second gradual increase portion 20B," a "second peak portion 21B (a second peak value PB)," a "second gentle gradient portion 22B," and a "second gradual decrease portion 23B."

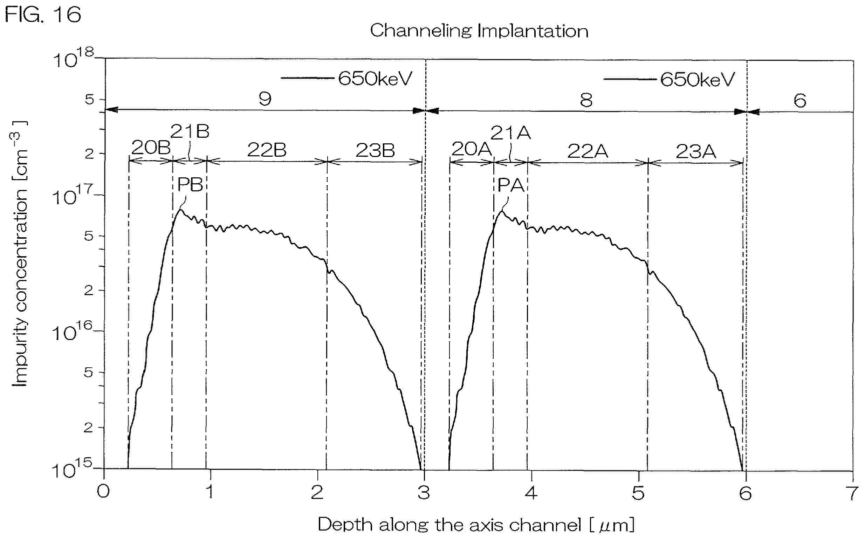

FIG. 15 is a cross-sectional perspective view showing the column region 12 according to the first configuration example. FIG. 16 is a graph showing an example of a concentration gradient of the column region 12 shown in FIG. 15.

With reference to FIGS. 15 and 16, the first region 14 has the first region thickness TR1 that is less than the first thickness T1 of the first layer 8, and is formed in the first layer 8 at an interval from both the lower end and the upper end of the first layer 8. Specifically, the first lower end portion 14a of the first region 14 is formed at an interval from the lower end (that is, the base layer 6) toward the upper end side of the first layer 8 and opposes the base layer 6 across a part (the lower end portion) of the first layer 8.

Meanwhile, the first upper end portion 14b of the first regions 14 is formed at an interval from the upper end (that is, the second layer 9) toward the lower end side of the first layer 8 and opposes the second layer 9 across a part (the upper end portion) of the first layer 8. The first gradual increase portion 20A, the first peak portion 21A, the first gentle gradient portion 22A, and the first gradual decrease portion 23A of the first region 14 are positioned in the first layer 8.

FIG. 16 shows an example in which the first layer 8 has the first thickness T1 of 3 µm, and the first region 14 is formed in the first layer 8 with the implantation energy of 650 KeV. As a matter of course, the first region 14 may be formed with the implantation energy of not more than 650 KeV.

The second region 15 has the second region thickness TR2 that is less than the second thickness T2 of the second layer 9, and is formed in the second layer 9 at an interval from both the lower end and the upper end of the second layer 9. Specifically, the second lower end portion 15a of the second region 15 is formed at an interval from the lower end (the first layer 8) toward the upper end side of the second layer 9 and opposes the first layer 8 across a part (the lower end portion) of the second layer 9.

Meanwhile, the second upper end portion 15b of the second region 15 is formed at an interval from the upper end (that is, the first main surface 3) toward the lower end side of the second layer 9 and opposes the first main surface 3 across a part (the upper end portion) of the second layer 9. The second gradual increase portion 20B, the second peak portion 21B, the second gentle gradient portion 22B, and the second gradual decrease portion 23B of the second region 15 are positioned in the second layer 9.

FIG. 16 shows an example in which the second layer 9 has the second thickness T2 of 3 µm, and the second region 15 is formed in the second layer 9 with the implantation energy of 650 KeV. As a matter of course, the second region 15 may be formed with the implantation energy of not more than 650 KeV. Also, the implantation energy related to the second region 15 may be different from the implantation energy related to the first region 14.

That is, the second region thickness TR2 of the second region 15 may be different from the first region thickness TR1 of the first region 14. The second region thickness TR2 may be less than the first region thickness TR1 or may be larger than the first region thickness TR1.

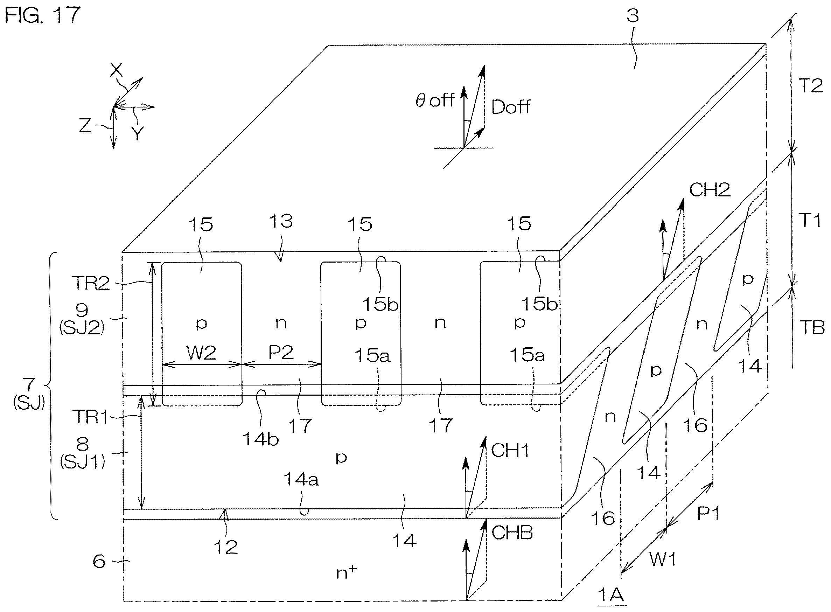

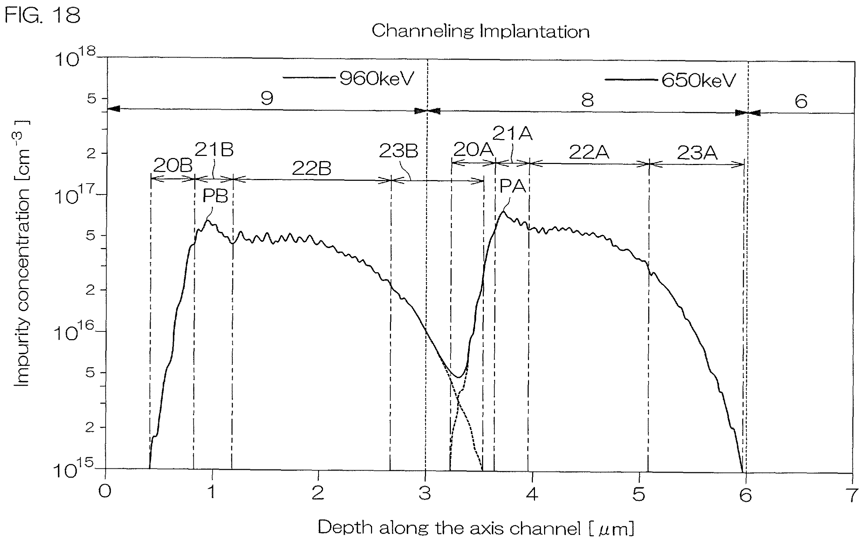

FIG. 17 is a cross-sectional perspective view showing the column region 12 according to the second configuration example. FIG. 18 is a graph showing an example of a concentration gradient of the column region 12 shown in FIG. 17. With reference to FIGS. 17 and 18, the column region 12 according to the second configuration example has a form obtained by modifying the second region 15 according to the first configuration example. The form of the first region 14 according to the second configuration example is identical to that of the first region 14 according to the first configuration example.

The second region 15 is formed in the second layer 9 at an interval from the upper end to the lower end side of the second layer 9 and has a portion positioned in the first layer 8 by crossing the boundary between the first layer 8 and the second layer 9. That is, the second lower end portion 15a of the second region 15 may have an extension portion that crosses the boundary portion between the first layer 8 and the second layer 9 and is positioned in the first layer 8.

Since the second axis channel CH2 is substantially matched with the first axis channel CH1, the extension portion of the second lower end portion 15a is formed along the first axis channel CH1 in the first layer 8. The extension portion of the second lower end portion 15a is preferably positioned on the upper end side of the first layer 8 with respect to the thickness range intermediate portion of the first layer 8. The extension portion of the second lower end portion 15a is connected to the first region 14 (the first upper end portion 14b) in the first layer 8.

In this configuration, a part (the extension portion) of the second region 15 is provided in a space between the upper end of the first layer 8 and the first upper end portion 14b of the first region 14, and one column region 12 continuously extending in a three-dimensional lattice shape is formed by the first region 14 and the second region 15. Therefore, the accuracy of the charge balance is improved.

In this example, the second region 15 has the second region thickness TR2 larger than the second thickness T2 of the second layer 9. Also, the second region thickness TR2 may be larger than the first thickness T1 of the first layer 8. Also, the second region thickness TR2 may be larger than the first region thickness TR1 of the first region 14. As a matter of course, the second region thickness TR2 may be less than the second thickness T2. Also, the second region thickness TR2 may be less than the first region thickness TR1. Also, the second region thickness TR2 may be less than the first region thickness TR1.

The second gradual increase portion 20B, the second peak portion 21B, the second gentle gradient portion 22B, and the second gradual decrease portion 23B of the second region 15 are positioned in the second layer 9. At least a part of the second gradual decrease portion 23B is positioned in the first layer 8. That is, the extension portion of the second lower end portion 15a includes the second gradual decrease portion 23B. As a matter of course, a part of the second gentle gradient portion 22B may be positioned in the first layer 8 (see FIG. 13E). That is, the extension portion of the second lower end portion 15a may include a part of the second gentle gradient portion 22B and the second gradual decrease portion 23B.

FIG. 18 shows an example in which the second layer 9 has the first thickness T1 of 3 µm, and the second region 15 is formed in the second layer 9 with the implantation energy of 960 KeV. As a matter of course, the second region 15 may be formed with the implantation energy of not less than 960 KeV. For example, the second thickness T2 may be more than 3 µm and be not more than 5 µm. In this case, the second regions 15 connected to the first regions 14 in the first layer 8 are formed with the implantation energy of not less than 960 KeV (see also FIGS. 13F to 13E).

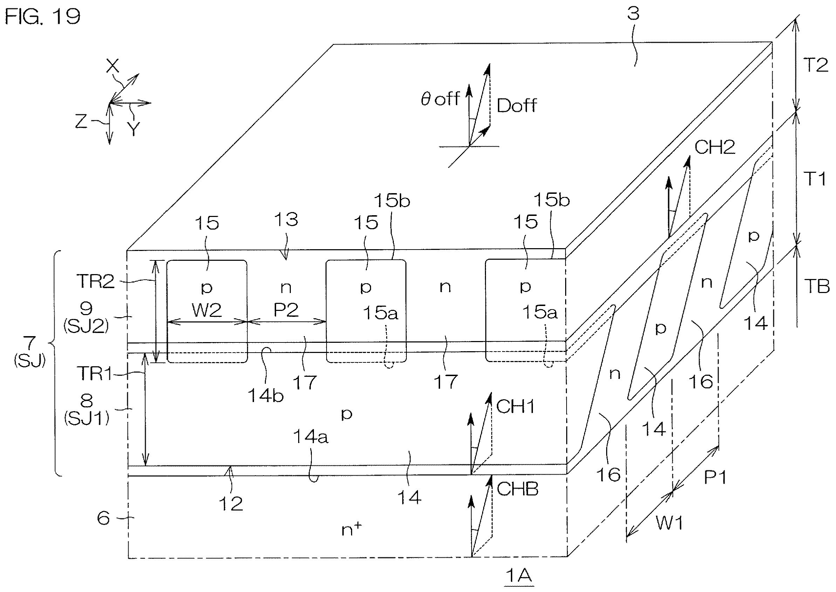

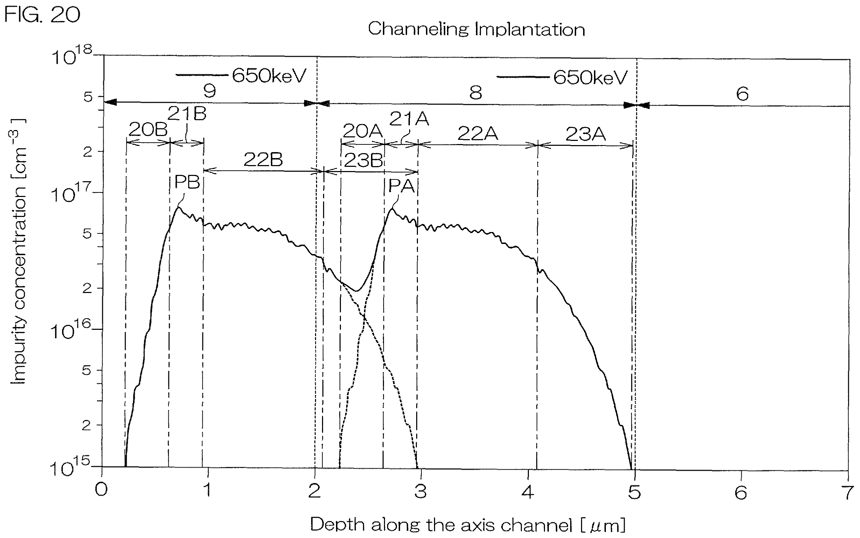

FIG. 19 is a cross-sectional perspective view showing the column region 12 according to the third configuration example. FIG. 20 is a graph showing an example of a concentration gradient of the column region 12 shown in FIG. 19. With reference to FIGS. 19 and 20, the column region 12 according to the third configuration example has a form obtained by modifying the second region 15 according to the second configuration example. The first region 14 according to the third configuration example has a form identical to that of the first region 14 according to the first configuration example.

The second region 15 according to the second configuration example is formed in the second layer 9 having the second thickness T2 substantially equal to the first thickness T1 of the first layer 8. On the other hand, the second region 15 according to the third configuration example is formed in the second layer 9 having the second thickness T2 that is less than the first thickness T1 of the first layer 8. In this example, the second region 15 has the second region thickness TR2 larger than the second thickness T2 of the second layer 9.

FIG. 19 shows an example in which the second layer 9 has the second thickness T2 of less than 3 µm (here, 2 µm), and the second region 15 is formed in the second layer 9 with the implantation energy of 650 KeV. As a matter of course, the second region 15 may be formed with the implantation energy of not more than 650 KeV.

For example, the second thickness T2 may be not less than 1 µm and not more than 2 µm. In this case, the second region 15 connected to the first region 14 in the first layer 8 is formed with the implantation energy of not less than 190 KeV (see also FIGS. 13A to 13E). For example, the second thickness T2 may be not less than 2 µm and less than 3 µm. In this case, the second region 15 connected to the first region 14 in the first layer 8 is formed with the implantation energy of not less than 380 KeV (see also FIGS. 13B to 13E).

In this configuration, a concentration gradient formed at a connection portion between the first region 14 and the second region 15 becomes gentle, and the accuracy of the charge balance is improved. Also, the second layer 9 having the relatively small second thickness T2 enables the second region 15 connected to the first region 14 to be formed with a relatively small implantation energy. Therefore, manufacturing costs are reduced.

For example, the relatively small second thickness T2 enables the second region 15 connected to the first region 14 in the first layer 8 to be formed while the first region thickness TR1 (the implantation energy) of the first region 14 and the second region thickness TR2 (the implantation energy) of the second region 15 are set to be equal to each other. In this case, process management of the manufacturing process is easily performed. In these cases, the second thickness T2 of the second layer 9 may be set to be less than the first thickness T1 of the first layer 8, and the second region 15 having the second region thickness TR2 larger than the second thickness T2 may be formed.

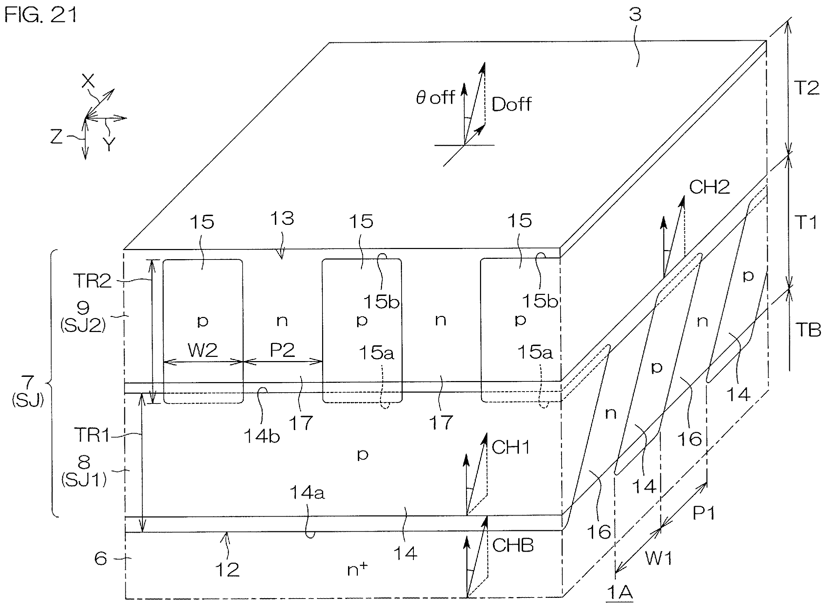

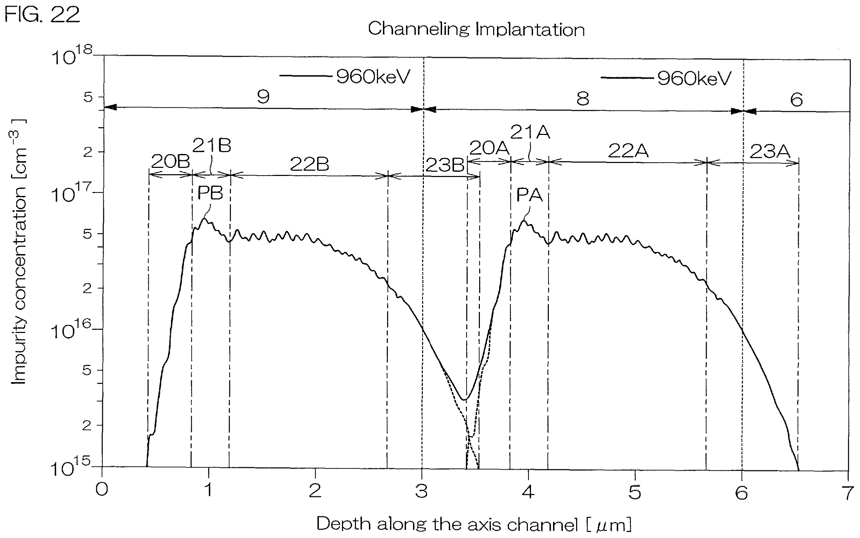

FIG. 21 is a cross-sectional perspective view showing the column region 12 according to the fourth configuration example. FIG. 22 is a graph showing an example of a concentration gradient of the column region 12 shown in FIG. 21. With reference to FIGS. 21 and 22, the column region 12 according to the fourth configuration example has a form obtained by modifying the first region 14 according to the second configuration example. The second region 15 according to the fourth configuration example has a form identical to the form of the second region 15 according to the second configuration example. As a matter of course, the second region 15 according to the fourth configuration example has a form identical to the form of the second region 15 according to the third configuration example.

The first region 14 is formed in the first layer 8 at an interval from the upper end to the lower end side of the first layer 8 and has a portion positioned in the base layer 6 by crossing the boundary between the base layer 6 and the first layer 8. That is, the first lower end portion 14a of the first region 14 may have an extension portion that crosses the boundary portion between the base layer 6 and the first layer 8 and is positioned in the base layer 6.

Since the first axis channel CH1 is substantially matched with the base axis channel CHB, the extension portion of the first lower end portion 14a is formed along the base axis channel CHB in the base layer 6. The extension portions of the first lower end portion 14a is preferably positioned on the upper end side of the base layer 6 with respect to a thickness range intermediate portion of the base layer 6. The extension portion of the first lower end portion 14a is, in the base layer 6, connected to this base layer 6.

In this example, the first region 14 has the first region thickness TR1 larger than the first thickness T1 of the first layer 8. Also, the first region thickness TR1 may be larger than the second thickness T2 of the second layer 9. Also, the first region thickness TR1 may be larger than the second region thickness TR2 of the second region 15. As a matter of course, the first region thickness TR1 may be less than the first thickness T1. As a matter of course, the first region thickness TR1 may be less than the second thickness T2. Also, the first region thickness TR1 may be less than the second region thickness TR2.

The first gradual increase portion 20A, the first peak portion 21A, the first gentle gradient portion 22A, and the first gradual decrease portion 23A of the first region 14 are positioned in the first layer 8. At least a part of the first gradual decrease portion 23A is positioned in the base layer 6. That is, the extension portion of the first lower end portion 14a includes the first gradual decrease portion 23A. As a matter of course, a part of the first gentle gradient portion 22A may be positioned in the base layer 6 (see FIG. 13E). That is, the extension portion of the first lower end portion 14a may include a part of the first gentle gradient portion 22A and the first gradual decrease portion 23A.

FIG. 22 shows an example in which the first layer 8 has the first thickness T1 of 3 µm, and the first region 14 is formed in the first layer 8 with the implantation energy of 960 KeV. As a matter of course, the first region 14 may be formed with the implantation energy of not less than 960 KeV. For example, the first thickness T1 may be more than 3 µm and be not more than 5 µm. In this case, the first regions 14 that are partially positioned in the base layer 6 are formed with the implantation energy of not less than 960 KeV (see also FIGS. 13F to 13E).

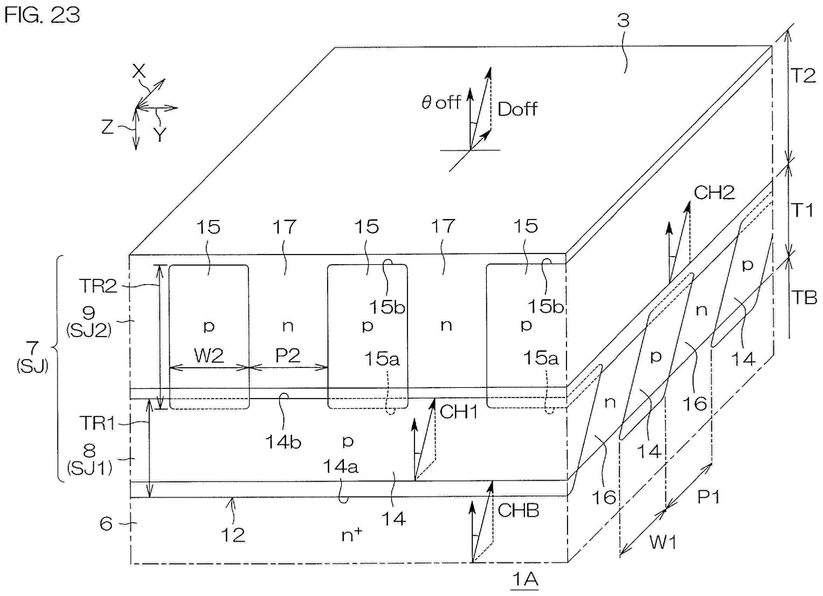

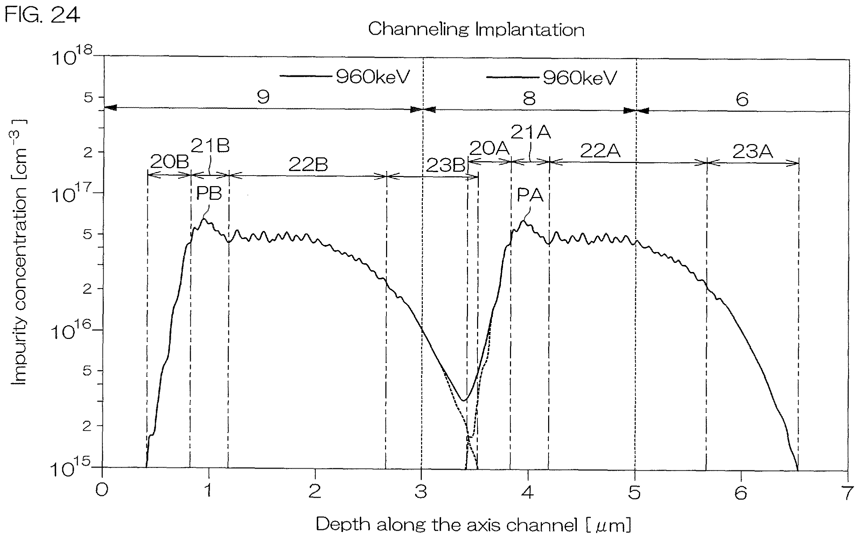

FIG. 23 is a cross-sectional perspective view showing the column region 12 according to the fifth configuration example. FIG. 24 is a graph showing an example of a concentration gradient of the column region 12 shown in FIG. 23. With reference to FIGS. 23 and 24, the column region 12 according to the fifth configuration example has a form obtained by modifying the first region 14 according to the fourth configuration example. The second region 15 according to the fifth configuration example has a form identical to the form of the second region 15 according to the second configuration example. As a matter of course, the second region 15 according to the fifth configuration example has a form identical to the form of the second region 15 according to the third configuration example.

In the fourth configuration example, the first layer 8 has the first thickness T1 of 3 µm, and the first region 14 is formed in the first layer 8 with the implantation energy of not less than 960 KeV. On the other hand, in the fifth configuration example, the first layer 8 has the first thickness T1 of less than 3 µm, and the first region 14 is formed in the first layer 8 with the implantation energy of not less than 650 KeV. In this example, the first region 14 has the first region thickness TR1 larger than the first thickness T1. In this example, the first thickness T1 is less than the second thickness T2 of the second layer 9.

For example, the first thickness T1 may be not less than 1 µm and not more than 2 µm. In this case, the first region 14 that is partially positioned in the base layer 6 is formed with the implantation energy of not less than 190 KeV (see also FIGS. 13A to 13E). For example, the first thickness T1 may be not less than 2 µm and less than 3 µm. In this case, the first region 14 that is partially positioned in the base layer 6 is formed with the implantation energy of not less than 380 KeV (see also FIGS. 13B to 13E).

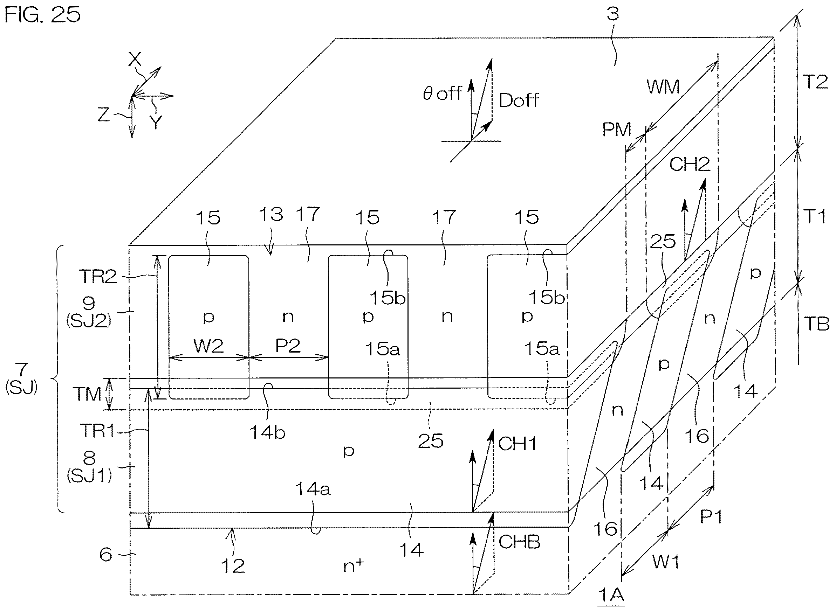

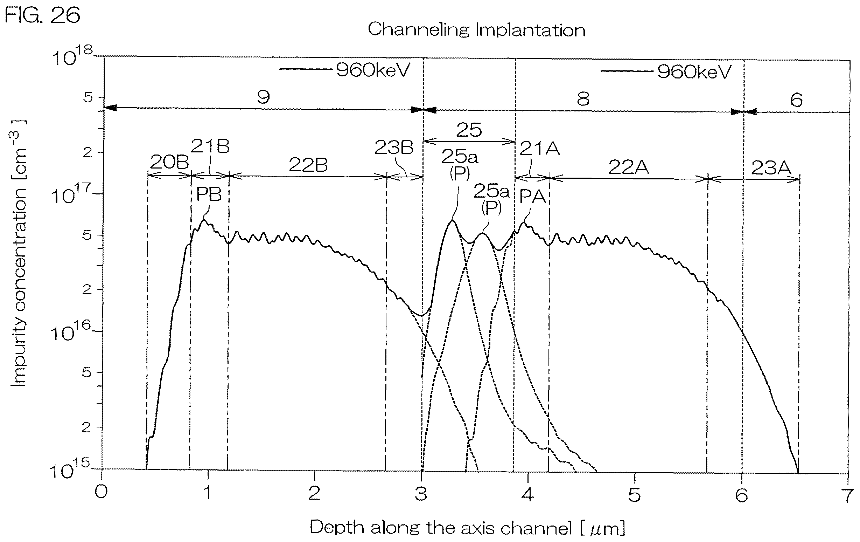

FIG. 25 is a cross-sectional perspective view showing the column region 12 according to the sixth configuration example. FIG. 26 is a graph showing an example of a concentration gradient of the column region 12 shown in FIG. 25. With reference to FIGS. 25 and 26, the column region 12 includes, in addition to the first region 14 and the second region 15, an intermediate region 25 of the p-type that is interposed between the first region 14 and the second region 15.

As a matter of course, the first region 14 may have a form identical to any one of the forms of the first regions 14 according to the first to fifth configuration examples. In this example, the first region 14 has a form identical to the form of the first region 14 according to the fourth configuration example. The second region 15 may have a form identical to any one of the forms of the second regions 15 according to the first to fifth configuration examples. The second region 15 has a form identical to the form of the second region 15 according to the fourth configuration example (the second configuration example).

A plurality of intermediate regions 25 are formed in a surface layer portion of the upper end side of the first layer 8 such as to be positioned at least in a plurality of intersection portions between the plurality of first regions 14 and the plurality of second regions 15, and overlap the corresponding first regions 14 and the corresponding second regions 15 in the lamination direction, respectively. In this embodiment, the plurality of intermediate regions 25 are arrayed at intervals in the first array direction Da1 such as to overlap the plurality of first regions 14 in the lamination direction in a one-to-one correspondence relationship and are each formed as a band extending in the first extension direction De1.

In this example, the first array direction Da1 is the a-axis direction (the first direction X), and the first extension direction De1 is the m-axis direction (the second direction Y). As a matter of course, an array direction and an extension direction of the plurality of intermediate regions 25 are changed in accordance with the first array direction Da1 and the first extension direction De1 of the plurality of first regions 14. Therefore, the first array direction Da1 may be the m-axis direction, and the first extension direction De1 may be the a-axis direction. Also, the first array direction Da1 may be a direction other than the a-axis direction and the m-axis direction, and the first extension direction De1 may be a direction other than the a-axis direction and the m-axis direction.

The plurality of intermediate regions 25 are led out from the active region 10 to the outer peripheral region 11, together with the plurality of first regions 14. That is, the plurality of intermediate regions 25 are led out from a portion of the first layer 8 positioned in the active region 10 to a portion of the first layer 8 positioned in the outer peripheral region 11. The plurality of intermediate regions 25 are arrayed at intervals in the first array direction Da1 also in the outer peripheral region 11 and are each formed as a band extending in the first extension direction De1.

The plurality of intermediate regions 25 extend from the outer peripheral region 11 toward one or both (in this embodiment, both) of the first side surface 5A and the third side surface 5C and respectively have portions exposed from one or both (in this embodiment, both) of the first side surface 5A and the third side surface 5C.

Each of the portions of the plurality of intermediate regions 25 exposed from the first side surface 5A forms a part (the upper end portion) of each of the plurality of first marks Mk1 in the first side surface 5A, and each of the portions of the plurality of intermediate regions 25 exposed from the third side surface 5C forms a part (the upper end portion) of each of the plurality of first marks Mk1 in the third side surface 5C.

That is, each of the plurality of intermediate regions 25 includes one or both of the part (the upper end portion) of each of the plurality of first marks Mk1 as an exposed portion exposed from the first side surface 5A and the part (the upper end portion) of each of the plurality of first marks Mk1 as an exposed portion exposed from the third side surface 5C.

In other words, the plurality of first marks Mk1 are formed using the plurality of first regions 14 and the plurality of intermediate regions 25, respectively. That is, the layout (the exposed locations or the array direction) of the plurality of first marks Mk1 with respect to the first side surface 5A (the third side surface 5C) is appropriately adjusted also by the layout (the first array direction Da1 or the first extension direction De1) of the plurality of first regions 14 and the plurality of intermediate regions 25.

The plurality of first marks Mk1 are not necessarily formed continuously from main body portions of the plurality of intermediate regions 25 and may be formed as separated portions separated from the main body portions of the plurality of intermediate regions 25. In this case, the plurality of first marks Mk1 are preferably separated from the main body portions of the plurality of intermediate regions 25 in the outer peripheral region 11.

As a matter of course, each of the plurality of intermediate regions 25 does not necessarily form a part (the upper end portion) of each of the plurality of first marks Mk1. That is, the plurality of intermediate regions 25 may be formed in an inner portion of the first layer 8 at intervals from the first to fourth side surfaces 5A to 5D in plan view. The description for the intermediate regions 25 is also applied to the first marks Mk1 (portions of the intermediate regions 25 that are exposed from the first side surface 5A/the third side surface 5C).

The plurality of intermediate regions 25 are formed in a region between the upper end of the first layer 8 and the first upper end portion 14b of the first region 14 in the first layer 8. The plurality of intermediate regions 25 are preferably positioned on the upper end side of the first layer 8 with respect to the thickness range intermediate portion of the first layer 8. The plurality of intermediate regions 25 may be exposed from the upper end of the first layer 8 or may be formed at intervals from the upper end toward the lower end side of the first layer 8. Each of the intermediate regions 25 may be formed in a laterally elongated columnar shape extending in the horizontal direction in cross-sectional view. As a matter of course, each of the intermediate regions 25 may be formed in a vertically long columnar shape extending in the vertical direction Z.

The plurality of intermediate regions 25 form a plurality of intermediate pn-junction portions having the charge balance together with the first layer 8. That is, the plurality of intermediate regions 25 constitute a part of the first super junction structure SJ1 with the plurality of first drift regions 16. The state of having the charge balance means a state in which, regarding the plurality of intermediate regions 25 adjacent to each other, a depletion layer expanding from one intermediate pn-junction portion and a depletion layer expanding from the other intermediate pn-junction portion are connected in the plurality of first drift regions 16.

With reference to FIG. 26, each of the intermediate regions 25 may include a single or a plurality of region elements 25a. FIG. 26 shows an example in which each of the intermediate regions 25 includes a plurality of (two) region elements 25a. In a case where each of the intermediate regions 25 is constituted of the single region element 25a, the single region element 25a is formed in a region between the upper end of the first layer 8 and the first upper end portion 14b of the first region 14 and is connected to the first upper end portion 14b of the first region 14.

In a case where each of the intermediate regions 25 is constituted of the plurality of region elements 25a, the plurality of region elements 25a are respectively formed at different depth positions in a region between the upper end of the first layer 8 and the first upper end portion 14b of the first region 14. In this case, the plurality of region elements 25a are respectively formed such as to be connected to each other in the lamination direction. Also, at least the lowermost region element 25a is connected to the first upper end portion 14b of the first region 14.

The region element 25a is constituted of a random impurity region introduced into the surface layer portion of the first layer 8 by the random implantation method with respect to the first layer 8 (see also FIG. 14). That is, the region element 25a is not formed in the second layer 9. Also, the region element 25a has a thickness less than the first region thickness TR1 of the first region 14 in a direction along the first axis channel CH1. Also, the thickness of the region element 25a is less than the second region thickness TR2 of the second region 15.

Unlike the first region 14, etc., the region element 25a does not have the gentle gradient portion 22 having a thickness of not less than 0.5 µm and has a concentration gradient including the gradual increase portion 20, the peak portion 21, and the gradual decrease portion 23 in a range of 0.5 µm. In a case where each of the intermediate regions 25 includes the plurality of region elements 25a, each of the intermediate regions 25 has a plurality of peak portions 21 (peak values P) corresponding to the number of the plurality of region elements 25a in the thickness direction of the first layer 8.

The region element 25a may have a p-type impurity concentration of not less than 1 × 10¹⁵ cm⁻³ and not more than 1 × 10¹⁸ cm⁻³ as the peak value P. FIG. 26 shows an example in which the peak value P of the p-type impurity concentration of the region element 25a is not less than 1 × 10¹⁶ cm⁻³ and not more than 1 × 10¹⁷ cm⁻³

The p-type impurity concentration of the intermediate region 25 is preferably adjusted by at least one type of trivalent element. The trivalent element of the intermediate region 25 may be the same type as the trivalent element of the first region 14, etc., or may be a type different from the trivalent element of the first region 14, etc. The trivalent element of the intermediate region 25 may be at least one type among boron, aluminum, gallium, and indium.

Each of the plurality of intermediate regions 25 has an intermediate width WM. The intermediate width WM is a width along the first array direction Da1. The intermediate width WM is preferably less than the first thickness T1 of the first layer 8. As a matter of course, the intermediate width WM may be not less than the first thickness T1. The intermediate width WM is preferably less than the second thickness T2 of the second layer 9. As a matter of course, the intermediate width WM may be not less than the second thickness T2.

The intermediate width WM is preferably substantially equal to the first width W1 of the first region 14. As a matter of course, the intermediate width WM may be not less than the first width W1 or may be less than the first width W1. The intermediate width WM is preferably not less than 1 µm. The intermediate width WM is preferably not more than 5 µm.

The intermediate width WM may have a value falling within any one of ranges of not less than 1 µm and not more than 1.5 µm, not less than 1.5 µm and not more than 2 µm, not less than 2 µm and not more than 2.5 µm, not less than 2.5 µm and not more than 3 µm, not less than 3 µm and not more than 3.5 µm, not less than 3.5 µm and not more than 4 µm, not less than 4 µm and not more than 4.5 µm, and not less than 4.5 µm and not more than 5 µm.

Each of the plurality of intermediate regions 25 has an intermediate thickness TM. The intermediate thickness TM is preferably not less than a distance between the upper end of the first layer 8 and the first upper end portion 14b of the first region 14. The intermediate thickness TM may be not less than 0.1 µm and not more than 2 µm. The intermediate thickness TM may have a value falling within any one of ranges of not less than 0.1 µm and not more than 0.5 µm, not less than 0.5 µm and not more than 1 µm, not less than 1 µm and not more than 1.5 µm, and not less than 1.5 µm and not more than 2 µm.

The plurality of intermediate regions 25 are formed at intervals of an intermediate pitch PM in the first array direction Da1. The intermediate pitch PM is preferably substantially equal to the first pitch P1 of the first region 14. As a matter of course, the intermediate pitch PM may be not less than the first pitch P1 or may be less than the first pitch P1. In FIG. 25, the intermediate pitch PM larger than the first pitch P1 is shown for clarity.

The intermediate pitch PM may be not less than 0.1 µm and not more than 5 µm. The intermediate pitch PM may have a value falling within any one of ranges of not less than 0.1 µm and not more than 0.25 µm, not less than 0.25 µm and not more than 0.5 µm, not less than 0.5 µm and not more than 0.75 µm, not less than 0.75 µm and not more than 1 µm, not less than 1 µm and not more than 1.5 µm, not less than 1.5 µm and not more than 2 µm, not less than 2 µm and not more than 2.5 µm, not less than 2.5 µm and not more than 3 µm, not less than 3 µm and not more than 3.5 µm, not less than 3.5 µm and not more than 4 µm, not less than 4 µm and not more than 4.5 µm, and not less than 4.5 µm and not more than 5 µm. The intermediate pitch PM is preferably not less than 0.5 µm and not more than 1.5 µm.

In such a configuration, it is preferable that the second region 15 has an extension portion positioned in the first layer 8 and is connected to the intermediate region 25 in the first layer 8. That is, it is preferable that the second region 15 is electrically connected to the first region 14 through the intermediate region 25 in the first layer 8. In this case, the second region 15 forms the single drift region 13 continuously extending in the lamination direction together with the first region 14 and the intermediate region 25.

As a matter of course, the extension portion of the second region 15 may be connected to both the intermediate region 25 and the first region 14 in the first layer 8. In the configuration in which the intermediate region 25 is provided, a concentration gradient in a region between the first region 14 and the second region 15 becomes gentle by the intermediate region 25, and the accuracy of the charge balance is improved.

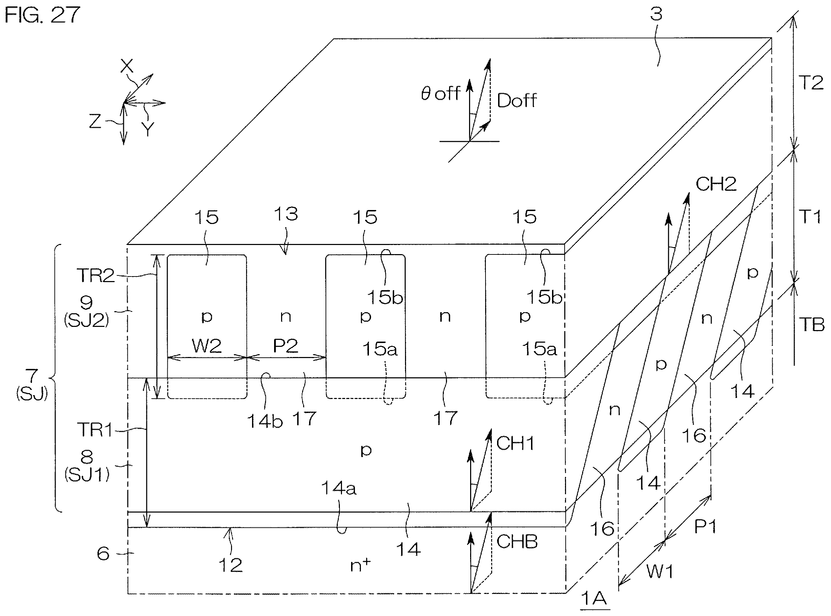

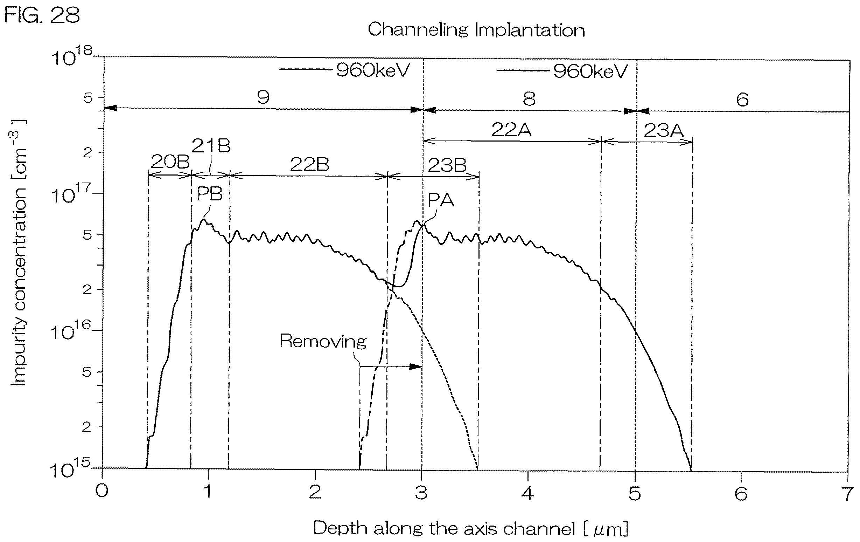

FIG. 27 is a cross-sectional perspective view showing the column region 12 according to the seventh configuration example. FIG. 28 is a graph showing an example of a concentration gradient of the column region 12 shown in FIG. 27. With reference to FIGS. 27 and 28, the column region 12 according to the seventh configuration example has a form obtained by modifying the first regions 14 according to the first to sixth configuration examples. The second region 15 according to the seventh configuration example may have a form identical to any one of the forms of the second regions 15 according to the first to sixth configuration examples.

In this example, the first region 14 is exposed from the upper end of the first layer 8. The first region 14 does not have the partial or entire first gradual increase portion 20A. FIG. 28 shows an example in which the first region 14 does not have the entire first gradual increase portion 20A and the first peak portion 21A. That is, in this example, the first upper end portion 14b includes the first gentle gradient portion 22A exposed from the upper end of the first layer 8.

The first region 14 has the first peak value PA at the upper end of the first layer 8 and has a concentration gradient gradually decreasing toward the lower end side of the first layer 8. As a matter of course, the first upper end portion 14b may include a part of the first gradual increase portion 20A or a part of the first peak portion 21A, and the part of the first gradual increase portion 20A or the part of the first peak portion 21A may be exposed from the upper end of the first layer 8.

In this configuration, it is preferable that the second region 15 has an extension portion positioned in the first layer 8 and is connected to the first region 14 in the first layer 8. In the configuration in which the first region 14 is exposed from the upper end of the first layer 8, a concentration gradient formed in a region between the first region 14 and the second region 15 becomes gentle by an exposed portion of the first region 14, and the accuracy of the charge balance is improved.

Such a configuration is obtained by partially removing the upper end of the first layer 8, after the formation of the first regions 14 until the partial or entire first gradual increase portion 20A of the first region 14 disappears. For example, the upper end of the first layer 8 may be partially removed by a grinding method. The grinding method may be a mechanical polishing method and/or a chemomechanical polishing method. In this case, the upper end of the first layer 8 is constituted of a ground surface, and the first region 14 is exposed from this ground surface. The second layer 9 is laminated on the ground surface of the first layer 8.

For example, the upper end of the first layer 8 may be partially removed by an etching method. The etching method may be a wet etching method and/or a dry etching method. In this case, the upper end of the first layer 8 is constituted of an etched surface, and the first region 14 is exposed from this etched surface. The second layer 9 is laminated on the etched surface of the first layer 8.

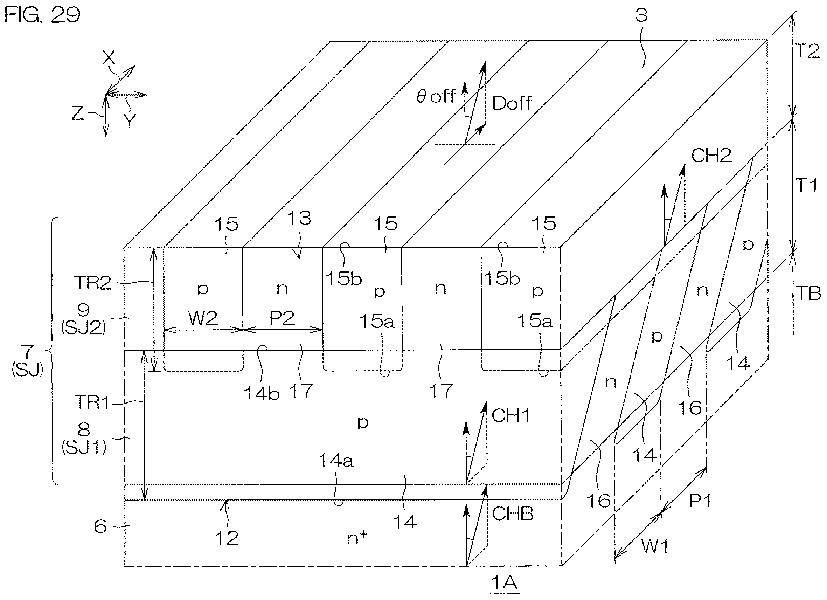

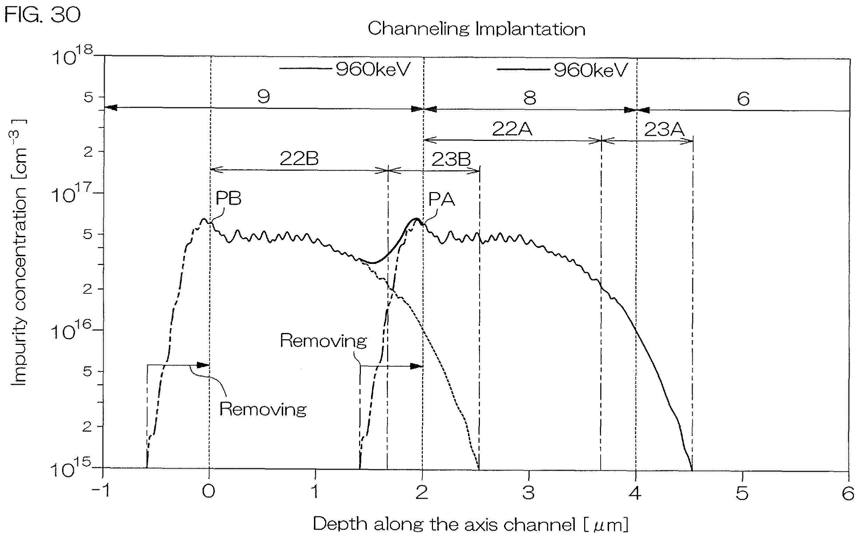

FIG. 29 is a cross-sectional perspective view showing the column region 12 according to the eighth configuration example. FIG. 30 is a graph showing an example of a concentration gradient of the column region 12 shown in FIG. 29. With reference to FIGS. 29 and 30, the column region 12 according to the eighth configuration example has a form obtained by modifying the second regions 15 according to the first to seventh configuration examples. The first region 14 according to the eighth configuration example may have a form identical to any one of the forms of the first regions 14 according to the first to seventh configuration examples. FIGS. 29 and 30 show the first region 14 according to the seventh configuration example.

In this example, the second region 15 is exposed from the upper end (the first main surface 3) of the second layer 9. The second region 15 does not have the partial or entire second gradual increase portion 20B. FIG. 30 shows an example in which the second region 15 does not have the entire second gradual increase portion 20B and the second peak portion 21B. That is, in this example, the second upper end portion 15b includes the second gentle gradient portion 22B exposed from the upper end of the second layer 9.

The second region 15 has the second peak value PB at the upper end of the second layer 9 and has a concentration gradient gradually decreasing toward the lower end side of the second layer 9. As a matter of course, the second upper end portion 15b may include a part of the second gradual increase portion 20B or a part of the second peak portion 21B, and the part of the second gradual increase portion 20B or the part of the second peak portion 21B may be exposed from the upper end of the second layer 9.

A configuration in which the second regions 15 are exposed from the upper end of the second layer 9 is effective in the case of adjusting electrical characteristics of a device structural component by using the second regions 15 in a case where the device structural component is formed using the second layer 9 (the first main surface 3).

Such a configuration is obtained by partially removing the upper end of the second layer 9, after the formation of the second regions 15 until the partial or entire second gradual increase portion 20B of the second region 15 disappears. For example, the upper end (the first main surface 3) of the second layer 9 may be partially removed by a grinding method. The grinding method may be a mechanical polishing method and/or a chemomechanical polishing method. In this case, the upper end of the second layer 9 is constituted of a ground surface, and the second region 15 is exposed from this ground surface.

For example, the upper end (the first main surface 3) of the second layer 9 may be partially removed by an etching method. The etching method may be a wet etching method and/or a dry etching method. In this case, the upper end of the second layer 9 is constituted of an etched surface, and the second region 15 is exposed from this etched surface.

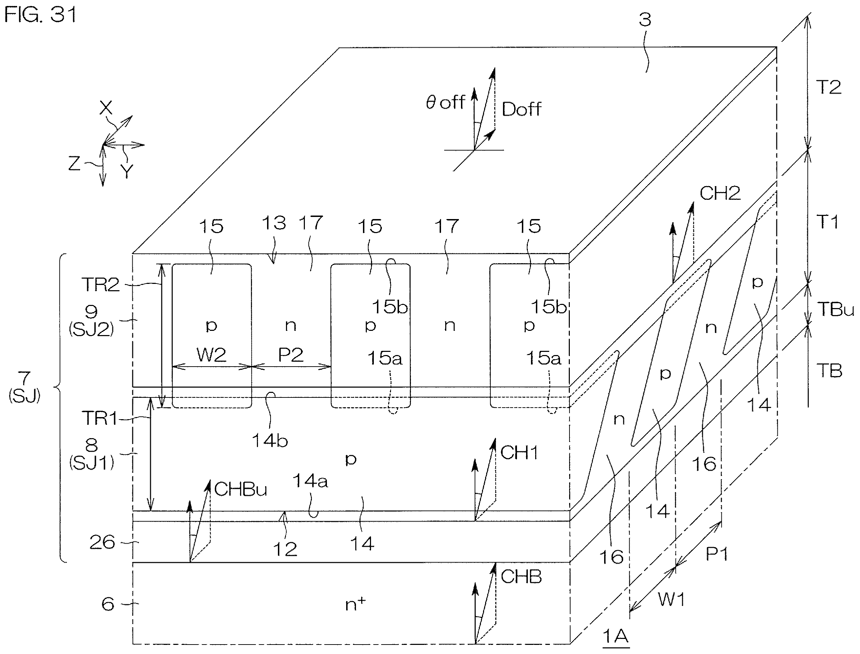

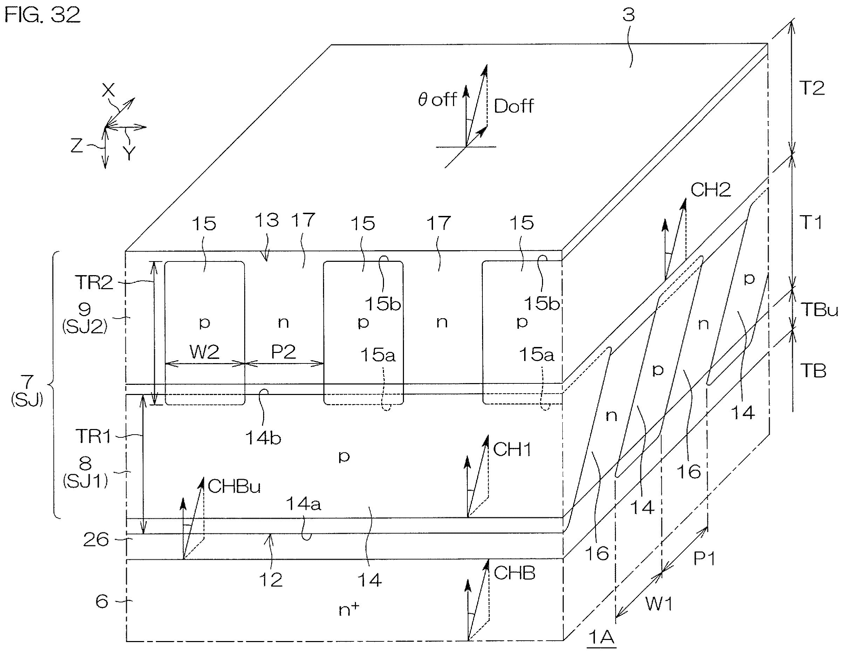

FIG. 31 is a cross-sectional perspective view showing the column region 12 according to the ninth configuration example. FIG. 32 is a cross-sectional perspective view showing the column region 12 according to the tenth configuration example. With reference to FIGS. 31 and 32, the laminated portion 7 may have a laminated structure including a buffer layer 26, the first layer 8, and the second layer 9 laminated in that order from the side of the base layer 6. The buffer layer 26 may be referred to as a "buffer SiC layer," a "buffer region," etc.

The buffer layer 26 includes an SiC monocrystal and has a conductivity type of the n-type. The buffer layer 26 is laminated on the base layer 6. The buffer layer 26 extends in a layer shape in the horizontal direction and forms an intermediate portion of the chip 2 and a part of each of the first to fourth side surfaces 5A to 5D. The buffer layer 26 is constituted of an epitaxial layer (that is, an SiC epitaxial layer) that is crystal-grown with the base layer 6 as a starting point.

The buffer layer 26 has a lower end and an upper end. The lower end of the buffer layer 26 is a crystal growth starting point, and the upper end of the buffer layer 26 is a crystal growth end point. Since the buffer layer 26 is continuously crystal-grown from the base layer 6, the lower end of the buffer layer 26 is matched with an upper end of the base layer 6. A boundary portion between the base layer 6 and the buffer layer 26 is not necessarily visible and can be indirectly evaluated and/or determined from other configurations or elements. The buffer layer 26 has the off direction Doff and the off angle θoff that are substantially matched with the off direction Doff and the off angle θoff of the base layer 6.

The buffer layer 26 has a buffer axis channel CHBu oriented along the lamination direction. The buffer axis channel CHBu is constituted of regions (channels) that are of comparatively wide interatomic distance (atomic interval) in the SiC monocrystal constituting the buffer layer 26 and are surrounded by atomic rows constituting a crystal axis extending in the lamination direction (crystal growth direction).

That is, the buffer axis channel CHBu is constituted of the regions that are sparse in atomic rows and extend in the lamination direction and are the regions in which atomic rows (interatomic distance/atomic density) in the horizontal direction are sparse in plan view. The buffer axis channel CHBu is preferably constituted of the regions surrounded by atomic rows oriented along a low index crystal axis among crystal axes.

In this embodiment, the buffer axis channel CHBu is constituted of the regions surrounded by atomic rows oriented along the c-axis of the SiC monocrystal. That is, the buffer axis channel CHBu extends along the c-axis and has the off direction Doff and the off angle θoff. In other words, the buffer axis channel CHBu is inclined by the off angle θoff from the vertical axis toward the off direction Doff.

An n-type impurity concentration of the buffer layer 26 is preferably less than the n-type impurity concentration of the base layer 6. The buffer layer 26 may have an n-type impurity concentration of not less than 1 × 10¹⁵ cm⁻³ and not more than 1 × 10¹⁸ cm⁻³ as a peak value. The n-type impurity concentration of the buffer layer 26 may be substantially constant in the thickness direction. As a matter of course, the n-type impurity concentration of the buffer layer 26 may have a concentration gradient that gradually increases and/or gradually decreases in the lamination direction (the crystal growth direction).

The buffer layer 26 has an n-type impurity concentration adjusted by at least one type of pentavalent element. For example, the n-type impurity concentration of the buffer layer 26 may be adjusted by at least one type among nitrogen, phosphorus, arsenic, antimony, and bismuth. The buffer layer 26 preferably includes a pentavalent element other than phosphorus.

In this case, the n-type impurity concentration of the buffer layer 26 is preferably adjusted by at least nitrogen. In a case where the buffer layer 26 includes two or more types of pentavalent elements, the buffer layer 26 preferably includes nitrogen and a pentavalent element other than nitrogen. In this case, the buffer layer 26 preferably includes one or both of arsenic and antimony as a pentavalent element other than phosphorus and nitrogen.

The buffer layer 26 has a buffer thickness TBu. The buffer thickness TBu is preferably less than the base thickness TB. The buffer thickness TBu is preferably not less than 1 µm. The buffer thickness TBu is preferably not more than 5 µm. The buffer thickness TBu may have a value falling within any one of ranges of not less than 1 µm and not more than 1.5 µm, not less than 1.5 µm and not more than 2 µm, not less than 2 µm and not more than 2.5 µm, not less than 2.5 µm and not more than 3 µm, not less than 3 µm and not more than 3.5 µm, not less than 3.5 µm and not more than 4 µm, not less than 4 µm and not more than 4.5 µm, and not less than 4.5 µm and not more than 5 µm.

In this embodiment, the first layer 8 is laminated on the buffer layer 26, and the second layer 9 is laminated on the first layer 8. The first layer 8 is constituted of an epitaxial layer (that is, an SiC epitaxial layer) that is crystal-grown with the buffer layer 26 as a starting point and has the conductivity type of the n-type. Therefore, the first layer 8 has the off direction Doff and the off angle θoff that are substantially matched with the off direction Doff and the off angle θoff of the buffer layer 26. Also, the first axis channel CH1 is substantially matched with the buffer axis channel CHBu.

The first thickness T1 of the first layer 8 is preferably larger than the buffer thickness TBu. As a matter of course, the first thickness T1 may be less than the buffer thickness TBu. Also, the first thickness T1 may be substantially equal to the buffer thickness TBu. The second thickness T2 of the second layer 9 is preferably larger than the buffer thickness TBu. As a matter of course, the second thickness T2 may be less than the buffer thickness TBu. Also, the second thickness T2 may be substantially equal to the buffer thickness TBu.

The first region 14 has a form identical to any one of the forms of the first regions 14 according to the first to eighth configuration examples and is formed in the first layer 8. The second region 15 has a form identical to any one of the forms of the first regions 14 according to the first to eighth configuration examples and is formed in the second layer 9.

With reference to FIG. 31, the first lower end portion 14a of the first region 14 may be formed at an interval from the lower end to the upper end side of the first layer 8 and may oppose the buffer layer 26 across a part (the lower end portion) of the first layer 8. That is, the entire first region 14 (the first gradual increase portion 20A, the first peak portion 21A, the first gentle gradient portion 22A, and the first gradual decrease portion 23A) may be positioned in the first layer 8. As a matter of course, the first lower end portion 14a may be substantially matched with the lower end of the first layer 8 and may be connected to the buffer layer 26.

With reference to FIG. 32, the first lower end portion 14a may have an extension portion that crosses a boundary portion between the buffer layer 26 and the first layer 8 and may be positioned in the buffer layer 26. Since the first axis channel CH1 is substantially matched with the buffer axis channel CHBu, the extension portion of the first lower end portion 14a is formed along the buffer axis channel CHBu in the buffer layer 26.

The extension portion of the first lower end portion 14a is preferably positioned on the upper end side of the buffer layer 26 with respect to a thickness range intermediate portion of the buffer layer 26. The extension portion of the first lower end portion 14a includes the first gradual decrease portion 23A. As a matter of course, the extension portion of the first lower end portion 14a may include a part of the first gentle gradient portion 22A and the first gradual decrease portion 23A.

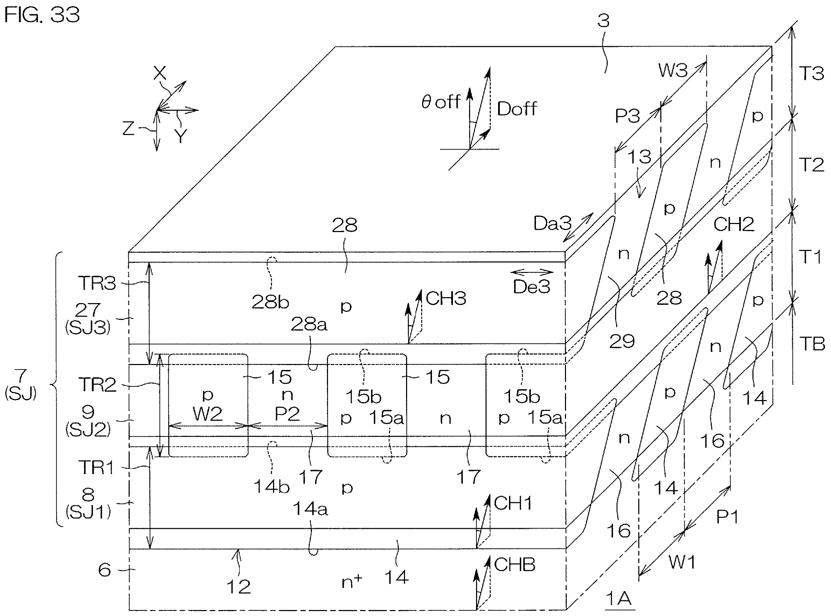

FIG. 33 is a cross-sectional perspective view showing the column region 12 according to the eleventh configuration example. In the embodiment described above, the descriptions have been provided with an intention that the super junction structure SJ having the laminated structure of three or more layers may be employed. FIG. 33 shows, as an example of this, the laminated portion 7 having a three-layer structure and the column region 12 having a three-layer structure.

Specifically, the laminated portion 7 includes a third layer 27 of the n-type made of an SiC monocrystal that is laminated on the second layer 9. The third layer 27 may be referred to as a "third SiC layer," a "third semiconductor layer," etc. As an example, the second layer 9 forms the intermediate portion of the chip 2 and a part of each of the first to fourth side surfaces 5A to 5D. The third layer 27 extends in a layer shape in the horizontal direction and forms the first main surface 3 and a part of each of the first to fourth side surfaces 5A to 5D. The third layer 27 is constituted of an epitaxial layer (that is, an SiC epitaxial layer) that is crystal-grown with the second layer 9 as a starting point.

The third layer 27 has a lower end and an upper end. The lower end of the third layer 27 is a crystal growth starting point, and the upper end of the third layer 27 is a crystal growth end point. Since the third layer 27 is continuously crystal-grown from the second layer 9, the lower end of the third layer 27 is matched with the upper end of the second layer 9. A boundary portion between the second layer 9 and the third layer 27 is not necessarily visible and can be indirectly evaluated and/or determined from other configurations or elements. The third layer 27 has the off direction Doff and the off angle θoff that are substantially matched with the off direction Doff and the off angle θoff of the second layer 9.

The third layer 27 has a third axis channel CH3 oriented along the lamination direction. The third axis channel CH3 is constituted of regions (channels) that are of comparatively wide interatomic distance (atomic interval) in the SiC monocrystal constituting the third layer 27 and are surrounded by atomic rows constituting a crystal axis extending in the lamination direction (crystal growth direction).

That is, the third axis channel CH3 is constituted of the regions that are sparse in atomic rows and extend in the lamination direction and are the regions in which atomic rows (interatomic distance/atomic density) in the horizontal direction are sparse in plan view. The third axis channel CH3 is preferably constituted of the regions surrounded by atomic rows oriented along a low index crystal axis among crystal axes.

In this embodiment, the third axis channel CH3 is constituted of the regions surrounded by atomic rows oriented along the c-axis of the SiC monocrystal. That is, the third axis channel CH3 extends along the c-axis and has the off direction Doff and the off angle θoff. In other words, the third axis channel CH3 is inclined by the off angle θoff from the vertical axis toward the off direction Doff.

An n-type impurity concentration of the third layer 27 is preferably less than the n-type impurity concentration of the base layer 6. The third layer 27 may have an n-type impurity concentration of not less than 1 × 10¹⁵ cm⁻³ and not more than 1 × 10¹⁸ cm⁻³ as a peak value. The n-type impurity concentration of the third layer 27 may be substantially constant in the thickness direction. As a matter of course, the n-type impurity concentration of the third layer 27 may have a concentration gradient that gradually increases and/or gradually decreases in the lamination direction (the crystal growth direction).

The third layer 27 has an n-type impurity concentration adjusted by at least one type of pentavalent element. For example, the n-type impurity concentration of the third layer 27 may be adjusted by at least one type among nitrogen, phosphorus, arsenic, antimony, and bismuth. The third layer 27 preferably includes a pentavalent element other than phosphorus.

The n-type impurity concentration of the third layer 27 is preferably adjusted by at least nitrogen. In a case where the third layer 27 includes two or more types of pentavalent elements, the third layer 27 preferably includes nitrogen and a pentavalent element other than nitrogen. In this case, the third layer 27 preferably includes one or both of arsenic and antimony as a pentavalent element other than phosphorus and nitrogen.

The third layer 27 has a third thickness T3. The third thickness T3 is preferably less than the base thickness TB. The third thickness T3 may be substantially equal to the second thickness T2, may be not less than the second thickness T2, or may be less than the second thickness T2. The third thickness T3 may be substantially equal to the first thickness T1, may be not less than the first thickness T1, or may be less than the first thickness T1.

The third thickness T3 is preferably not less than 1 µm. The third thickness T3 is preferably not more than 5 µm. The third thickness T3 may have a value falling within any one of ranges of not less than 1 µm and not more than 1.5 µm, not less than 1.5 µm and not more than 2 µm, not less than 2 µm and not more than 2.5 µm, not less than 2.5 µm and not more than 3 µm, not less than 3 µm and not more than 3.5 µm, not less than 3.5 µm and not more than 4 µm, not less than 4 µm and not more than 4.5 µm, and not less than 4.5 µm and not more than 5 µm.

The column region 12 includes a third region 28 formed in the third layer 27. A plurality of third regions 28 are formed at intervals in the horizontal direction in the third layer 27 and define a plurality of third drift regions 29 of the n-type that are each constituted of a part of the third layer 27. The plurality of third regions 28 form a plurality of third pn-junction portions having the charge balance together with the plurality of third drift regions 29.

That is, the plurality of third regions 28 constitute a third super junction structure SJ3 with the third layer 27. The state of having the charge balance means a state in which, regarding the plurality of third regions 28 adjacent to each other, a depletion layer expanding from one third pn-junction portion and a depletion layer expanding from the other third pn-junction portion are connected in the plurality of third drift regions 29.

The plurality of third regions 28 are formed in the third layer 27 such as to overlap the plurality of second regions 15 in the lamination direction. Specifically, the plurality of third regions 28 are arrayed at intervals in a third array direction Da3 different from the second array direction Da2 in the third layer 27 and are each formed as a band extending in a third extension direction De3 different from the second extension direction De2. That is, the plurality of third regions 28 are formed as stripes extending in the third extension direction De3, and the plurality of third drift regions 29 are formed as stripes extending in the third extension direction De3.

The plurality of third regions 28 intersect the plurality of second regions 15 in plan view. Therefore, the plurality of third drift regions 29 are connected to the plurality of second drift regions 17 at the boundary portion between the second layer 9 and the third layer 27 and form the single drift region 13 in a three-dimensional lattice shape together with the plurality of first drift regions 16 and the plurality of second drift regions 17. The plurality of third drift regions 29 form three-dimensional lattice-shaped current paths extending in the lamination direction together with the plurality of first drift regions 16 and the plurality of second drift regions 17.

The third array direction Da3 may be matched with the first array direction Da1. Also, the third extension direction De3 may be matched with the first extension direction De1. That is, the plurality of third regions 28 may extend in the same direction as the plurality of first regions 14 in plan view. In this case, the plurality of third regions 28 may oppose the plurality of first regions 14 in the lamination direction in a one-to-one correspondence relationship.

As a matter of course, the plurality of third regions 28 may be arrayed shifted from the plurality of first regions 14 in the first array direction Da1 and may oppose one or both of the first region 14 and the first drift region 16 in the lamination direction. As a matter of course, the third array direction Da3 may be different from the first array direction Da1. Also, the third extension direction De3 may be different from the first extension direction De1. That is, the plurality of third regions 28 may intersect (for example, be orthogonal to) the plurality of first regions 14 in plan view.

Although not specifically shown, in this embodiment, the plurality of third regions 28 are led out from the active region 10 to the outer peripheral region 11. That is, the plurality of third regions 28 are led out from a portion of the third layer 27 positioned in the active region 10 to a portion of the third layer 27 positioned in the outer peripheral region 11. The plurality of third regions 28 are arrayed at intervals in the third array direction Da3 also in the outer peripheral region 11 and are each formed as a band extending in the third extension direction De3.

Further, the plurality of third regions 28 extend from the outer peripheral region 11 toward one or both (in this embodiment, both) of the first side surface 5A and the third side surface 5C and respectively have portions exposed from one or both (in this embodiment, both) of the first side surface 5A and the third side surface 5C.

The portions of the plurality of third regions 28 exposed from the first side surface 5A form the plurality of third marks (not shown) in the first side surface 5A, and the portions of the plurality of third regions 28 exposed from the third side surface 5C form the plurality of third marks in the third side surface 5C. That is, the plurality of third regions 28 include one or both of the plurality of third marks as exposed portions exposed from the first side surface 5A and the plurality of third marks as exposed portions exposed from the third side surface 5C.

In other words, each of the plurality of third marks is formed using a part (an exposed portion) of each of the plurality of third regions 28. The plurality of third marks define a plurality of third spaces in the first side surface 5A (the third side surface 5C). The plurality of third marks and the plurality of third spaces are formed in the first side surface 5A (the third side surface 5C) in a layout identical to that of the plurality of first marks Mk1 and the plurality of first spaces Sp1.

Therefore, the description of the plurality of first marks Mk1 (the plurality of first spaces Sp1) is applied to the description of the plurality of third marks (the plurality of third spaces). The layout (the exposed locations or the array direction) of the plurality of third marks with respect to the first side surface 5A (the third side surface 5C) is appropriately adjusted by the layout (the third array direction Da3 or the third extension direction De3) of the plurality of third regions 28.

The plurality of third marks are not necessarily formed continuously from main body portions of the plurality of third regions 28 and may be formed as separated portions separated from the main body portions of the plurality of third regions 28. In this case, the plurality of third marks are preferably separated from the main body portions of the plurality of third regions 28 in the outer peripheral region 11. The description for the third regions 28 is also applied to the third marks (portions of the third regions 28 that are exposed from the first side surface 5A/the third side surface 5C).

The plurality of third regions 28 are constituted of channeling regions (third channeling regions) extending along the third axis channel CH3 in the third layer 27 in cross-sectional view. That is, the third region 28 is an impurity region introduced parallel to or substantially parallel to the regions (the third axis channel CH3) surrounded by atomic rows oriented along the low index crystal axis in the third layer 27 and inclinedly extends with respect to the first main surface 3.

Each of the plurality of third regions 28 has a third lower end portion 28a on a lower end side of the third layer 27 and a third upper end portion 28b on an upper end side of the third layer 27. The third lower end portion 28a is positioned in a region on the lower end side of the third layer 27 with respect to a thickness range intermediate portion of the third layer 27, and the third upper end portion 28b is positioned in a region on the upper end side of the third layer 27 with respect to the thickness range intermediate portion of the third layer 27. That is, the plurality of third regions 28 are each constituted of a single impurity region having a thickness (a depth) that crosses an intermediate portion of the third layer 27 along the third axis channel CH3.

The third lower end portion 28a may be formed at an interval from the lower end to the upper end side of the third layer 27 and may oppose the second layer 9 across a part (a lower end portion) of the third layer 27. The third lower end portion 28a may be substantially matched with the lower end of the third layer 27 and may be connected to the second layer 9. A distance between the lower end of the third layer 27 and the third lower end portion 28a may be not less than 0 µm and not more than 2 µm. The distance between the lower end of the third layer 27 and the third lower end portion 28a may have a value falling within any one of ranges of not less than 0 µm and not more than 0.5 µm, not less than 0.5 µm and not more than 1 µm, not less than 1 µm and not more than 1.5 µm, and not less than 1.5 µm and not more than 2 µm.

The third lower end portion 28a may have an extension portion that crosses the boundary portion between the second layer 9 and the third layer 27 and is positioned in the second layer 9. In this case, a thickness of the extension portion of the third lower end portion 28a on the basis of the upper end of the second layer 9 may exceed 0 µm and be not more than 2 µm. The thickness of the extension portion of the third lower end portion 28a may have a value falling within any one of ranges of exceeding 0 µm and not more than 0.5 µm, not less than 0.5 µm and not more than 1 µm, not less than 1 µm and not more than 1.5 µm, and not less than 1.5 µm and not more than 2 µm.

The third upper end portion 28b may be formed at an interval from the upper end (that is, the first main surface 3) toward the lower end side of the third layer 27 and may oppose the upper end of the third layer 27 across a part (an upper end portion) of the third layer 27. The third upper end portion 28b may be exposed from the upper end (that is, the first main surface 3) of the third layer 27.

A distance between the upper end of the third layer 27 and the third upper end portion 28b may be not less than 0 µm and not more than 1 µm. The distance between the upper end of the third layer 27 and the third upper end portion 28b may have a value falling within any one of ranges of not less than 0 µm and not more than 0.25 µm, not less than 0.25 µm and not more than 0.5 µm, not less than 0.5 µm and not more than 0.75 µm, and not less than 0.75 µm and not more than 1 µm.

The plurality of third regions 28 may have a p-type impurity concentration of not less than 1 × 10¹⁵ cm⁻³ and not more than 1 × 10¹⁸ cm⁻³ as a peak value. The p-type impurity concentration (a peak value) of the third region 28 may be not less than the p-type impurity concentration (the peak value) of the first region 14. The p-type impurity concentration (the peak value) of the third region 28 may be less than the p-type impurity concentration (the peak value) of the first region 14. The p-type impurity concentration (the peak value) of the third region 28 may be substantially equal to the p-type impurity concentration (the peak value) of the first region 14.

The p-type impurity concentration of the third region 28 is preferably adjusted by at least one type of trivalent element. The p-type impurity concentration of the third region 28 is particularly preferably adjusted by a trivalent element belonging to heavy elements heavier than carbon. That is, the third region 28 preferably includes a trivalent element other than boron (at least one type among aluminum, gallium, and indium). In this embodiment, the p-type impurity concentration of the third region 28 is adjusted by aluminum.

Each of the plurality of third regions 28 has a third width W3. The third width W3 is a width along the third array direction Da3. The third width W3 is preferably less than the third thickness T3 of the third layer 27. As a matter of course, the third width W3 may be not less than the third thickness T3. The third width W3 is preferably less than the first thickness T1 of the first layer 8. As a matter of course, the third width W3 may be not less than the first thickness T1. The third width W3 is preferably less than the second thickness T2 of the second layer 9. As a matter of course, the third width W3 may be not less than the second thickness T2.

As a matter of course, the third width W3 may be not less than the first width W1 of the first region 14 or may be less than the first width W1. The third width W3 is preferably substantially equal to the first width W1. As a matter of course, the third width W3 may be not less than the second width W2 of the second region 15 or may be less than the second width W2. The third width W3 is preferably substantially equal to the second width W2.

The third width W3 may be not less than 0.1 µm and not more than 5 µm. The third width W3 may have a value falling within any one of ranges of not less than 0.1 µm and not more than 0.25 µm, not less than 0.25 µm and not more than 0.5 µm, not less than 0.5 µm and not more than 0.75 µm, not less than 0.75 µm and not more than 1 µm, not less than 1 µm and not more than 1.5 µm, not less than 1.5 µm and not more than 2 µm, not less than 2 µm and not more than 2.5 µm, not less than 2.5 µm and not more than 3 µm, not less than 3 µm and not more than 3.5 µm, not less than 3.5 µm and not more than 4 µm, not less than 4 µm and not more than 4.5 µm, and not less than 4.5 µm and not more than 5 µm. The third width W3 is preferably not less than 0.5 µm and not more than 1.5 µm.

Each of the plurality of third regions 28 has a third region thickness TR3. The third region thickness TR3 may be less than the third thickness T3 of the third layer 27. The third region thickness TR3 may be larger than the third thickness T3. The third region thickness TR3 may be substantially equal to the third thickness T3.

The third region thickness TR3 may be less than the first thickness T1 of the first layer 8. The third region thickness TR3 may be larger than the first thickness T1. The third region thickness TR3 may be substantially equal to the first thickness T1. The third region thickness TR3 may be less than the second thickness T2 of the second layer 9. The third region thickness TR3 may be larger than the second thickness T2. The third region thickness TR3 may be substantially equal to the second thickness T2.

The third region thickness TR3 is preferably not less than 1 µm. The third region thickness TR3 is preferably not more than 5 µm. The third region thickness TR3 may have a value falling within any one of ranges of not less than 1 µm and not more than 1.5 µm, not less than 1.5 µm and not more than 2 µm, not less than 2 µm and not more than 2.5 µm, not less than 2.5 µm and not more than 3 µm, not less than 3 µm and not more than 3.5 µm, not less than 3.5 µm and not more than 4 µm, not less than 4 µm and not more than 4.5 µm, and not less than 4.5 µm and not more than 5 µm.

Preferably, the third width W3 is less than the third thickness T3 of the third layer 27, and the third region thickness TR3 is larger than the third width W3. That is, each of the plurality of third regions 28 preferably has a third aspect ratio TR3/W3 extending in a vertically long columnar shape along the third axis channel CH3. The third aspect ratio TR3/W3 is a ratio of the third region thickness TR3 to the third width W3. In this case, the third region thickness TR3 is particularly preferably larger than the third thickness T3. For example, the third aspect ratio TR3/W3 may exceed 1 and be not more than 100.

The plurality of third regions 28 are formed at intervals of a third pitch P3 in the third array direction Da3. The third pitch P3 is preferably less than the third thickness T3 of the third layer 27. As a matter of course, the third pitch P3 may be not less than the third thickness T3. The third pitch P3 is preferably less than the first thickness T1 of the first layer 8. Also, the third pitch P3 is preferably less than the second thickness T2 of the second layer 9. As a matter of course, the third pitch P3 may be not less than the first thickness T1. As a matter of course, the third pitch P3 may be not less than the second thickness T2.

The third pitch P3 may be substantially equal to the first pitch P1 or may be different from the first pitch P1. The third pitch P3 may be larger than the first pitch P1 or may be smaller than the first pitch P1. The third pitch P3 may be substantially equal to the second pitch P2 or may be different from the second pitch P2. The third pitch P3 may be larger than the second pitch P2 or may be smaller than the second pitch P2.

The third pitch P3 may be not less than 0.1 µm and not more than 5 µm. The third pitch P3 may have a value falling within any one of ranges of not less than 0.1 µm and not more than 0.25 µm, not less than 0.25 µm and not more than 0.5 µm, not less than 0.5 µm and not more than 0.75 µm, not less than 0.75 µm and not more than 1 µm, not less than 1 µm and not more than 1.5 µm, not less than 1.5 µm and not more than 2 µm, not less than 2 µm and not more than 2.5 µm, not less than 2.5 µm and not more than 3 µm, not less than 3 µm and not more than 3.5 µm, not less than 3.5 µm and not more than 4 µm, not less than 4 µm and not more than 4.5 µm, and not less than 4.5 µm and not more than 5 µm. The third pitch P3 is preferably not less than 0.5 µm and not more than 1.5 µm.

Besides the above, the description of the concentration gradient shown in FIGS. 13A to 13E is applied to the description of the concentration gradient of the third region 28. Also, the configurations of the first regions 14 (the first layer 8) or the second regions 15 (the second layer 9) described in the first to twelfth configuration examples are applied to the configuration of the third region 28 (the third layer 27).

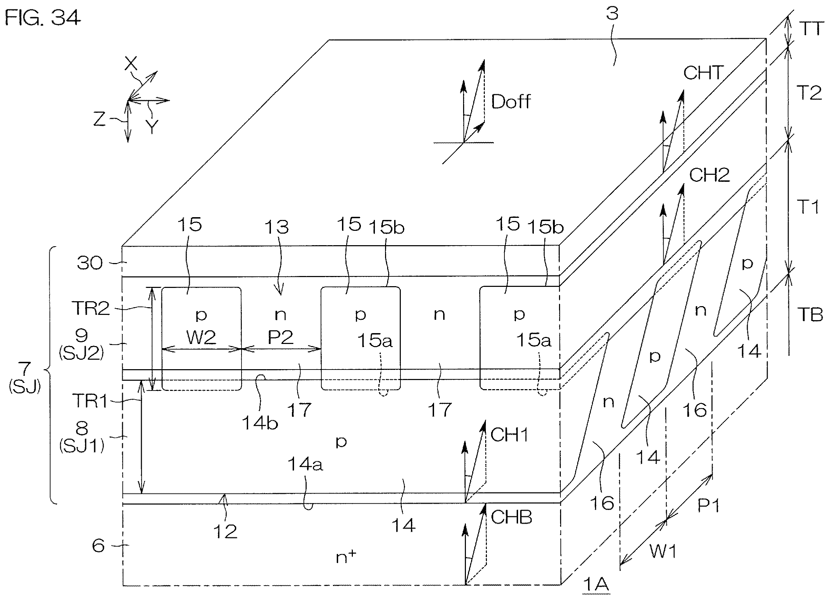

FIG. 34 is a cross-sectional perspective view showing the column region 12 according to the twelfth configuration example. In this example, with reference to FIG. 34, the laminated portion 7 may include a top layer 30 of the n-type that is constituted of an SiC monocrystal and is laminated on the second layer 9. The top layer 30 is formed to separate the first main surface 3 from the column region 12. That is, the top layer 30 is also a portion that forms at least a part of a region between the first main surface 3 and the second upper end portions 15b of the plurality of second regions 15. The top layer 30 may be regarded as a portion that forms the upper end portion of the second layer 9.

In this example, the top layer 30 has the conductivity type of the n-type, but the conductivity type of the top layer 30 can be adjusted as appropriate in accordance with properties of the device structural component formed on the first main surface 3. Therefore, the conductivity type of the top layer 30 is not necessarily limited to the n-type and may be the p-type.

The top layer 30 is laminated on the second layer 9. The top layer 30 extends in a layer shape in the horizontal direction and forms the first main surface 3 and a part of each of the first to fourth side surfaces 5A to 5D. The top layer 30 is constituted of an epitaxial layer (that is, an SiC epitaxial layer) that is crystal-grown the second layer 9 as a starting point.

Since the top layer 30 is continuously crystal-grown from the second layer 9, the lower end of the top layer 30 is matched with the upper end of the second layer 9. A boundary portion between the top layer 30 and the second layer 9 is not necessarily visible and can be indirectly evaluated and/or determined from other configurations or elements. The top layer 30 has the off direction Doff and the off angle θoff that are substantially matched with the off direction Doff and the off angle θoff of the second layer 9.

The top layer 30 has a top axis channel CHT oriented along the lamination direction. The top axis channel CHT is constituted of regions (channels) that are of comparatively wide interatomic distance (atomic interval) in the SiC monocrystal constituting the top layer 30 and are surrounded by atomic rows constituting a crystal axis extending in the lamination direction (crystal growth direction).

That is, the top axis channel CHT is constituted of the regions that are sparse in atomic rows and extend in the lamination direction and are the regions in which atomic rows (interatomic distance/atomic density) in the horizontal direction are sparse in plan view. The top axis channel CHT is preferably constituted of the regions surrounded by atomic rows oriented along a low index crystal axis among crystal axes.

In this embodiment, the top axis channel CHT is constituted of the regions surrounded by atomic rows oriented along the c-axis of the SiC monocrystal. That is, the top axis channel CHT extends along the c-axis and has the off direction Doff and the off angle θoff. In other words, the top axis channel CHT is inclined by the off angle θoff from the vertical axis toward the off direction Doff.

An n-type impurity concentration of the top layer 30 is preferably less than the n-type impurity concentration of the base layer 6. The top layer 30 may have an n-type impurity concentration of not less than 1 × 10¹⁵ cm⁻³ and not more than 1 × 10¹⁸ cm⁻³ as a peak value. The n-type impurity concentration of the top layer 30 may be substantially equal to the n-type impurity concentration of the first layer 8 (the second layer 9). The n-type impurity concentration of the top layer 30 may be substantially constant in the thickness direction. As a matter of course, the n-type impurity concentration of the top layer 30 may have a concentration gradient that gradually increases and/or gradually decreases in the lamination direction (the crystal growth direction).

The top layer 30 has an n-type impurity concentration adjusted by at least one type of pentavalent element. For example, the n-type impurity concentration of the top layer 30 may be adjusted by at least one type among nitrogen, phosphorus, arsenic, antimony, and bismuth. The top layer 30 preferably includes a pentavalent element other than phosphorus.

In this case, the n-type impurity concentration of the top layer 30 is preferably adjusted by at least nitrogen. In a case where the top layer 30 includes two or more types of pentavalent elements, the top layer 30 preferably includes nitrogen and a pentavalent element other than nitrogen. In this case, the top layer 30 preferably includes one or both of arsenic and antimony as a pentavalent element other than phosphorus and nitrogen.

The top layer 30 has a top thickness TT. The top thickness TT is preferably less than the base thickness TB. The top thickness TT is preferably less than the first thickness T1 (the second thickness T2). As a matter of course, the top thickness TT may be not less than the first thickness T1 (the second thickness T2).

The top thickness TT may be not less than 0.1 µm and not more than 5 µm. The top thickness TT may have a value falling within any one of ranges of not less than 0.1 µm and not more than 0.25 µm, not less than 0.25 µm and not more than 0.5 µm, not less than 0.5 µm and not more than 0.75 µm, not less than 0.75 µm and not more than 1 µm, not less than 1 µm and not more than 1.5 µm, not less than 1.5 µm and not more than 2 µm, not less than 2 µm and not more than 2.5 µm, not less than 2.5 µm and not more than 3 µm, not less than 3 µm and not more than 3.5 µm, not less than 3.5 µm and not more than 4 µm, not less than 4 µm and not more than 4.5 µm, and not less than 4.5 µm and not more than 5 µm.

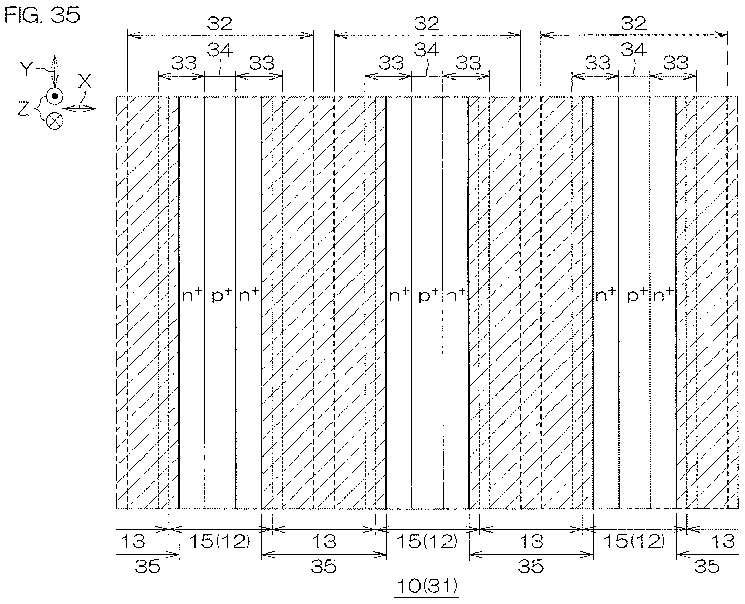

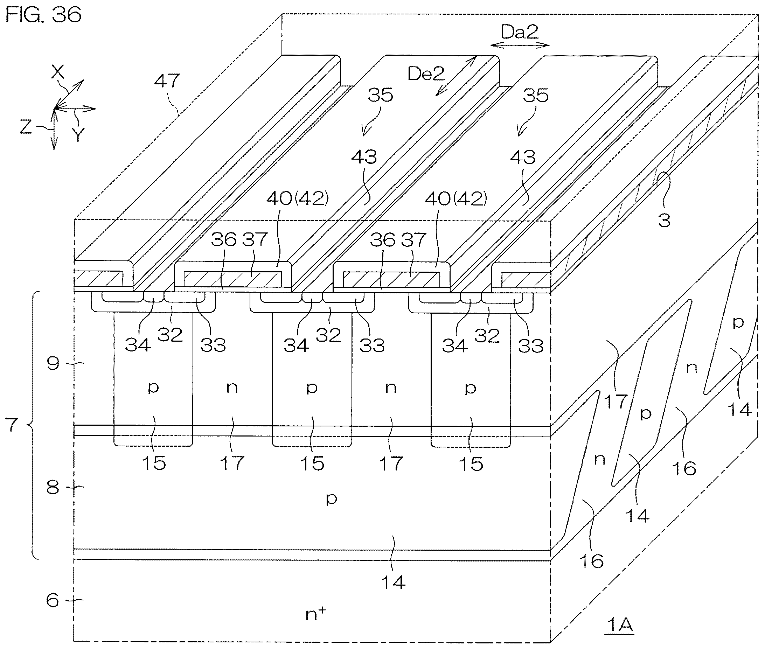

Hereinafter, a configuration example of a device structural component formed in the active region 10 will be described. FIG. 35 is a plan view showing a main portion of the active region 10. FIG. 36 is a cross-sectional perspective view showing the gate structure 35 according to a first configuration example. FIG. 36 illustrates a configuration in which the column region 12 according to the second configuration example is applied to the column region 12 according to the first basic form. As a matter of course, in FIG. 36, a configuration may be applied in which any one or the plurality of column regions 12 according to the first to twelfth configuration examples are applied to any one of the column regions 12 according to the first to third basic forms.

With reference to FIGS. 35 and 36, in this embodiment, the SiC semiconductor device 1A includes an MIS structure 31 (metal insulator semiconductor) as an example of the device structural component formed in the active region 10. The MIS structure 31 may be referred to as a "field effect transistor structure."

Here, an example is described in which the MIS structure 31 is formed on the second layer 9 (the first main surface 3). In a case where the above-described top layer 30 is formed, the MIS structure 31 is formed on the top layer 30 (the first main surface 3). The embodiment in this case is obtained by replacing the "second layer 9" with the "top layer 30" in the following description as necessary. Although the following configurations will be described as components of the SiC semiconductor device 1A, the configurations are also components of the MIS structure 31.

The SiC semiconductor device 1A includes a plurality of body regions 32 of the p-type formed in the active region 10. The plurality of body regions 32 are formed in a surface layer portion of the first main surface 3 such as to overlap the plurality of second regions 15 in the lamination direction. In this embodiment, the plurality of body regions 32 are arrayed at intervals in the second array direction Da2 such as to overlap the plurality of second regions 15 in the lamination direction in a one-to-one correspondence relationship and are each formed as a band extending in the second extension direction De2.

In this example, the second array direction Da2 is the m-axis direction (the second direction Y), and the second extension direction De2 is the a-axis direction (the first direction X). As a matter of course, an array direction and an extension direction of the plurality of body regions 32 are changed in accordance with the second array direction Da2 and the second extension direction De2 of the plurality of second regions 15. Therefore, the second array direction Da2 may be the a-axis direction, and the second extension direction De2 may be the m-axis direction. Also, the second array direction Da2 may be a direction other than the a-axis direction and the m-axis direction, and the second extension direction De2 may be a direction other than the a-axis direction and the m-axis direction.

In a case where the plurality of second regions 15 are formed at intervals from the first main surface 3, the plurality of body regions 32 are respectively formed in regions between the first main surface 3 and the second upper end portions 15b of the plurality of second regions 15. It is preferable that the plurality of body regions 32 are formed on the first main surface 3 side with respect to the thickness range intermediate portion of the second layer 9 and are exposed from the first main surface 3. It is preferable that plurality of body regions 32 are connected to the corresponding second regions 15 (the second upper end portions 15b).

The plurality of body regions 32 are respectively formed to be wider than the second regions 15 positioned directly below the body regions 32 and are formed at intervals from the plurality of adjacent second regions 15 toward the side of the second regions 15 positioned directly below the body regions 32. The plurality of body regions 32 expose a part of each of the second drift regions 17 from regions of the first main surface 3 between the plurality of adjacent second regions 15.

The plurality of body regions 32 are constituted of random impurity regions introduced into a surface layer portion of the second layer 9 by the random implantation method with respect to the second layer 9 (see also FIG. 14). Therefore, the plurality of body regions 32 have a thickness less than the second region thickness TR2 of the second regions 15 in a direction along the second axis channel CH2. The thickness of the plurality of body regions 32 is less than the first region thickness TR1 of the first regions 14.

Unlike the second region 15, etc., the plurality of body regions 32 do not have the gentle gradient portion 22 having a thickness of not less than 0.5 µm and have a concentration gradient including the gradual increase portion 20, the peak portion 21, and the gradual decrease portion 23 in a range of 0.5 µm. The plurality of body regions 32 may have a p-type impurity concentration of not less than 1 × 10¹⁵ cm⁻³ and not more than 1 × 10¹⁸ cm⁻³ as a peak value.

The p-type impurity concentration of the plurality of body regions 32 is preferably adjusted by at least one type of trivalent element. The trivalent element of the body region 32 may be the same type as the trivalent element of the second region 15, etc., or may be a type different from the trivalent element of the second region 15, etc. The trivalent element of the body region 32 may be at least one type among boron, aluminum, gallium, and indium.

The SiC semiconductor device 1A includes one or a plurality of source regions 33 of the n-type respectively formed in surface layer portions of the plurality of body regions 32 in the active region 10. In this embodiment, a plurality of (two in this embodiment) source regions 33 are formed at intervals in the surface layer portion of each of the body regions 32. The plurality of source regions 33 have an n-type impurity concentration higher than the n-type impurity concentration of the second layer 9 (the plurality of second drift regions 17). The plurality of source regions 33 may have an n-type impurity concentration of not less than 1 × 10¹⁸ cm⁻³ and not more than 1 × 10²¹ cm⁻³ as a peak value.

The plurality of source regions 33 may extend as a band in an extension direction of the corresponding body regions 32. As a matter of course, the plurality of source regions 33 may be formed at intervals in the extension direction of the corresponding body regions 32. The plurality of source regions 33 are formed at intervals from bottom portions of the corresponding body regions 32 toward the first main surface 3 side and are formed at intervals inward from peripheral edges of the corresponding body regions 32. The plurality of source regions 33 define, together with the plurality of second drift regions 17, channels (current paths) along the first main surface 3 in peripheral edge portions of the body regions 32.

The SiC semiconductor device 1A includes one or a plurality of contact regions 34 of the p-type respectively formed in surface layer portions of the plurality of body regions 32 in the active region 10. The contact region 34 may be referred to as a "back gate region." In this embodiment, the single contact region 34 is formed in a region between the plurality of source regions 33 adjacent to each other in the surface layer portion of each of the body regions 32.

The plurality of contact regions 34 have a p-type impurity concentration (a peak value) higher than the p-type impurity concentration (the peak value) of the plurality of body regions 32. The p-type impurity concentration (the peak value) of the plurality of contact regions 34 is higher than the p-type impurity concentration (the peak value) of the plurality of second regions 15. The plurality of contact regions 34 may have a p-type impurity concentration of not less than 1 × 10¹⁸ cm⁻³ and not more than 1 × 10²¹ cm⁻³ as a peak value.

The plurality of contact regions 34 may extend as a band in the extension direction of the corresponding body regions 32. As a matter of course, the plurality of contact regions 34 may be formed at intervals in the extension direction of the corresponding body regions 32. The plurality of contact regions 34 are formed at intervals from bottom portions of the corresponding body regions 32 toward the first main surface 3 side and are formed at intervals inward from the peripheral edge portions of the corresponding body regions 32.

The SiC semiconductor device 1A includes a plurality of the gate structures 35 of a planar electrode type arranged on the first main surface 3 in the active region 10. The gate structure 35 may be referred to as a "planar gate structure." The plurality of gate structures 35 are arrayed at intervals on the first main surface 3 such as to overlap the at least one body region 32 (a channel) in the lamination direction. A gate potential as a control potential is applied to the plurality of gate structures 35. The plurality of gate structures 35 control inversion and non-inversion of a channel (a current path) in the body region 32 in response to the gate potential.

In this embodiment, the plurality of gate structures 35 are arrayed at intervals in the second array direction Da2 and are each formed as a band extending in the second extension direction De2. In this example, the second array direction Da2 is the m-axis direction (the second direction Y), and the second extension direction De2 is the a-axis direction (the first direction X).

As a matter of course, an array direction and an extension direction of the plurality of gate structures 35 are changed in accordance with the second array direction Da2 and the second extension direction De2 of the plurality of second regions 15 (body regions 32). Therefore, the second array direction Da2 may be the a-axis direction, and the second extension direction De2 may be the m-axis direction. Also, the second array direction Da2 may be a direction other than the a-axis direction and the m-axis direction, and the second extension direction De2 may be a direction other than the a-axis direction and the m-axis direction.

The plurality of gate structures 35 are arranged shifted from the plurality of second regions 15 toward the plurality of second drift regions 17 side and overlap the plurality of second drift regions 17 in the lamination direction in a one-to-one correspondence relationship. In this embodiment, the plurality of gate structures 35 are each arranged such as to straddle two adjacent body regions 32 and each cover the plurality of source regions 33 positioned in one and the other body regions 32.

Each of the plurality of gate structures 35 has a laminated structure including a gate insulating film 36 arranged on the first main surface 3 and a gate electrode 37 arranged on the gate insulating film 36. The gate insulating film 36 may include a silicon oxide film. The gate electrode 37 may include a conductive polysilicon.

One or both of the gate insulating film 36 and the gate electrode 37 may be arranged such as to partially overlap the second region 15 in the lamination direction. As a matter of course, one or both of the gate insulating film 36 and the gate electrode 37 may be arranged such as not to partially overlap the second region 15 in the lamination direction.

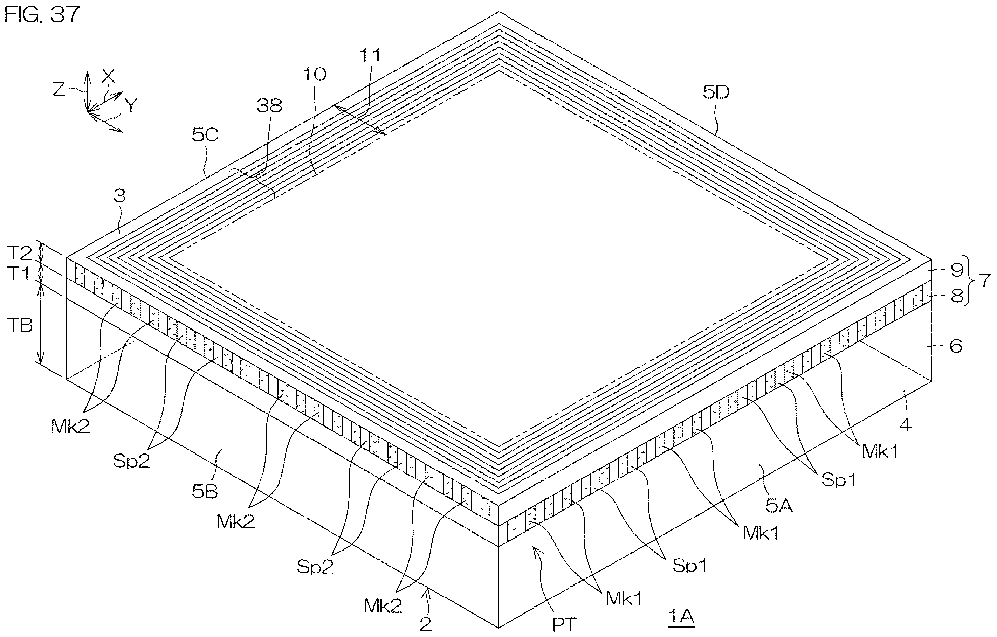

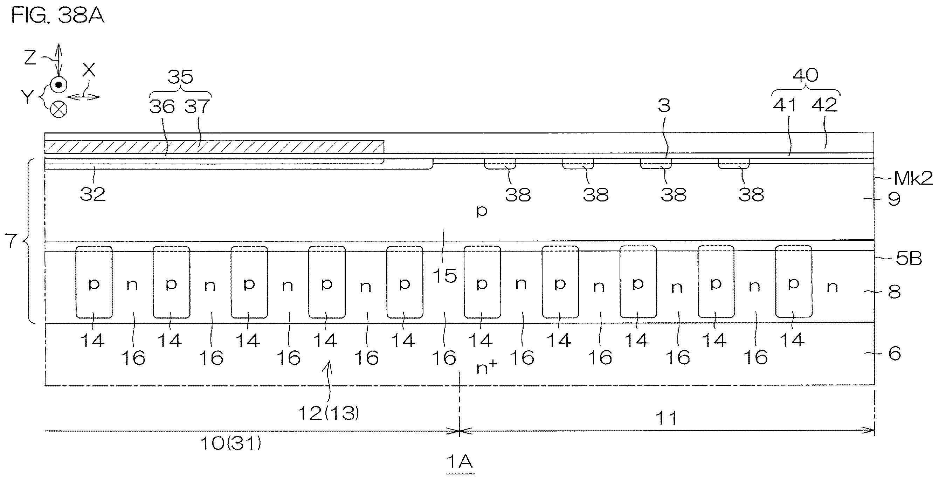

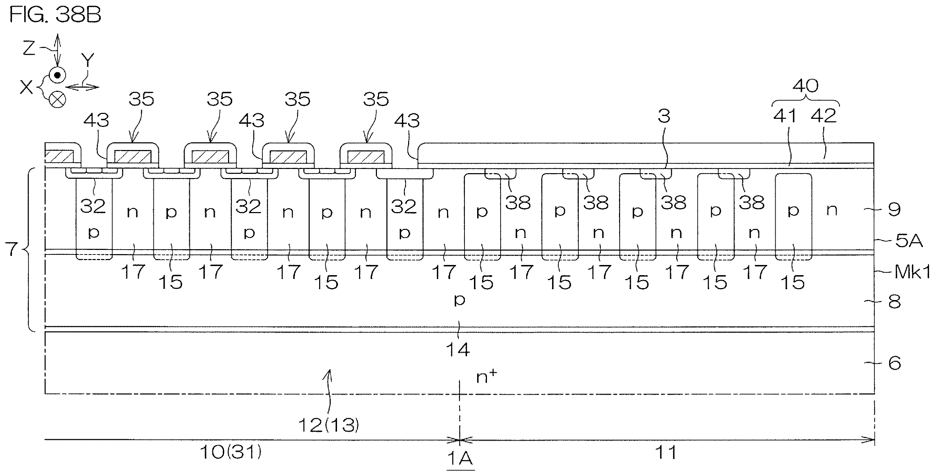

Hereinafter, a configuration on the outer peripheral region 11 side will be described. FIG. 37 is a perspective view showing a configuration of the outer peripheral region 11. FIG. 38A is a cross-sectional view showing a main portion of the outer peripheral region 11 in the first direction X. FIG. 38B is a cross-sectional view in the second direction Y showing the main portion of the outer peripheral region 11. In FIG. 37, illustration of the column region 12 is omitted.

The SiC semiconductor device 1A includes at least one field region 38 (preferably, not less than two and not more than twenty field regions 38) of the p-type formed in the surface layer portion of the first main surface 3 in the outer peripheral region 11. The number of the plurality of field regions 38 is typically not less than four and not more than eight. The plurality of field regions 38 are formed in an electrically floating state and relax an electric field inside the chip 2 at peripheral edge portions of the first main surface 3. The number, width, depth, p-type impurity concentration, etc., of the field regions 38 are arbitrary and can take on various values in accordance with the electric field to be relaxed.

The plurality of field regions 38 are formed at intervals in a region between the peripheral edges of the chip 2 and the active region 10. The plurality of field regions 38 are each formed as a band extending along the active region 10 in plan view. Each of the plurality of field regions 38 has a portion extending as a band in the first direction X and a portion extending as a band in the second direction Y. In this embodiment, the plurality of field regions 38 are each formed in an annular shape (specifically, a quadrangular annular shape) surrounding the active region 10 in plan view.

The plurality of field regions 38 overlap the column region 12 in the lamination direction in the outer peripheral region 11. That is, the plurality of field regions 38 are formed in regions above the plurality of intersection portions of the plurality of first regions 14 and the plurality of second regions 15. The plurality of field regions 38 intersect the plurality of second regions 15 in portions extending in the first extension direction De1 and intersect the plurality of first regions 14 in portions extending in the second extension direction De2 in plan view.

The plurality of field regions 38 are formed in the second layer 9 at intervals from the lower end of the second layer 9 toward the first main surface 3 side and respectively form pn-junction portions with the second layer 9. The plurality of field regions 38 preferably have bottom portions positioned on the first main surface 3 side with respect to the thickness range intermediate portion of the second layer 9. The bottom portions of the plurality of field regions 38 are particularly preferably positioned on the side of the first main surface 3 with respect to thickness range intermediate portions of the second regions 15.

The bottom portions of the plurality of field regions 38 may be positioned closer to the second lower end portion 15a of the second regions 15 than the depth positions of the second upper end portions 15b of the second regions 15. In this case, the plurality of field regions 38 may be connected to the plurality of second regions 15 in the portions extending along the second extension direction De2. As a matter of course, the plurality of field regions 38 may be formed at intervals in the horizontal direction from the plurality of second regions 15 in the portions extending along the second extension direction De2 and are not necessarily be connected to the plurality of second regions 15.

For example, in a case where a distance between the first main surface 3 and the second upper end portions 15b is sufficiently wide, the bottom portions of the plurality of field regions 38 may be positioned closer to the first main surface 3 than the depth positions of the second upper end portions 15b of the second regions 15. As a matter of course, in a case where the top layer 30 is formed, the bottom portions of the plurality of field regions 38 may be positioned closer to the first main surface 3 than the depth positions of the second upper end portions 15b of the second regions 15.

The plurality of field regions 38 may have a thickness that is substantially equal to the thickness of the plurality of body regions 32. In this case, the plurality of field regions 38 can be formed simultaneously with the plurality of body regions 32. As a matter of course, the thickness of the plurality of field regions 38 may be larger than the thickness of the plurality of body regions 32. Also, the thickness of the plurality of field regions 38 may be smaller than the thickness of the plurality of body regions 32.

The plurality of field regions 38 are constituted of the random impurity regions introduced into the surface layer portion of the second layer 9 by the random implantation method with respect to the second layer 9 (see also FIG. 14). Therefore, the plurality of field regions 38 have a thickness less than the second region thickness TR2 of the second regions 15 in a direction along the second axis channel CH2. The thickness of the plurality of field regions 38 is less than the first region thickness TR1 of the first region 14.

Unlike the second region 15, etc., the plurality of field regions 38 do not have the gentle gradient portion 22 having a thickness of not less than 0.5 µm and have a concentration gradient including the gradual increase portion 20, the peak portion 21, and the gradual decrease portion 23 in a range of 0.5 µm. The plurality of field regions 38 may have a p-type impurity concentration of not less than 1 × 10¹⁵ cm⁻³ and not more than 1 × 10¹⁸ cm⁻³ as a peak value.

The p-type impurity concentration of the field region 38 may be substantially equal to the p-type impurity concentration of the body region 32. The p-type impurity concentration of the plurality of field regions 38 may be higher than the p-type impurity concentration of the plurality of body regions 32. Also, the p-type impurity concentration of the plurality of field regions 38 may be lower than the p-type impurity concentration of the plurality of body regions 32.

The p-type impurity concentration of the plurality of field regions 38 is preferably adjusted by at least one type of trivalent element. The trivalent element of the field region 38 may be the same type as the trivalent element of the second region 15, etc., or may be a type different from the trivalent element of the second region 15, etc. The trivalent element of the field region 38 may be at least one type among boron, aluminum, gallium, and indium.

Each of the plurality of field regions 38 preferably has a width different from the second width W2 of the second region 15 (the first width W1 of the first region 14). That is, electric field relaxation effects obtained by the plurality of field regions 38 are preferably adjusted separately from the column region 12.

The width of each of the plurality of field regions 38 is particularly preferably larger than the second width W2 of the second region 15 (the first width W1). As a matter of course, the width of each of the plurality of field regions 38 may be smaller than the second width W2 (the first width W1). Also, the width of the column region 12 may be substantially equal to the second width W2 (the first width W1).

The plurality of field regions 38 are preferably formed at a pitch different from the second pitch P2 of the second regions 15 (the first pitch P1 of the first regions 14). The pitch of the plurality of field regions 38 is particularly preferably larger than the second pitch P2 (the first pitch P1). As a matter of course, the pitch of the plurality of field regions 38 may be smaller than the second pitch P2 (the first pitch P1). Also, the pitch of the plurality of field regions 38 may be substantially equal to the second pitch P2 (the first pitch P1).

The SiC semiconductor device 1A includes an interlayer insulating film 40 that covers the first main surface 3. The interlayer insulating film 40 may be referred to as an "insulating film," an "interlayer film," an "intermediate insulating film," etc. In this embodiment, the interlayer insulating film 40 has a laminated structure including a first insulating film 41 and a second insulating film 42. The first insulating film 41 may include at least one of a silicon oxide film, a silicon nitride film, and a silicon oxynitride film. The first insulating film 41 particularly preferably includes the silicon oxide film constituted of an oxide of the chip 2 (the second layer 9).

The first insulating film 41 selectively covers the first main surface 3 in the active region 10 and the outer peripheral region 11. The first insulating film 41 covers a region outside the gate insulating film 36 in the active region 10 and is connected to the gate insulating film 36. In the outer peripheral region 11, the first insulating film 41 covers the plurality of field regions 38.

In this embodiment, the first insulating film 41 is continuous to peripheral edges (the first to fourth side surfaces 5A to 5D) of the first main surface 3. Therefore, the first insulating film 41 overlaps the plurality of second marks Mk2 (the plurality of second regions 15) at the peripheral edges of the first main surface 3. As a matter of course, the first insulating film 41 may be formed at an interval inward from the peripheral edges of the first main surface 3 and may expose the second layer 9 from the peripheral edge portions of the first main surface 3.

The second insulating film 42 is laminated on the first insulating film 41. The second insulating film 42 may include at least one of a silicon oxide film, a silicon nitride film, and a silicon oxynitride film. The interlayer insulating film 40 preferably includes the silicon oxide film. The second insulating film 42 covers the first main surface 3 across the first insulating film 41 in the active region 10 and the outer peripheral region 11.

The second insulating film 42 covers the plurality of gate structures 35 in the active region 10. The second insulating film 42 covers the plurality of field regions 38 across the first insulating film 41 in the outer peripheral region 11. In this embodiment, the second insulating film 42 is continuous to peripheral edges of the first main surface 3. The second insulating film 42 may overlap the plurality of second marks Mk2 (the plurality of second regions 15) across the first insulating film 41 at the peripheral edges of the first main surface 3. As a matter of course, the second insulating film 42 may be formed at an interval inward from the peripheral edges of the first main surface 3 and may expose the peripheral edge portions of the first main surface 3 together with the first insulating film 41.

The SiC semiconductor device 1A includes a plurality of contact openings 43 formed in the interlayer insulating film 40. The plurality of contact openings 43 include the plurality of contact openings 43 (not shown) that expose the plurality of gate structures 35 (the gate electrodes 37) and the plurality of contact openings 43 that expose the plurality of source regions 33. The plurality of contact openings 43 for the source regions 33 are formed in regions between the plurality of adjacent gate structures 35 and expose the plurality of source regions 33 and the plurality of contact regions 34.

With reference to FIG. 1, the SiC semiconductor device 1A includes a gate pad 45 which is arranged on the interlayer insulating film 40. The gate pad 45 is an electrode to which a gate potential is applied from an exterior. The gate pad 45 may be referred to as a "gate pad electrode," a "first pad electrode," etc. The gate pad 45 may have a laminated structure including a Ti-based metal film and an Al-based metal film laminated in that order from the interlayer insulating film 40 side.

In this embodiment, the gate pad 45 is arranged on a portion of the interlayer insulating film 40 that covers the active region 10. The gate pad 45 may be arranged at an interval from the outer peripheral region 11 toward the active region 10 side. In this embodiment, the gate pad 45 is arranged at peripheral edge portions of the active region 10 in plan view.

FIG. 1 shows an example in which the gate pad 45 is arranged in a region along a central portion of the first side surface 5A at the peripheral edge portions of the active region 10. As a matter of course, the gate pad 45 may be arranged in a region along any one of central portions of the first to fourth side surfaces 5A to 5D. As a matter of course, the gate pad 45 may be arranged at an arbitrary corner portion of the active region 10 in plan view. Also, the gate pad 45 may be arranged at a central portion of the active region 10 in plan view. In this embodiment, the gate pad 45 is formed in a quadrangular shape in plan view.

The SiC semiconductor device 1A includes at least one gate wiring 46 (in this embodiment, a plurality of gate wirings 46) which is led out onto the interlayer insulating film 40 from the gate pad 45. The gate wiring 46 may be referred to as a "wiring," a "wiring electrode," etc. The plurality of gate wirings 46 may have a laminated structure including a Ti-based metal film and an Al-based metal film laminated in that order from the interlayer insulating film 40 side. In this embodiment, the plurality of gate wirings 46 include a first gate wiring 46A and a second gate wiring 46B.

The first gate wiring 46A is led out from the gate pad 45 toward the second side surface 5B side and extends linearly along the peripheral edges of the active region 10 such as to intersect (specifically, to be orthogonal to) a part (specifically, one end portion) of each of the plurality of gate structures 35. The first gate wiring 46A penetrates the interlayer insulating film 40 through the plurality of contact openings 43 and is electrically connected to the one end portions of the plurality of gate structures 35.

The second gate wiring 46B is led out from the gate pad 45 toward the fourth side surface 5D side and extends linearly along the peripheral edges of the active region 10 such as to intersect (specifically, to be orthogonal to) a part (specifically, the other end portion) of each of the plurality of gate structures 35. The second gate wiring 46B penetrates the interlayer insulating film 40 through the plurality of contact openings 43 and is electrically connected to the other end portions of the plurality of gate structures 35.

The SiC semiconductor device 1A includes a source pad 47 arranged on the interlayer insulating film 40 at an interval from the gate pad 45 and the gate wiring 46. The source pad 47 is an electrode to which a source potential is applied from the exterior. The source pad 47 may be referred to as a "source pad electrode," a "second pad electrode," etc. The source pad 47 may have a laminated structure including a Ti-based metal film and an Al-based metal film laminated in that order from the interlayer insulating film 40 side.

The source pad 47 is arranged on a portion of the interlayer insulating film 40 that covers the active region 10. The source pad 47 may be arranged at an interval from the outer peripheral region 11 toward the active region 10 side. In this embodiment, the source pad 47 is formed in a polygonal shape having a recess portion that is recessed along the gate pad 45 in plan view. As a matter of course, the source pad 47 may be formed in a quadrangular shape in plan view.

The source pad 47 penetrates the interlayer insulating film 40 through the plurality of contact openings 43 and is electrically connected to the plurality of body regions 32, the plurality of source regions 33, and the plurality of contact regions 34. That is, the source pad 47 is electrically connected to the column region 12 through the plurality of body regions 32.

The SiC semiconductor device 1A includes a drain pad 48 that covers the second main surface 4. The drain pad 48 is an electrode to which a drain potential is applied from the exterior. The drain pad 48 may be referred to as a "drain pad electrode," a "third pad electrode," etc. The drain pad 48 forms an ohmic contact with the base layer 6 exposed from the second main surface 4. That is, the drain pad 48 is electrically connected to the first layer 8 (the plurality of first drift regions 16) and the second layer 9 (the plurality of second drift regions 17) through the base layer 6.

The drain pad 48 may cover the entire region of the second main surface 4 such as to be continuous with the peripheral edges (the first to fourth side surfaces 5A to 5D) of the chip 2. The drain pad 48 may cover the second main surface 4 at an interval inward from the peripheral edges of the chip 2 such as to expose the peripheral edge portions of the chip 2.

A breakdown voltage that can be applied between the source pad 47 and the drain pad 48 (between the first main surface 3 and the second main surface 4) may be not less than 500 V and not more than 3000 V. The breakdown voltage may have a value falling within any one of ranges of not less than 500 V and not more than 1000 V, not less than 1000 V and not more than 1500 V, not less than 1500 V and not more than 2000 V, not less than 2000 V and not more than 2500 V, and not less than 2500 V and not more than 3000 V.

In a case where the laminated portion 7 having a two-layer structure is employed, the breakdown voltage is preferably set to a value falling within any one of ranges of not less than 500 V and not more than 1000 V, not less than 1000 V and not more than 1500 V, and not less than 1500 V and not more than 2000 V. In a case where the laminated portion 7 having a three-layer structure is employed, the breakdown voltage is preferably set to a value falling within any one of ranges of not less than 1000 V and not more than 1500 V, not less than 1500 V and not more than 2000 V, not less than 2000 V and not more than 2500 V, and not less than 2500 V and not more than 3000 V.

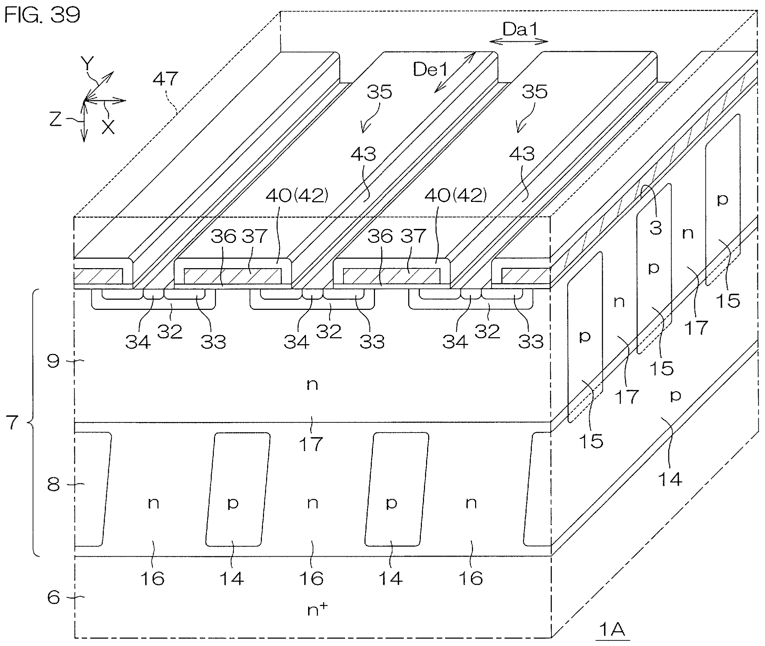

FIG. 39 is a cross-sectional perspective view showing the gate structures 35 according to a second configuration example. The plurality of gate structures 35 according to the first configuration example extend in the second extension direction De2 of the plurality of second regions 15. On the other hand, the plurality of gate structures 35 according to the second configuration example extend in a direction other than the second extension direction De2 such as to intersect the plurality of second regions 15.

In this embodiment, the plurality of body regions 32 described above extend in a direction other than the second extension direction De2 such as to intersect the plurality of second regions 15 in the lamination direction. In this embodiment, the plurality of body regions 32 are arrayed at intervals in the first array direction Da1 of the first regions 14 and extend in the first extension direction De1 of the first regions 14. That is, the plurality of body regions 32 are orthogonal to the plurality of second regions 15. In this example, the first array direction Da1 is the a-axis direction (the first direction X), and the first extension direction De1 is the m-axis direction (the second direction Y).

The plurality of body regions 32 may oppose the plurality of first regions 14 in the lamination direction in a one-to-one correspondence relationship. As a matter of course, the respective body regions 32 may oppose the plurality of first regions 14 in the lamination direction. The plurality of body regions 32 may oppose the plurality of first drift regions 16 in the lamination direction in a one-to-one correspondence relationship.

As a matter of course, the respective body regions 32 may oppose the plurality of first drift regions 16 in the lamination direction. The plurality of body regions 32 may be arrayed shifted from the plurality of first regions 14 in the first array direction Da1 and may oppose one or both of the first region 14 and the first drift region 16 in the lamination direction.

As a matter of course, an array direction and an extension direction of the plurality of body regions 32 are changed in accordance with the first array direction Da1 and the first extension direction De1 of the plurality of first regions 14. Therefore, the first array direction Da1 may be the m-axis direction, and the first extension direction De1 may be the a-axis direction. Also, the first array direction Da1 may be a direction other than the a-axis direction and the m-axis direction, and the first extension direction De1 may be a direction other than the a-axis direction and the m-axis direction.

As a matter of course, the array direction of the plurality of body regions 32 may be a direction other than the first array direction Da1 and the second array direction D2. Also, the extension direction of the plurality of body regions 32 may be a direction other than the first extension direction De1 and the second extension direction De2. That is, the plurality of body regions 32 may intersect both the plurality of first regions 14 and the plurality of second regions 15 in plan view. In this case, a form in which the array direction of the plurality of body regions 32 is one of the a-axis direction and the m-axis direction, and the extension direction of the plurality of body regions 32 is the other of the a-axis direction and the m-axis direction is not precluded.

For example, an angle (an absolute value) between the extension direction of the body regions 32 and the second extension direction De2 may exceed 0° and be not more than 90°. The angle (the absolute value) of the body regions 32 may have a value falling within any one of ranges of exceeding 0° and not more than 18°, not less than 18° and not more than 36°, not less than 36° and not more than 54°, not less than 54° and not more than 72°, and not less than 72° and not more than 90°. The angle (the absolute value) of the body regions 32 may be set to a value falling within any one of ranges of 30° ± 5°, 45° ± 5°, and 60° ± 5°.

The plurality of source regions 33 and the plurality of contact regions 34 described above are formed along the extension direction of the corresponding body regions 32 and respectively oppose the plurality of second regions 15 and the plurality of second drift regions 17 across parts of the corresponding body regions 32 in the lamination direction.

In this embodiment, the plurality of gate structures 35 are arrayed at intervals in the first array direction Da1 of the first regions 14 and extend in the first extension direction De1 of the first regions 14. That is, the plurality of gate structures 35 are orthogonal to the plurality of second regions 15. In this example, the first array direction Da1 is the a-axis direction (the first direction X), and the first extension direction Del is the m-axis direction (the second direction Y).

The plurality of gate structures 35 may oppose the plurality of first regions 14 in the lamination direction in a one-to-one correspondence relationship. As a matter of course, the respective gate structures 35 may oppose the plurality of first regions 14 in the lamination direction. The plurality of gate structures 35 may oppose the plurality of first drift regions 16 in the lamination direction in a one-to-one correspondence relationship.

As a matter of course, the respective gate structures 35 may oppose the plurality of first drift regions 16 in the lamination direction. The plurality of gate structures 35 may be arrayed shifted from the plurality of first regions 14 in the first array direction Da1 and may oppose one or both of the first region 14 and the first drift region 16 in the lamination direction.

As a matter of course, an array direction and an extension direction of the plurality of gate structures 35 are changed in accordance with the first array direction Da1 and the first extension direction De1 of the plurality of first regions 14 (body regions 32). Therefore, the first array direction Da1 may be the m-axis direction, and the first extension direction De1 may be the a-axis direction. Also, the first array direction Da1 may be a direction other than the a-axis direction and the m-axis direction, and the first extension direction De1 may be a direction other than the a-axis direction and the m-axis direction.

As a matter of course, the array direction of the plurality of gate structures 35 may be a direction other than the first array direction Da1 and the second array direction D2. Also, the extension direction of the plurality of gate structures 35 may be a direction other than the first extension direction De1 and the second extension direction De2. That is, the plurality of gate structures 35 may intersect both the plurality of first regions 14 and the plurality of second regions 15 in plan view. In this case, a form in which the array direction of the plurality of gate structures 35 is one of the a-axis direction and the m-axis direction, and the extension direction of the plurality of gate structures 35 is the other of the a-axis direction and the m-axis direction is not precluded.

For example, an angle (an absolute value) between the extension direction of the gate structures 35 and the second extension direction De2 may exceed 0° and be not more than 90°. The angle (the absolute value) of the gate structures 35 may have a value falling within any one of ranges of exceeding 0° and not more than 18°, not less than 18° and not more than 36°, not less than 36° and not more than 54°, not less than 54° and not more than 72°, and not less than 72° and not more than 90°. The angle (the absolute value) of the gate structures 35 may be set to a value falling within any one of ranges of 30° ± 5°, 45° ± 5°, and 60° ± 5°.

In this embodiment, the plurality of gate structures 35 are each arranged such as to straddle two adjacent body regions 32 and each cover the plurality of source regions 33 positioned in one and the other body regions 32. Also, the plurality of gate structures 35 respectively oppose the plurality of second regions 15 (second regions 15) and the plurality of second drift regions 17 in the lamination direction.

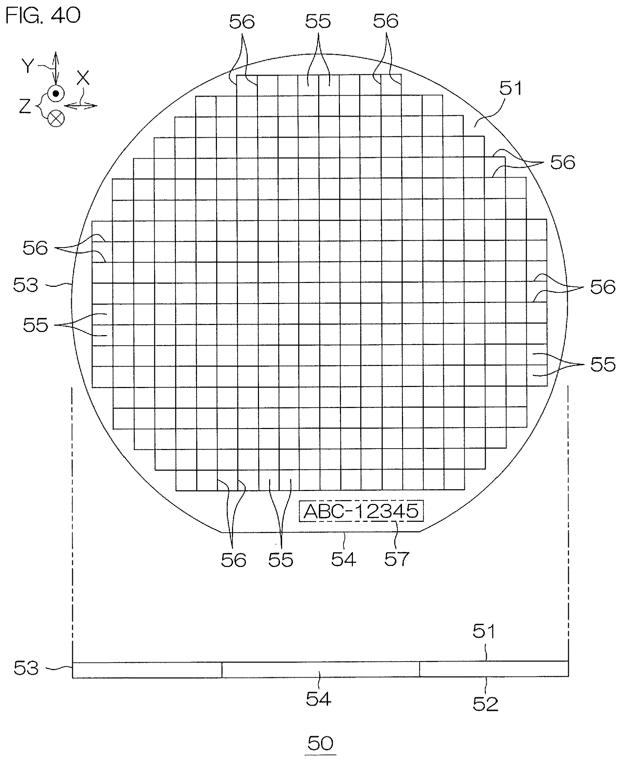

FIG. 40 is a schematic view showing a wafer 50 used in manufacturing the SiC semiconductor device 1A. The wafer 50 is a base material of the base layer 6 and includes an SiC monocrystal. The wafer 50 is formed in a flat disk shape. As a matter of course, the wafer 50 may be formed in a flat rectangular parallelepiped shape. The wafer 50 has a first wafer main surface 51 on one side, a second wafer main surface 52 on the other side, and a wafer side surface 53 connecting the first wafer main surface 51 and the second wafer main surface 52.

The first wafer main surface 51 corresponds to the upper end of the base layer 6, and the second wafer main surface 52 corresponds to the lower end of the base layer 6. The first wafer main surface 51 and the second wafer main surface 52 are formed of c-planes of the SiC monocrystal. The first wafer main surface 51 is formed of a silicon plane of the SiC monocrystal, and the second wafer main surface 52 is formed of a carbon plane of the SiC monocrystal. The wafer 50 (the first wafer main surface 51 and the second wafer main surface 52) has the off direction Doff and the off angle θoff described above.

The wafer 50 has a mark 54 that indicates a crystal orientation of the SiC monocrystal at the wafer side surface 53. The mark 54 may include one or both of an orientation flat and an orientation notch. The orientation flat is constituted of a notched portion linearly cut in plan view. The orientation notch is constituted of a notched portion cut in a concave shape (for example, a tapered shape) toward a central portion of the first wafer main surface 51 in plan view.

The mark 54 may include one or both of a first orientation flat extending in the m-axis direction and a second orientation flat extending in the a-axis direction. The mark 54 may include one or both of an orientation notch recessed in the m-axis direction and an orientation notch recessed in the a-axis direction. FIG. 40 shows an orientation flat extending in the a-axis direction in plan view.

The wafer 50 includes a wafer ID 57 provided in the first wafer main surface 51. The wafer ID 57 is an identification label (a part number) attached to each of the wafers 50 for process management. The wafer ID 57 includes at least one of a barcode, a QR code (registered trademark), a letter, a character, and a symbol. FIG. 40 shows an example in which the wafer ID 57 includes alphabetic characters (ABC), numeric characters (1245), and a symbol (a hyphen) connecting the alphabetic characters and numeric characters.

As a matter of course, the wafer ID 57 may include a figure, a logo, a picture, etc. As a matter of course, the wafer ID 57 may include arbitrary information about the wafer 50. For example, the wafer ID 57 may include various items of information about specifications of the wafer 50, such as a size, a shape, and a manufacturing date of the wafer 50. As a matter of course, various items of information about the wafer 50 may be stored in a bar code, a QR code (registered trademark), etc.

The wafer ID 57 may include a plurality of engraved marks formed in the first wafer main surface 51. For example, the wafer ID 57 may include an agglomeration of a plurality of engraved marks arrayed in a dot shape. The plurality of engraved marks may be laser irradiation marks formed by irradiating the first wafer main surface 51 with laser light.

The plurality of engraved marks may be notched marks obtained by forming a groove-shaped notch in the first wafer main surface 51 with a needle, etc. The plurality of engraved marks may be etching processing marks formed by etching the first wafer main surface 51 into a groove shape. The wafer ID 57 may be printed on the first wafer main surface 51 with an ink, etc.

The wafer ID 57 is provided in a peripheral edge portion of the first wafer main surface 51. In this embodiment, the wafer ID 57 is arranged in the vicinity of the mark 54 at an interval from the mark 54 in the peripheral edge portion of the first wafer main surface 51. At least a part of the wafer ID 57 preferably opposes the mark 54 in the horizontal direction.

For example, in a case where the mark 54 includes the orientation flat, the wafer ID 57 may be formed along the orientation flat with the orientation flat as an underline. For example, in the case where the mark 54 includes the orientation notch, the wafer ID 57 may oppose the orientation notch in the first direction X or the second direction Y. As a matter of course, the wafer ID 57 may be formed at an interval from the orientation notch in a direction intersecting both the first direction X and the second direction Y, and may oppose the orientation notch in the direction intersecting both the first direction X and the second direction Y.

For example, a plurality of device regions 55 and a plurality of intended cutting lines 56 are set in the wafer 50 by an alignment mark, etc. Each of the device regions 55 is a region corresponding to the SiC semiconductor device 1A. The plurality of device regions 55 are each set in a quadrangular shape in plan view.

In this embodiment, the plurality of device regions 55 are set in a matrix in the first direction X and the second direction Y in plan view. The plurality of device regions 55 are each set at intervals inward from peripheral edges of the first wafer main surface 51 in plan view. The plurality of device regions 55 are set in a region outside the wafer ID 57, and oppose the mark 54 across the wafer ID 57 in the horizontal direction. The plurality of intended cutting lines 56 are set in a lattice that extends in the first direction X and the second direction Y such as to define the plurality of device regions 55.

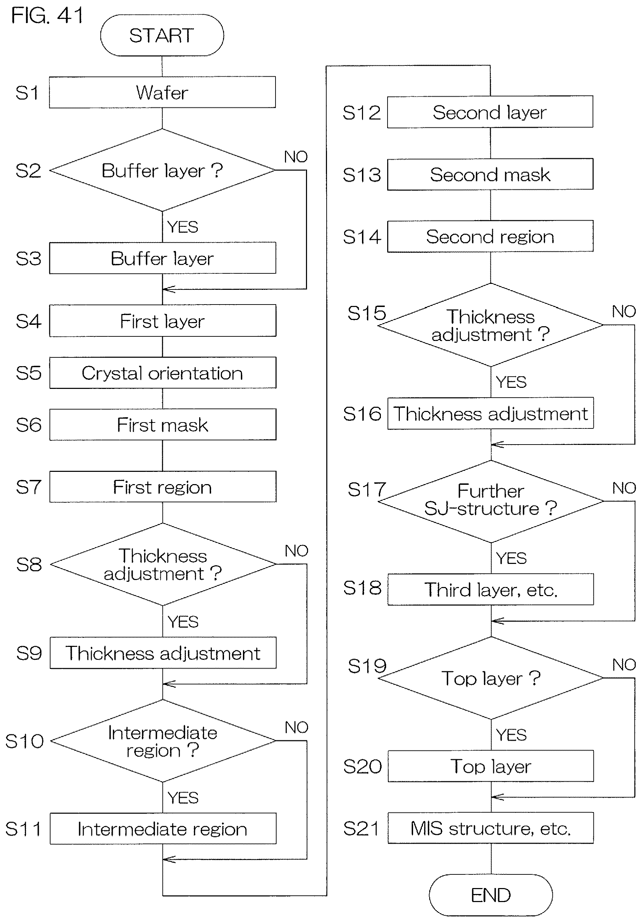

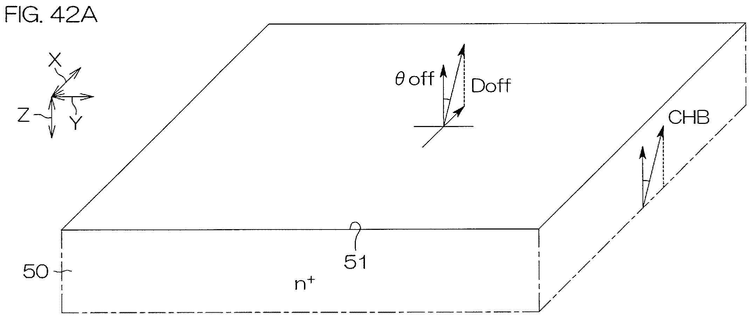

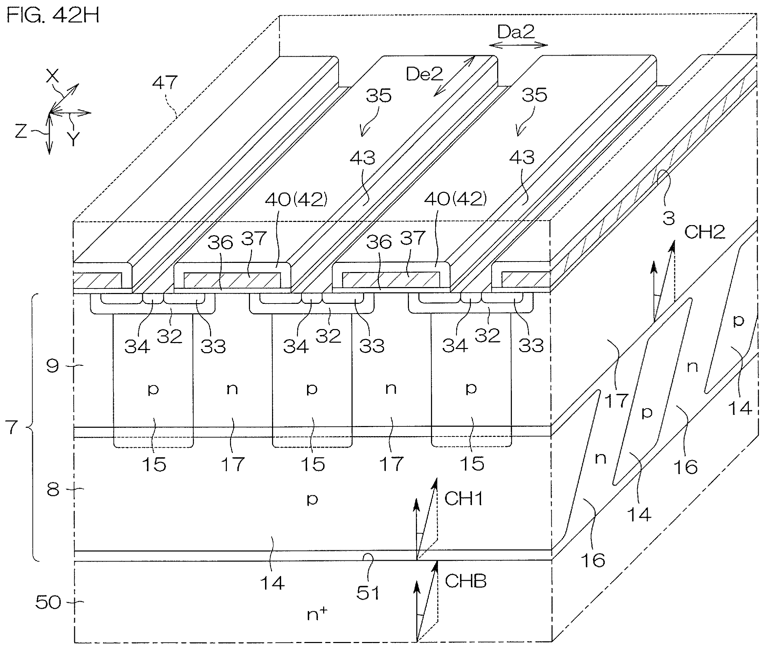

FIG. 41 is a flowchart showing a manufacturing method example of the SiC semiconductor device 1A. FIGS. 42A to 42H are cross-sectional perspective views showing the manufacturing method example of the SiC semiconductor device 1A. FIGS. 42A to 42H show cross-sectional perspective views of a portion of the active region 10 of the single device region 55.

First, with reference to FIG. 42A, a preparation step of the wafer 50 described above is performed (step S1 in FIG. 41). Next, a determination step of whether or not to perform a forming step of the n-type buffer layer 26 (see FIGS. 31 and 32) is performed (step S2 in FIG. 41). In a case where the buffer layer 26 is formed (step S2 in FIG. 41: YES), the buffer layer 26 is formed with the first wafer main surface 51 (the wafer 50) as a starting point by an epitaxial growth method (step S3 in FIG. 41). In a case where the forming step of the buffer layer 26 is not performed (step S2 in FIG. 41: NO), this step is omitted.

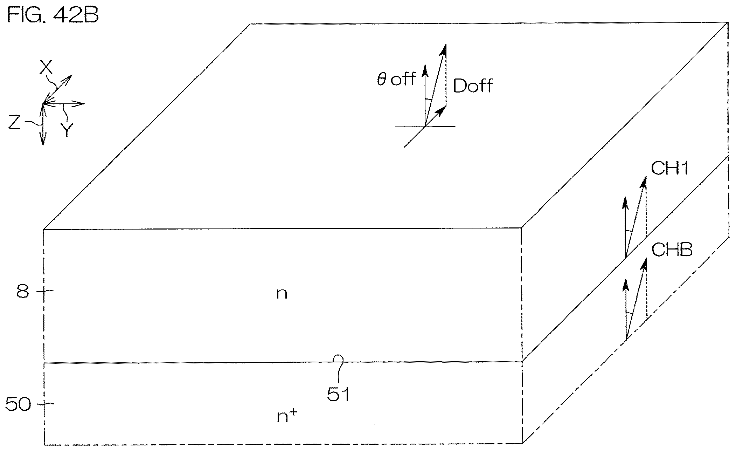

Next, with reference to FIG. 42B, a forming step of the n-type first layer 8 is performed (step S4 in FIG. 41). In a case where the forming step of the buffer layer 26 is omitted, the first layer 8 is formed with the first wafer main surface 51 (the wafer 50) as a starting point by the epitaxial growth method. Consequently, an epitaxial wafer including the wafer 50 and the first layer 8 as an epitaxial layer is formed.

In a case where the buffer layer 26 is formed, the first layer 8 is formed with the buffer layer 26 as a starting point by the epitaxial growth method. Consequently, the epitaxial wafer including the wafer 50, the buffer layer 26 as an epitaxial layer, and the first layer 8 as another epitaxial layer is formed. In this case, after the forming step of the buffer layer 26, the first layer 8 may be formed by being continuously crystal-grown from the buffer layer 26 by using the forming step of the buffer layer 26.

Next, a measurement step of a crystal orientation of the first layer 8 is performed (step S5 in FIG. 41). The crystal orientation of the first layer 8 includes a step of measuring the off angle θoff of the first layer 8. That is, this step includes a step of measuring a crystal orientation of the first axis channel CH1 of the first layer 8.

The wafer 50 is cut out from an ingot (an SiC ingot) which is a crystalline lump, but there is a risk that an error occurs in the off angle θoff due to a process error. In a case where an error occurs in the off angle θoff of the wafer 50, a process error also occurs in the off angle θoff of the first layer 8, and this becomes an obstacle at the time of a channeling implantation step. Therefore, it is preferable that data (information) of the off angle θoff is acquired before the channeling implantation step, and the channeling implantation step is performed based on the data (information) of this off angle θoff.

The off angle θoff of the first layer 8 is substantially matched with the off angle θoff of the wafer 50 and the off angle θoff of the buffer layer 26. Therefore, the measurement step of the crystal orientation may be performed on the wafer 50 or the buffer layer 26 before the forming step of the first layer 8. However, from the viewpoint of ensuring accuracy, the measurement step of the crystal orientation is preferably performed on the first layer 8.

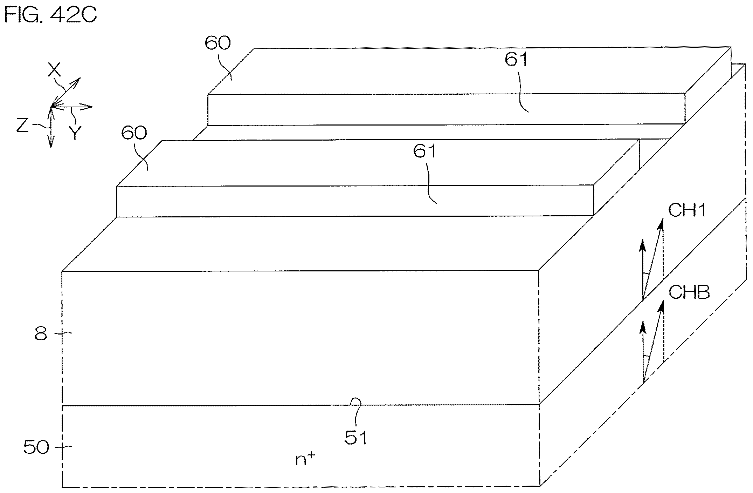

Next, with reference to FIG. 42C, a forming step of a first mask 60 having a predetermined pattern is performed (step S6 in FIG. 41). The first mask 60 is preferably an organic mask (a resist mask). The first mask 60 is arranged on the upper end of the first layer 8 and has a plurality of first openings 61 that expose regions of the first layer 8 in which the plurality of first regions 14 are to be formed.

Specifically, the plurality of first openings 61 are formed at intervals in the first array direction Da1 in the entire surface of the upper end of the first layer 8 and are each defined as a band extending in the first extension direction De1. That is, the plurality of first openings 61 cross the plurality of device regions 55 and the plurality of intended cutting lines 56 in the first extension direction De1 and expose the plurality of device regions 55 and the plurality of intended cutting lines 56 as stripes. The plurality of first openings 61 expose, in each device region 55, both a portion of the upper end of the first layer 8 positioned in the active region 10 and a portion of the upper end of the first layer 8 positioned in the outer peripheral region 11.

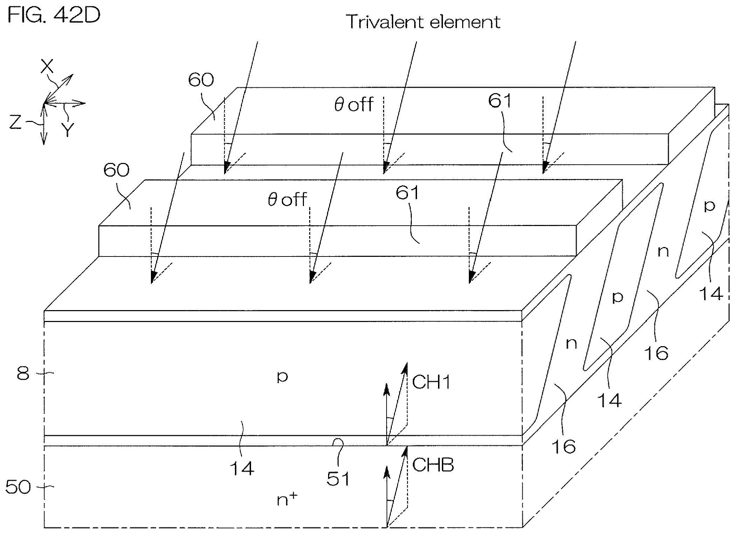

Next, with reference to FIG. 42D, a forming step of the plurality of first regions 14 is performed (step S7 in FIG. 41). The forming step of the plurality of first regions 14 includes a channeling implantation step of a trivalent element (p-type impurity) into the first layer 8. The first layer 8 (the wafer 50) has the off angle θoff inclined at a predetermined angle in the predetermined off direction Doff with respect to the first wafer main surface 51. The channeling implantation step is performed based on the data (information) of the off angle θoff.

In the random implantation method, a trivalent element is introduced into the first layer 8 with predetermined implantation energy in a direction intersecting the first axis channel CH1 (the off angle θoff) (see also FIG. 14). For example, in the random implantation method, the trivalent element is implanted in the vertical direction Z perpendicular to the upper end (the first wafer main surface 51) of the first layer 8.

In the case of the random implantation method, since the trivalent element is introduced in a direction in which relatively dense atomic rows are present in plan view, the trivalent element collides with the atomic rows at a relatively shallow depth position. Hence, the atomic rows inhibit the trivalent element from being introduced into a relatively deep depth position of the first layer 8. As a result, the first region 14 not having the gentle gradient portion 22 is formed (see also FIG. 14).

Meanwhile, in the channeling implantation method, an implantation angle of the trivalent element with respect to the first layer 8 is controlled, and the trivalent element is introduced into the first layer 8 with predetermined implantation energy along the first axis channel CH1 (the c-axis of the SiC monocrystal in this embodiment) (see also FIGS. 13A to 13E). In this case, one or both of the implantation angle of the trivalent element with respect to the first layer 8 and an inclination angle of the first layer 8 with respect to the implantation angle of the trivalent element are adjusted.

For example, the wafer 50 may be horizontally supported, and the trivalent element may be introduced into the first layer 8 along the first axis channel CH1. As a matter of course, the wafer 50 may be supported in a state of being inclined by the off angle θoff with respect to the horizontal, and the trivalent element may be introduced into the first layer 8 along the first axis channel CH1. The plurality of first regions 14 having a predetermined thickness are formed at a predetermined depth position by an arbitrary combination of implantation energies of the trivalent element and implantation temperatures of the trivalent element (temperatures of the wafer 50) (see also FIGS. 13A to 13E).

The implantation energy of the trivalent element may be not less than 100 KeV and not more than 2000 KeV. The implantation energy may have a value falling within any one of ranges of not less than 100 KeV and not more than 250 KeV, not less than 250 KeV and not more than 500 KeV, not less than 500 KeV and not more than 750 KeV, not less than 750 KeV and not more than 1000 KeV, not less than 1000 KeV and not more than 1250 KeV, not less than 1250 KeV and not more than 1500 KeV, not less than 1500 KeV and not more than 1750 KeV, and not less than 1750 KeV and not more than 2000 KeV.

The implantation temperature of the trivalent element may be adjusted in a range of not less than 0°C and not more than 1500°C. The implantation temperature may have a value falling within any one of ranges of not less than 0°C and not more than 25°C, not less than 25°C and not more than 50°C, not less than 50°C and not more than 100°C, not less than 100°C and not more than 250°C, not less than 250°C and not more than 500°C, not less than 500°C and not more than 750°C, not less than 750°C and not more than 1000°C, not less than 1000°C and not more than 1250°C, and not less than 1250°C and not more than 1500°C.

The implantation angle of the trivalent element is preferably set within a range of ±2° on the basis of an axis along the first axis channel CH1 (the c-axis of the SiC monocrystal in this embodiment) (0°). The implantation angle of the trivalent element is particularly preferably set within a range of ±1° on the basis of the axis along the first axis channel CH1 (the c-axis of the SiC monocrystal in this embodiment) (0°).

In the case of the channeling implantation method, the trivalent element is introduced along the first axis channel CH1 in which atomic rows are relatively sparse in plan view. The trivalent element travels in the first axis channel CH1 while repeating small-angle scattering due to a channeling effect and reaches a relatively deep depth position of the first layer 8. That is, in the case of the channeling implantation method, a collision probability of the trivalent element with respect to the atomic rows of the SiC monocrystal is reduced.

In this case, a trivalent element belonging to heavy elements heavier than carbon is preferably introduced into the first layer 8. That is, the trivalent element is preferably a trivalent element (at least one type among aluminum, gallium, and indium) other than boron. In this embodiment, the trivalent element is aluminum.

The first extension direction De1 may be the a-axis direction or the m-axis direction. The first extension direction De1 may be a direction other than the a-axis direction and the m-axis direction. In a case where the first extension direction De1 is matched with the m-axis direction (see also FIG. 8A, etc.), the trivalent element is introduced into the first layer 8 through the plurality of first openings 61 while being inclined by substantially the off angle θoff with respect to the upper end of the first layer 8 in cross-sectional view in the first array direction Da1.

In the case where the first extension direction De1 is matched with the a-axis direction (the off direction Doff) (see also FIG. 10A, etc.), the trivalent element is introduced into the first layer 8 through the plurality of first openings 61 while being substantially perpendicular to the upper end of the first layer 8 in cross-sectional view in the first array direction Da1. Therefore, the plurality of first regions 14 are prevented from being formed in an inclined posture in the first layer 8. Also, wall surfaces of the plurality of first openings 61 are prevented from becoming blocking objects with respect to an incident path of the trivalent element.

In the case where the first extension direction De1 is a direction other than the a-axis direction and the m-axis direction (see also FIGS. 12A to 12C, etc.), a need to strictly control alignment deviation of the plurality of first regions 14 with respect to the crystal orientation of the SiC monocrystal is eliminated.

After the implantation step of the trivalent element, by an annealing method, lattice defects, etc., that formed in the first layer 8 may be repaired at the same time as the trivalent element is electrically activated. An annealing temperature for the first layer 8 may be not less than 500°C and not more than 2000°C. Consequently, the plurality of first regions 14 are formed, and at the same time, the first super junction structure SJ1 is formed.

The plurality of first regions 14 are arrayed at intervals in the first array direction Da1 over the entire region of the first layer 8 and are each formed such as to extend as a band in the first extension direction De1. That is, the plurality of first regions 14 are formed as stripes such as to cross the plurality of device regions 55 and the plurality of intended cutting lines 56 in the first extension direction De1. After the forming step of the plurality of first regions 14, the first mask 60 is removed.

Next, a determination step of whether or not to perform a thickness adjustment step of the first layer 8 is performed (step S8 in FIG. 41). In a case where the thickness of the first layer 8 is adjusted (step S8 in FIG. 41: YES), the first layer 8 is thinned from the upper end side (step S9 in FIG. 41).

The thickness adjustment step (thinning step) may include a step of partially removing the upper end portion of the first layer 8 by the grinding method. The grinding method may be a mechanical polishing method and/or a chemomechanical polishing method. The thickness adjustment step may include a step of partially removing the upper end portion of the first layer 8 by the etching method. The etching method may be a wet etching method and/or a dry etching method.

The thickness adjustment step may include a step of exposing the plurality of first regions 14 from the upper end of the first layer 8 (see also FIGS. 27 to 30, etc.). That is, the thickness adjustment step may include a step of partially or entirely removing the first gradual increase portion 20A of the plurality of first regions 14. In the case where the thickness adjustment step is not performed (step S8 in FIG. 41: NO), this step is omitted.

Next, a determination step of whether or not to perform a forming step of the plurality of intermediate regions 25 (see also FIGS. 25 and 26) is performed (step S10 in FIG. 41). In a case where the plurality of intermediate regions 25 are formed (step S10 in FIG. 41: YES), the plurality of intermediate regions 25 are formed in the surface layer portion of the first layer 8 (step S11 in FIG. 41).

The forming step of the plurality of intermediate regions 25 includes a step of arranging a mask (not shown) having a predetermined pattern on the upper end of the first layer 8. The mask (not shown) is preferably an organic mask (a resist mask). The mask (not shown) has a plurality of openings that respectively expose regions where the plurality of first regions 14 are formed in the first layer 8.

Specifically, the plurality of openings are formed at intervals in the first array direction Dal in the entire surface of the upper end of the first layer 8 and are each defined as a band extending in the first extension direction De1. That is, the plurality of openings cross the plurality of device regions 55 and the plurality of intended cutting lines 56 in the first extension direction De1 and expose the plurality of device regions 55 and the plurality of intended cutting lines 56 as stripes. The plurality of openings expose, in each device region 55, both a portion of the upper end of the first layer 8 positioned in the active region 10 and a portion of the upper end of the first layer 8 positioned in the outer peripheral region 11.

The forming step of the plurality of intermediate regions 25 includes a step of introducing the trivalent element into the first layer 8 with a predetermined implantation energy in a direction intersecting the first axis channel CH1 (the off angle θoff) by a random implantation method through the mask (not shown) (see also FIG. 14). The trivalent element may be introduced into the first layer 8 once or a plurality of times. In the case where the trivalent element is introduced a plurality of times, the trivalent element may be introduced into different depth positions of the first layer 8 in multiple stages with a plurality of implantation energies.

The plurality of intermediate regions 25 are arrayed at intervals in the first array direction Da1 over the entire region of the first layer 8 and are each formed such as to extend as a band in the first extension direction De1. That is, the plurality of intermediate regions 25 are formed as stripes such as to cross the plurality of device regions 55 and the plurality of intended cutting lines 56 in the first extension direction De1. After the forming step of the plurality of intermediate regions 25, the mask (not shown) is removed.

In the case where the thickness adjustment step of the first layer 8 described above is not performed, the forming step of the plurality of intermediate regions 25 may be continuously performed after the forming step of the plurality of first regions 14. In this case, the plurality of intermediate regions 25 may be formed using the first mask 60 described above.

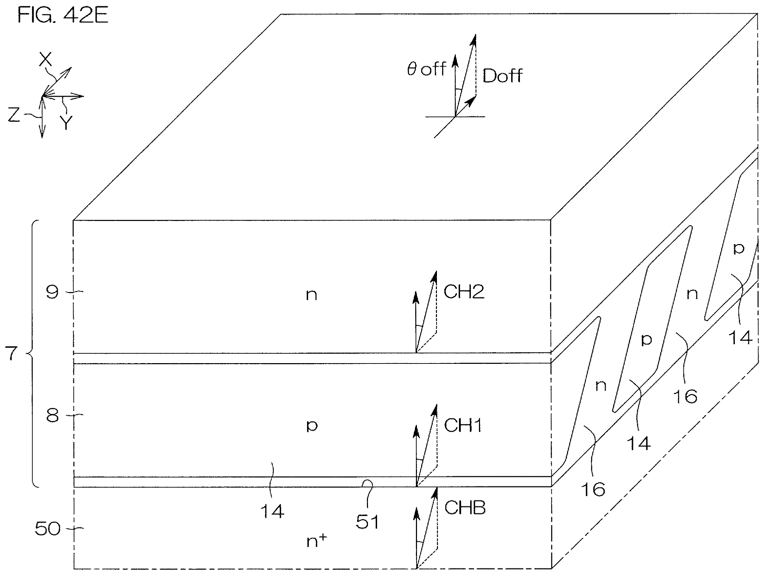

Next, with reference to FIG. 42E, a forming step of the second layer 9 is performed (step S12 in FIG. 41). The second layer 9 is formed with the first layer 8 as a starting point by the epitaxial growth method. Thereafter, a measurement step of a crystal orientation (the off angle θoff) of the second layer 9 may be performed by a method identical to that in step S4 in FIG. 41.

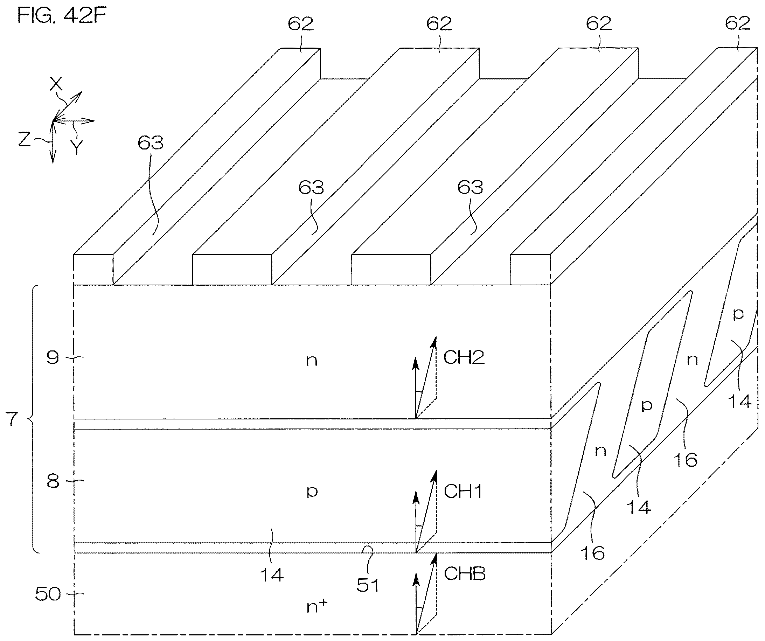

Next, with reference to FIG. 42F, a forming step of a second mask 62 having a predetermined pattern is performed (step S13 in FIG. 41). The second mask 62 is preferably an organic mask (a resist mask). The second mask 62 is arranged on the upper end of the second layer 9 and has a plurality of second openings 63 that expose regions of the second layer 9 in which the plurality of second regions 15 are to be formed.

Specifically, the plurality of second openings 63 are formed at intervals in the second array direction Da2 different from the first array direction Da1 in the entire surface of the upper end of the second layer 9 and are each defined as a band extending in the second extension direction De2 different from the first extension direction De1. That is, the plurality of second openings 63 cross the plurality of device regions 55 and the plurality of intended cutting lines 56 in the second extension direction De2 and expose the plurality of device regions 55 and the plurality of intended cutting lines 56 as stripes. The plurality of second openings 63 expose, in each device region 55, both a portion of the upper end of the second layer 9 positioned in the active region 10 and a portion of the upper end of the second layer 9 positioned in the outer peripheral region 11.

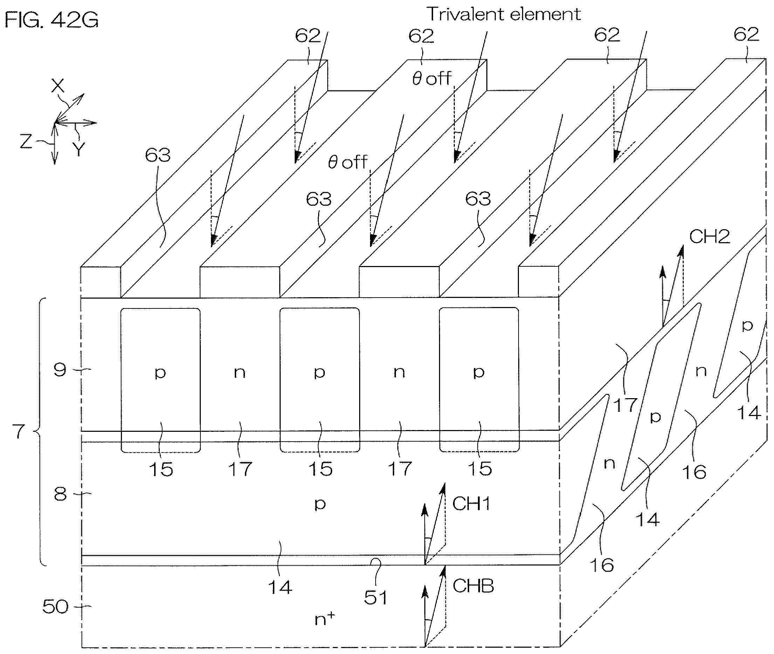

Next, with reference to FIG. 42G, a forming step of the plurality of second regions 15 is performed (step S14 in FIG. 41). The forming step of the plurality of second regions 15 includes a channeling implantation step of a trivalent element (p-type impurity) into the second layer 9. The channeling implantation step is performed based on the data (information) of the off angle θoff described above.

In the channeling implantation method, an implantation angle of the trivalent element with respect to the second layer 9 is controlled, and the trivalent element is introduced into the second layer 9 with predetermined implantation energy along the second axis channel CH2 (the c-axis of the SiC monocrystal in this embodiment) (see also FIGS. 13A to 13E). In this case, one or both of the implantation angle of the trivalent element with respect to the second layer 9 and an inclination angle of the second layer 9 with respect to the implantation angle of the trivalent element are adjusted.

For example, the wafer 50 may be horizontally supported, and the trivalent element may be introduced into the second layer 9 along the second axis channel CH2. As a matter of course, the wafer 50 may be supported in a state of being inclined by the off angle θoff with respect to the horizontal, and the trivalent element may be introduced into the second layer 9 along the second axis channel CH2. The plurality of second regions 15 having a predetermined thickness are formed at a predetermined depth position by an arbitrary combination of implantation energies of the trivalent element and implantation temperatures of the trivalent element (see also FIGS. 13A to 13E).

The implantation energy of the trivalent element may be not less than 100 KeV and not more than 2000 KeV. The implantation energy may have a value falling within any one of ranges of not less than 100 KeV and not more than 250 KeV, not less than 250 KeV and not more than 500 KeV, not less than 500 KeV and not more than 750 KeV, not less than 750 KeV and not more than 1000 KeV, not less than 1000 KeV and not more than 1250 KeV, not less than 1250 KeV and not more than 1500 KeV, not less than 1500 KeV and not more than 1750 KeV, and not less than 1750 KeV and not more than 2000 KeV.

The implantation energy related to the second regions 15 may be substantially equal to the implantation energy related to the first regions 14 or may be different from the implantation energy related to the first regions 14. The implantation energy related to the second regions 15 may be not less than the implantation energy related to the first regions 14. Also, the implantation energy related to the second regions 15 may be less than the implantation energy related to the first regions 14.

The implantation temperature of the trivalent element may be adjusted in a range of not less than 0°C and not more than 1500°C. The implantation temperature may have a value falling within any one of ranges of not less than 0°C and not more than 25°C, not less than 25°C and not more than 50°C, not less than 50°C and not more than 100°C, not less than 100°C and not more than 250°C, not less than 250°C and not more than 500°C, not less than 500°C and not more than 750°C, not less than 750°C and not more than 1000°C, not less than 1000°C and not more than 1250°C, and not less than 1250°C and not more than 1500°C.

The implantation temperature related to the second regions 15 may be substantially equal to the implantation temperature related to the first regions 14 or may be different from the implantation temperature related to the first regions 14. The implantation temperature related to the second regions 15 may be not less than the implantation temperature related to the first regions 14. Also, the implantation temperature related to the second regions 15 may be less than the implantation temperature related to the first regions 14.

The implantation angle of the trivalent element is preferably set within a range of ±2° on the basis of an axis along the second axis channel CH2 (the c-axis of the SiC monocrystal in this embodiment) (0°). The implantation angle of the trivalent element is particularly preferably set within a range of ±1° on the basis of an axis along the second axis channel CH2 (the c-axis of the SiC monocrystal in this embodiment) (0°).

In the case of the channeling implantation method, the trivalent element is introduced along the second axis channel CH2 in which atomic rows are relatively sparse in plan view. The trivalent element travels in the second axis channel CH2 while repeating small-angle scattering due to a channeling effect and reaches a relatively deep depth position of the second layer 9. That is, in the case of the channeling implantation method, a collision probability of the trivalent element with respect to the atomic rows of the SiC monocrystal is reduced.

In this case, a trivalent element belonging to heavy elements heavier than carbon is preferably introduced into the second layer 9. That is, the trivalent element is preferably a trivalent element (at least one type among aluminum, gallium, and indium) other than boron. In this embodiment, the trivalent element is aluminum.

The second extension direction De2 may be the a-axis direction or the m-axis direction. The second extension direction De2 may be a direction other than the a-axis direction and the m-axis direction. In the case where the second extension direction De2 is matched with the a-axis direction (the off direction Doff) (see also FIG. 8A, etc.), the trivalent element is introduced into the second layer 9 through the plurality of second openings 63 while being substantially perpendicular to the upper end of the second layer 9 in cross-sectional view in the second array direction Da2. Therefore, the plurality of second regions 15 are prevented from being formed in an inclined posture in the second layer 9. Also, wall surfaces of the plurality of second openings 63 are prevented from becoming blocking objects with respect to an incident path of the trivalent element.

In the case where the second extension direction De2 is matched with the m-axis direction (see also FIG. 10A, etc.), the trivalent element is introduced into the second layer 9 through the plurality of second openings 63 while being inclined by substantially the off angle θoff with respect to the upper end of the second layer 9 in cross-sectional view in the second array direction Da2.

In the case where the second extension direction De2 is a direction other than the a-axis direction and the m-axis direction (see also FIGS. 12A to 12C, etc.), a need to strictly control alignment deviation of the plurality of second regions 15 with respect to the crystal orientation of the SiC monocrystal is eliminated.

In the case where the first extension direction De1 of the first regions 14 is a direction other than the a-axis direction and the m-axis direction, the second extension direction De2 is also preferably a direction other than the a-axis direction and the m-axis direction. In this case, the plurality of first regions 14 have the first extension angle θ1 inclined toward one side of the m-axis with respect to the a-axis, and the plurality of second regions 15 have the second extension angle θ2 toward the other side of the m-axis with respect to the a-axis.

The absolute value of the second extension angle θ2 may be different from the absolute value of the first extension angle θ1. However, in this case, a relative implantation angle condition of the trivalent element in the forming step of the second regions 15 is different from a relative implantation angle condition of the trivalent element in the forming step of the first regions 14. Hence, a blocking area of the plurality of second openings 63 with respect to the incident path of the trivalent element is different from the blocking area of the plurality of first openings 61 with respect to the incident path of the trivalent element.

That is, a process error of the plurality of second regions 15 due to shadowing by the plurality of second openings 63 is different from a process error of the plurality of first regions 14 due to shadowing by the plurality of first openings 61. Therefore, the absolute value of the second extension angle θ2 is preferably substantially equal to the absolute value of the first extension angle θ1. In this case, the process error of the plurality of second regions 15 becomes substantially identical to the process error of the plurality of first regions 14. Therefore, the accuracy of the charge balance is improved.

As an example, the first extension angle θ1 may be +45° ± 5°, and the second extension angle θ2 may be -45° ± 5° (see FIG. 12A). As an example, the first extension angle θ1 may be +30° ± 5°, and the second extension angle θ2 may be -30° ± 5° (see FIG. 12B). As an example, the first extension angle θ1 may be +60° ± 5°, and the second extension angle 02 may be -60° ± 5° (see FIG. 12C).

After the implantation step of the trivalent element, by an annealing method, lattice defects, etc., that formed in the second layer 9 may be repaired at the same time as the trivalent element is electrically activated. An annealing temperature for the second layer 9 may be not less than 500°C and not more than 2000°C. Consequently, the plurality of second regions 15 are formed, and at the same time, the second super junction structure SJ2 is formed.

The plurality of second regions 15 are arrayed at intervals in the second array direction Da2 over the entire region of the second layer 9 and are each formed such as to extend as a band in the second extension direction De2. That is, the plurality of second regions 15 are formed as stripes such as to cross the plurality of device regions 55 and the plurality of intended cutting lines 56 in the second extension direction De2.

The annealing method related to the plurality of second regions 15 may also serve as the annealing method related to the plurality of first regions 14 described above. In this case, the annealing method related to the first regions 14 before the forming step of the second regions 15 may be omitted.

Next, a determination step of whether or not to perform a thickness adjustment step of the second layer 9 is performed (step S15 in FIG. 41). In a case where the thickness of the second layer 9 is adjusted (step S15 in FIG. 41: YES), the second layer 9 is thinned from the upper end side (step S16 in FIG. 41).

The thickness adjustment step (thinning step) may include a step of partially removing the upper end portion of the second layer 9 by the grinding method. The grinding method may be a mechanical polishing method and/or a chemomechanical polishing method. The thinning step of the second layer 9 may include a step of partially removing the upper end portion of the second layer 9 by the etching method. The etching method may be a wet etching method and/or a dry etching method.

The thickness adjustment step may include a step of exposing the plurality of second regions 15 from the upper end of the second layer 9 (see also FIGS. 27 to 30, etc.). That is, the thickness adjustment step may include a step of partially or entirely removing the second gradual increase portion 20B of the plurality of second regions 15. In the case where the thickness adjustment step is not performed (step S15 in FIG. 41: NO), this step is omitted.

Next, a determination step of whether or not to perform a forming step of the further super junction structure SJ on the second layer 9 is performed (step S17 in FIG. 41). For example, in a case where a forming step of the third super junction structure SJ3 (see also FIG. 33) is performed (step S17 in FIG. 41: YES), the third layer 27 is formed on the second layer 9, and the plurality of third regions 28 are formed in the third layer 27 through steps identical to steps S12 to S14 in FIG. 41 (step S18 in FIG. 41).

As a matter of course, before the forming step of the further super junction structure SJ, the plurality of intermediate regions 25 may be formed in the surface layer portion of the second layer 9 through a step identical to step S11 in FIG. 41 (see also FIGS. 25 and 26). In the case where the forming step of the further super junction structure SJ is not performed (step S17 in FIG. 41: NO), this step is omitted.

Next, a determination step of whether or not to perform a forming step of the top layer 30 (see also FIG. 34) is performed (step S19 in FIG. 41). In the case where the forming step of the top layer 30 is performed (step S19 in FIG. 41: YES), the top layer 30 is formed with the second layer 9 as a starting point by the epitaxial growth method (step S20 in FIG. 41). In the case where the forming step of the top layer 30 is not performed (step S19 in FIG. 41: NO), this step is omitted.

Thereafter, the MIS structure 31, the plurality of field regions 38, the interlayer insulating film 40, the gate pad 45, the gate wiring 46, the source pad 47, the drain pad 48, etc., are formed (step S21 in FIG. 41).

Then, the wafer 50 is cut along the plurality of intended cutting lines 56. Portions of the plurality of first regions 14 positioned on the plurality of intended cutting lines 56 are exposed from the first side surface 5A (the third side surface 5C) as the plurality of first marks Mk1. In a case where the plurality of intermediate regions 25 are formed, a portion of each of the plurality of intermediate regions 25 positioned on the plurality of intended cutting lines 56 is exposed as a part (the upper end portion) of each of the plurality of first marks Mk1 from the first side surface 5A (the third side surface 5C). Portions of the plurality of second regions 15 positioned on the plurality of intended cutting lines 56 are exposed as the plurality of second marks Mk2 from the second side surface 5B (the fourth side surface 5D).

Also, in a case where the intermediate portion of the second region 15 is cut along the second extension direction De2, a part of the second region 15 is exposed as the first difference mark Md1 from the first side surface 5A (the third side surface 5C). Also, in a case where the intermediate portion of the first region 14 is cut along the first extension direction De1, a part of the first region 14 is exposed as the second difference mark Md2 from the second side surface 5B (the fourth side surface 5D).

A cutting step of the wafer 50 may include a machining step of the wafer 50. In this case, the wafer 50 is cut along the plurality of intended cutting lines 56 by a dicing blade. Consequently, the chip 2 having the first to fourth side surfaces 5A to 5D that are each constituted of the ground surface is formed.

The cutting step of the wafer 50 may include a cleavage step of the wafer 50. In this case, a plurality of modified layers (damaged layers) along the plurality of intended cutting lines 56 are formed inside the wafer 50 by a laser light irradiation method, and the wafer 50 is cleaved along the plurality of intended cutting lines 56 with the plurality of modified layers as starting points. Consequently, the chip 2 having the first to fourth side surfaces 5A to 5D that are each constituted of a cleavage surface is formed.

In the case of the cleavage step of the wafer 50, the plurality of modified layers are preferably formed in a thickness range of the wafer 50 (the base layer 6) with respect to a thickness range of the laminated portion 7. Specifically, the plurality of modified layers are preferably formed in the wafer 50 (the base layer 6) at intervals from the thickness range of the laminated portion 7 to the side of the second wafer main surface 52 of the wafer 50.

According to this manufacturing method, the plurality of modified layers are formed (remain) in portions of the first to fourth side surfaces 5A to 5D after cleavage that are constituted of the base layer 6. Therefore, it is possible to prevent the plurality of modified layers from overlapping the ornamental pattern PT (the plurality of first marks Mk1 and the plurality of second marks Mk2). Consequently, the visibility of the ornamental pattern PT is improved. Also, electrical influences of the plurality of modified layers on the plurality of first regions 14 and the plurality of second regions 15 through the ornamental pattern PT are reduced.

In a case where the cleavage step is performed, each of the first to fourth side surfaces 5A to 5D is constituted of a cleavage surface and has the plurality of modified layers. Therefore, the plurality of modified layers may be regarded as one component of the SiC semiconductor device 1A (the chip 2).

The above-described various determination steps (steps S2, S8, S10, S15, S17, and S19 in FIG. 41) may be determined in advance at a stage of the preparation step of the wafer 50 (step S1 in FIG. 41). That is, the SiC semiconductor device 1A may be manufactured along a predetermined manufacturing line. A plurality of SiC semiconductor devices 1A are manufactured from the single wafer 50 through steps including the above-described steps.

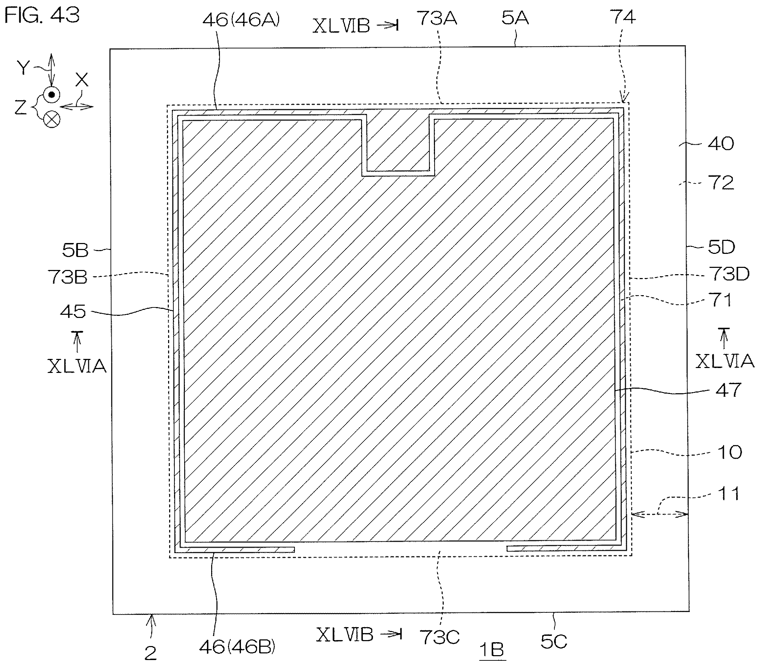

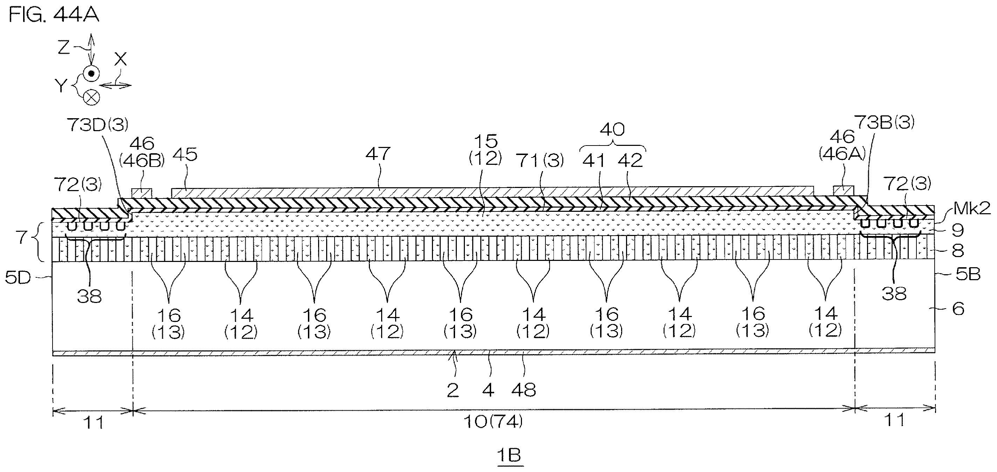

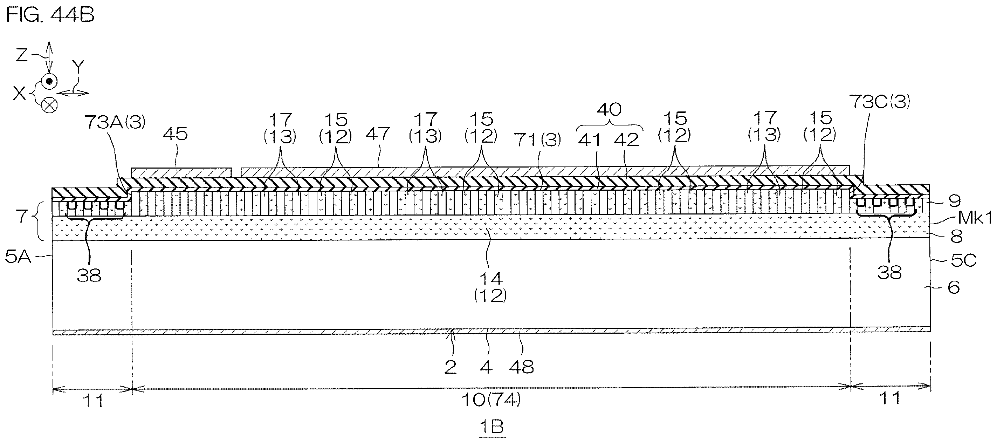

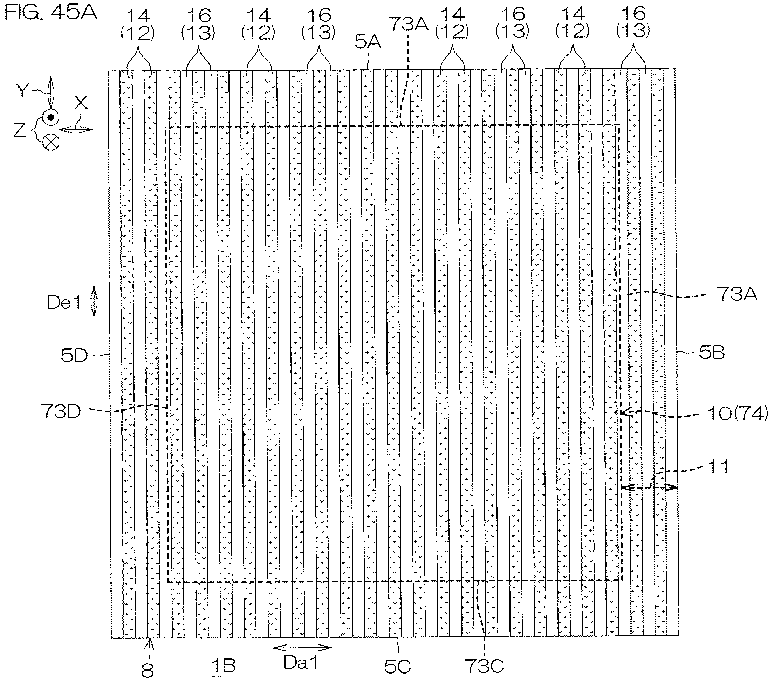

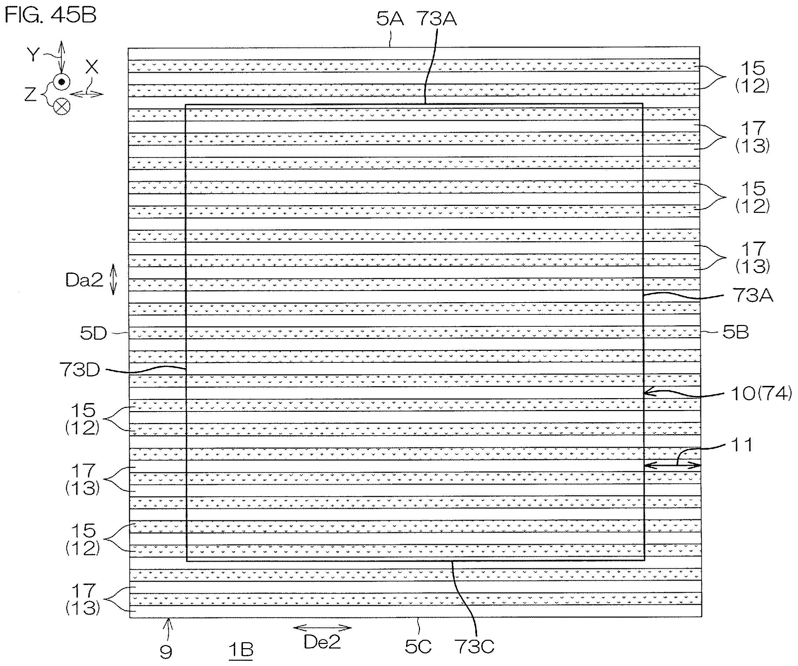

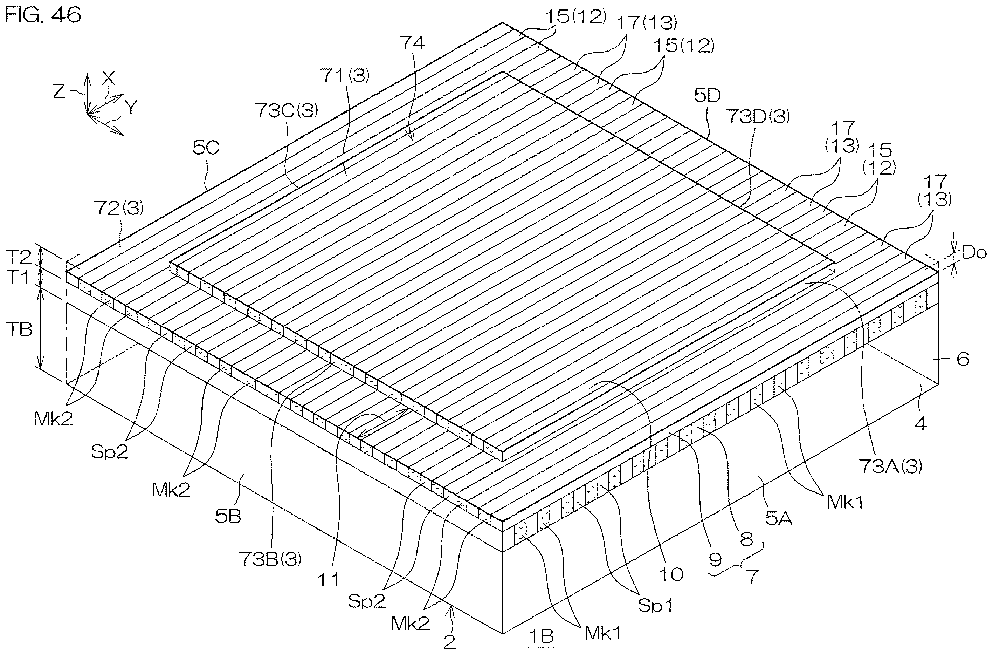

FIG. 43 is a plan view showing an SiC semiconductor device 1B according to a second embodiment. FIG. 44A is a cross-sectional view taken along line XLIVA-XLIVA in FIG. 43. FIG. 44B is a cross-sectional view taken along line XLIVB-XLIVB in FIG. 43. FIG. 45A is a plan view showing a layout example of the chip 2 (the first layer 8). FIG. 45B is a plan view showing a layout example of the chip 2 (the second layer 9). FIG. 46 is a perspective view showing the layout example of the chip 2.

With reference to FIGS. 43 to 46, as in the case of the SiC semiconductor device 1A, the SiC semiconductor device 1B includes the chip 2, the base layer 6, the laminated portion 7 (the first layer 8 and the second layer 9), the active region 10, and the outer peripheral region 11.

In this embodiment, the SiC semiconductor device 1B includes an active surface 71, an outer surface 72, and first to fourth connecting surfaces 73A to 73D that are formed in the first main surface 3. The active surface 71, the outer surface 72, and the first to fourth connecting surfaces 73A to 73D define an active mesa 74 in the first main surface 3.

The active surface 71 may be referred to as a "first surface portion," the outer surface 72 may be referred to as a "second surface portion," the first to fourth connecting surfaces 73A to 73D may be referred to as "connecting surface portions," and the active mesa 74 may be referred to as a "mesa portion." The active surface 71, the outer surface 72, and the first to fourth connecting surfaces 73A to 73D (that is, the active mesa 74) may be considered as components of the chip 2 (the first main surface 3).

The active surface 71 is formed in the active region 10. That is, the active surface 71 is formed at an interval inward from the peripheral edges (the first to fourth side surfaces 5A to 5D) of the first main surface 3. The active surface 71 has a flat surface extending in the first direction X and the second direction Y. In this embodiment, the active surface 71 is formed of the c-plane (an Si surface). In this embodiment, the active surface 71 is formed in a quadrangular shape having four sides parallel to the first to fourth side surfaces 5A to 5D in plan view.

The outer surface 72 is formed in the outer peripheral region 11. That is, the outer surface 72 is formed outside the active surface 71. The outer surface 72 is recessed in the thickness direction (toward the second main surface 4 side) of the chip 2 with respect to the active surface 71. Specifically, in this embodiment, the outer surface 72 is recessed at a depth less than the thickness of the second layer 9 such as to expose the second layer 9. The outer surface 72 extends as a band along the active surface 71 in plan view and is formed in an annular shape (specifically, a quadrangular annular shape) surrounding the active surface 71.

The outer surface 72 has a flat surface extending in the first direction X and the second direction Y and is formed substantially parallel to the active surface 71. In this embodiment, the outer surface 72 is formed of the c-plane (the Si surface). The outer surface 72 is continuous to the first to fourth side surfaces 5A to 5D. The outer surface 72 has an outer depth DO.

The outer depth DO may be not less than 0.1 µm and not more than 2 µm. The outer depth DO may have a value falling within any one of ranges of not less than 0.1 µm and not more than 0.25 µm, not less than 0.25 µm and not more than 0.5 µm, not less than 0.5 µm and not more than 0.75 µm, not less than 0.75 µm and not more than 1 µm, not less than 1 µm and not more than 1.5 µm, and not less than 1.5 µm and not more than 2 µm. The outer depth DO is preferably not less than 0.1 µm and not more than 1.5 µm.

The first to fourth connecting surfaces 73A to 73D extend in the vertical direction Z and connect the active surface 71 and the outer surface 72. The first connecting surface 73A is positioned on the first side surface 5A side, the second connecting surface 73B is positioned on the second side surface 5B side, the third connecting surface 73C is positioned on the third side surface 5C side, and the fourth connecting surface 73D is positioned on the fourth side surface 5D side. The first connecting surface 73A and the third connecting surface 73C extend in the first direction X and oppose each other in the second direction Y. The second connecting surface 73B and the fourth connecting surface 73D extend in the second direction Y and oppose each other in the first direction X.

The first to fourth connecting surfaces 73A to 73D may extend substantially vertically between the active surface 71 and the outer surface 72 such as to define the active mesa 74 having a quadrangular column shape. The first to fourth connecting surfaces 73A to 73D may be inclined obliquely downward from the active surface 71 toward the outer surface 72 such as to define the active mesa 74 having a quadrangular pyramid shape. In this manner, the active mesa 74 is defined in a projecting shape on the second layer 9 in the first main surface 3. The active mesa 74 is formed only on the second layer 9 and not on the first layer 8.

As in the case of the SiC semiconductor device 1A, the SiC semiconductor device 1B includes the ornamental pattern PT according to the first configuration example in the first to fourth side surfaces 5A to 5D. The ornamental pattern PT includes the plurality of first marks Mk1 and the plurality of second marks Mk2.

The plurality of first marks Mk1 and the plurality of second marks Mk2 are formed in the same mode as in the SiC semiconductor device 1A. The plurality of first marks Mk1 are preferably formed at intervals from the outer surface 72 to the lower end side of the first layer 8. Meanwhile, the plurality of second marks Mk2 are preferably exposed from the upper end of the outer surface 72. The plurality of second marks Mk2 may have a thickness less than the thickness of the plurality of first marks Mk1. As a matter of course, the plurality of second marks Mk2 may have a thickness of not less than the thickness of the plurality of first marks Mk1.

As a matter of course, the SiC semiconductor device 1B may include the ornamental patterns PT according to the second to fifth configuration examples. In a case where the ornamental pattern PT includes the first difference mark Md1 (see FIG. 6A, FIG. 6C, etc.), the first difference mark Md1 is preferably interposed in a region between the outer surface 72 and the plurality of first marks Mk1 and is exposed from the outer surface 72.

In a case where the ornamental pattern PT includes the second difference mark Md2 (see FIG. 6B, FIG. 6C, etc.), it is preferable that the second difference mark Md2 is formed at an interval from the outer surface 72 to the lower end side of the first layer 8 and opposes the outer surface 72 across the plurality of second marks Mk2.

The SiC semiconductor device 1B includes the p-type column region 12 formed in the laminated portion 7 in the active region 10. The column region 12 is formed in the same layout as that in the case of the SiC semiconductor device 1A. That is, the plurality of first regions 14 are formed in the first layer 8 in the same layout as the plurality of first regions 14 according to the SiC semiconductor device 1A and define the plurality of first drift regions 16. Also, the plurality of second regions 15 are formed in the second layer 9 in the same layout as the plurality of second regions 15 according to the SiC semiconductor device 1A and define the plurality of second drift regions 17.

The column region 12 may have at least one of the plurality of features described in the first to twelfth configuration examples. The column region 12 may have a feature obtained by combining the plurality of (not less than two) features described in the first to twelfth configuration examples described above.

Each of the plurality of first regions 14 is formed in a region surrounded by peripheral edges (the first to fourth connecting surfaces 73A to 73D) of the active surface 71 in plan view. In this embodiment, the plurality of first regions 14 are led out from the active region 10 to the outer peripheral region 11 by crossing a region directly below the first to fourth connecting surfaces 73A to 73D (see FIG. 45A).

That is, the plurality of first regions 14 are led out from a portion of the first layer 8 that opposes the active surface 71 to a portion of the first layer 8 that opposes the outer surface 72. The plurality of first regions 14 are arrayed at intervals in the first array direction Da1 also in the outer peripheral region 11 and are each formed as a band extending in the first extension direction De1. The plurality of first regions 14 are formed at intervals from the outer surface 72 toward the lower end side of the first layer 8 in the outer peripheral region 11 and oppose the outer surface 72 across the second layer 9.

Further, the plurality of first regions 14 extend from the outer peripheral region 11 toward one or both (in this embodiment, both) of the first side surface 5A and the third side surface 5C and respectively have portions exposed from one or both (in this embodiment, both) of the first side surface 5A and the third side surface 5C. The portions of the plurality of first regions 14 exposed from the first side surface 5A form the plurality of first marks Mk1 in the first side surface 5A, and the portions of the plurality of first regions 14 exposed from the third side surface 5C form the plurality of first marks Mk1 in the third side surface 5C.

Each of the plurality of second regions 15 is formed in a region surrounded by the peripheral edges (the first to fourth connecting surfaces 73A to 73D) of the active surface 71 in plan view. In this embodiment, the plurality of second regions 15 are led out from a portion of the second layer 9 that is positioned in the active region 10 to a portion of the second layer 9 that is positioned in the outer peripheral region 11.

A portion of each of the plurality of second regions 15 that is positioned in the outer peripheral region 11 may have a thickness less than the thickness of the plurality of first regions 14. As a matter of course, a portion of each of the plurality of second regions 15 that is positioned in the outer peripheral region 11 may have a thickness of not less than the thickness of the plurality of first regions 14. The second lower end portions 15a of the plurality of second regions 15 are positioned in regions closer to the lower end of the second layer 9 than the depth position of the outer surface 72 in the thickness direction of the second layer 9. Also, the second upper end portions 15b of the plurality of second regions 15 are positioned in regions closer to the active surface 71 than the outer surface 72 in the thickness direction of the second layer 9.

Therefore, the plurality of second regions 15 are exposed from at least one connecting surface of the first to fourth connecting surfaces 73A to 73D orthogonal to the second extension direction De2. In this embodiment, the plurality of second regions 15 are exposed from both the second connecting surface 73B and the fourth connecting surface 73D.

As a matter of course, in a case where the first connecting surface 73A is formed along the second extension direction De2 from an intermediate portion of the second region 15, the second region 15 may be exposed from the entire region of the first connecting surface 73A. Also, in a case where the third connecting surface 73C is formed along the second extension direction De2 from the intermediate portion of the second region 15, the second region 15 may be exposed from the entire region of the third connecting surface 73C.

Also, in a case where the second extension direction De2 is orthogonal to the first connecting surface 73A and the third connecting surface 73C, the plurality of second regions 15 may be exposed from one or both of the first connecting surface 73A and the third connecting surface 73C. Also, in these cases, the second regions 15 may be exposed from the entire region of one or both of the second connecting surface 73B and the fourth connecting surface 73D.

The plurality of second regions 15 are arrayed at intervals in the second array direction Da2 also in the outer peripheral region 11 and are each formed as a band extending in the second extension direction De2. The plurality of second regions 15 are exposed from the outer surface 72 in the outer peripheral region 11.

Further, the plurality of second regions 15 extend from the outer peripheral region 11 toward one or both (in this embodiment, both) of the second side surface 5B and the fourth side surface 5D and respectively have portions exposed from one or both (in this embodiment, both) of the second side surface 5B and the fourth side surface 5D. The portions of the plurality of second regions 15 exposed from the second side surface 5B form the plurality of second marks Mk2 in the second side surface 5B, and the portions of the plurality of second regions 15 exposed from the fourth side surface 5D form the plurality of second marks Mk2 in the fourth side surface 5D.

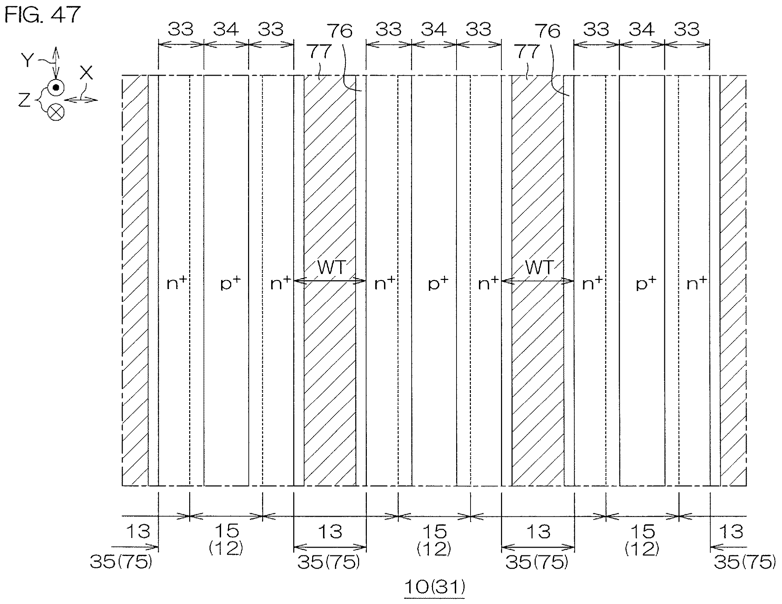

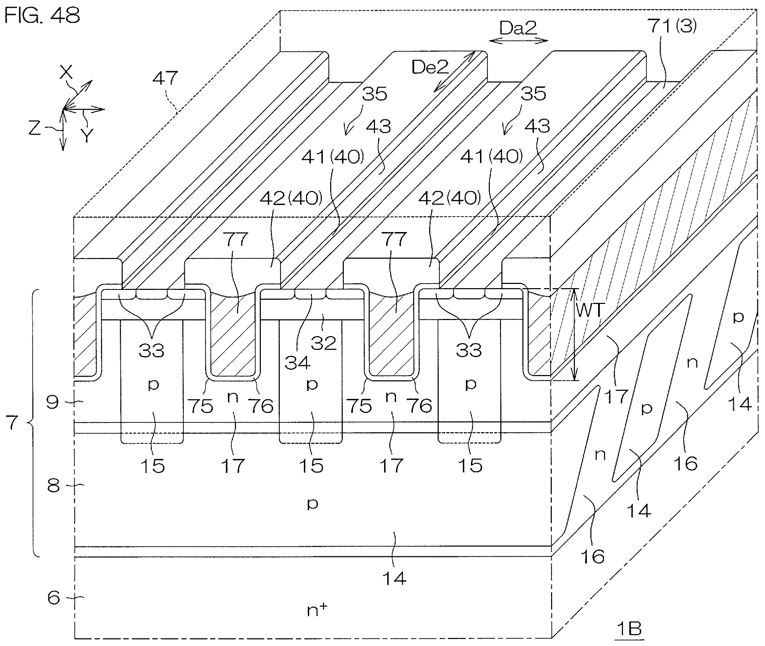

FIG. 47 is a plan view showing a main portion of the active region 10. FIG. 48 is a cross-sectional perspective view showing the gate structure 35 according to a first configuration example. With reference to FIGS. 47 and 48, the SiC semiconductor device 1B includes the MIS structure 31 formed in the active region 10. Although the following configurations will be described as components of the SiC semiconductor device 1B, the configurations are also components of the MIS structure 31.

The SiC semiconductor device 1B includes the p-type body region 32 formed in the surface layer portion of the first main surface 3 (the active surface 71). In this embodiment, the body region 32 is formed in a layer shape extending along the active surface 71. The body region 32 may be formed in the entire region of the active surface 71 and may be exposed from the first to fourth connecting surfaces 73A to 73D.

The body region 32 is formed at an interval from the lower end of the second layer 9 toward the active surface 71 side and overlaps the column region 12 (the plurality of second regions 15) in the lamination direction. It is preferable that the body region 32 is formed at an interval from the depth position of the outer surface 72 toward the active surface 71 side and is exposed from the first main surface 3. In a case where the plurality of second regions 15 are formed at intervals from the first main surface 3, the body regions 32 are formed in regions between the active surface 71 and the second upper end portions 15b of the plurality of second regions 15. The body regions 32 are preferably connected to the plurality of second regions 15 (the second upper end portions 15b).

The body regions 32 are constituted of random impurity regions introduced into the surface layer portion of the second layer 9 by the random implantation method with respect to the second layer 9 (see also FIG. 14). Therefore, the body region 32 has a thickness less than the second region thickness TR2 of the second region 15 in the direction along the second axis channel CH2. The thickness of the body region 32 is less than the first region thickness TR1 of the first region 14.

Unlike the second region 15, etc., the body region 32 does not have the gentle gradient portion 22 having a thickness of not less than 0.5 µm and has the concentration gradient including the gradual increase portion 20, the peak portion 21, and the gradual decrease portion 23 in a range of 0.5 µm. The body region 32 may have a p-type impurity concentration of not less than 1 × 10¹⁵ cm⁻³ and not more than 1 × 10¹⁸ cm⁻³ as a peak value.

The p-type impurity concentration of the body region 32 is preferably adjusted by at least one type of trivalent element. The trivalent element of the body region 32 may be the same type as the trivalent element of the second region 15, etc., or may be a type different from the trivalent element of the second region 15, etc. The trivalent element of the body region 32 may be at least one type among boron, aluminum, gallium, and indium. As a matter of course, the body region 32 may be formed using a part of the p-type top layer 30.

The SiC semiconductor device 1B includes a plurality of the gate structures 35 of a trench electrode type formed on the first main surface 3 (the active surface 71) in the active region 10. The gate structure 35 may be referred to as a "trench gate structure." A gate potential as a control potential is applied to the plurality of gate structures 35. The plurality of gate structures 35 control inversion and non-inversion of a channel (a current path) in the body region 32 in response to the gate potential.

The plurality of gate structures 35 are arranged at intervals inward from the peripheral edges (the first to fourth connecting surfaces 73A to 73D) of the active surface 71 in the active region 10. In this embodiment, the plurality of gate structures 35 are arrayed at intervals in the second array direction Da2 and are each formed as a band extending in the second extension direction De2. That is, in this embodiment, the plurality of gate structures 35 are arrayed as stripes extending along the plurality of second regions 15 and intersect the plurality of first regions 14 and the plurality of first drift regions 16 in the lamination direction.

In this example, the second array direction Da2 is the m-axis direction (the second direction Y), and the second extension direction De2 is the a-axis direction (the first direction X). As a matter of course, the array direction and the extension direction of the plurality of gate structures 35 are changed in accordance with the second array direction Da2 and the second extension direction De2 of the plurality of second regions 15. Therefore, the second array direction Da2 may be the a-axis direction, and the second extension direction De2 may be the m-axis direction. Also, the second array direction Da2 may be a direction other than the a-axis direction and the m-axis direction, and the second extension direction De2 may be a direction other than the a-axis direction and the m-axis direction.

In this embodiment, the plurality of gate structures 35 are arranged shifted from the plurality of second regions 15 toward the plurality of second drift regions 17 side. Specifically, the plurality of gate structures 35 penetrate the body regions 32 at intervals from the plurality of second regions 15 and are arranged in the plurality of second drift regions 17 in a one-to-one correspondence relationship. That is, the plurality of gate structures 35 and the plurality of second regions 15 are alternately arrayed along the second array direction Da2, and the plurality of gate structures 35 oppose the plurality of second regions 15 in the horizontal direction.

The plurality of gate structures 35 are formed at intervals from lower ends of the plurality of second drift regions 17 toward the active surface 71 side and oppose the plurality of first regions 14 and the plurality of first drift regions 16 across parts of the plurality of second drift regions 17. The plurality of gate structures 35 are preferably formed at intervals from the thickness range intermediate portions of the plurality of second regions 15 toward the active surface 71 side. As a matter of course, the plurality of gate structures 35 may be formed at depth positions such as to cross the thickness range intermediate portions of the plurality of second regions 15.

Each of the gate structures 35 has a trench width WT in an array direction (the second direction Y in this embodiment) and a trench depth DT in the vertical direction Z. The trench width WT is less than the second pitch P2 (the first pitch P1). The trench depth DT is less than the second thickness T2 of the second layer 9. The trench depth DT is preferably substantially equal to the outer depth DO described above. As a matter of course, the trench depth DT may be not less than the outer depth DO or may be less than the outer depth DO.

The trench width WT may be not less than 0.1 µm and not more than 5 µm. The trench width WT may have a value falling within any one of ranges of not less than 0.1 µm and not more than 0.25 µm, not less than 0.25 µm and not more than 0.5 µm, not less than 0.5 µm and not more than 0.75 µm, not less than 0.75 µm and not more than 1 µm, not less than 1 µm and not more than 1.5 µm, not less than 1.5 µm and not more than 2 µm, not less than 2 µm and not more than 2.5 µm, not less than 2.5 µm and not more than 3 µm, not less than 3 µm and not more than 3.5 µm, not less than 3.5 µm and not more than 4 µm, not less than 4 µm and not more than 4.5 µm, and not less than 4.5 µm and not more than 5 µm.

The trench depth DT may be not less than 0.1 µm and not more than 5 µm. The trench depth DT may have a value falling within any one of ranges of not less than 0.1 µm and not more than 0.25 µm, not less than 0.25 µm and not more than 0.5 µm, not less than 0.5 µm and not more than 1 µm, not less than 1 µm and not more than 1.5 µm, not less than 1.5 µm and not more than 2 µm, not less than 2 µm and not more than 3 µm, not less than 3 µm and not more than 4 µm, and not less than 4 µm and not more than 5 µm. The trench depth DT is preferably not less than 0.1 µm and not more than 1.5 µm.

Each of the gate structures 35 includes a trench 75, an insulating film 76, and an embedded electrode 77. The trench 75 is formed in the active surface 71 and defines a wall surface of the gate structure 35. The insulating film 76 covers the wall surface of the trench 75. The insulating film 76 may include at least one of a silicon oxide film, a silicon nitride film, and a silicon oxynitride film.

In this embodiment, the insulating film 76 has a single layer structure constituted of the silicon oxide film. The insulating film 76 particularly preferably includes the silicon oxide film constituted of the oxide of the chip 2. The embedded electrode 77 is embedded in the trench 75 across the insulating film 76 and opposes a channel across the insulating film 76. The embedded electrode 77 may include p-type or n-type conductive polysilicon.

The SiC semiconductor device 1B includes a plurality of source regions 33 formed on both sides of the plurality of gate structures 35 in the surface layer portion of the first main surface 3 (the active surface 71). The plurality of source regions 33 are formed in surface layer portions of body regions 32. The plurality of source regions 33 have an n-type impurity concentration (a peak value) higher than that of the second layer 9 (the second drift regions 17). The plurality of source regions 33 may have an n-type impurity concentration of not less than 1 × 10¹⁸ cm⁻³ and not more than 1 × 10²¹ cm⁻³ as a peak value.

The plurality of source regions 33 extend as a band along the corresponding gate structures 35 in plan view. The plurality of source regions 33 are formed at intervals from bottom portions of the body regions 32 toward the active surface 71 side and oppose the second drift regions 17 across parts of the body regions 32 in the lamination direction. The plurality of source regions 33 define, together with the plurality of second drift regions 17 positioned directly below the source regions 33, the channels (current paths) extending along the wall surfaces of the corresponding gate structures 35.

The plurality of source regions 33 may oppose the second regions 15 across parts of the body regions 32 in the lamination direction. As a matter of course, the plurality of source regions 33 may be formed at intervals from the second regions 15 toward the second drift regions 17 side (the gate structures 35 side) such as not to oppose the second regions 15 in the lamination direction.

The SiC semiconductor device 1A includes the plurality of contact regions 34 formed in regions between the plurality of gate structures 35 in the surface layer portion of the first main surface 3 (the active surface 71). The plurality of contact regions 34 are formed in surface layer portions of body regions 32.

The plurality of contact regions 34 have a p-type impurity concentration (a peak value) higher than the p-type impurity concentration (the peak value) of the plurality of body regions 32. The p-type impurity concentration (the peak value) of the plurality of contact regions 34 is higher than the p-type impurity concentration (the peak value) of the plurality of second regions 15. The plurality of contact regions 34 may have a p-type impurity concentration of not less than 1 × 10¹⁸ cm⁻³ and not more than 1 × 10²¹ cm⁻³ as a peak value.

The plurality of contact regions 34 are interposed in regions between the plurality of source regions 33 adjacent to each other and each extend as a band along the plurality of gate structures 35. The plurality of contact regions 34 are formed at intervals from the bottom portions of the body regions 32 toward active surface 71 side and oppose the plurality of second regions 15 across parts of the body regions 32 in the lamination direction.

The plurality of contact regions 34 may oppose the second drift regions 17 across parts of the body regions 32 in the lamination direction. As a matter of course, the plurality of contact regions 34 may be formed at intervals from the second drift regions 17 toward the second regions 15 side such as not to oppose the second drift regions 17 in the lamination direction.

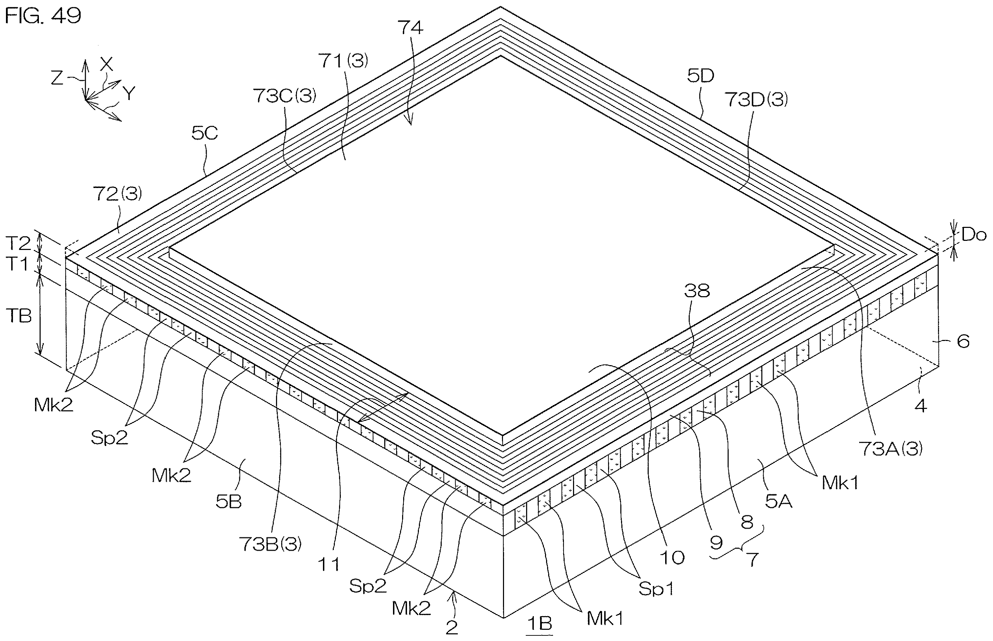

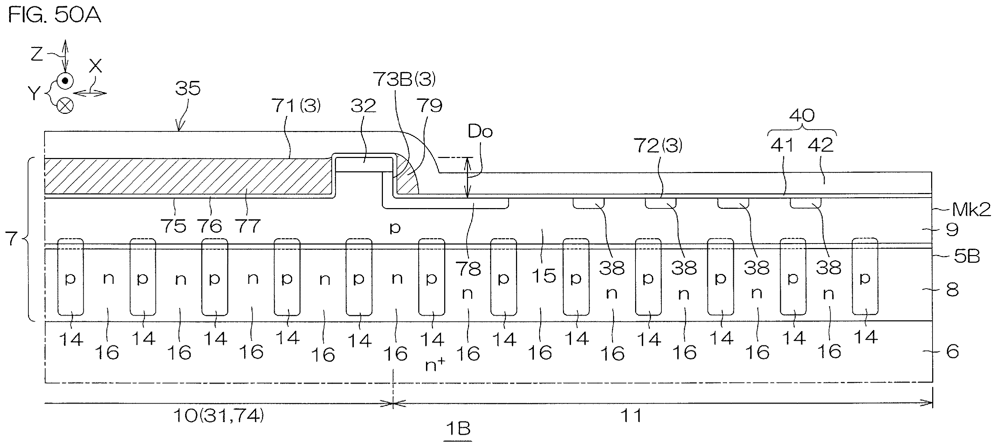

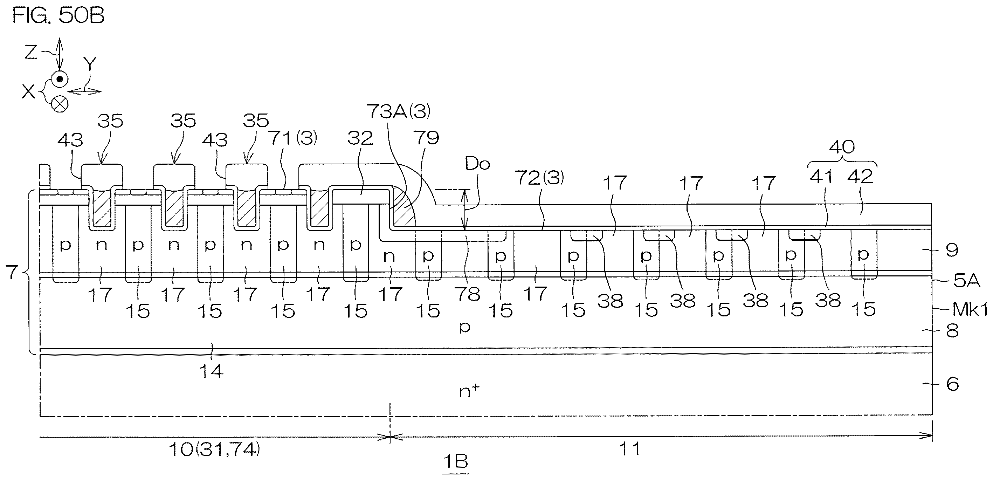

Hereinafter, a configuration on the outer peripheral region 11 side will be described. FIG. 49 is a perspective view showing a configuration of the outer peripheral region 11. FIG. 50A is a cross-sectional view showing a main portion of the outer peripheral region 11 in the first direction X. FIG. 50B is a cross-sectional view showing the main portion of the outer peripheral region 11 in the second direction Y. In FIG. 49, illustration of the column region 12 is omitted.

The SiC semiconductor device 1B includes a well region 78 of the p-type formed in the surface layer portion of the outer surface 72. The well region 78 is formed at an interval from the peripheral edges (the first to fourth side surfaces 5A to 5D) of the outer surface 72 toward the active surface 71 side and extends as a band along the active surface 71 in plan view. In this embodiment, the well region 78 is formed in an annular shape (specifically, a quadrangular annular shape) surrounding the active surface 71 in plan view. The well region 78 is led out from the surface layer portion of the outer surface 72 toward the first to fourth connecting surfaces 73A to 73D side and extends along the surface layer portions of the first to fourth connecting surfaces 73A to 73D.

The well region 78 is electrically connected to the body regions 32 in the surface layer portion of the active surface 71 and is electrically connected to the plurality of second regions 15 in the first to fourth connecting surfaces 73A to 73D. The well region 78 is formed at an interval from the lower end of the second layer 9 toward the outer surface 72 side and opposes the first layer 8 across a part of the second layer 9.

A bottom portion of the well region 78 is positioned closer to the lower end side of the second layer 9 than the bottom wall of the gate structure 35. The bottom portion of the well region 78 is preferably positioned on the outer surface 72 side with respect to the second lower end portions 15a of the plurality of second regions 15. The bottom portion of the well region 78 is particularly preferably positioned on the outer surface 72 side with respect to the thickness range intermediate portions of the plurality of second regions 15.

The well region 78 is constituted of a random impurity region introduced into the surface layer portion of the second layer 9 by the random implantation method with respect to the second layer 9 (see also FIG. 14). Therefore, the well region 78 has a thickness less than the second region thickness TR2 of the second region 15 in the direction along the second axis channel CH2. The thickness of the well region 78 is less than the first region thickness TR1 of the first region 14.

Unlike the second region 15, etc., the well region 78 does not have the gentle gradient portion 22 having a thickness of not less than 0.5 µm and has the concentration gradient including the gradual increase portion 20, the peak portion 21, and the gradual decrease portion 23 in a range of 0.5 µm. The well region 78 may have a p-type impurity concentration of not less than 1 × 10¹⁵ cm⁻³ and not more than 1 × 10¹⁸ cm⁻³ as a peak value.

The well region 78 has a p-type impurity concentration lower than the p-type impurity concentration of the contact regions 34. The p-type impurity concentration of the well region 78 is higher than the p-type impurity concentration of the body regions 32. As a matter of course, the p-type impurity concentration of the well region 78 may be lower than that of the body regions 32. The well region 78 forms a pn-junction portion with the second layer 9.

The p-type impurity concentration of the well region 78 is preferably adjusted by at least one type of trivalent element. The trivalent element of the well region 78 may be the same type as the trivalent element of the second region 15, etc., or may be a type different from the trivalent element of the second region 15, etc. The trivalent element of the well region 78 may be at least one type among boron, aluminum, gallium, and indium.

The SiC semiconductor device 1B includes the at least one (preferably, not less than two and not more than twenty) p-type field region 38 formed in the surface layer portion of the outer surface 72 in the outer peripheral region 11. The plurality of field regions 38 are formed in the surface layer portion of the outer surface 72 in the same mode as in the case of the SiC semiconductor device 1A.

In this embodiment, the plurality of field regions 38 are arrayed at intervals from the peripheral edges (the first to fourth connecting surfaces 73A to 73D) of the active surface 71 and the peripheral edges (the first to fourth side surfaces 5A to 5D) of the chip 2. Specifically, the plurality of field regions 38 are arrayed at intervals from the well region 78 toward the peripheral edge sides of the outer surface 72. Each of the plurality of field regions 38 extends as a band along the active surface 71 and is formed in an annular shape (specifically, a quadrangular annular shape) surrounding the active surface 71 in plan view.

In this embodiment, the plurality of field regions 38 overlap the column region 12 in the lamination direction in the outer surface 72. That is, the plurality of field regions 38 are formed in regions above the plurality of intersection portions of the plurality of first regions 14 and the plurality of second regions 15. The plurality of field regions 38 intersect the plurality of second regions 15 in portions extending in the first extension direction De1 and intersect the plurality of first regions 14 in portions extending in the second extension direction De2 in plan view.

The plurality of field regions 38 are formed at an interval from the bottom portion of the second layer 9 toward the outer surface 72 side and oppose the first layer 8 across a part of the second layer 9. The plurality of field regions 38 are positioned closer to the lower end side of the second layer 9 than the bottom portions of the gate structures 35.

The bottom portions of the plurality of field regions 38 are preferably positioned on the side of the outer surface 72 with respect to the thickness range intermediate portions of the second regions 15. The plurality of field regions 38 may be connected to the plurality of second regions 15 in the portions extending along the second extension direction De2. As a matter of course, the plurality of field regions 38 may be formed at intervals in the horizontal direction from the plurality of second regions 15 in the portions extending along the second extension direction De2 and are not necessarily be connected to the plurality of second regions 15.

The SiC semiconductor device 1B includes the above-described interlayer insulating film 40 that covers the first main surface 3. The interlayer insulating film 40 has a laminated structure including the first insulating film 41 and the second insulating film 42. In this embodiment, the first insulating film 41 selectively covers the active surface 71, the outer surface 72, and the first to fourth connecting surfaces 73A to 73D. The first insulating film 41 is connected to the insulating film 76 on the active surface 71 and exposes the embedded electrode 77.

On the outer surface 72, the first insulating film 41 covers the well region 78 and the plurality of field regions 38. In this embodiment, the first insulating film 41 is continuous to the first to fourth side surfaces 5A to 5D. Therefore, the first insulating film 41 covers the plurality of second marks Mk2 (the plurality of second regions 15) at the peripheral edges of the outer surface 72.

As a matter of course, the first insulating film 41 may be formed at an interval inward from the peripheral edges of the outer surface 72 and may expose the second layer 9 from the peripheral edge portions of the outer surface 72. In this case, the first insulating film 41 exposes the plurality of second marks Mk2 (the plurality of second regions 15) from the peripheral edges of the outer surface 72. The first insulating film 41 covers the well region 78 on the first to fourth connecting surfaces 73A to 73D.

In this embodiment, the second insulating film 42 selectively covers the active surface 71, the outer surface 72, and the first to fourth connecting surfaces 73A to 73D across the first insulating film 41. The second insulating film 42 covers the plurality of gate structures 35 in the active region 10. The second insulating film 42 covers the plurality of field regions 38 and the well region 78 across the first insulating film 41 in the outer peripheral region 11.

In this embodiment, the second insulating film 42 is continuous to the first to fourth side surfaces 5A to 5D. The second insulating film 42 may cover the plurality of second marks Mk2 (the plurality of second regions 15) across the first insulating film 41 at the peripheral edges of the outer surface 72. As a matter of course, the second insulating film 42 may be formed at an interval inward from the peripheral edges of the outer surface 72 and may expose the plurality of second marks Mk2 (the plurality of second regions 15) from the peripheral edges of the outer surface 72 together with the first insulating film 41.

The SiC semiconductor device 1A includes a plurality of contact openings 43 formed in the interlayer insulating film 40. The plurality of contact openings 43 include the plurality of contact openings 43 (not shown) that expose the plurality of gate structures 35 (the embedded electrodes 77) and the plurality of contact openings 43 that expose the plurality of source regions 33. The plurality of contact openings 43 for the source regions 33 are formed in regions between the plurality of adjacent gate structures 35 and expose the plurality of source regions 33 and the plurality of contact regions 34.

The SiC semiconductor device 1B includes a side wall structure 79 which is arranged in the interlayer insulating film 40 such as to cover at least one of the first to fourth connecting surfaces 73A to 73D. The side wall structure 79 is arranged on the first insulating film 41 and is covered with the second insulating film 42. The side wall structure 79 moderates a level difference formed between the active surface 71 and the outer surface 72.

The side wall structure 79 is formed as a band extending along at least one of the first to fourth connecting surfaces 73A to 73D. In this embodiment, the side wall structure 79 is formed in an annular shape (specifically, a quadrangular annular shape) extending along the first to fourth connecting surfaces 73A to 73D such as to surround the active surface 71 in plan view.

The side wall structure 79 has a portion extending in a film shape along the outer surface 72 and a portion extending in a film shape along the first to fourth connecting surfaces 73A to 73D. In this embodiment, the side wall structure 79 is formed at an interval from the innermost field region 38 to the side of the active surface 71 and opposes the plurality of second regions 15 and the well region 78 across the first insulating film 41 in the horizontal direction and the lamination direction. The side wall structure 79 may oppose the body region 32 across the first insulating film 41.

As in the case of the SiC semiconductor device 1A, the SiC semiconductor device 1B includes the gate pad 45, the plurality of gate wirings 46, the source pad 47, and the drain pad 48. The drain pad 48 is formed in a configuration as in the case of the first configuration example.

In this embodiment, the gate pad 45 is arranged on the active surface 71 at an interval from the outer surface 72 in plan view. The gate pad 45 is arranged in a region close to a central portion of one side (the second connecting surface 73B in this embodiment) of the active surface 71 in plan view. As a matter of course, the gate pad 45 may be arranged at a corner portion of the active surface 71 or at a central portion of the active surface 71 in plan view.

In this embodiment, the plurality of gate wirings 46 are arranged on the active surface 71 at intervals from the outer surface 72 in plan view. The plurality of gate wirings 46 include a first gate wiring 46A and a second gate wiring 46B.

The first gate wiring 46A is led out from the gate pad 45 toward the second connecting surface 73B side and extends linearly along the peripheral edges of the active surface 71 such as to intersect (specifically, to be orthogonal to) a part (specifically, one end portion) of each of the plurality of gate structures 35. The first gate wiring 46A penetrates the interlayer insulating film 40 through the plurality of contact openings 43 and is electrically connected to the one end portions of the plurality of gate structures 35 (the embedded electrodes 77).

The second gate wiring 46B is led out from the gate pad 45 toward the fourth connecting surface 73D side and extends linearly along the peripheral edges of the active surface 71 such as to intersect (specifically, to be orthogonal to) a part (specifically, the other end portion) of each of the plurality of gate structures 35. The second gate wiring 46B penetrates the interlayer insulating film 40 through the plurality of contact openings 43 and is electrically connected to the other end portions of the plurality of gate structures 35 (the embedded electrodes 77).

In this embodiment, the source pad 47 is arranged on the active surface 71 at an interval from the outer surface 72 in plan view. The source pad 47 penetrates the interlayer insulating film 40 through the plurality of contact openings 43 and is electrically connected to the body regions 32, the plurality of source regions 33, and the plurality of contact regions 34. That is, the source pad 47 is electrically connected to the column region 12 through the body region 32.

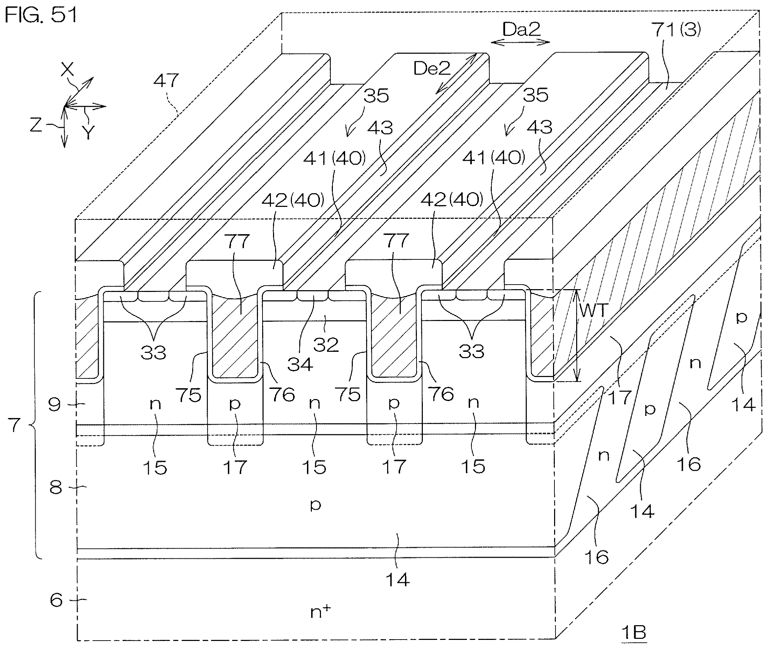

FIG. 51 is a cross-sectional perspective view showing the gate structure 35 according to a second configuration example. The plurality of gate structures 35 according to the first configuration example described above are arrayed by being shifted from the column region 12 (the plurality of second regions 15) toward the plurality of second drift regions 17 side. On the other hand, with reference to FIG. 51, the plurality of gate structures 35 according to the second configuration example are arrayed such as to overlap the plurality of second regions 15 in the lamination direction. The plurality of gate structures 35 overlap the plurality of second regions 15 in the lamination direction in a one-to-one correspondence relationship.

The plurality of gate structures 35 respectively have bottom walls connected to the corresponding second regions 15. Specifically, the plurality of gate structures 35 are formed to be wider than the corresponding second regions 15 and respectively have bottom walls connected to the corresponding second regions 15 and side walls connected to the corresponding second drift regions 17.

That is, the embedded electrode 77 opposes the corresponding second region 15 across the insulating film 76 in the lamination direction and opposes the corresponding second drift region 17 across the insulating film 76 in the horizontal direction. The plurality of source regions 33 and the plurality of contact regions 34 described above respectively oppose the corresponding second drift regions 17 across parts of the body regions 32 in the lamination direction.

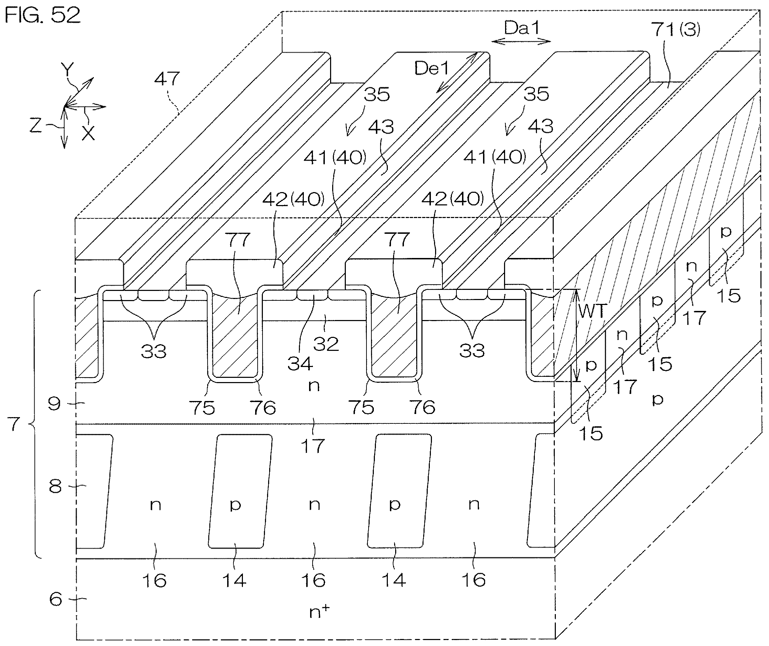

FIG. 52 is a cross-sectional perspective view showing the gate structure 35 according to a third configuration example. The plurality of gate structures 35 according to the third configuration example respectively have layouts in which there is no need to consider a positional deviation with respect to the plurality of second regions 15.

Specifically, with reference to FIG. 52, the plurality of gate structures 35 extend in a direction other than the second extension direction De2 such as to intersect the plurality of second regions 15. In this embodiment, the plurality of gate structures 35 are arrayed at intervals in the first array direction Da1 of the first regions 14 and extend in the first extension direction De1 of the first regions 14. In this example, the first array direction Da1 is the a-axis direction (the first direction X), and the first extension direction De1 is the m-axis direction (the second direction Y).

The plurality of gate structures 35 may oppose the plurality of first regions 14 in the lamination direction in a one-to-one correspondence relationship. As a matter of course, the respective gate structures 35 may oppose the plurality of first regions 14 in the lamination direction. The plurality of gate structures 35 may oppose the plurality of first drift regions 16 in the lamination direction in a one-to-one correspondence relationship.

As a matter of course, the respective gate structures 35 may oppose the plurality of first drift regions 16 in the lamination direction. The plurality of gate structures 35 may be arrayed shifted from the plurality of first regions 14 in the first array direction Da1 and may oppose one or both of the first region 14 and the first drift region 16 in the lamination direction.

As a matter of course, the array direction and the extension direction of the plurality of gate structures 35 are changed in accordance with the first array direction Da1 and the first extension direction De1 of the plurality of first regions 14. Therefore, the first array direction Da1 may be the m-axis direction, and the first extension direction De1 may be the a-axis direction. Also, the first array direction Da1 may be a direction other than the a-axis direction and the m-axis direction, and the first extension direction De1 may be a direction other than the a-axis direction and the m-axis direction.

As a matter of course, the array direction of the plurality of gate structures 35 may be a direction other than the first array direction Da1 and the second array direction D2. Also, the extension direction of the plurality of gate structures 35 may be a direction other than the first extension direction De1 and the second extension direction De2. That is, the plurality of gate structures 35 may intersect both the plurality of first regions 14 and the plurality of second regions 15 in plan view.

For example, an angle (an absolute value) between the extension direction of the gate structures 35 and the second extension direction De2 may exceed 0° and be not more than 90°. The angle (the absolute value) of the gate structures 35 may have a value falling within any one of ranges of exceeding 0° and not more than 18°, not less than 18° and not more than 36°, not less than 36° and not more than 54°, not less than 54° and not more than 72°, and not less than 72° and not more than 90°. The angle (the absolute value) of the gate structures 35 may be set to a value falling within any one of ranges of 30° ± 5°, 45° ± 5°, and 60° ± 5°.

In this embodiment, the embedded electrode 77 opposes the plurality of second regions 15 and the plurality of second drift regions 17 across the insulating film 76 in the lamination direction and the horizontal direction. In this embodiment, the plurality of source regions 33 and the plurality of contact regions 34 described above respectively oppose the plurality of second regions 15 and the plurality of second drift regions 17 across parts of the body regions 32 in the lamination direction.

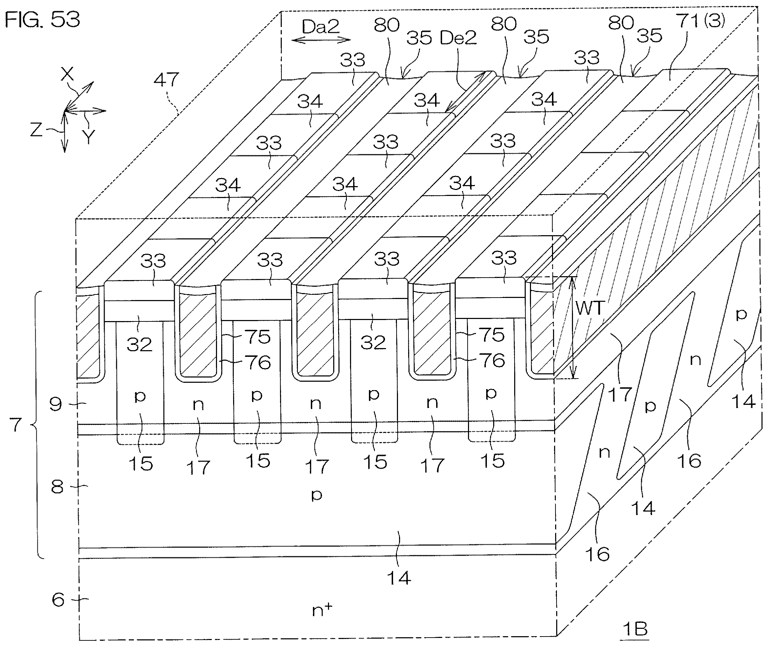

FIG. 53 is a cross-sectional perspective view showing the gate structure 35 according to a fourth configuration example. With reference to FIG. 53, the plurality of gate structures 35 according to the fourth configuration example respectively have configurations contributing to pitch reduction. The plurality of gate structures 35 according to the fourth configuration example are particularly effective in achieving the pitch reduction of the column region 12 (the plurality of second regions 15). FIG. 53 shows an example in which the gate structure 35 according to the first configuration example described above is replaced with the gate structure 35 according to the fourth configuration example, but the configuration of the gate structure 35 according to the fourth configuration example is also applicable to the configurations of the gate structures 35 according to the second and third configuration examples.

Each of the plurality of gate structures 35 includes the trench 75, the insulating film 76, the embedded electrode 77, and an embedded insulator 80. The trench 75 has a configuration as in the case of the first configuration example. In this embodiment, the insulating film 76 is formed at an interval from the first main surface 3 (the active surface 71) toward the bottom wall side of the trench 75 and exposes the surface layer portion of the first main surface 3 (the active surface 71) at an opening end of the trench 75. An upper end portion of the insulating film 76 is preferably positioned on the first main surface 3 side with respect to a depth range intermediate portion of the trench 75.

In this embodiment, the embedded electrode 77 is embedded in the trench 75 at an interval from the first main surface 3 (the active surface 71) toward the bottom wall side of the trench 75 and defines an opening recess recessed toward the bottom wall of the trench 75 at the opening end of the trench 75. The embedded electrode 77 exposes the surface layer portion of the first main surface 3 (the active surface 71) and the upper end portion of the insulating film 76 at the opening end of the trench 75. The upper end portion of the embedded electrode 77 is preferably positioned on the first main surface 3 side with respect to the depth range intermediate portion of the trench 75.

The embedded insulator 80 is embedded in the trench 75 (the opening recess) such as to expose the first main surface 3 (the active surface 71) and covers the insulating film 76 and the embedded electrode 77 in the trench 75. The embedded insulator 80 is embedded in the trench 75 at an interval from the first main surface 3 (the active surface 71) toward the embedded electrode 77 side and exposes the surface layer portion of the first main surface 3 (the active surface 71) at the opening end of the trench 75.

An upper end portion of the embedded insulator 80 is preferably positioned on the first main surface 3 side with respect to the depth range intermediate portion of the trench 75. The embedded insulator 80 may include at least one of a silicon oxide film, a silicon nitride film, and a silicon oxynitride film. The embedded insulator 80 preferably includes the silicon oxide film.

In this embodiment, the plurality of source regions 33 described above are respectively formed in regions between the plurality of gate structures 35 adjacent to each other in the surface layer portion of the first main surface 3 (the active surface 71). The plurality of source regions 33 are arrayed at intervals along the plurality of gate structures 35 such as to be connected to the plurality of gate structures 35 positioned on both sides.

Specifically, the plurality of source regions 33 on one side arrayed along a side wall of the gate structure 35 on one side oppose the plurality of source regions 33 on the other side by being arrayed along a side wall of the gate structure 35 on the other side in a one-to-one correspondence relationship. That is, the plurality of source regions 33 are arrayed in a matrix in plan view.

As a matter of course, the plurality of source regions 33 on one side may oppose regions between the plurality of source regions 33 on the other side in a one-to-one correspondence relationship. That is, the plurality of source regions 33 may be arrayed in a staggered arrangement in plan view. Each of the plurality of source regions 33 has a portion exposed from the side wall of the trench 75 at the opening end of the trench 75 and opposes the embedded electrode 77 and the embedded insulator 80 across the insulating film 76.

In this embodiment, the plurality of contact regions 34 described above are respectively formed in regions between the plurality of gate structures 35 adjacent to each other in the surface layer portion of the first main surface 3 (the active surface 71). The plurality of contact regions 34 are arrayed at intervals along the plurality of gate structures 35 such as to be connected to the plurality of gate structures 35 positioned on both sides.

Specifically, the plurality of contact regions 34 and the plurality of source regions 33 are alternately arrayed along the plurality of gate structures 35. More specifically, the plurality of contact regions 34 on one side arrayed along a side wall of the gate structure 35 on one side oppose the plurality of contact regions 34 on the other side arrayed along a side wall of the gate structure 35 on the other side in a one-to-one correspondence relationship. Also, the plurality of source regions 33 are arrayed in a matrix in plan view.

As a matter of course, the plurality of contact regions 34 on one side may oppose regions (that is, the plurality of source regions 33) between the plurality of source regions 33 on the other side in a one-to-one correspondence relationship. That is, the plurality of contact regions 34 may be arrayed in a staggered arrangement in plan view. Each of the plurality of contact regions 34 has a portion exposed from the side wall of the trench 75 at the opening end of the trench 75 and opposes the embedded electrode 77 and the embedded insulator 80 across the insulating film 76.

Although not specifically shown, the interlayer insulating film 40 described above has the laminated structure including the first insulating film 41 and the second insulating film 42. As in the case according to the first configuration example, the first insulating film 41 selectively covers the active surface 71, the outer surface 72, and the first to fourth connecting surfaces 73A to 73D.

In this embodiment, the first insulating film 41 covers the peripheral edge portions of the active surface 71 and collectively exposes the plurality of gate structures 35 in the inner portion of the active surface 71. Specifically, the first insulating film 41 is connected to the insulating film 76 at both end portions of each of the plurality of gate structures 35 and exposes the embedded electrode 77. Also, the first insulating film 41 covers the outer surface 72 and the first to fourth connecting surfaces 73A to 73D in the same mode as in the case of the first configuration example.

As in the case according to the first configuration example, the second insulating film 42 selectively covers the active surface 71, the outer surface 72, and the first to fourth connecting surfaces 73A to 73D across the first insulating film 41. In this embodiment, the second insulating film 42 covers the peripheral edge portions of the active surface 71 and collectively exposes the plurality of gate structures 35 in the inner portion of the active surface 71. Specifically, the second insulating film 42 enters into the trench 75 from above the first main surface 3 (the active surface 71) at both end portions of each of the plurality of gate structures 35 and is connected to the embedded insulator 80 in the trench 75.

In this embodiment, the interlayer insulating film 40 includes the plurality of contact openings 43 (not shown) that expose both end portions (the embedded electrodes 77) of each of the plurality of gate structures 35 and the single contact opening 43 that collectively exposes inner portions (the embedded insulators 80) of the plurality of gate structures 35, the plurality of source regions 33, and the plurality of contact regions 34.

The gate pad 45 described above, the plurality of gate wirings 46 described above, and the drain pad 48 described above have configurations as in the case of the first configuration example. The source pad 47 described above enters into the single contact opening 43 from above the interlayer insulating film 40 and collectively covers the inner portions (the embedded insulators 80) of the plurality of gate structures 35, the plurality of source regions 33, and the plurality of contact regions 34 in the single contact opening 43.

The source pad 47 is electrically insulated from the plurality of gate structures 35 (the embedded electrodes 77) by the embedded insulator 80 and is electrically connected to the plurality of source regions 33 and the plurality of contact regions 34 on the first main surface 3 (the active surface 71). The source pad 47 has an embedded portion embedded in the trench 75. The embedded portion of the source pad 47 opposes the embedded electrode 77 across the embedded insulator 80 in the trench 75 and is electrically connected to the plurality of source regions 33 and the plurality of contact regions 34 at the opening end of the trench 75.

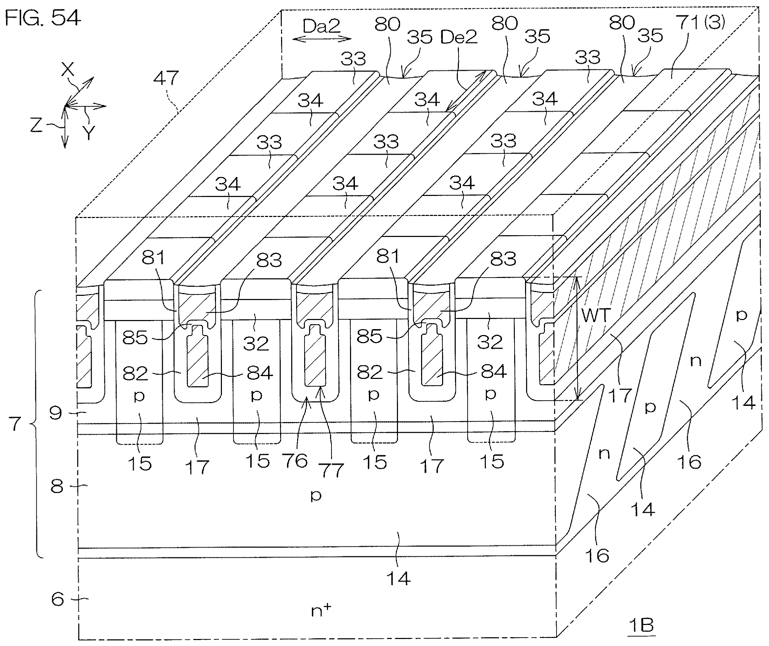

FIG. 54 is a cross-sectional perspective view showing the gate structure 35 according to a fifth configuration example. With reference to FIG. 54, the plurality of gate structures 35 according to the fifth configuration example respectively have configurations obtained by modifying the plurality of gate structures 35 according to the fourth configuration example. The configuration of the gate structures 35 according to the fifth configuration example are also applicable to the configurations of the gate structures 35 according to the first to third configuration examples.

Each of the plurality of gate structures 35 includes the trench 75, the insulating film 76, the embedded electrode 77, and an embedded insulator 80. The trench 75 has a configuration as in the case of the first configuration example. In this embodiment, the insulating film 76 includes an upper insulating film 81 and a lower insulating film 82.

The upper insulating film 81 is formed as an insulating film for controlling a channel and covers a wall surface of the trench 75 on the opening side with respect to the bottom portion of the body region 32. The upper insulating film 81 has a portion that crosses a boundary portion between the second drift region 17 and the body region 32 and covers the second drift region 17. In this case, a covering area of the upper insulating film 81 with respect to the body region 32 is preferably larger than a covering area of the upper insulating film 81 with respect to the second drift region 17.

The upper insulating film 81 may include a silicon oxide film. The upper insulating film 81 preferably includes the silicon oxide film constituted of the oxide of the chip 2. The upper insulating film 81 may have a thickness of not less than 1 nm and not more than 100 nm. The thickness of the upper insulating film 81 may have a value falling within any one of ranges of not less than 1 nm and not more than 25 nm, not less than 25 nm and not more than 50 nm, not less than 50 nm and not more than 75 nm, and not less than 75 nm and not more than 100 nm.

The lower insulating film 82 covers a wall surface of the trench 75 on the bottom wall side with respect to the bottom portion of the body region 32. The lower insulating film 82 covers the second drift region 17. A covering area of the lower insulating film 82 with respect to the second drift region 17 is larger than a covering area of the upper insulating film 81 with respect to the body region 32.

The lower insulating film 82 may include a silicon oxide film. The lower insulating film 82 may include a silicon oxide film constituted of the oxide of the chip 2 or may include a silicon oxide film formed by a CVD method. The lower insulating film 82 has a thickness larger than the thickness of the upper insulating film 81. The thickness of the lower insulating film 82 is preferably not less than ten times and not more than fifty times the thickness of the upper insulating film 81.

The lower insulating film 82 may have a thickness of not less than 100 nm and not more than 500 nm. The thickness of the lower insulating film 82 may have a value falling within any one of ranges of not less than 100 nm and not more than 150 nm, not less than 150 nm and not more than 200 nm, not less than 200 nm and not more than 250 nm, not less than 250 nm and not more than 300 nm, not less than 300 nm and not more than 350 nm, not less than 350 nm and not more than 400 nm, not less than 400 nm and not more than 450 nm, and not less than 450 nm and not more than 500 nm.

In this embodiment, the embedded electrode 77 has a multi-electrode structure (a double-electrode structure) including an upper electrode 83, a lower electrode 84, and an intermediate insulating film 85. The upper electrode 83 is embedded on the opening side of the trench 75 across the insulating film 76. Specifically, the upper electrode 83 is embedded on the opening side of the trench 75 across the upper insulating film 81 and opposes the body region 32 across the upper insulating film 81.

An opposing area of the upper electrode 83 with respect to the body region 32 is larger than an opposing area of the upper electrode 83 with respect to the second drift region 17. In this embodiment, the upper electrode 83 is embedded in the trench 75 at an interval from the first main surface 3 (the active surface 71) toward the bottom wall side of the trench 75 and defines an opening recess recessed toward the bottom wall of the trench 75 at the opening end of the trench 75. The upper electrode 83 exposes the surface layer portion of the first main surface 3 (the active surface 71) and the upper end portion of the upper insulating film 81 at the opening end of the trench 75.

The gate potential as a control potential is applied to the upper electrode 83. The upper electrode 83 controls inversion and non-inversion of a channel (a current path) in the body region 32 in response to a gate potential. The upper electrode 83 may include p-type or n-type conductive polysilicon.

The lower electrode 84 is embedded on the bottom wall side of the trench 75 across the insulating film 76. Specifically, the lower electrode 84 is embedded on the bottom wall side of the trench 75 across the lower insulating film 82 and opposes the second drift region 17 across the lower insulating film 82. That is, the lower electrode 84 is embedded on the bottom wall side of the trench 75 with respect to the bottom portion of the body region 32. Although not specifically shown, the lower electrode 84 is led out to the opening side of the trench 75 in a part (both end portions in this embodiment) of the trench 75.

An opposing area of the lower electrode 84 with respect to the second drift region 17 is larger than an opposing area of the upper electrode 83 with respect to the body region 32. The lower electrode 84 extends in a wall shape in a depth direction of the trench 75. The lower electrode 84 has an upper end portion projecting from the lower insulating film 82 toward the upper electrode 83 side and engages with a lower end portion of the upper electrode 83. The upper end portion of the lower electrode 84 opposes the upper insulating film 81 (the body region 32) across the lower end portion of the upper electrode 83 in the horizontal direction.

A gate potential or a source potential may be applied to lower electrode 84. In the case where the gate potential is applied to lower electrode 84, the lower electrode 84 has a potential equal to that of the upper electrode 83. Therefore, a voltage drop between the upper electrode 83 and the lower electrode 84 is prevented. Consequently, electric field concentration with respect to the gate structure 35 is prevented.

Meanwhile, in the case where the source potential is applied to the lower electrode 84, the lower electrode 84 can function as a field electrode. Therefore, parasitic capacitance between the lower electrode 84 (the field electrode) and the second layer 9 (the drift regions 13) is reduced. Consequently, a decrease in the switching speed caused by the parasitic capacitance is prevented. The lower electrode 84 may include p-type or n-type conductive polysilicon.

The intermediate insulating film 85 is interposed between the upper electrode 83 and the lower electrode 84 and electrically insulates the upper electrode 83 and the lower electrode 84 in the trench 75. The intermediate insulating film 85 is continuous with the upper insulating film 81 and the lower insulating film 82. The intermediate insulating film 85 has a thickness smaller than the thickness of the lower insulating film 82. The thickness of the intermediate insulating film 85 is preferably larger than the thickness of the upper insulating film 81. The intermediate insulating film 85 may include a silicon oxide film. The intermediate insulating film 85 preferably includes the silicon oxide film constituted of an oxide of the lower electrode 84.

The embedded insulator 80 is embedded in the trench 75 (the opening recess) such as to expose the first main surface 3 (the active surface 71) and covers the upper insulating film 81 and the upper electrode 83 in the recess. The embedded insulator 80 is embedded in the trench 75 at an interval from the first main surface 3 (the active surface 71) toward the upper electrode 83 side and exposes the surface layer portion of the first main surface 3 (the active surface 71) at the opening end of the trench 75.

In this embodiment, each of the plurality of source regions 33 described above has a portion exposed from the side wall of the trench 75 at the opening end of the trench 75 and opposes the upper electrode 83 and the embedded insulator 80 across the upper insulating film 81. In this embodiment, each of the plurality of contact regions 34 described above has a portion exposed from the side wall of the trench 75 at the opening end of the trench 75 and opposes the upper electrode 83 and the embedded insulator 80 across the upper insulating film 81.

The plurality of field regions 38 described above, the interlayer insulating film 40 described above, the gate pad 45, the plurality of gate wirings 46 described above, the source pad 47 described above, and the drain pad 48 described above have configurations as in the case of the second configuration example. In this embodiment, the plurality of gate wirings 46 penetrate the interlayer insulating film 40 through the plurality of contact openings 43 and are electrically connected to the plurality of upper electrodes 83. In the case where the gate potential is applied to the lower electrode 84, the plurality of gate wirings 46 penetrate the interlayer insulating film 40 through the plurality of contact openings 43 and are electrically connected to the plurality of upper electrodes 83 and the plurality of lower electrodes 84.

In the case where the source potential is applied to the lower electrode 84, the source pad 47 is electrically connected to the plurality of lower electrodes 84. In this case, the SiC semiconductor device 1B may include a source wiring led out from the source pad 47 onto the interlayer insulating film 40. In this case, the source wiring is formed in a line shape extending along the peripheral edges of the active surface 71 such as to intersect (specifically, to be orthogonal to) a part (one end portion or both end portions) of each of the plurality of gate structures 35 in a region outside the plurality of gate wirings 46. The source wiring penetrates the interlayer insulating film 40 through the plurality of contact openings 43 and is electrically connected to the plurality of lower electrodes 84.

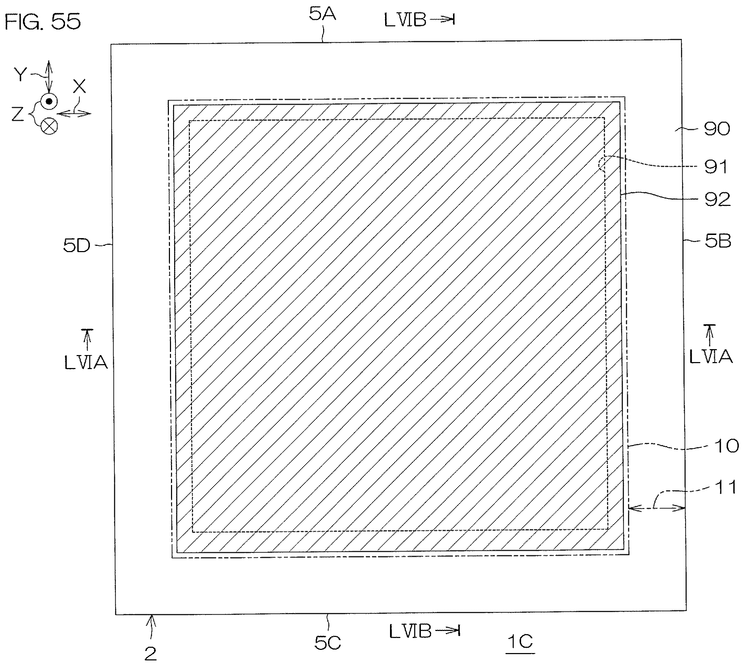

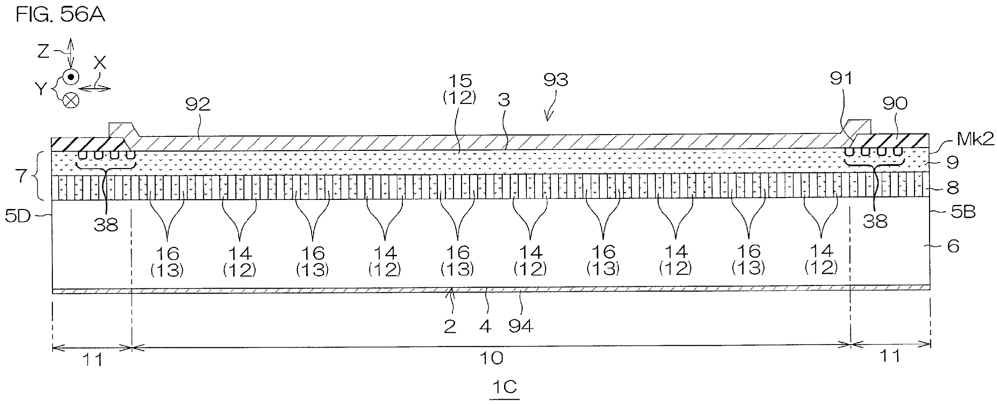

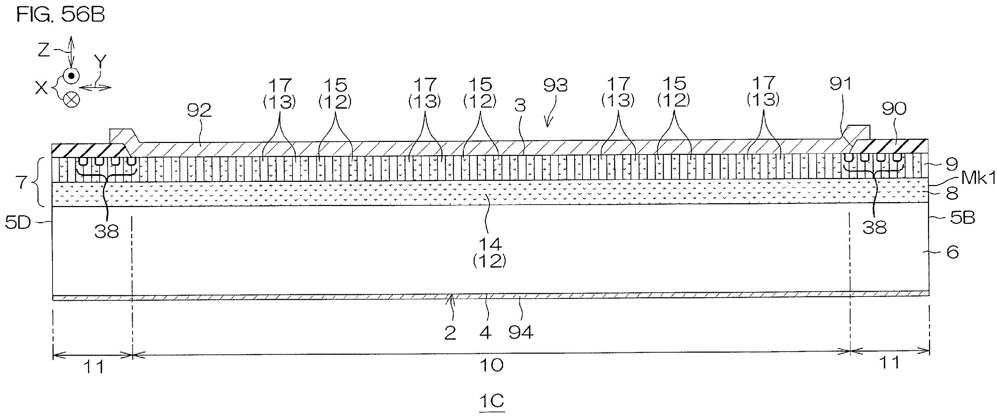

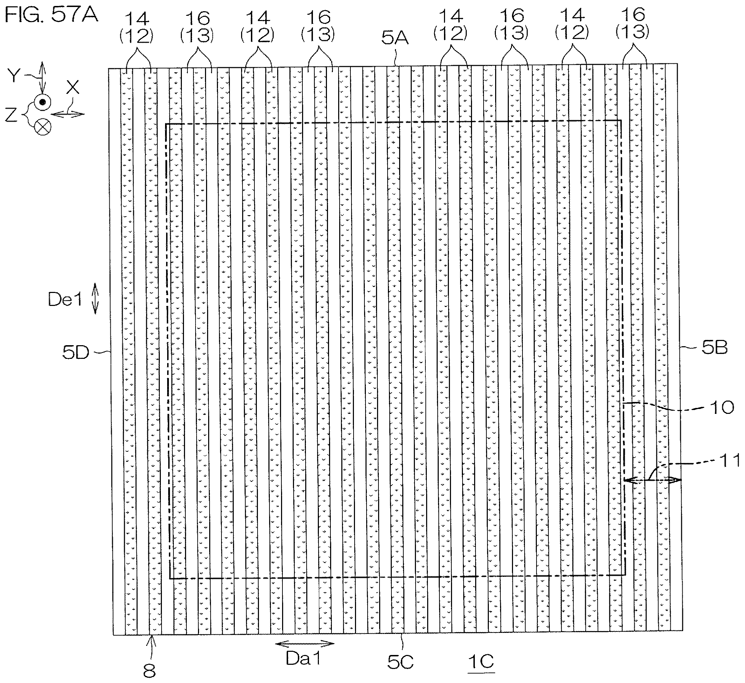

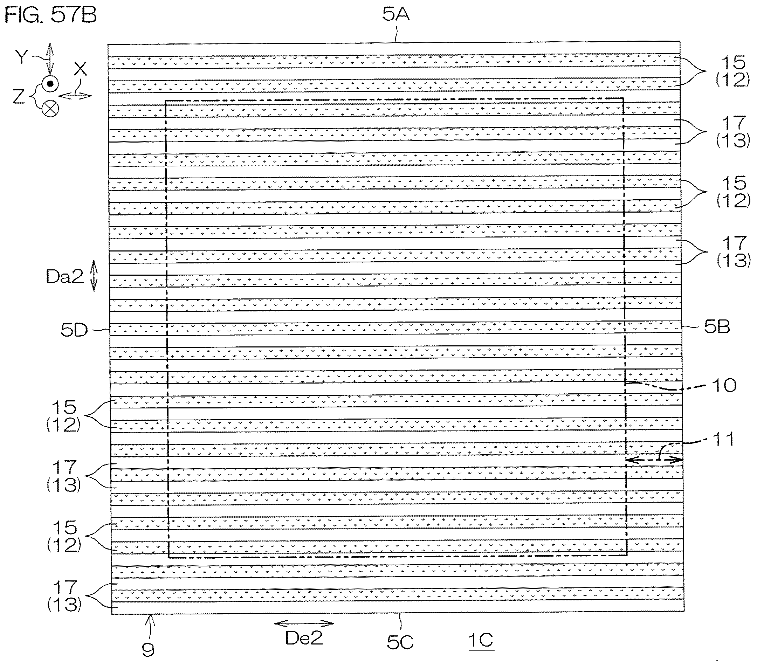

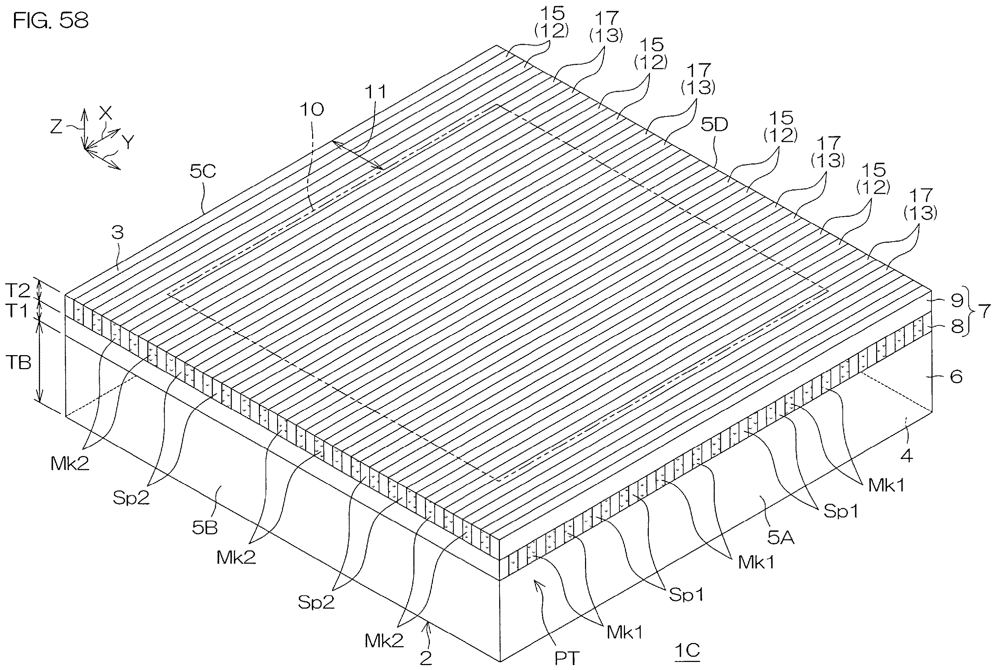

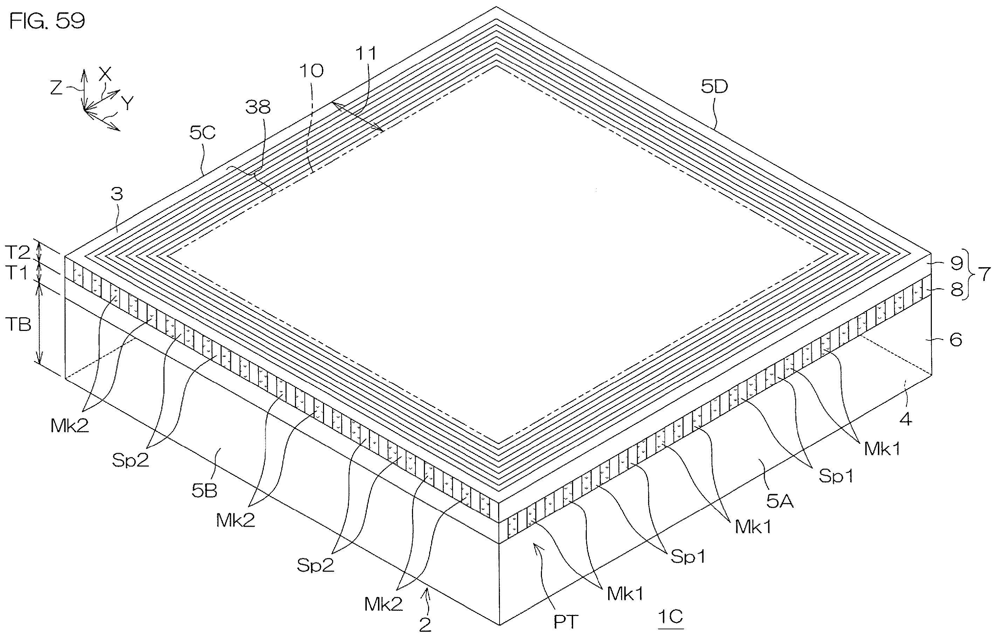

FIG. 55 is a plan view showing an SiC semiconductor device 1C according to a third embodiment. FIG. 56A is a cross-sectional view taken along line LVIA-LVIA in FIG. 55. FIG. 56B is a cross-sectional view taken along line LVIB-LVIB in FIG. 55. FIG. 57A is a plan view showing a layout example of the chip 2 (the first layer 8). FIG. 57B is a plan view showing a layout example of the chip 2 (the second layer 9). FIG. 58 is a perspective view showing the layout example of the chip 2. FIG. 59 is a perspective view showing a configuration of the outer peripheral region 11. In FIG. 59, illustration of the column region 12 is omitted.

With reference to FIGS. 55 to 59, as in the case of the SiC semiconductor device 1A, the SiC semiconductor device 1C includes the chip 2, the base layer 6, the laminated portion 7 (the first layer 8 and the second layer 9), the active region 10, the outer peripheral region 11, the column region 12, and the plurality of field regions 38, and the ornamental patterns PT.

The ornamental patterns PT may have at least one of the plurality of features described in the first to fifth configuration examples. The column region 12 may have at least one of the plurality of features described in the first to twelfth configuration examples described above. The column region 12 may have a feature obtained by combining the plurality of (not less than two) features described in the first to twelfth configuration examples described above.

The SiC semiconductor device 1C includes an interlayer insulating film 90 that selectively covers the first main surface 3. The interlayer insulating film 90 may have a single-layer structure or a laminated structure including at least one of a silicon oxide film, a silicon nitride film, and a silicon oxynitride film. In this embodiment, the interlayer insulating film 90 has a single layer structure including the silicon oxide film.

In the outer peripheral region 11, the interlayer insulating film 90 covers the plurality of field regions 38. In this embodiment, the interlayer insulating film 90 is continuous to the peripheral edges (the first to fourth side surfaces 5A to 5D) of the first main surface 3. As a matter of course, the interlayer insulating film 90 may be formed at an interval inward from the peripheral edges of the first main surface 3 and may expose the second layer 9 from the peripheral edge portions of the first main surface 3.

The interlayer insulating film 90 has a contact opening 91 that exposes the active region 10. In this embodiment, the contact opening 91 has an opening wall surface positioned on the innermost field region 38 and exposes the entire active region 10 and an inner edge portion of the innermost field region 38.

The SiC semiconductor device 1C includes a first pad electrode 92 that covers the first main surface 3 in the active region 10. The first pad electrode 92 is formed as an anode pad. The first pad electrode 92 is arranged at an interval inward from the peripheral edges of the chip 2. The first pad electrode 92 is formed in a polygonal shape (a quadrangular shape in this embodiment) along the peripheral edges of the chip 2 in plan view.

The first pad electrode 92 enters into the contact opening 91 from above the interlayer insulating film 90 and is electrically connected to the first main surface 3 and the innermost field region 38 in the contact opening 91. The first pad electrode 92 forms a Schottky junction with the first main surface 3 (the second layer 9). Consequently, an SBD structure 93 (Schottky barrier diode structure) as a diode structure (a device structural component) is formed in the active region 10.

The SiC semiconductor device 1C includes a second pad electrode 94 that covers the second main surface 4. The second pad electrode 94 is formed as a cathode pad. The second pad electrode 94 forms an ohmic contact with the base layer 6 exposed from the second main surface 4. That is, the second pad electrode 94 is electrically connected to the first layer 8 (the plurality of first drift regions 16) and the second layer 9 (the plurality of second drift regions 17) through the base layer 6.

The second pad electrode 94 may cover the entire region of the second main surface 4 such as to be continuous with the peripheral edges (the first to fourth side surfaces 5A to 5D) of the chip 2. The second pad electrode 94 may cover the second main surface 4 at an interval inward from the peripheral edges of the chip 2 such as to expose the peripheral edge portions of the chip 2.

A breakdown voltage that can be applied between the first pad electrode 92 and the second pad electrode 94 (between the first main surface 3 and the second main surface 4) may be 500 V and not more than 3000 V. The breakdown voltage may have a value falling within any one of ranges of 500 V and not more than 1000 V, not less than 1000 V and not more than 1500 V, not less than 1500 V and not more than 2000 V, not less than 2000 V and not more than 2500 V and not less than 2500 V and not more than 3000 V.

In a case where the laminated portion 7 having a two-layer structure is employed, the breakdown voltage is preferably set to a value falling within any one of ranges of not less than 500 V and not more than 1000 V, not less than 1000 V and not more than 1500 V, and not less than 1500 V and not more than 2000 V. In a case where the laminated portion 7 having a three-layer structure is employed, the breakdown voltage is preferably set to a value falling within any one of ranges of not less than 1000 V and not more than 1500 V, not less than 1500 V and not more than 2000 V, not less than 2000 V and not more than 2500 V, and not less than 2500 V and not more than 3000 V.

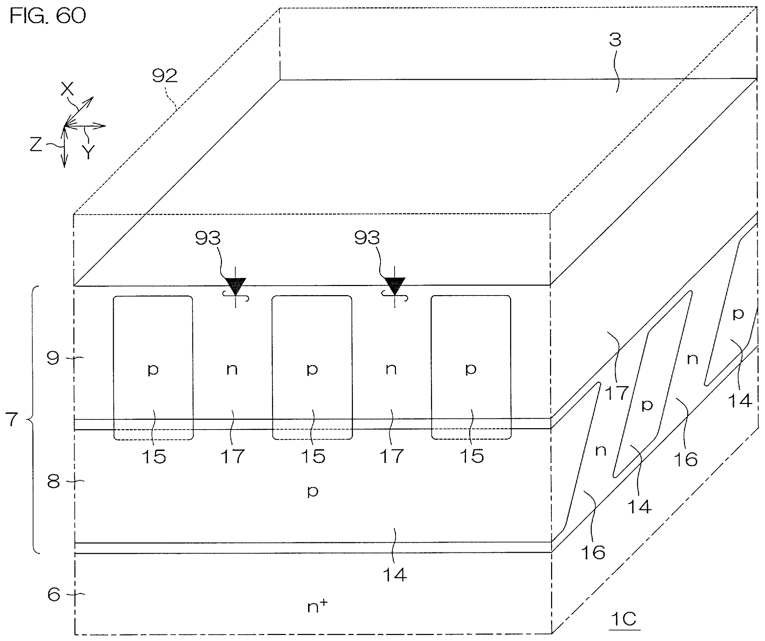

Hereinafter, first to fifth configuration examples of the SBD structure 93 will be described with reference to FIGS. 60 to 64. FIG. 60 is a cross-sectional perspective view showing the SBD structure 93 according to the first configuration example. With reference to FIG. 60, in a case where the second upper end portions 15b of the plurality of second regions 15 are formed at intervals from the first main surface 3 toward the lower end side of the second layer 9 (see also, for example, FIGS. 20 to 27, etc.), the first pad electrode 92 forms a Schottky junction with a portion of the second layer 9 interposed between the first main surface 3 and the second upper end portions 15b.

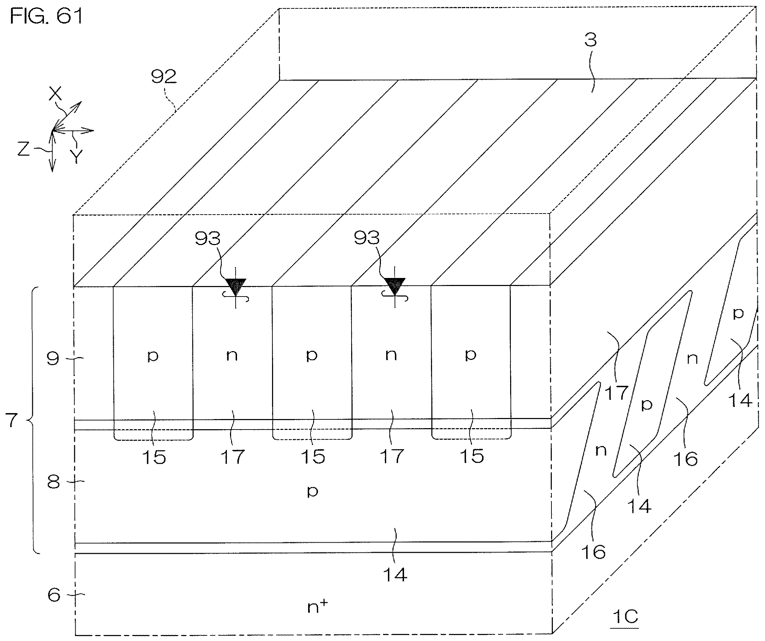

FIG. 61 is a cross-sectional perspective view showing the SBD structure 93 according to the second configuration example. With reference to FIG. 61, in a case where the plurality of second regions 15 and the plurality of second drift regions 17 are exposed from the first main surface 3 (see also, for example, FIG. 29, etc.), the first pad electrode 92 is mechanically and electrically connected to the plurality of second regions 15 and the plurality of second drift regions 17 on the first main surface 3. In this case, the first pad electrode 92 forms a JBS structure (Junction Barrier Controlled Schottky structure) with the plurality of second regions 15 and forms a Schottky junction with the plurality of second drift regions 17.

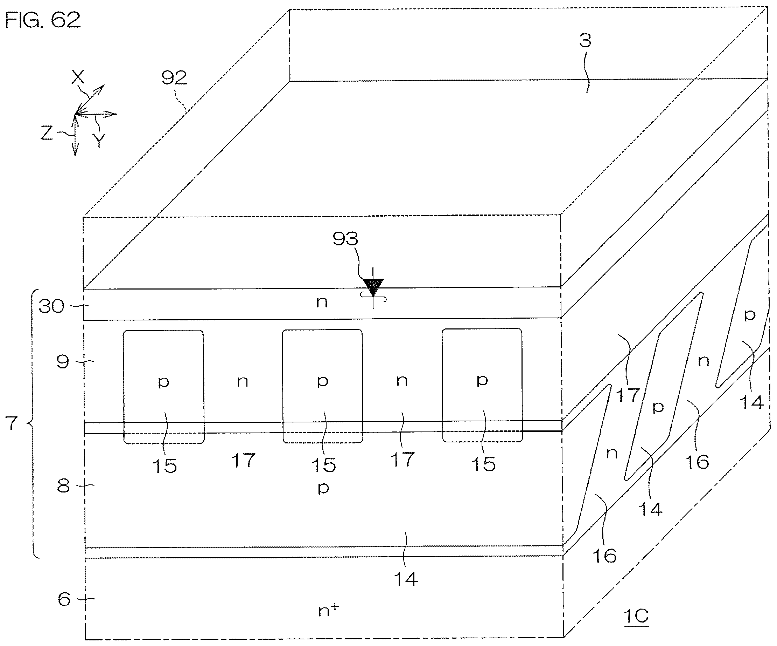

FIG. 62 is a cross-sectional perspective view showing the SBD structure 93 according to the third configuration example. With reference to FIG. 62, in a case where the laminated portion 7 includes the top layer 30 (see also FIG. 34, etc.), the first pad electrode 92 forms a Schottky junction with the top layer 30 (the first main surface 3). As a matter of course, in a case where a sufficient space is formed between the first main surface 3 and the column region 12 in the second layer 9 in a state in which the top layer 30 is not formed, the top layer 30 may be omitted.

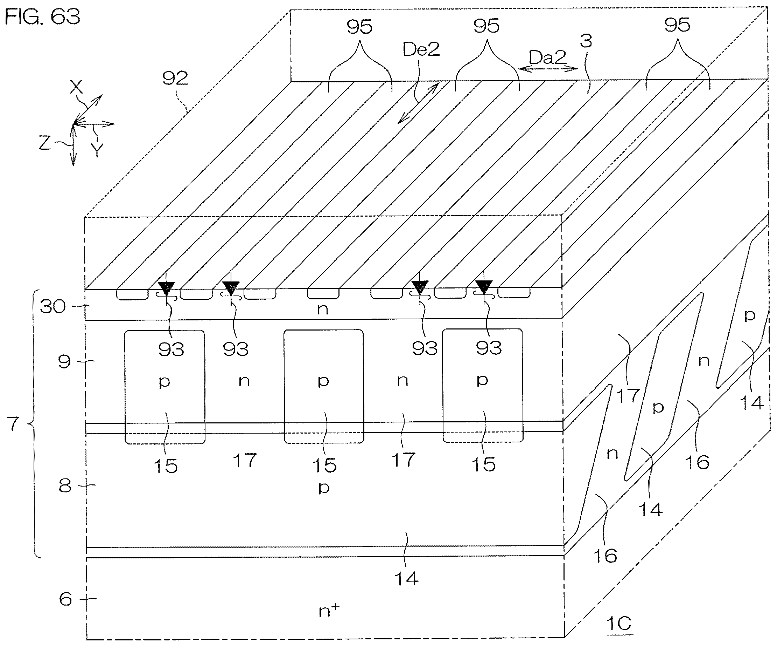

FIG. 63 is a cross-sectional perspective view showing the SBD structure 93 according to the fourth configuration example. With reference to FIG. 63, in a case where the laminated portion 7 includes the top layer 30 (see also FIG. 34, etc.), the SiC semiconductor device 1C may include a plurality of surface layer regions 95 of the p-type (impurity regions) formed in the surface layer portion of the first main surface 3 in the top layer 30 of the active region 10.

In this embodiment, the plurality of surface layer regions 95 are arrayed at intervals in the second array direction Da2 and are each formed as a band extending in the second extension direction De2. That is, in this embodiment, the plurality of surface layer regions 95 are arrayed as stripes extending in the second extension direction De2 of the plurality of second regions 15.

In this example, the second array direction Da2 is the m-axis direction, and the second extension direction De2 is the a-axis direction. As a matter of course, an array direction and an extension direction of the plurality of surface layer regions 95 are changed in accordance with the second array direction Da2 and the second extension direction De2 of the plurality of second regions 15. Therefore, the second array direction Da2 may be the a-axis direction, and the second extension direction De2 may be the m-axis direction. Also, the second array direction Da2 may be a direction other than the a-axis direction and the m-axis direction, and the second extension direction De2 may be a direction other than the a-axis direction and the m-axis direction.

Preferably, the plurality of surface layer regions 95 each have a width different from the width of each of the plurality of first regions 14 and are arrayed at a pitch different from the pitch of the plurality of first regions 14. The width of each of the surface layer regions 95 may be less than the width of each of the plurality of first regions 14, and the pitch of the surface layer regions 95 may be less than the pitch of the plurality of first regions 14. The width of each of the surface layer regions 95 may be less than the width of each of the plurality of first regions 14, and the pitch of the surface layer regions 95 may be larger than the pitch of the plurality of first regions 14.

The width of each of the surface layer regions 95 may be larger than the width of each of the plurality of first regions 14, and the pitch of the surface layer regions 95 may be less than the pitch of the plurality of first regions 14. The width of each of the surface layer regions 95 may be larger than the width of each of the plurality of first regions 14, and the pitch of the surface layer regions 95 may be larger than the pitch of the plurality of first regions 14. As a matter of course, the width of each of the plurality of surface layer regions 95 may be substantially equal to the width of each of the plurality of first regions 14. Also, the pitch of the plurality of surface layer regions 95 may be substantially equal to the pitch of the plurality of first regions 14.

Preferably, the plurality of surface layer regions 95 each have a width different from the width of each of the plurality of second regions 15 and are arrayed at a pitch different from the pitch of the plurality of second regions 15. The width of each of the surface layer regions 95 may be less than the width of each of the plurality of second regions 15, and the pitch of the surface layer regions 95 may be less than the pitch of the plurality of second regions 15. The width of each of the surface layer regions 95 may be less than the width of each of the plurality of second regions 15, and the pitch of the surface layer regions 95 may be larger than the pitch of the plurality of second regions 15.

The width of each of the surface layer regions 95 may be larger than the width of each of the plurality of second regions 15, and the pitch of the surface layer regions 95 may be less than the pitch of the plurality of second regions 15. The width of each of the surface layer regions 95 may be larger than the width of each of the plurality of second regions 15, and the pitch of the surface layer regions 95 may be larger than the pitch of the plurality of second regions 15. As a matter of course, the width of each of the plurality of surface layer regions 95 may be substantially equal to the width of each of the plurality of second regions 15. Also, the pitch of the plurality of surface layer regions 95 may be substantially equal to the pitch of the plurality of second regions 15.

The plurality of surface layer regions 95 are formed at intervals from the plurality of second regions 15 toward the first main surface 3 side. Preferably, the plurality of surface layer regions 95 are formed at intervals from the lower end (the second layer 9) of the top layer 30 toward the first main surface 3 side and oppose the plurality of second layers 9 across at least a part of the top layer 30. The plurality of surface layer regions 95 may oppose one or both of the second regions 15 and the second drift regions 17 in the lamination direction.

The plurality of surface layer regions 95 are constituted of random impurity regions introduced into the surface layer portion of the second layer 9 by the random implantation method with respect to the second layer 9 (see also FIG. 14). Therefore, the plurality of surface layer regions 95 have a thickness less than the second region thickness TR2 of the second region 15 in a direction along the top axis channel CHT. The thickness of the plurality of surface layer regions 95 is less than the first region thickness TR1 of the first region 14.

Unlike the second region 15, etc., the plurality of surface layer regions 95 do not have the gentle gradient portion 22 having a thickness of not less than 0.5 µm and has a concentration gradient including the gradual increase portion 20, the peak portion 21, and the gradual decrease portion 23 in a range of 0.5 µm. The plurality of surface layer regions 95 may have a p-type impurity concentration of not less than 1 × 10¹⁵ cm⁻³ and not more than 1 × 10²¹ cm⁻³ as a peak value.

The p-type impurity concentration of the plurality of surface layer regions 95 is preferably adjusted by at least one type of trivalent element. The trivalent element of the surface layer region 95 may be the same type as the trivalent element of the second region 15, etc., or may be a type different from the trivalent element of the second region 15, etc. The trivalent element of the surface layer region 95 may be at least one type among boron, aluminum, gallium, and indium.

The first pad electrode 92 is mechanically and electrically connected to the top layer 30 on first main surface 3. In this case, the first pad electrode 92 forms the JBS structure with the plurality of surface layer regions 95 on the first main surface 3 and forms the Schottky junction with a region between the plurality of surface layer regions 95 on the first main surface 3. That is, in the SBD structure 93 according to the fourth configuration example, restrictions on the layout of the JBS structure and restrictions on the electrical characteristics due to the layout of the super junction structure SJ (the second super junction structure SJ2) are relaxed.

In this example, the plurality of surface layer regions 95 are formed in the top layer 30. However, in the case where a sufficient space is formed between the first main surface 3 and the column region 12 in the second layer 9 in a state in which the top layer 30 is not formed, the top layer 30 may be omitted.

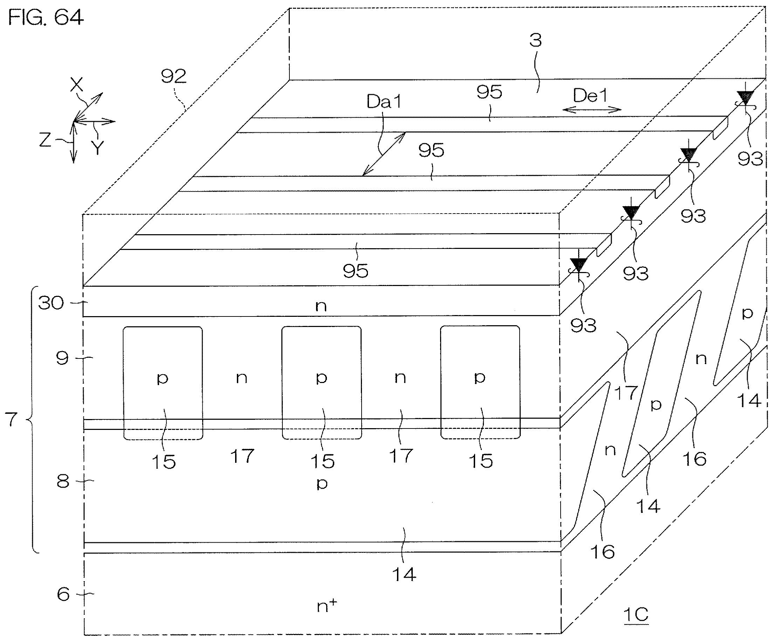

FIG. 64 is a cross-sectional perspective view showing the SBD structure 93 according to the fifth configuration example. The SBD structure 93 according to the fifth configuration example has a layout obtained by modifying the layout of the plurality of surface layer regions 95 according to the fourth configuration example. Specifically, the plurality of surface layer regions 95 are arrayed as stripes extending in a direction intersecting the second extension direction De2 of the plurality of second regions 15 in the active region 10.

In this embodiment, the plurality of surface layer regions 95 are arrayed at intervals in the first array direction Da1 of the first regions 14 and extend in the first extension direction De1 of the first regions 14. In this example, the first array direction Da1 is the m-axis direction, and the first extension direction De1 is the a-axis direction. As a matter of course, the array direction and the extension direction of the plurality of surface layer regions 95 are changed in accordance with the first array direction Da1 and the first extension direction De1 of the plurality of first regions 14. Therefore, the first array direction Da1 may be the a-axis direction, and the first extension direction De1 may be the m-axis direction. Also, the first array direction Da1 may be a direction other than the a-axis direction and the m-axis direction, and the first extension direction De1 may be a direction other than the a-axis direction and the m-axis direction.

As a matter of course, the array direction of the plurality of surface layer regions 95 may be a direction other than the first array direction Da1 and the second array direction D2. Also, the extension direction of the plurality of surface layer regions 95 may be a direction other than the first extension direction De1 and the second extension direction De2. That is, the plurality of surface layer regions 95 may intersect both the plurality of first regions 14 and the plurality of second regions 15 in plan view.

For example, an angle (an absolute value) between the extension direction of the surface layer regions 95 and the second extension direction De2 may exceed 0° and be not more than 90°. The angle (the absolute value) of the surface layer regions 95 may have a value falling within any one of ranges of exceeding 0° and not more than 18°, not less than 18° and not more than 36°, not less than 36° and not more than 54°, not less than 54° and not more than 72°, and not less than 72° and not more than 90°. The angle (the absolute value) of the surface layer regions 95 may be set to a value falling within any one of ranges of 30° ± 5°, 45° ± 5°, and 60° ± 5°.

Hereinafter, modification examples of the ornamental pattern PT will be described. Hereinafter, an example will be described in which the ornamental pattern PT according to a modification example is employed in the SiC semiconductor device 1 according to the first embodiment, but the ornamental pattern PT according to the modification example can also be applied to the SiC semiconductor device 1B according to the second embodiment and the SiC semiconductor device 1C according to the third embodiment.

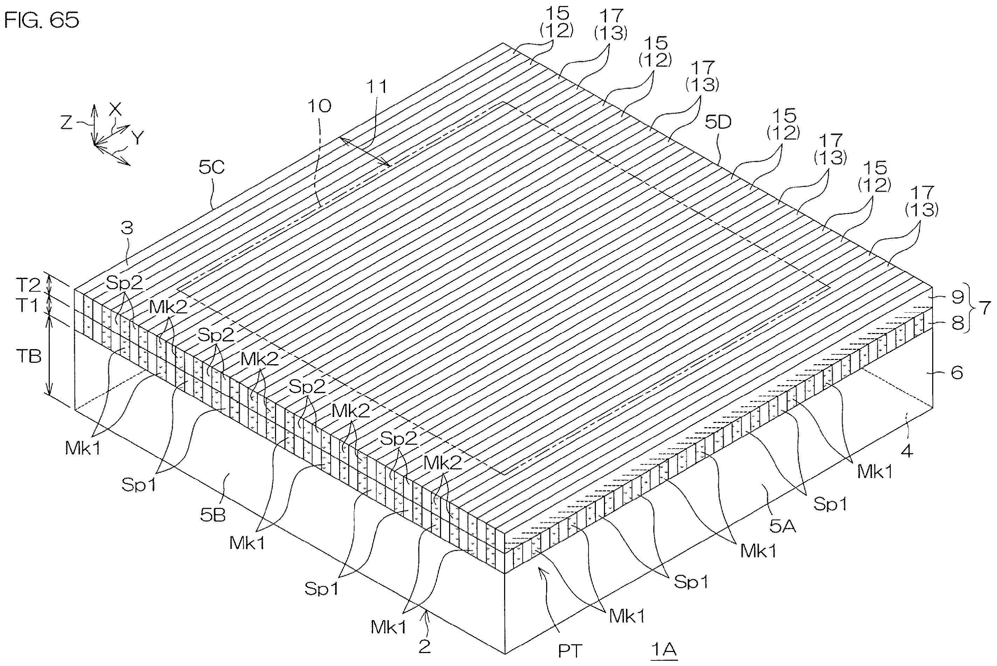

FIG. 65 is a perspective view showing the chip 2 together with the ornamental pattern PT according to a first modification example. In each of the embodiments described above, the example has been described in which the plurality of first marks Mk1 are formed in a side surface different from that of the plurality of second marks Mk2. However, with reference to FIG. 65, the plurality of first marks Mk1 may be formed in the same side surface as the plurality of second marks Mk2. FIG. 65 shows an example in which the plurality of first marks Mk1 are formed in both the first side surface 5A and the second side surface 5B.

The plurality of first marks Mk1 may have a width (the first width W1) different from the width (the second width W2) of the plurality of second marks Mk2 in the second side surface 5B. The plurality of first marks Mk1 may have a pitch (the first pitch P1) different from the pitch (the second pitch P2) of the plurality of second marks Mk2 in the second side surface 5B. The plurality of first marks Mk1 may overlap one or both of the plurality of second marks Mk2 and the plurality of second spaces Sp2 in the thickness direction in the second side surface 5B.

The ornamental pattern PT according to the first modification example is realized by forming the plurality of first regions 14 extending in a direction intersecting both the first side surface 5A and the second side surface 5B. For example, the first extension direction De1 of the plurality of first regions 14 is a direction intersecting both the a-axis direction and the m-axis direction. In a case where the plurality of first marks Mk1 are formed in the second side surface 5B, the second difference mark Md2 is not formed in the second side surface 5B.

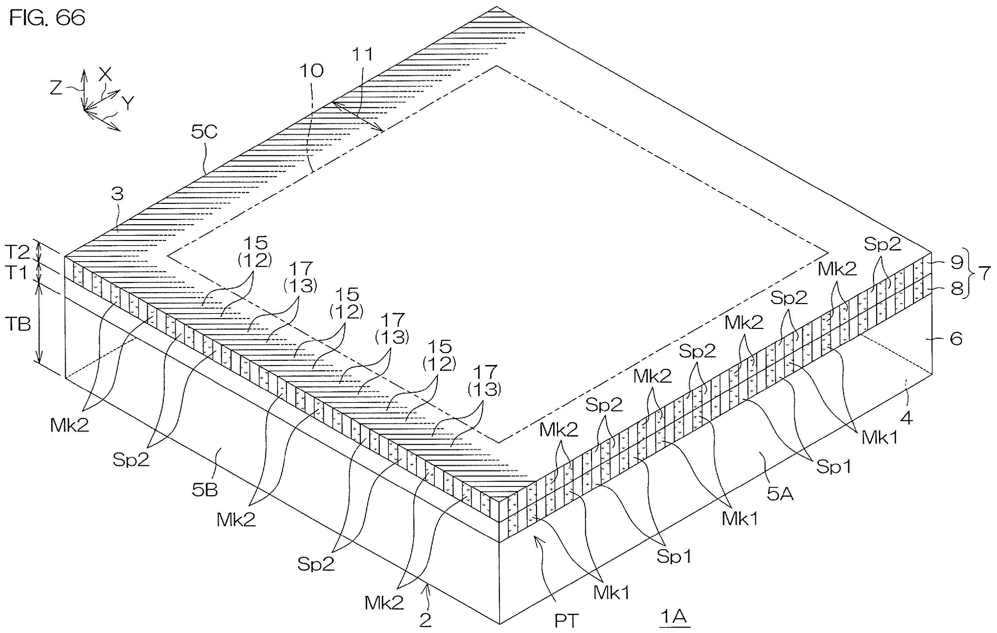

FIG. 66 is a perspective view showing the chip 2 together with the ornamental pattern PT according to a second modification example. In each of the embodiments described above, the example has been described in which the plurality of second marks Mk2 are formed in a side surface different from that of the plurality of first marks Mk1. However, with reference to FIG. 66, the plurality of second marks Mk2 may be formed in the same side surface as the plurality of first marks Mk1. FIG. 66 shows an example in which the plurality of second marks Mk2 are formed in both the first side surface 5A and the second side surface 5B.

The plurality of second marks Mk2 may have a width (the second width W2) different from the width (the first width W1) of the plurality of first marks Mk1 in the first side surface 5A. The plurality of second marks Mk2 may have a pitch (the second pitch P2) different from the pitch (the first pitch P1) of the plurality of first marks Mk1 in the first side surface 5A. The plurality of second marks Mk2 may overlap one or both of the plurality of first marks Mk1 and the plurality of first spaces Sp1 in the thickness direction in the first side surface 5A.

The ornamental pattern PT according to the second modification example is realized by forming the plurality of second regions 15 extending in a direction intersecting both the first side surface 5A and the second side surface 5B. For example, the second extension direction De2 of the plurality of second regions 15 is a direction intersecting both the a-axis direction and the m-axis direction. In a case where the plurality of second marks Mk2 are formed in the first side surface 5A, the first difference mark Md1 is not formed in the first side surface 5A.

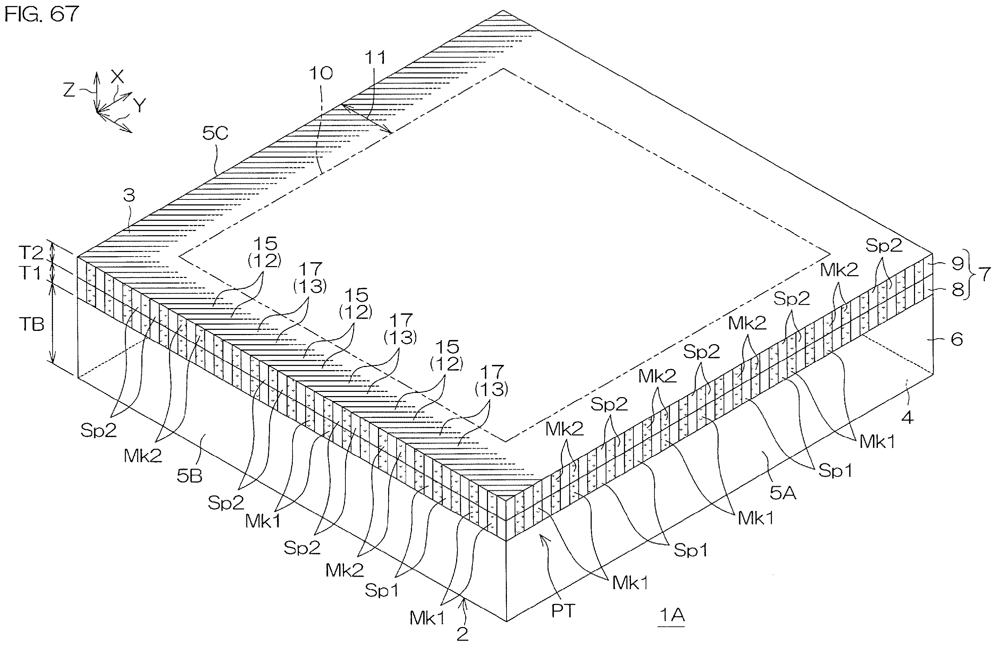

FIG. 67 is a perspective view showing the chip 2 together with the ornamental pattern PT according to a third modification example. The ornamental pattern PT according to the third modification example has a form in which the ornamental pattern PT according to the first modification example and the ornamental pattern PT according to the second modification example are combined. That is, the plurality of first marks Mk1 are exposed from both the first side surface 5A and the second side surface 5B, and the plurality of second marks Mk2 are exposed from both the first side surface 5A and the second side surface 5B.

In this case, the plurality of first regions 14 extending in a direction intersecting the first side surface 5A and the second side surface 5B are formed, and the plurality of second regions 15 extending in a direction intersecting the first side surface 5A and the second side surface 5B are formed. The plurality of second regions 15 intersect or are orthogonal to the plurality of first regions 14.

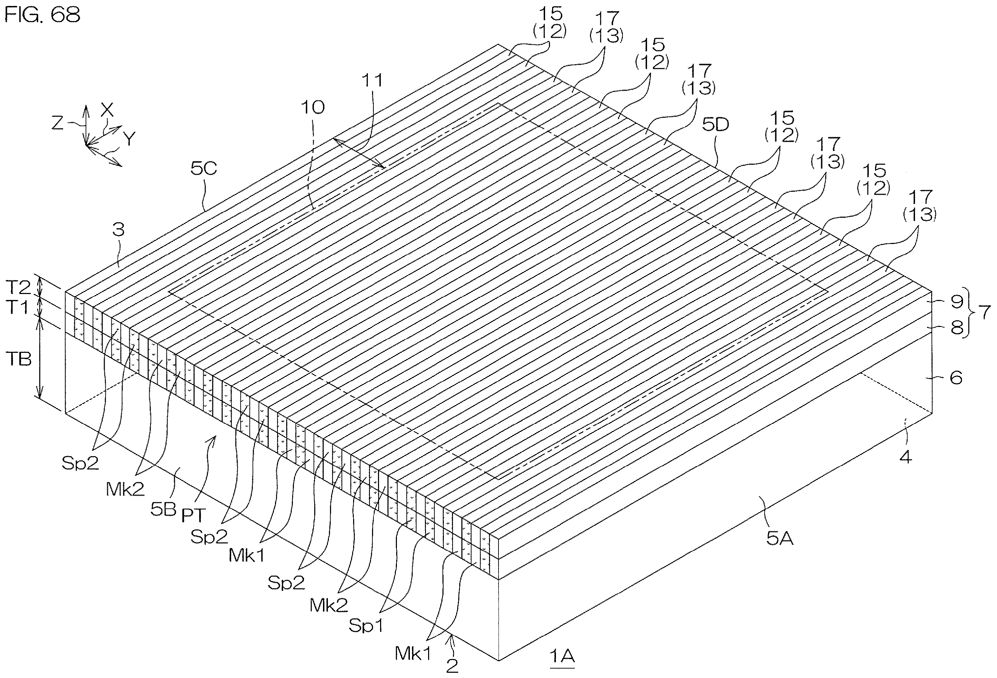

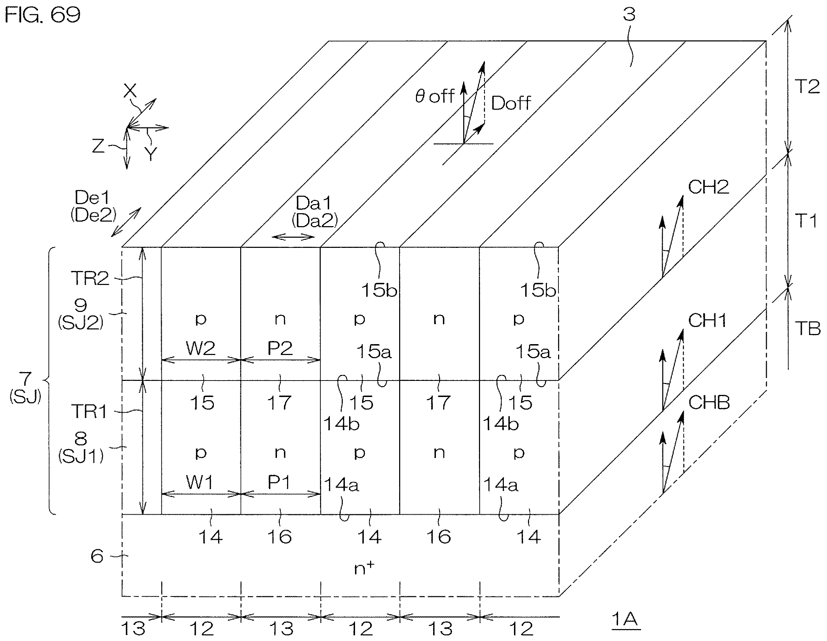

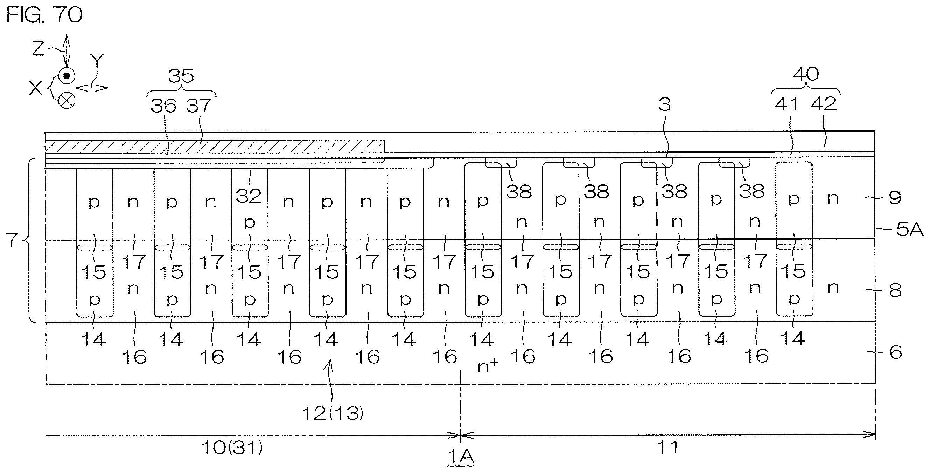

FIG. 68 is a perspective view showing the chip 2 together with the ornamental pattern PT according to a fourth modification example. FIG. 69 is a cross-sectional perspective view showing the column region 12 according to a modification example. FIG. 70 is a cross-sectional view showing the main portion of the outer peripheral region 11 together with the column region 12 according to the modification example. FIG. 69 shows a modification example of the column region 12 according to the first basic form.

As a matter of course, the column region 12 according to the modification example may have at least one of a plurality of features described in the first to twelfth configuration examples. The column region 12 according to the modification example may have a feature obtained by combining the plurality of (two or more) features described in the first to twelfth configuration examples.

In each of the embodiments described above, the example has been described in which the plurality of first marks Mk1 are formed in the first side surface 5A (the third side surface 5C) and the plurality of second marks Mk2 are formed in the second side surface 5B (the fourth side surface 5D).

However, as shown in FIG. 68, the plurality of first marks Mk1 and the plurality of second marks Mk2 may be formed in only one of the first side surface 5A (the third side surface 5C) extending in the first direction X and the second side surface 5B (the fourth side surface 5D) extending in the second direction Y. FIG. 68 shows an example in which both of the plurality of first marks Mk1 and the plurality of second marks Mk2 are formed in the second side surface 5B (the fourth side surface 5D). The plurality of first marks Mk1 are formed in the lower range of the laminated portion 7 in the second side surface 5B in the same mode as in the case of the above-described embodiment.

Meanwhile, the plurality of second marks Mk2 are formed in the upper range of the laminated portion 7 in the second side surface 5B. The plurality of second marks Mk2 are arrayed at intervals in the first direction X in the upper range such as to overlap the plurality of first marks Mk1 in the lamination direction and define the plurality of second spaces Sp2 which are each constituted of a part of the laminated portion 7 (the second layer 9). Specifically, the plurality of second marks Mk2 overlap the plurality of first marks Mk1 in a one-to-one correspondence in the lamination direction, and the plurality of second spaces Sp2 overlap the plurality of first spaces Sp1 in a one-to-one correspondence in the lamination direction.

The lower end portion of the second mark Mk2 may be formed at an interval from the lower end to the upper end side of the second layer 9 and may oppose the first mark Mk1 across a part (the lower end portion) of the second layer 9. The lower end portion of the second mark Mk2 may have an extension portion that crosses the boundary portion between the first layer 8 and the second layer 9 and is positioned in the first layer 8. In this case, the extension portions of the plurality of second marks Mk2 are preferably connected to the plurality of first marks Mk1 in a one-to-one correspondence relationship. That is, it is preferable that the plurality of second marks Mk2 form a stripe pattern integrated with the plurality of first marks Mk1.

With reference to FIG. 69, the ornamental pattern PT according to the fourth modification example is realized by making both the second array direction Da2 and the second extension direction De2 of the plurality of second regions 15 be matched with both the first array direction Da1 and the first extension direction De1 of the plurality of first regions 14. In this case, the plurality of second regions 15 are formed in the second layer 9 such as to overlap the plurality of first regions 14 in the lamination direction in a one-to-one correspondence relationship in both the active region 10 and the outer peripheral region 11.

That is, the plurality of first regions 14 extend as stripes in the first extension direction De1 (the second extension direction De2) in the first layer 8. The plurality of first regions 14 define a plurality of first drift regions 16 extending as a stripe in the first extension direction De1 (the second extension direction De2) in the first layer 8.

Meanwhile, the plurality of second regions 15 extend as stripes in the first extension direction De1 (the second extension direction De2) in the second layer 9. The plurality of second regions 15 define a plurality of second drift regions 17 extending as stripes in the first extension direction De1 (the second extension direction De2) in the second layer 9.

The plurality of second regions 15 form the plurality of column regions 12 extending as stripes in the first extension direction De1 (the second extension direction De2) together with the plurality of first regions 14 in the laminated portion 7. The plurality of column regions 12 define a plurality of drift regions 13 extending as stripes in the first extension direction De1 (the second extension direction De2) in the laminated portion 7.

In this example, the first array direction Da1 and the second array direction Da2 are the a-axis direction, and the first extension direction De1 and the second extension direction De2 are the m-axis direction. As a matter of course, the first array direction Da1 and the second array direction Da2 may be the m-axis direction, and the first extension direction De1 and the second extension direction De2 may be the a-axis direction.

As a matter of course, the first extension direction De1 and the second extension direction De2 may be a direction other than the a-axis direction and the m-axis direction. In this case, the ornamental pattern PT identical to the ornamental pattern PT according to the third modification example is formed by the plurality of column regions 12 extending as stripes.

With reference to FIG. 70, the plurality of field regions 38 are formed in a region on the side of the first main surface 3 with respect to the plurality of column regions 12 having a stripe shape. The plurality of field regions 38 extend along the plurality of first regions 14 and the plurality of second regions 15 in a portion extending in the first extension direction De1 (the second extension direction De2).

The plurality of field regions 38 intersect the plurality of first regions 14 and the plurality of second regions 15 at the same locations in a portion extending in a direction intersecting the first extension direction De1 (the second extension direction De2). The plurality of field regions 38 may be connected to the plurality of second regions 15, or may be formed at intervals from the plurality of second regions 15.

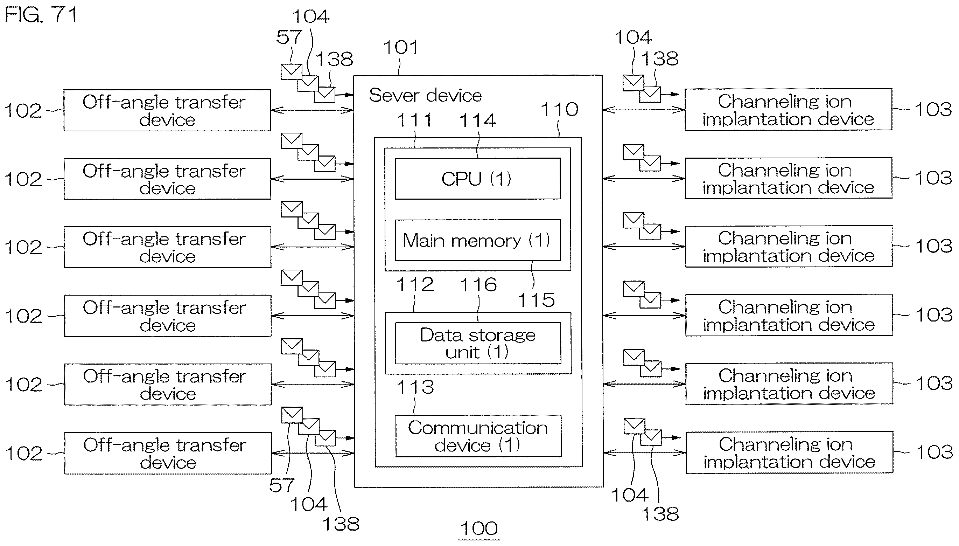

Next, an ion implantation processing system 100 used in manufacture of the SiC semiconductor devices 1A to 1C according to the first to third embodiments described above will be described. FIG. 71 is a schematic diagram showing a configuration example of the ion implantation processing system 100 used in the manufacture of the SiC semiconductor devices 1A to 1C according to the first to third embodiments.

The ion implantation processing system 100 is a system that performs some of the various processes (FIGS. 41 and 42A to 42H) performed on the wafer 50 (see FIG. 40) described above. The following description is provided with reference to FIGS. 40, 41, and 42A to 42H, as necessary.

With reference to FIG. 71, the ion implantation processing system 100 includes one or a plurality of server devices 101 (servers), one or a plurality of off-angle transfer devices 102 (transfer devices), and one or a plurality of channeling ion implantation devices 103 (ion implantation devices). The server device 101 is a device that executes transmission and reception of various items of data to be used in the manufacture of the SiC semiconductor devices 1A to 1C and stores the data. The server device 101 may be a physical server device or a virtual server device.

The off-angle transfer device 102 is a device that transfers (uploads) various items of data to be used in the manufacture of the SiC semiconductor devices 1A to 1C to the server device 101. Specifically, the off-angle transfer device 102 transfers off-angle data 104 corresponding to the off angle θoff of the wafer 50 to the server device 101.

The channeling ion implantation device 103 is a device that acquires (downloads) various items of data to be used in the manufacture of the SiC semiconductor devices 1A to 1C from the server device 101 and executes ion implantation processing on the wafer 50 based on the data. Specifically, the channeling ion implantation device 103 acquires the off-angle data 104 from the server device 101, controls an ion implantation angle based on the off-angle data 104, and executes an ion implantation processing step for the wafer 50.

The ion implantation processing step is a channeling ion implantation step. In the channeling ion implantation step, the ion implantation angle with respect to the wafer 50 is adjusted based on the off-angle data 104, and ions are implanted into the wafer 50 (into the first layer 8) along the base axis channel CHB (the first axis channel CH1 of the first layer 8) of the wafer 50 (see also FIGS. 42A to 42H).

The number of server devices 101, the number of off-angle transfer devices 102, and the number of channeling ion implantation devices 103 are all arbitrary. However, increases in the number of off-angle transfer devices 102 and the number of channeling ion implantation devices 103 result in improvement of manufacturing efficiency. Therefore, the ion implantation processing system 100 preferably includes a plurality of off-angle transfer devices 102. Also, the ion implantation processing system 100 preferably includes a plurality of channeling ion implantation devices 103.

For example, the ion implantation processing system 100 may include a first number of off-angle transfer devices 102 (the first number of devices, that is, one or more devices) and a second number of channeling ion implantation devices 103 (the second number of devices, that is, one or more devices) different from the first number. The second number of channeling ion implantation devices 103 may be larger than the first number of off-angle transfer devices 102. The second number of channeling ion implantation devices 103 may be smaller than the first number of off-angle transfer devices 102.

As a matter of course, the second number of channeling ion implantation devices 103 may be equal to the first number of off-angle transfer devices 102. In view of the processing capability of the off-angle transfer device 102 and the processing capability of the channeling ion implantation device 103, the second number is preferably smaller than the first number. That is, preferably, the first number is two or more, and the second number is one or more.

FIG. 71 shows an example in which the plurality of off-angle transfer devices 102 are connected to the single server device 101. As a matter of course, the plurality of off-angle transfer devices 102 may be connected to the plurality of server devices 101. Also, the single off-angle transfer device 102 may be connected to the single or the plurality of server devices 101.

The plurality of off-angle transfer devices 102 may be installed independently of the server device 101. As a matter of course, the single or the plurality of server devices 101 may be incorporated in the single or the plurality of off-angle transfer devices 102. That is, the single or the plurality of off-angle transfer devices 102 may include the single or the plurality of server devices 101.

The plurality of off-angle transfer devices 102 are connected to the server device 101 in a wired or wireless manner. In this embodiment, the plurality of off-angle transfer devices 102 are connected to the server device 101 through a communication network. The communication network is a bidirectional network. In this embodiment, the communication network is the Internet. The communication network may be a network (an intranet) having a limited communication range such as an organization intranet.

Examples of the communication networks may include Transmission Control Protocol/Internet Protocol (TCP/IP), GSM (registered trademark), CDMA, LTE, Bluetooth (registered trademark), wi-fi (registered trademark), Z-WAVE, Insteon, EnOcean, ZigBee (registered trademark), HomePlug (registered trademark), MQTT, XMPP, CoAP, etc. As a matter of course, the communication network may be a network obtained by combining at least two of these examples of the communication networks.

FIG. 71 shows an example in which the plurality of channeling ion implantation devices 103 are connected to the single server device 101. As a matter of course, the plurality of channeling ion implantation devices 103 may be connected to a plurality of server devices 101. Also, the single channeling ion implantation device 103 may be connected to the single or the plurality of server devices 101.

The plurality of channeling ion implantation devices 103 are installed independently of the plurality of off-angle transfer devices 102. The plurality of channeling ion implantation devices 103 may be installed independently of the server device 101.

In a case where the off-angle transfer device 102 is installed independently of the server device 101, the single or the plurality of server devices 101 may be incorporated in the single or the plurality of channeling ion implantation devices 103. That is, the channeling ion implantation device 103 may include the server device 101. As a matter of course, both the off-angle transfer device 102 and the channeling ion implantation device 103 may include the respective server devices 101.

The plurality of channeling ion implantation devices 103 are connected to the server device 101 in a wired or wireless manner. In this embodiment, the plurality of channeling ion implantation devices 103 are connected to the server device 101 through the communication network. Therefore, an installation location of the channeling ion implantation device 103 is not limited by an installation location of the off-angle transfer device 102. For example, the channeling ion implantation device 103 can be installed far away from the installation location of the off-angle transfer device 102.

Hereinafter, a configuration example of the server device 101 will be described. The server device 101 includes a server control device 110. The server control device 110 includes a first processing device 111, a first auxiliary memory 112, and a first communication device 113. The first processing device 111 includes a first central processing unit 114 and a first main memory 115. The first main memory 115 may be a semiconductor memory. The semiconductor memory may include a volatile memory such as a random access memory (RAM) and a nonvolatile memory such as a read only memory (ROM).

The first auxiliary memory 112 is a storage medium (specifically, a non-volatile storage medium) in which a program for causing the first processing device 111 to execute a predetermined step has been stored. The first auxiliary memory 112 may include a single storage medium or a plurality of storage media.

Examples of the first auxiliary memory 112 may include a magnetic disk, an optical disk, a flash memory, etc. The first auxiliary memory 112 includes a first data storage unit 116. The first data storage unit 116 is a region in which various items of data (the off-angle data 104, etc.) to be used in the manufacture of the SiC semiconductor devices 1A to 1C are stored.

The first communication device 113 is an interface that is connected to another device in a wired or wireless manner and transmits and receives various items of data to and from the other device. In this embodiment, the first communication device 113 is an interface connected to another device through a communication network. The first communication device 113 may be a wireless LAN interface, a wired LAN interface, a wireless WAN, a wired WAN, etc.

In a case where the server device 101 is incorporated in the off-angle transfer device 102, the server device 101 may be realized by using some functions of the off-angle transfer device 102. In a case where the server device 101 is incorporated in the channeling ion implantation device 103, the server device 101 may be realized by using some functions of the channeling ion implantation device 103.

In a case where the server device 101 is incorporated in both the off-angle transfer device 102 and the channeling ion implantation device 103, the server device 101 may be realized by using some functions of the off-angle transfer device 102 and some functions of the channeling ion implantation device 103.

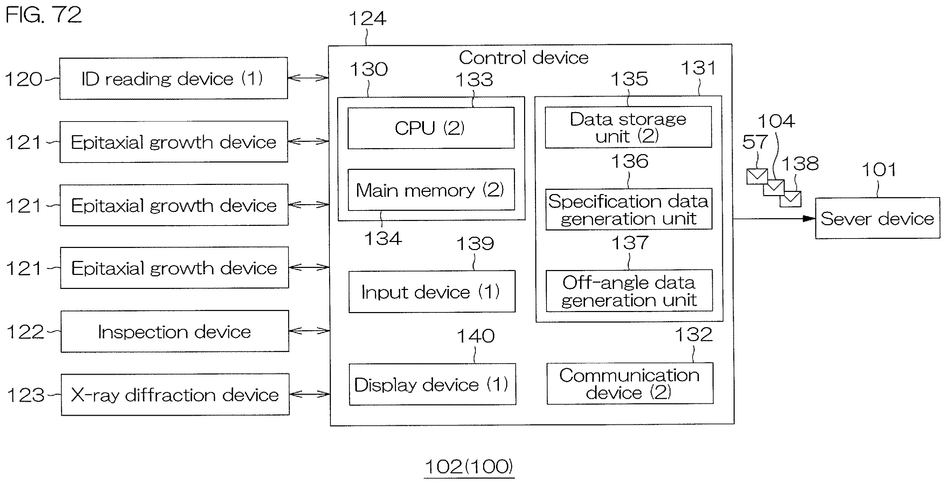

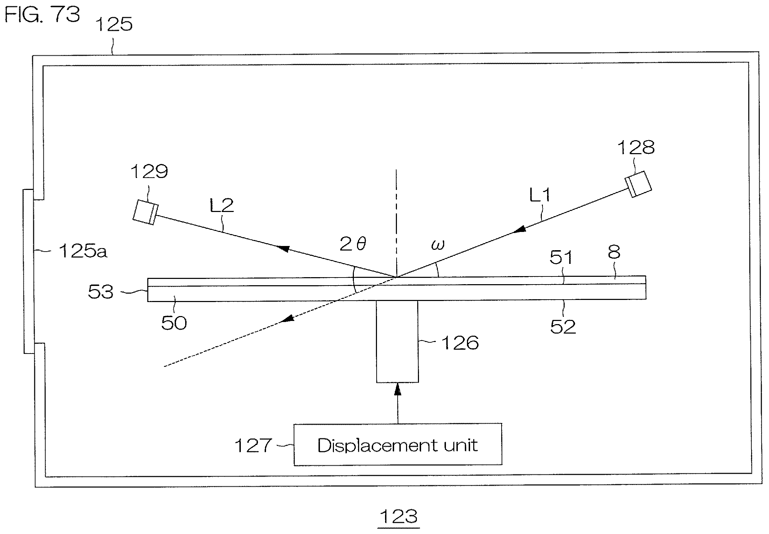

Hereinafter, a configuration example of the off-angle transfer device 102 will be described. FIG. 72 is a schematic diagram showing the configuration example of the off-angle transfer device 102 shown in FIG. 71. FIG. 73 is a schematic diagram showing a configuration example of an X-ray diffraction device 123 in FIG. 72. FIG. 72 shows the configuration example of one off-angle transfer device 102.

With reference to FIG. 72, the off-angle transfer device 102 includes one or a plurality of first ID reading devices 120, one or a plurality of epitaxial growth devices 121, one or a plurality of inspection devices 122, the single or the plurality of X-ray diffraction devices 123, and a transfer-side control device 124.

The first ID reading device 120 may be referred to as a "first ID reading unit". The epitaxial growth device 121 may be referred to as an "epitaxial growth processing unit". The inspection device 122 may be referred to as an "inspection unit". The X-ray diffraction device 123 may be referred to as an "X-ray diffraction (XRD) device", an "X-ray diffraction processing unit", an "X-ray device", an "X-ray measurement device", etc.

FIG. 72 shows an example in which the single first ID reading device 120, the plurality of (three in FIG. 72) epitaxial growth devices 121, the single inspection device 122, and the single X-ray diffraction device 123 are provided. The number of the first ID reading devices 120, the number of the epitaxial growth devices 121, the number of the inspection devices 122, and the number of the X-ray diffraction devices 123 are arbitrary. However, the number of wafers 50 processed per unit time by the X-ray diffraction device 123 is larger than the number of wafers 50 processed per unit time by the epitaxial growth device 121.

Therefore, it is preferably configured such that the plurality of epitaxial growth devices 121 are provided and the plurality of wafers 50 after an epitaxial growth step are sequentially transferred from the plurality of epitaxial growth devices 121 to the single or the plurality of X-ray diffraction devices 123. According to this configuration, a process dead time between the epitaxial growth step and an X-ray diffraction step is prevented. In this case, the number of the X-ray diffraction devices 123 is preferably less than the number of the epitaxial growth devices 121.

The first ID reading device 120 is a device that reads the wafer ID 57 (see FIG. 40) of the wafer 50. For example, the first ID reading device 120 is a scanner that includes an imaging device which images the wafer 50 and that reads the wafer ID 57 from image data of the wafer 50.

The imaging device may include any one or both of a charge coupled device (CCD) image sensor and a complementary metal oxide semiconductor (CMOS) image sensor. For example, the first ID reading device 120 may include a processing chamber (not shown) and be arranged to obtain the wafer ID 57 in the processing chamber. As a matter of course, the first ID reading device 120 may be a handheld scanner.

Each of the epitaxial growth devices 121 is a device that includes a processing chamber (not shown) and laminates an epitaxial layer on the wafer 50 (the first wafer main surface 51) in the processing chamber. That is, each of the epitaxial growth devices 121 is a device that forms one or both of the first layer 8 and the second layer 9.

The inspection device 122 is a device that includes a processing chamber (not shown) and inspects an epitaxial layer in the processing chamber. That is, the inspection device 122 inspects the first layer 8 (the second layer 9) as the epitaxial layer. The inspection of the first layer 8 (the second layer 9) may be a non-contact inspection of an optical system, or may be a contact inspection using an electrode, etc.

For example, the inspection device 122 measures at least one of the thickness of the first layer 8 (the second layer 9), a resistance value of the first layer 8 (the second layer 9), a sheet resistance value of the first layer 8 (the second layer 9), resistivity of the first layer 8 (the second layer 9), the impurity concentration of the first layer 8 (the second layer 9), and a carrier density of the first layer 8 (the second layer 9). The inspection device 122 preferably measures at least one of the thickness of the first layer 8 (the second layer 9) and the impurity concentration of the first layer 8 (the second layer 9).

The X-ray diffraction device 123 is a device that measures a crystal orientation of the wafer 50. The crystal orientation of the wafer 50 is the off angle θoff of the wafer 50. In this embodiment, the X-ray diffraction device 123 measures the off angle θoff of the first layer 8 (the second layer 9) as the off angle θoff of the wafer 50 after the forming step of the first layer 8 (the second layer 9).

As described above, the off angle θoff of the first layer 8 (the epitaxial layer) and the off angle θoff of the second layer 9 (the epitaxial layer) are substantially matched with the off angle θoff of the wafer 50. Therefore, the X-ray diffraction device 123 may be programmed such as to measure the off angle θoff of the wafer 50 before the forming step of the first layer 8 (the second layer 9). However, from the viewpoint of ensuring accuracy, the measurement step of the crystal orientation is preferably performed on the first layer 8 (the second layer 9).

Hereinafter, an example will be described in which the crystal orientation of the first layer 8 as the epitaxial layer is measured. As a matter of course, the following description is also applied to the wafer 50 and the second layer 9 instead of the first layer 8. In a case where the wafer 50 is applied, the first layer 8 (the upper end of the first layer 8) is replaced with the wafer 50 (the first wafer main surface 51 of the wafer 50) in the following description. In a case where the second layer 9 is applied, the first layer 8 is replaced with the second layer 9 in the following description.

The X-ray diffraction device 123 measures the crystal orientation of the first layer 8 by an X-ray diffraction method (a so-called ω-2θ measurement method). Specifically, with reference to FIG. 73, the X-ray diffraction device 123 includes a processing chamber 125, a support unit 126, a displacement unit 127, an incident unit 128, and a detection unit 129, and executes a rocking curve measurement method. The processing chamber 125 has box-shaped partition walls that define an internal space thereof and has an opening/closing shutter 125a that enables the wafer 50 to be carried-in/carried-out.

The support unit 126 is provided in the processing chamber 125 and supports the wafer 50 from the second wafer main surface 52 side in the processing chamber 125. The support unit 126 may be an electrostatic chuck that supports the wafer 50 with static electricity or may be a vacuum chuck that supports the wafer 50 with a suction force.

The displacement unit 127 is connected to the support unit 126 and displaces, together with the support unit 126, a posture of the wafer 50. For example, the displacement unit 127 may rotate the wafer 50 about the vertical axis. For example, the displacement unit 127 may rotate, together with the support unit 126, the wafer 50 about a horizontal axis orthogonal to the vertical axis and inclines the wafer 50 with respect to the horizontal plane. For example, the displacement unit 127 may include one or a plurality of electric motors.

The incident unit 128 is provided in the processing chamber 125 and irradiates the upper end of the first layer 8 (the first wafer main surface 51 of the wafer 50) with an incident X-ray L1 having a predetermined incident angle ω. The incident angle ω is defined by an angle between the incident X-ray L1 and the upper end of the first layer 8. In this embodiment, the incident angle ω is adjusted by changing an inclination angle of the upper end of the first layer 8 with respect to the incident X-ray L1. As a matter of course, the incident angle ω may be adjusted by changing an incident direction of the incident X-ray L1 with respect to the upper end of the first layer 8.

The detection unit 129 is provided in the processing chamber 125, is arranged at an angular position of a diffraction angle 2θ (θ is a Bragg angle) with respect to an irradiation position on the upper end of the first layer 8 with the incident X-ray L1, and detects a diffracted X-ray L2. The diffraction angle 2θ is an angle between an incident direction of the incident X-ray L1 and a diffraction direction of the diffracted X-ray L2. In the rocking curve measurement method, the incident angle ω is shifted in a minute angle range in a state in which the diffraction angle 2θ is fixed, and a rocking curve representing the intensity of the diffracted X-ray L2 (an intensity profile of the diffracted X-ray L2) is measured.

The transfer-side control device 124 is connected to the first ID reading device 120, the plurality of epitaxial growth devices 121, the inspection device 122, and the X-ray diffraction device 123, retrieves the wafer ID 57 acquired by the first ID reading device 120, and controls the epitaxial growth devices 121, the inspection device 122, and the X-ray diffraction device 123 based on a predetermined processing recipe.

The transfer-side control device 124 includes a second processing device 130, a second auxiliary memory 131, and a second communication device 132. The second processing device 130 includes a second central processing unit 133 and a second main memory 134. The second main memory 134 may be a semiconductor memory. The semiconductor memory may include a volatile memory such as a RAM and a nonvolatile memory such as a ROM.

The second auxiliary memory 131 is a storage medium (specifically, a non-volatile storage medium) in which a program for causing the second processing device 130 to execute a predetermined step has been stored. The second auxiliary memory 131 may include a single storage medium or a plurality of storage media. Examples of the second auxiliary memory 131 may include a magnetic disk, an optical disk, a flash memory, etc.

The second auxiliary memory 131 includes a second data storage unit 135, a specification data generation unit 136, and an off-angle data generation unit 137. The second data storage unit 135 is a region which includes one or a plurality of memories and in which various items of data to be used in the manufacture of the SiC semiconductor devices 1A to 1C are stored.

The second data storage unit 135 includes a processing recipe for controlling the epitaxial growth device 121, a processing recipe for controlling the inspection device 122, a processing recipe for controlling the X-ray diffraction device 123, etc. Also, the second data storage unit 135 includes a region in which the wafer ID 57 acquired by the first ID reading device 120 is stored, a region in which the inspection results of the inspection device 122 are stored, a region in which the measurement results by the X-ray diffraction device 123 are stored, etc.

The specification data generation unit 136 is a unit that generates specification data 138 of the first layer 8 (the epitaxial layer) based on the inspection results acquired by the inspection device 122. The specification data generation unit 136 generates the specification data 138 associated with the wafer IDs 57 in a one-to-one correspondence. The wafer ID 57 is the wafer ID 57 of the wafer 50 which is a lamination target of the specific first layer 8, and the specification data 138 is the specification data 138 of the specific first layer 8 laminated on the wafer 50 which is the lamination target.

The specification data 138 includes at least one of thickness data of the first layer 8 (the second layer 9), resistance value data of the first layer 8 (the second layer 9), sheet resistance value data of the first layer 8 (the second layer 9), resistivity data of the first layer 8 (the second layer 9), impurity concentration data of the first layer 8 (the second layer 9), and carrier density data of the first layer 8 (the second layer 9). The specification data 138 preferably includes at least one of the thickness data of the first layer 8 (the second layer 9) and the impurity concentration data of the first layer 8 (the second layer 9).

The off-angle data generation unit 137 is a unit that generates the off-angle data 104 of the wafer 50 based on the off angle θoff acquired by the X-ray diffraction device 123. In this embodiment, the off-angle data generation unit 137 generates the off-angle data 104 of the first layer 8 as the off-angle data 104 of the wafer 50.

The off-angle data generation unit 137 generates the off-angle data 104 associated with the wafer IDs 57 in a one-to-one correspondence. The wafer ID 57 is the wafer ID 57 of the wafer 50 which is a lamination target of the specific first layer 8, and the off-angle data 104 is the off-angle data 104 of the specific first layer 8 laminated on the wafer 50 which is the lamination target.

The second communication device 132 is an interface that is connected to the server device 101 in a wired or wireless manner and transmits and receives various items of data to and from the server device 101. In this embodiment, the second communication device 132 is an interface communicating with the server device 101 through a communication network. The second communication device 132 may be a wireless LAN interface, a wired LAN interface, a wireless WAN, a wired WAN, etc.

The transfer-side control device 124 transfers (uploads) a data set including the wafer ID 57, the off-angle data 104 associated with the wafer ID 57, and the specification data 138 associated with the wafer ID 57 to the server device 101 through the second communication device 132. As a matter of course, the transfer-side control device 124 may be arranged to transfer the off-angle data 104 and the specification data 138 to the server device 101 at different timings.

The transfer-side control device 124 may include a first input device 139 and a first display device 140. The first input device 139 is a device for retrieving data to the transfer-side control device 124 (the second processing device 130, the second auxiliary memory 131, etc.) by external operation (for example, user operation).

Examples of the first input device 139 may include a keyboard, a pointing device, a touch panel, etc. The first display device 140 is a device that outputs processing details in the transfer-side control device 124 to the outside. Examples of the first display device 140 may include a touch panel, a display, etc.

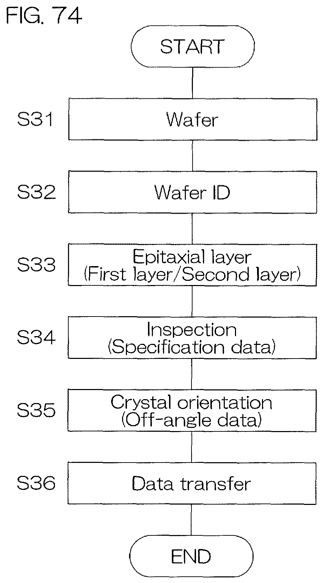

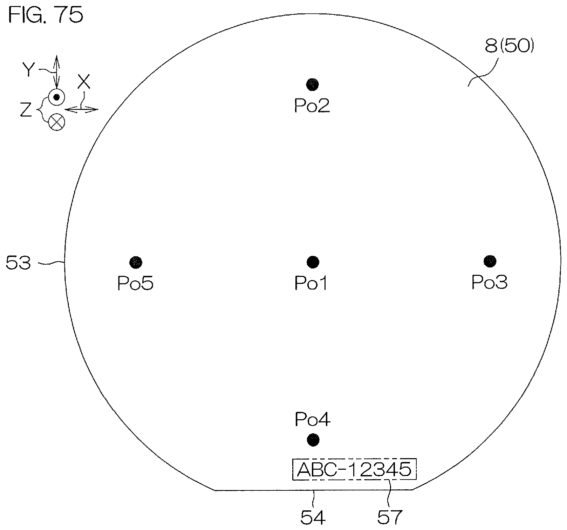

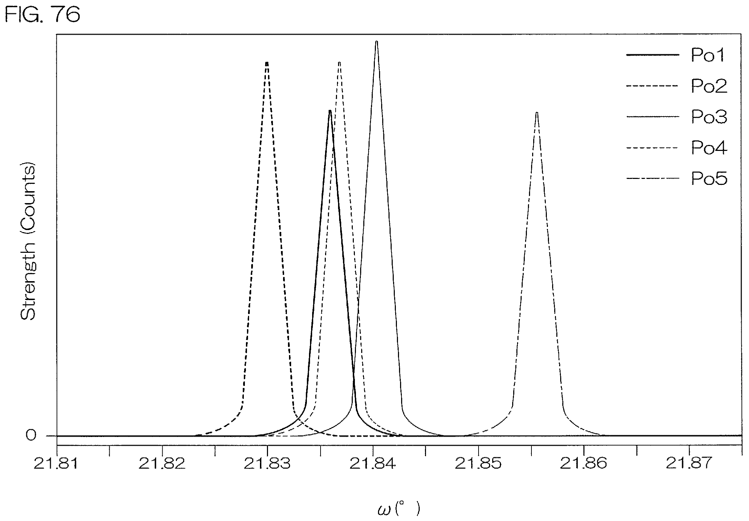

FIG. 74 is a flowchart showing a process example of the off-angle transfer device 102. FIG. 75 is a schematic view showing a measurement example by the X-ray diffraction device 123 shown in FIG. 73. FIG. 76 is a graph showing a rocking curve.

First, with reference to FIG. 74, a preparation step of the wafer 50 described above (see FIG. 40) is performed (step S31 in FIG. 74). The preparation step of the wafer 50 may include a step of cutting out the wafer 50 from an ingot consisting of an SiC monocrystal block (a semiconductor monocrystal block). The ingot may be formed into a columnar shape (a circular columnar shape or a prismatic shape), a spherical shape, etc. A cutting-out step of the wafer 50 includes the step of cutting out the wafer 50 at the predetermined off angle θoff.

The cutting-out step of the wafer 50 may include at least one of the cutting step using a cutting member, a separation step using laser irradiation (the cleavage step), and a separation step using light ion irradiation. The cutting step includes a step of cutting out the wafer 50 having the off angle θoff from the ingot by the cutting member. The cutting member may be a wire saw.

The cleavage step includes a forming step of a plurality of modified layers and an external force applying step. In the forming step of the plurality of modified layers, a predetermined depth position of the ingot is irradiated with a laser beam having a focal point (light focus portion) along a predetermined plane direction along the off angle θoff, and the plurality of modified layers along the predetermined plane direction are formed inside the ingot. The plurality of modified layers are portions (laser irradiation marks) in which a part of a crystal structure of the ingot is modified to have different properties, and have fragile physical properties as compared with the other regions.

In the external force applying step, an external force (stress) is applied to the ingot, and the ingot is separated (cleaved) with the plurality of modified layers as starting points. Consequently, the wafer 50 having the off angle θoff is cut out of the ingot. Examples of the external force (stress) applied to the ingot may include at least one of stress caused by the cutting member, stress caused by a pressing member, stress caused by ultrasonic vibrations, and thermal stress caused by heating and cooling.

The separation step includes an introduction step of light ions and a thermal treatment step. In the introduction step of light ions, light ions are introduced into a predetermined depth position of the ingot along a predetermined plane direction along the off angle θoff by an ion implantation method (ion beam), and an ion embrittlement portion (an ion embrittlement region) along the predetermined plane direction is formed in the ingot.

Light ions are ions of an element lighter than carbon (that is, at least one type among hydrogen ions, helium ions, lithium ions, beryllium ions, and boron ions). The light ions are preferably one or both types of hydrogen ions and helium ions. The light ions are particularly preferably hydrogen ions. In this case, an embrittlement portion is formed using a hydrogen embrittlement phenomenon. In the thermal treatment step, a thermal load is applied to the ion embrittlement portion by a thermal treatment, and the wafer 50 having the off angle θoff is separated from the ingot with the ion embrittlement portion as a start point.

After the preparation step of the wafer 50, the wafer ID 57 is provided in a predetermined portion of the wafer ID 57 (the first wafer main surface 51). The wafer ID 57 may be formed by irradiating the first wafer main surface 51 with laser light. The wafer ID 57 may be formed by notching the first wafer main surface 51 in a groove shape with a needle, etc. The wafer ID 57 may be printed on the first wafer main surface 51 with an ink, etc. The wafer ID 57 may be formed by digging into the first wafer main surface 51 by an etching method.

After the wafer ID 57 is provided, an acquisition step of the wafer ID 57 is performed by the first ID reading device 120 (step S32 in FIG. 74). The wafer ID 57 acquired by the first ID reading device 120 is stored in the transfer-side control device 124.

Next, the forming step of the first layer 8 as the epitaxial layer is performed by the epitaxial growth device 121 (step S33 in FIG. 74). In this step, the wafer 50 is carried into the epitaxial growth device 121, and the first layer 8 is formed with the first wafer main surface 51 of the wafer 50 as a starting point by the epitaxial growth method (step S4 in FIG. 41: see also FIG. 42B).

Consequently, an epitaxial wafer including the wafer 50 and the first layer 8 is formed. After the forming step of the first layer 8, the wafer 50 is carried out from the epitaxial growth device 121. In this step, the epitaxial growth step is performed in parallel on the plurality of wafers 50 by the plurality of epitaxial growth devices 121.

Next, an inspection step of the first layer 8 (the epitaxial layer) is performed by the inspection device 122 (step S34 in FIG. 74). In this step, the wafer 50 is carried into the inspection device 122, and specifications of the first layer 8 are inspected. In this step, the plurality of wafers 50 having been subjected to the epitaxial growth step from the plurality of epitaxial growth devices 121 are sequentially carried into the inspection device 122, and the specifications of the first layers 8 of the plurality of wafers 50 are sequentially inspected by the inspection device 122. Inspection results of the first layer 8 are stored in the transfer-side control device 124, and the specification data 138 is generated. After the inspection step of the first layer 8, the wafer 50 is carried out from the inspection device 122.

Next, a measurement step of the crystal orientation of the wafer 50 is performed by the X-ray diffraction device 123 (step S35 in FIG. 74). The measurement step of the crystal orientation (step S35 in FIG. 74) may be performed before the inspection step (step S34 in FIG. 74). In this step, the crystal orientation of the first layer 8 (the epitaxial layer) as the crystal orientation of the wafer 50 is inspected (see also step S5 in FIG. 41). The crystal orientation of the first layer 8 is the off angle θoff of the first layer 8.

In this step, the plurality of wafers 50 having been subjected to the inspection step from the plurality of inspection devices 122 are sequentially carried into the X-ray diffraction device 123, and the crystal orientations of the plurality of wafers 50 are sequentially measured by the X-ray diffraction device 123. The X-ray diffraction device 123 performs the measurement step of the off angle θoff of the first layer 8 by the rocking curve measurement method (the so-called ω-2θ measurement method).

The X-ray diffraction device 123 may be programmed to perform the rocking curve measurement method only for one location (for example, a central portion) of the upper end of the first layer 8. In a case where in-plane variation in the off angle θoff is assumed, the X-ray diffraction device 123 may be programmed to perform the rocking curve measurement method at a plurality of locations (for example, a central portion and a peripheral edge portion) of the upper end of the first layer 8.

FIG. 75 shows measuring locations in the case where the rocking curve measurement method is performed at a plurality of (here, five) locations of the upper end of the first layer 8. Here, the off angle θoff of the first layer 8 is set to approximately 4°. In FIG. 75, first to fifth measuring points Po1 to Po5 are shown.

The first measuring point Po1 is set at the central portion of the first layer 8. The second measuring point Po2 is set on the peripheral edge portion of the first layer 8 on one side (a side opposite to the mark 54) in the second direction Y at an interval from the first measuring point Po1. The third measuring point Po3 is set on the peripheral edge portion of the first layer 8 on one side (the right side with respect to the mark 54) in the first direction X at an interval from the first measuring point Po1.

The fourth measuring point Po4 is set on the peripheral edge portion of the first layer 8 on the other side (the mark 54 side) in the second direction Y at an interval from the first measuring point Po1. The fifth measuring point Po5 is set on the peripheral edge portion of the first layer 8 on the other side (the left side with respect to the mark 54) in the first direction X at an interval from the first measuring point Po1.

Measurement results of the incident angles ω, the diffraction angles 2θ, and the off angles θoff at the first to fifth measuring points Po1 to Po5 are as shown on the graph in FIG. 76. In FIG. 76, the ordinate indicates the strength of the diffracted X-ray L2, and the abscissa indicates the incident angle ω. The measurement results in FIG. 76 are shown in Table 1 below. The off angle θoff is obtained by a calculation formula of "ω - (20 × 1/2)" using the incident angle ω and the diffraction angle 2θ.

### [Table 1]

**Table 1**

| Measuring point | ω (°) | 2θ (°) | θoff (°) |
|---|---|---|---|
| Po1 | 21.836 | 35.606 | 4.033 |
| Po2 | 21.830 | 35.609 | 4.025 |
| Po3 | 21.841 | 35.611 | 4.035 |
| Po4 | 21.837 | 35.609 | 4.033 |
| Po5 | 21.856 | 35.606 | 4.053 |
| Average | | | 4.036 |
| Standard deviation | | | 0.009 |

As shown in Table 1, an average value of the off angles θoff of the first to fifth measuring points Po1 to Po5 was 4.036°, and the standard deviation of these off angles θoff was 0.009° (±0.01°). This leads to an understanding that the in-plane variation in the off angle θoff occurring at the upper end of the first layer 8 is very small and has a magnitude that does not interfere with the channeling implantation step.

Therefore, it is understood that there is no problem to set at least one location as a measuring location with respect to the upper end of the first layer 8. For example, the measuring location may be any one or a plurality of (all of) the first to fifth measuring points Po1 to Po5. For example, the measuring location may be only the first measuring point Po1. By reducing measuring locations (the number of measurements), the number of manufacturing processes (manufacturing costs) is reduced.

As a matter of course, the off angle θoff may be measured at a plurality of locations of the upper end of the first layer 8, and an implantation angle according to the in-plane variation in the off angle θoff may be set in the channeling implantation step. In this case, although the number of manufacturing processes (manufacturing costs) increases, an in-plane error of the first regions 14 formed in the first layer 8 is appropriately prevented. The measurement result (the off angle θoff of the first layer 8) by the X-ray diffraction device 123 is stored in the transfer-side control device 124, and the off-angle data 104 is generated. After the off-angle measurement step, the wafer 50 is carried out from the X-ray diffraction device 123.

Next, a transfer step of the off-angle data 104 through the second communication device 132 is performed (step S36 in FIG. 74). In this step, the specification data 138 is also transferred. Specifically, the transfer-side control device 124 accesses the server device 101 through the second communication device 132 and transfers (uploads) a data set including the wafer ID 57, the off-angle data 104 associated with the wafer ID 57, and the specification data 138 associated with the wafer ID 57 to the server device 101. The data set transferred to the server device 101 is stored in the server control device 110 of the server device 101.

The off-angle transfer device 102 does not necessarily transfer both the off-angle data 104 and the specification data 138 to the server device 101 at the same time. For example, the off-angle transfer device 102 may transfer the off-angle data 104 and the specification data 138 to the server device 101 at different timings. As a matter of course, the off-angle transfer device 102 may transfer only the off-angle data 104 to the server device 101.

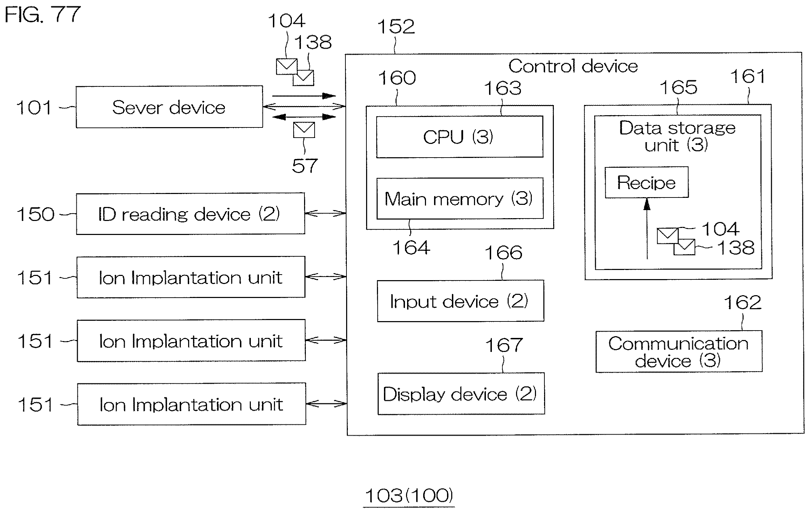

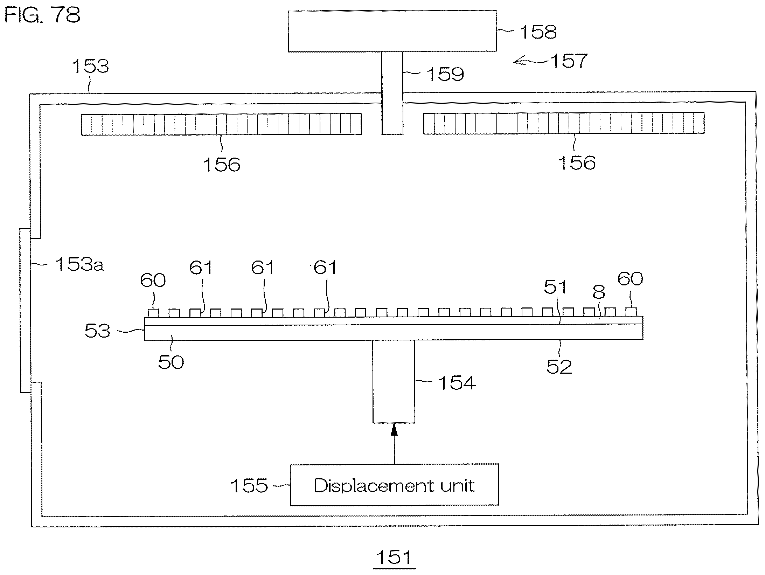

Hereinafter, a configuration example of the channeling ion implantation device 103 will be described. FIG. 77 is a schematic diagram showing the configuration example of the channeling ion implantation device 103 shown in FIG. 71. FIG. 78 is a schematic diagram showing a configuration of an ion implantation processing unit 151 shown in FIG. 77. FIG. 77 shows a configuration of one channeling ion implantation device 103.

The channeling ion implantation device 103 includes one or a plurality of second ID reading devices 150, one or a plurality of ion implantation processing units 151, and a control device 152. The second ID reading device 150 may be referred to as a "second ID reading unit". The ion implantation processing unit 151 may be referred to as an "ion implanting unit", an "ion implantation device", etc.

The number of the second ID reading devices 150 and the number of the ion implantation processing units 151 are arbitrary. In view of the manufacturing efficiency, the channeling ion implantation device 103 preferably includes a plurality of ion implantation processing units 151. FIG. 77 shows an example in which the single second ID reading device 150 and the plurality of ion implantation processing units 151 are provided.

The second ID reading device 150 is a device that reads the wafer ID 57 of the wafer 50. For example, the second ID reading device 150 is a scanner that includes an imaging device which images the wafer 50 and that reads the wafer ID 57 from image data of the wafer 50.

The imaging device may include one or both of a CCD image sensor and a CMOS image sensor. For example, the second ID reading device 150 may include a processing chamber (not shown) and be arranged to obtain the wafer ID 57 in the processing chamber. As a matter of course, the second ID reading device 150 may be a handheld scanner.

The plurality of ion implantation processing units 151 are units that implant ions into the first layer 8 (into the wafer 50) by a channeling ion implantation method. That is, the plurality of ion implantation processing units 151 constitute respective main body portions of the channeling ion implantation devices 103. With reference to FIG. 78, each of the ion implantation processing units 151 includes a processing chamber 153, a support unit 154, a displacement unit 155, a heating unit 156, and an ion beam generation unit 157.

For example, the processing chamber 153 has box-shaped partition walls that define an internal space thereof and has an opening/closing shutter 153a that enables the wafer 50 to be carried-in/carried-out. The support unit 154 is provided in the processing chamber 153 and supports the wafer 50 from the second wafer main surface 52 side. The support unit 154 may be an electrostatic chuck that supports the wafer 50 with static electricity or may be a vacuum chuck that supports the wafer 50 with a suction force.

The displacement unit 155 is connected to the support unit 154 and displaces, together with the support unit 154, a posture of the wafer 50. For example, the displacement unit 155 may rotate the wafer 50 about the vertical axis. For example, the displacement unit 155 may rotate, together with the support unit 154, the wafer 50 about the horizontal axis orthogonal to the vertical axis and inclines the wafer 50 with respect to the horizontal plane. For example, the displacement unit 155 may include one or a plurality of electric motors. The heating unit 156 is arranged in the processing chamber 153 and heats the wafer 50.

The ion beam generation unit 157 is a unit that irradiates the wafer 50 with an ion beam including a trivalent element or a pentavalent element. In this embodiment, since the plurality of first regions 14 are formed in the first layer 8 (the plurality of second regions 15 in the second layer 9), a trivalent element is selected. As a matter of course, in a case where an n-type channeling implantation region is formed in the epitaxial layer, a pentavalent element is selected.

The ion beam generation unit 157 includes an ion source unit 148 and a beamline unit 149. The ion source unit 148 is provided outside the processing chamber 153 and ionizes impurity gas composed of a trivalent element or a pentavalent element. The beamline unit 149 is coupled to the processing chamber 153 and the ion source unit 148. The beamline unit 149 includes an accelerator and a lens, accelerates ions generated by the ion source unit 148, and shapes the ions into a beam shape.

The control device 152 is connected to the second ID reading device 150 and the plurality of ion implantation processing units 151, retrieves the wafer ID 57 from the second ID reading device 150, and controls the ion implantation processing unit 151 based on a predetermined processing recipe.

The control device 152 includes a third processing device 160, a third auxiliary memory 161, and a third communication device 162. The third processing device 160 includes a third central processing unit 163 and a third main memory 164. The third main memory 164 may be a semiconductor memory. The semiconductor memory may include a volatile memory such as a RAM and a nonvolatile memory such as a ROM.

The third auxiliary memory 161 is a storage medium (specifically, a non-volatile storage medium) in which a program for causing the third processing device 160 to execute a predetermined step has been stored. The third auxiliary memory 161 may include a single storage medium or a plurality of storage media. Examples of the third auxiliary memory 161 may include a magnetic disk, an optical disk, a flash memory, etc.

The third auxiliary memory 161 includes a third data storage unit 165. The third data storage unit 165 is a region which includes one or a plurality of memories and in which various items of data to be used in the manufacture of the SiC semiconductor devices 1A to 1C are stored. The third data storage unit 165 includes a processing recipe, etc., for controlling the ion implantation processing unit 151. Also, the third data storage unit 165 includes a region in which the wafer ID 57 is stored, a region in which the off-angle data 104 is stored, a region in which the specification data 138 is stored, etc.

The third communication device 162 is an interface that is connected to the server device 101 in a wired or wireless manner and transmits and receives various items of data to and from the server device 101. In this embodiment, the third communication device 162 is an interface communicating with the server device 101 through a communication network. The third communication device 162 may be a wireless LAN interface, a wired LAN interface, a wireless WAN, a wired WAN, etc.

The control device 152 accesses the server device 101 through the third communication device 162 and acquires (downloads) a data set including the off-angle data 104 and the specification data 138 from the server device 101. As a matter of course, the control device 152 may be arranged to acquire the off-angle data 104 and the specification data 138 from the server device 101 at different timings.

Specifically, the control device 152 acquires a data set including the off-angle data 104 associated with the wafer ID 57 and the specification data 138 associated with the wafer ID 57 based on the wafer ID 57 acquired by the second ID reading device 150. The off-angle data 104 and the specification data 138 acquired through the third communication device 162 are stored in the third data storage unit 165 and incorporated into the processing recipe of the ion implantation processing unit 151.

The control device 152 may include a second input device 166 and a second display device 167. The second input device 166 is a device for retrieving data to the control device 152 (the third processing device 160, the third auxiliary memory 161, etc.) by external operation (for example, user operation).

Examples of the second input device 166 may include a keyboard, a pointing device, a touch panel, etc. The second display device 167 is a device that outputs processing details in the control device 152 to the outside. Examples of the second display device 167 may include a touch panel, a display, etc.

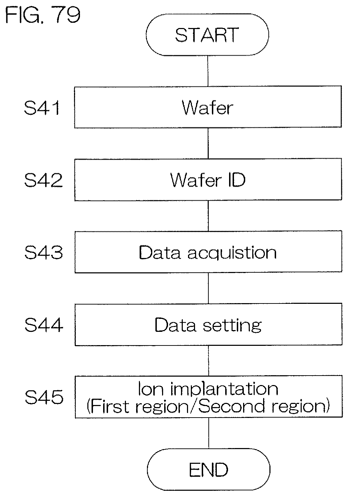

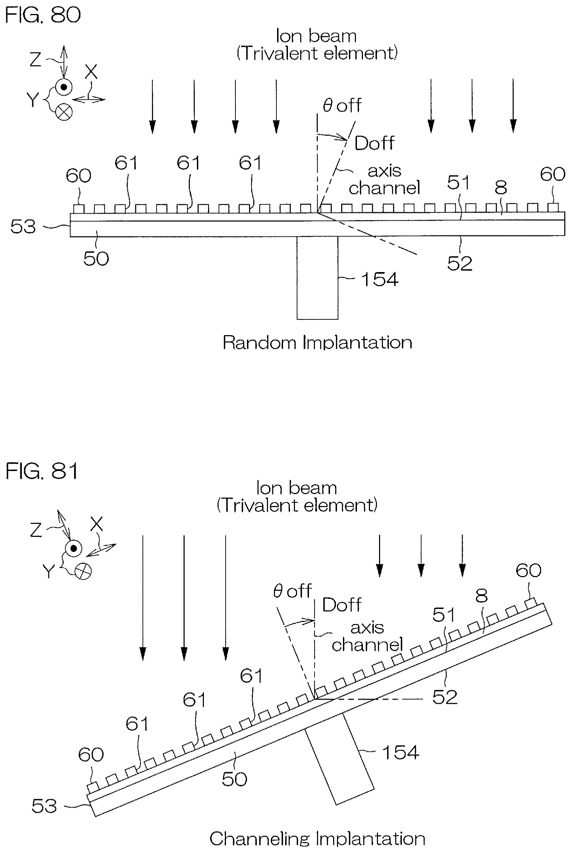

FIG. 79 is a flowchart showing a process example of the channeling ion implantation device 103. FIG. 80 is a schematic view for illustrating an ion implantation step. FIG. 81 is a schematic view for illustrating an ion implantation step.

First, with reference to FIG. 79, a preparation step of the wafer 50 (see FIG. 40) described above is performed (step S41 in FIG. 79). The wafer 50 is the wafer 50 in which the first mask 60 is formed on the first layer 8 through a series of processing steps by the off-angle transfer device 102 (step S6 in FIG. 41: see also FIG. 42C). That is, the wafer 50 is the epitaxial wafer having the first layer 8.

Next, an acquisition step of the wafer ID 57 is performed by the second ID reading device 150 (step S42 in FIG. 79). The wafer ID 57 acquired by the second ID reading device 150 is stored in the control device 152.

Next, an acquisition step of the off-angle data 104 through the third communication device 162 is performed (step S43 in FIG. 79). Specifically, the control device 152 accesses the server device 101 through the third communication device 162 and acquires (downloads) the data set including the off-angle data 104 associated with the wafer ID 57 and the specification data 138 associated with the wafer ID 57 based on the wafer ID 57 acquired by the second ID reading device 150. The data set including the off-angle data 104 and the specification data 138 is stored in the control device 152.

The channeling ion implantation device 103 does not necessarily acquire both the off-angle data 104 and the specification data 138 from the server device 101 at the same time. For example, the channeling ion implantation device 103 may acquire the off-angle data 104 and the specification data 138 from the server device 101 at different timings. As a matter of course, the channeling ion implantation devices 103 may acquire only the off-angle data 104 from the server device 101.

Next, the off-angle data 104 is set in the processing recipe of the ion implantation processing unit 151 (step S43 in FIG. 79). In this step, the specification data 138 is also set in the processing recipe of the ion implantation processing unit 151. The ion implantation processing unit 151 is controlled based on the processing recipe in which the off-angle data 104 and the specification data 138 are incorporated. Specifically, in the ion implantation processing unit 151, the displacement unit 127 is controlled based on the off-angle data 104, and the inclination angle of the first layer 8 with respect to the ion implantation angle of the ion beam (the trivalent element) is adjusted.

Also, in the ion implantation processing unit 151, the implantation energy of the ion beam (the trivalent element) and the implantation temperature (the temperature of the wafer 50) of the ion beam (the trivalent element) are adjusted based on the specification data 138. That is, in this step, a concentration profile of the first region 14 which needs to be formed in the first layer 8, the thickness (the depth) of the first region 14, etc., are adjusted based on the off-angle data 104 and the specification data 138 (see also FIGS. 13A to 13E).

Next, the channeling implantation step for the first layer 8 is performed by the ion implantation processing unit 151 (step S44 in FIG. 79). In this step, an ion beam (the trivalent element) is introduced into the first layer 8 along the first axis channel CH1 (step S7 in FIG. 41: see also FIG. 42D).

The implantation angle of the ion beam (the trivalent element) is preferably set within a range of ±2° on the basis of an axis along the first axis channel CH1 (the c-axis of the SiC monocrystal in this embodiment) (0°). The implantation angle is particularly preferably set within a range of ±1° on the basis of an axis along the first axis channel CH1 (the c-axis of the SiC monocrystal in this embodiment) (0°).

In other words, the implantation angle is preferably set within a range of ±2° of the off angle θoff. The implantation angle is particularly preferably set within a range of ±1° of the off angle θoff. Preferably, the implantation angle is substantially equal to the off angle θoff.

With reference to FIG. 80, in the random implantation method, a trivalent element is introduced into the first layer 8 with predetermined implantation energy in a direction intersecting the first axis channel CH1 (see also FIG. 14). For example, in the random implantation method, the trivalent element is implanted in the vertical direction Z perpendicular to the upper end (the first wafer main surface 51) of the first layer 8.

In the case of the random implantation method, since the trivalent element is introduced in a direction in which relatively dense atomic rows are present in plan view, the trivalent element collides with the atomic rows at a relatively shallow depth position. Hence, the atomic rows inhibit the trivalent element from being introduced into a relatively deep depth position of the first layer 8. As a result, the first region 14 not having the gentle gradient portion 22 is formed (see also FIG. 14).

Meanwhile, with reference to FIG. 81, in the channeling implantation method, an implantation angle of the trivalent element with respect to the first layer 8 is controlled, and the trivalent element is introduced into the first layer 8 with predetermined implantation energy along the first axis channel CH1 (the c-axis of the SiC monocrystal in this embodiment) (see also FIGS. 13A to 13E).

In the case of the channeling implantation method, the trivalent element is introduced along the first axis channel CH1 in which atomic rows are relatively sparse in plan view. The trivalent element travels in the first axis channel CH1 while repeating small-angle scattering due to a channeling effect and reaches a relatively deep depth position of the first layer 8.

That is, in the case of the channeling implantation method, a collision probability of the trivalent element with respect to the atomic rows of the SiC monocrystal is reduced. Consequently, the first region 14 having a target concentration profile and a target thickness is formed. After the forming step of the first region 14, the wafer 50 is carried out from the ion implantation processing unit 151. Thereafter, steps S8 to S21 in FIG. 41 (see FIGS. 42E to 42H) are sequentially performed.

The forming step of the second layer 9 (see step S12 in FIG. 41, and FIG. 42E) and the forming step of the second region 15 (see step S14 in FIG. 41, and FIG. 42G) are performed by using the ion implantation processing system 100 described above as in the case of the forming step of the first layer 8 (step S33 in FIG. 74) and the forming step of the first region 14 (step S45 in FIG. 79). The specific description of this case is obtained by replacing the "first layer 8" with the "second layer 9" and replacing the "first region 14" with the "second region 15" in the above description.

In a case where the off-angle data 104 of the second layer 9 is substantially equal to the off-angle data 104 of the first layer 8, the off-angle data 104 of the first layer 8 may be used as the off-angle data 104 of the second layer 9. In a case where the specification data 138 of the second layer 9 is substantially equal to the specification data 138 of the first layer 8, the specification data 138 of the first layer 8 may be used as the specification data 138 of the second layer 9.

For example, in a device in which the X-ray diffraction device 123 is incorporated in the channeling ion implantation device 103, the off-angle measurement step by the X-ray diffraction device 123 and the ion implantation step by the channeling ion implantation device 103 are completed in one device, thus enhancing convenience.

However, the number of wafers 50 processed per unit time by the channeling ion implantation device 103 is different from the number of wafers 50 processed per unit time by the X-ray diffraction device 123. Specifically, the number of wafers processed by the channeling ion implantation device 103 is less than the number of wafers processed by the X-ray diffraction device 123. That is, the X-ray diffraction device 123 has a processing capability higher than a processing capability of the channeling ion implantation device 103, and can perform the off-angle measurement step a plurality of times before one ion implantation step is ended.

Therefore, in a case where the off-angle measurement step and the ion implantation step are sequentially performed for the plurality of wafers 50, the off-angle measurement step needs to be performed after the end of the ion implantation step, thus resulting in a process dead time between the off-angle measurement step and the ion implantation step. Therefore, in the device in which the X-ray diffraction device 123 is incorporated in the channeling ion implantation device 103, the processing capability of the X-ray diffraction device 123 cannot be sufficiently utilized.

On the other hand, the ion implantation processing system 100 includes the channeling ion implantation device 103 (the ion implantation device) that acquires, from the server device 101 (a server), the off-angle data 104 of the wafer 50 that is the ion implantation processing target and controls the ion implantation angle with respect to the wafer 50 based on the off-angle data 104.

According to this configuration, the channeling ion implantation device 103 acquires, from the server device 101, the off-angle data 104 stored in advance in the server device 101. Therefore, since the off-angle measurement step is separated from the ion implantation step, the off-angle measurement step does not need to be performed after the end of the ion implantation step. Consequently, the process dead time between the off-angle measurement step and the ion implantation step is prevented.

Also, the ion implantation processing system 100 preferably includes the plurality of channeling ion implantation devices 103. According to this configuration, the manufacturing efficiency can be improved. The channeling ion implantation device 103 preferably acquires the off-angle data 104 based on the wafer ID 57 from the server device 101 in which the off-angle data 104 associated with the wafer ID 57 has been stored. According to this configuration, since the ion implantation step is managed for each wafer 50 based on the wafer ID 57, the accuracy of the process is improved.

The wafer 50 may have the first wafer main surface 51 to which the wafer ID 57 is provided. The channeling ion implantation device 103 may include the second ID reading device 150 (the ID reading device) that reads the wafer ID 57 from the first wafer main surface 51. In this case, the channeling ion implantation device 103 acquires the off-angle data 104 associated with the wafer ID 57 from the server device 101 based on the wafer ID 57 acquired by the second ID reading device 150.

The wafer 50 may be the epitaxial wafer including the first layer 8 (the epitaxial layer). In this case, the off-angle data 104 may correspond to the off angle θoff of the first layer 8. The channeling ion implantation device 103 may control the ion implantation angle with respect to the first layer 8 based on the off-angle data 104. According to this configuration, the ion implantation step for the first layer 8 can be accurately performed.

As a matter of course, the wafer 50 may be the epitaxial wafer including the second layer 9 (the epitaxial layer). In this case, the off-angle data 104 may correspond to the off angle θoff of the second layer 9. The channeling ion implantation device 103 may control the ion implantation angle with respect to the second layer 9 based on the off-angle data 104. According to this configuration, the ion implantation step for the second layer 9 can be accurately performed.

The channeling ion implantation device 103 may acquire the off-angle data 104 and the specification data 138 from the server device 101 in which the off-angle data 104 of the first layer 8 (the second layer 9) and the specification data 138 of the first layer 8 (the second layer 9) are stored. In this case, the channeling ion implantation device 103 may adjust an ion implantation processing condition for the first layer 8 (the second layer 9) based on the off-angle data 104 and the specification data 138. According to this configuration, the first region 14 (the second region 15) can be appropriately formed in accordance with the specifications of the first layer 8 (the second layer 9).

The ion implantation processing system 100 preferably includes the off-angle transfer device 102 that transfers the off-angle data 104 of the wafer 50 before ion implantation processing to the server device 101. According to this configuration, independently of the channeling ion implantation device 103, the off-angle transfer device 102 can transfer the off-angle data 104 to the server device 101. Therefore, the off-angle transfer device 102 does not need to be performed after the end of the ion implantation processing step of the channeling ion implantation device 103.

Meanwhile, independently of the off-angle transfer device 102, the channeling ion implantation device 103 can acquire the off-angle data 104 from the server device 101 and perform the ion implantation step. That is, the channeling ion implantation device 103 can sequentially process the wafers 50 based on the off-angle data 104 stored in advance in the server device 101. Consequently, the process dead time between the off-angle transfer device 102 and the channeling ion implantation device 103 is prevented.

In this case, the channeling ion implantation device 103 is installed independently of the off-angle transfer device 102. The ion implantation processing system 100 preferably includes the plurality of off-angle transfer devices 102. According to this configuration, the manufacturing efficiency can be improved.

The off-angle transfer device 102 preferably transfers the off-angle data 104 of the wafer 50 in association with the wafer ID 57 to the server device 101. In this case, the channeling ion implantation device 103 preferably acquires the off-angle data 104 corresponding to the wafer ID 57 from the server device 101. According to this configuration, the off-angle data 104 is managed for each wafer 50 based on the wafer ID 57, and the ion implantation step is managed for each wafer 50 based on the wafer ID 57, so that the accuracy of the process is improved.

The wafer 50 may be the epitaxial wafer including the first layer 8 (the epitaxial layer). In this case, the off-angle transfer device 102 may transfer the off angle θoff of the first layer 8 as the off-angle data 104 of the wafer 50 to the server device 101. The channeling ion implantation device 103 may control the ion implantation angle with respect to the first layer 8 based on the off-angle data 104. According to this configuration, the ion implantation step for the first layer 8 can be accurately performed.

As a matter of course, the wafer 50 may be the epitaxial wafer including the second layer 9 (the epitaxial layer). In this case, the off-angle transfer device 102 may transfer the off angle θoff of the second layer 9 as the off-angle data 104 of the wafer 50 to the server device 101. The channeling ion implantation device 103 may control the ion implantation angle with respect to the second layer 9 based on the off-angle data 104. According to this configuration, the ion implantation step for the second layer 9 can be accurately performed.

The off-angle transfer device 102 can include the X-ray diffraction device 123 that measures the off angle θoff of the wafer 50 with X-rays. The off angle θoff of the wafer 50 may be the off angle θoff of the first layer 8 (the second layer 9). In this case, the off-angle transfer device 102 generates the off-angle data 104 based on the measurement result by the X-ray diffraction device 123 and transfers the off-angle data 104 to the server device 101.

According to this configuration, the off-angle measurement step by the X-ray diffraction device 123 does not need to be performed after the end of the ion implantation step by the channeling ion implantation device 103. Therefore, it is possible to prevent the occurrence of the process dead time between the off angle measurement step by the X-ray diffraction device 123 and the ion implantation step by the channeling ion implantation device 103. Accordingly, the processing capability of the X-ray diffraction device 123 can be appropriately utilized.

The off-angle transfer device 102 may include the epitaxial growth device 121 that laminates the first layer 8 (the second layer 9) on the wafer 50 and forms the epitaxial wafer. In this case, the off-angle transfer device 102 may generate the specification data 138 of the first layer 8 (the second layer 9) and transfer, together with off-angle data 104, the specification data 138 to server device 101.

Meanwhile, the channeling ion implantation device 103 may acquire the off-angle data 104 and the specification data 138 from the server device 101. According to this configuration, the first region 14 (the second region 15) can be appropriately formed in accordance with the specifications of the first layer 8 (the second layer 9). In this case, the off-angle transfer device 102 may include the inspection device 122 that inspects the first layer 8 (the second layer 9) and generate the specification data 138 based on the inspection results of the inspection device 122.

In general, the X-ray diffraction device 123 has higher processing capability than the processing capability of the epitaxial growth device 121. Therefore, the off-angle transfer device 102 can include a plurality of epitaxial growth devices 121 in addition to the X-ray diffraction device 123.

According to this configuration, the plurality of wafers 50 are sequentially transferred from the plurality of epitaxial growth devices 121 to the X-ray diffraction device 123, and the X-ray diffraction device 123 sequentially performs the off-angle measurement step on the plurality of wafers 50. Therefore, since a stop time of the X-ray diffraction device 123 can be shortened, the processing capability of the X-ray diffraction device 123 can be appropriately utilized.

The off-angle transfer device 102 only needs to have a function of transferring (uploading) the off-angle data 104 (preferably, the wafer ID 57 and the off-angle data 104 associated with the wafer ID 57) to the server device 101, and the presence or absence of the first ID reading device 120, the presence or absence of the X-ray diffraction device 123, the presence or absence of the inspection device 122, and the presence or absence of the epitaxial growth device 121 are all arbitrary.

Therefore, the off-angle transfer device 102 that does not include at least one or all of the first ID reading device 120, the X-ray diffraction device 123, the inspection device 122, and the epitaxial growth device 121 may be employed.

The off-angle transfer device 102 does not necessarily need to include the first ID reading device 120, and the ion implantation processing system 100 may include the first ID reading device 120 installed independently of the off-angle transfer device 102.

For example, in a case where the wafer ID 57 is acquired in advance, etc., the off-angle transfer device 102 may be arranged to retrieve the wafer ID 57 to the transfer-side control device 124 by input operation from the outside through the first input device 139. The "input operation" mentioned here includes not only a manual input of the wafer ID 57 by a user but also includes download operation of the wafer ID 57 through the communication network (the second communication device 132).

The off-angle transfer device 102 does not necessarily need to include the X-ray diffraction device 123, and the ion implantation processing system 100 may include the X-ray diffraction device 123 installed independently of the off-angle transfer device 102.

For example, in a case where the off-angle data 104 is acquired in advance, etc., the off-angle transfer device 102 may be arranged to retrieve the off-angle data 104 to the transfer-side control device 124 by the input operation from the outside through the first input device 139. The "input operation" mentioned here includes not only a manual input of the off-angle data 104 by the user but also download operation of the off-angle data 104 through the communication network (the second communication device 132).

The off-angle transfer device 102 does not necessarily need to include the inspection device 122, and the ion implantation processing system 100 may include the inspection device 122 installed independently of the off-angle transfer device 102.

For example, in a case where the specification data 138 is acquired in advance, etc., the off-angle transfer device 102 may be arranged to retrieve the specification data 138 to the transfer-side control device 124 by the input operation from the outside through the first input device 139. The "input operation" mentioned here includes not only a manual input of the specification data 138 by the user but also download operation of the specification data 138 through the communication network (the second communication device 132).

As a matter of course, the ion implantation processing system 100 that does not include the inspection device 122 may be employed. For example, in a case where the specifications of the first layer 8 (the second layer 9) are determined to some extent, in a case where the specifications of the first layer 8 (the second layer 9) are not strictly managed, etc., the common specification data 138 applied to all the wafers 50 (the wafer IDs 57) may be stored in advance in the transfer-side control device 124 (the second data storage unit 135). As a matter of course, the common specification data 138 may be stored in the server device 101 in advance.

The off-angle transfer device 102 does not necessarily need to include the epitaxial growth device 121, and the ion implantation processing system 100 may include the epitaxial growth device 121 installed independently of the off-angle transfer device 102.

The channeling ion implantation device 103 does not necessarily need to include the second ID reading device 150, and the ion implantation processing system 100 may include the second ID reading device 150 installed independently of the channeling ion implantation device 103.

For example, in the case where the wafer ID 57 is acquired in advance, etc., the channeling ion implantation device 103 may be arranged to retrieve the wafer ID 57 to the control device 152 by input operation from the outside through the second input device 166. The "input operation" mentioned here includes not only the manual input of the wafer ID 57 by the user but also download operation of the wafer ID 57 through the communication network (the third communication device 162).

The embodiments described above can be implemented in yet other embodiments. In each of the embodiments described above, the ornamental pattern PT is formed in the first to fourth side surfaces 5A to 5D. However, a structure without the ornamental pattern PT may be employed. In this case, the plurality of first regions 14 and the plurality of second regions 15 are formed in the laminated portion 7 at intervals inward from the first to fourth side surfaces 5A to 5D.

For example, the plurality of first regions 14 and the plurality of second regions 15 may be formed in the active region 10 at intervals inward from the outer peripheral region 11. As a matter of course, one of the plurality of first regions 14 and the plurality of second regions 15 may be exposed from the first to fourth side surfaces 5A to 5D, and the other of the plurality of first regions 14 and the plurality of second regions 15 may be formed at intervals inward from the first to fourth side surfaces 5A to 5D.

In each of the embodiments described above, the base layer 6, the first layer 8, the second layer 9, the buffer layer 26, and the top layer 30 each including the SiC monocrystal are employed. However, at least one or all of the base layer 6, the first layer 8, the second layer 9, the buffer layer 26, and the top layer 30 may include a monocrystal of a wide bandgap semiconductor other than the SiC monocrystal.

The wide bandgap semiconductor is a semiconductor that has a bandgap wider than the bandgap of silicon. Examples of the monocrystal of the wide bandgap semiconductor include silicon carbide (SiC), gallium nitride (GaN), diamond (C), and gallium oxide (Ga₂O₃). The base layer 6, the first layer 8, the second layer 9, the buffer layer 26, and the top layer 30 may be constituted of a monocrystal of the same type or may be constituted of a monocrystal of different types.

The channeling implantation step (the step of implanting impurities into a region where atomic rows are sparse) described above is also applicable to a monocrystal constituting a cubical crystal. Therefore, the monocrystal of the wide bandgap semiconductor may be a cubical crystal or a hexagonal crystal. In a case where a cubical monocrystal is applied to at least one or all of the base layer 6, the first layer 8, the second layer 9, the buffer layer 26, and the top layer 30, these axis channels are formed by the regions surrounded by atomic rows oriented along a low-index crystal axis of cubical crystal axes.

The low-index crystal axis related to the cubical crystal is a crystal axis whose absolute values of "h," "k," and "l" are all represented by not more than 2 (preferably not more than 1) with respect to Miller indices (h, k, and l). As a matter of course, at least one or all of the base layer 6, the first layer 8, the second layer 9, the buffer layer 26, and the top layer 30 may include a silicon monocrystal.

In the respective embodiments described above, an example in which the MIS structure 31 and the SBD structure 93 are individually formed in the different chips 2 was illustrated. However, the MIS structure 31 and the SBD structure 93 may be formed in the single chip 2. In this case, the SBD structure 93 may be electrically interposed between the source pad 47 (the anode pad) and the drain pad 48 (the cathode pad) as freewheeling diodes with respect to the MIS structure 31.

In the respective embodiments described above, the n-type base layer 6 was described. However, the base layer 6 of the p-type may be employed. In this case, an IGBT (insulated gate bipolar transistor) structure is formed instead of the MISFET structure. In this case, in the above description, the "source" of the MISFET structure is replaced with an "emitter" of the IGBT structure, and the "drain" of the MISFET structure is replaced with a "collector" of the IGBT structure. The p-type base layer 6 may be a p-type region that includes a trivalent element introduced into the surface layer portion of the second main surface 4 of the chip 2 by an ion implantation method.

Hereinafter, examples of features extracted from this Description and the accompanying drawings will be described. Hereinafter, the alphanumeric characters, etc., in parentheses represent the corresponding components, etc., in the respective embodiments described above, but are not intended to limit the scope of clauses to the respective embodiments described above. A "semiconductor device" in the following clauses may be replaced with an "SiC semiconductor device," a "wide bandgap semiconductor device," a "semiconductor switching device," a "semiconductor rectifier," a "MISFET device," an "IGBT device," a "diode device," etc., as necessary.

[A1] A semiconductor device (1A, 1B, 1C) comprising: a first layer (8) of a first conductivity type (n-type) that includes a semiconductor monocrystal and has a first axis channel (CH1) oriented along a lamination direction; a second layer (9) of the first conductivity type (n-type) that includes a semiconductor monocrystal and has a second axis channel (CH2) oriented along the lamination direction and is laminated on the first layer (8); a first region (14) of a second conductivity type (p-type) that extends along the first axis channel (CH1) in the first layer (8) in cross-sectional view and extends in a first extension direction (De1) in plan view; and a second region (15) of the second conductivity type (p-type) that extends along the second axis channel (CH2) in the second layer (9) in cross-sectional view and extends in a second extension direction (De2) intersecting the first extension direction (De1) such as to intersect the first region (14) in plan view.

[A2] The semiconductor device (1A, 1B, 1C) according to A1, wherein the first extension direction (De1) is an m-axis direction or an a-axis direction among crystal orientations.

[A3] The semiconductor device (1A, 1B, 1C) according to A2, wherein the second extension direction (De2) is orthogonal to the first extension direction (De1).

[A4] The semiconductor device (1A, 1B, 1C) according to A2, wherein the second extension direction (De2) is not orthogonal to the first extension direction (De1).

[A5] The semiconductor device (1A, 1B, 1C) according to A1, wherein the first extension direction (De1) is a direction other than an m-axis direction and an a-axis direction among crystal orientations.

[A6] The semiconductor device (1A, 1B, 1C) according to A5, wherein the second extension direction (De2) is orthogonal to the first extension direction (De1).

[A7] The semiconductor device (1A, 1B, 1C) according to A5, wherein the second extension direction (De2) is not orthogonal to the first extension direction (De1).

[A8] The semiconductor device (1A, 1B, 1C) according to any one of A1 to A7, wherein the second extension direction (De2) is a direction other than the m-axis direction and the a-axis direction among crystal orientations.

[A9] The semiconductor device (1A, 1B, 1C) according to any one of A1 to A8, wherein the second region (15) has an extension portion that crosses a boundary portion between the first layer (8) and the second layer (9) and is positioned in the first layer (8).

[A10] The semiconductor device (1A, 1B, 1C) according to A9, wherein the extension portion of the second region (15) is connected to the first region (14) in the first layer (8).

[A11] The semiconductor device (1A, 1B, 1C) according to A9 or A10, wherein the first region (14) is formed at an interval from an upper end toward a lower end side of the first layer (8).

[A12] The semiconductor device (1A, 1B, 1C) according to any one of A1 to A11, further comprising: an intermediate region (25) of the second conductivity type (p-type) that is interposed in a region between the first region (14) and the second region (15).

[A13] The semiconductor device (1A, 1B, 1C) according to A12, wherein the intermediate region (25) is formed in the first layer (8) in the region between the first region (14) and the second region (15).

[A14] The semiconductor device (1A, 1B, 1C) according to any one of A1 to A13, wherein the first region (14) is constituted of a single impurity region that crosses an intermediate portion of the first layer (8) along the first axis channel (CH1), and the second region (15) is constituted of a single impurity region that crosses an intermediate portion of the second layer (9) along the second axis channel (CH2).

[A15] The semiconductor device (1A, 1B, 1C) according to any one of A1 to A14, wherein the first region (14) has a first lower end portion (14a) on a lower end side of the first layer (8) and a first upper end portion (14b) on an upper end side of the first layer (8), and has a first concentration gradient that gradually decreases from the first upper end portion (14b) toward the first lower end portion (14a).

[A16] The semiconductor device (1A, 1B, 1C) according to A15, wherein the first concentration gradient includes a first peak value (PA, 21A) on the first upper end portion (14b) side and a first gentle gradient portion (22A) where an impurity concentration gradually decreases at a gentle decrease rate in a region closer to the first lower end portion (14a) than the first peak value (PA, 21A).

[A17] The semiconductor device (1A, 1B, 1C) according to A16, wherein the first gentle gradient portion (22A) accounts for a thickness range of not less than 1/4 of the first region (14).

[A18] The semiconductor device (1A, 1B, 1C) according to any one of A1 to A17, wherein the second region (15) has a second lower end portion (15a) on a lower end side of the second layer (9) and a second upper end portion (15b) on an upper end side of the second layer (9), and has a second concentration gradient that gradually decreases from the second upper end portion (15b) toward the second lower end portion (15a).

[A19] The semiconductor device (1A, 1B, 1C) according to A18, wherein the second concentration gradient includes a second peak value (PB, 21B) on the second upper end portion (15b) side and a second gentle gradient portion (22B) where an impurity concentration gradually decreases at a gentle decrease rate in a region closer to the second lower end portion (15a) than the second peak value (PB, 21B).

[A20] The semiconductor device (1A, 1B, 1C) according to A19, wherein the second gentle gradient portion (22B) accounts for a thickness range of not less than 1/4 of the second region (15).

[A21] The semiconductor device (1A, 1B, 1C) according to any one of A1 to A20, wherein the first layer (8) is a first SiC layer (8) including an SiC monocrystal, and the second layer (9) is a second SiC layer (9) including an SiC monocrystal.

[B1] A semiconductor device (1A, 1B, 1C) comprising: a semiconductor layer (7) of a first conductivity type (n-type) that has a main surface (3); an active region (10) set in an inner portion of the main surface (3); an outer peripheral region (11) set in a peripheral edge portion of the main surface (3); and a column region (12) of a second conductivity type (p-type) that includes impurity regions (14, 15) which are formed in the semiconductor layer (7) at an interval in a horizontal direction along the main surface (3) and positioned in both the active region (10) and the outer peripheral region (11).

[B2] The semiconductor device (1A, 1B, 1C) according to B1, wherein the semiconductor layer (7) has a laminated structure including a first layer (8) of the first conductivity type (n-type) and a second layer (9) of the first conductivity type (n-type) that is laminated on the first layer (8), and the column region (12) includes first regions (14) as the impurity regions (14, 15) that are formed in the first layer (8) at an interval in the horizontal direction and positioned in both the active region (10) and the outer peripheral region (11), and second regions (15) as the impurity regions (14, 15) that are formed in the second layer (9) at an interval in the horizontal direction and positioned in both the active region (10) and the outer peripheral region (11).

[B3] The semiconductor device (1A, 1B, 1C) according to B2, wherein the first layer (8) has a first axis channel (CH1) oriented along a lamination direction, the second layer (9) has a second axis channel (CH2) oriented along the lamination direction, the first region (14) extends along the first axis channel (CH1) in the first layer (8), and the second region (15) extends along the second axis channel (CH2) in the second layer (9).

[B4] The semiconductor device (1A, 1B, 1C) according to B3, wherein the first region (14) is constituted of the single impurity region (14) that crosses an intermediate portion of the first layer (8) along the first axis channel (CH1), and the second region (15) is constituted of the single impurity region (15) that crosses an intermediate portion of the second layer (9) along the second axis channel (CH2).

[B5] The semiconductor device (1A, 1B, 1C) according to any one of B2 to B4, wherein the second region (15) has an extension portion that crosses a boundary portion between the first layer (8) and the second layer (9) and is positioned in the first layer (8).

[B6] The semiconductor device (1A, 1B, 1C) according to any one of B2 to B5, wherein the first region (14) is formed at an interval from an upper end toward a lower end side of the first layer (8).

[B7] The semiconductor device (1A, 1B, 1C) according to any one of B2 to B6 wherein the first region (14) includes a first peak value (PA, 21A) on an upper end side of the first layer (8) and a first gentle gradient portion (22A) in which an impurity concentration gradually decreases at a gentle decrease rate in a region closer to a lower end of the first layer (8) than the first peak value (PA, 21A), and the second region (15) includes a second peak value (PB, 21B) on an upper end side of the second layer (9) and a second gentle gradient portion (22B) in which an impurity concentration gradually decreases at a gentle decrease rate in a region closer to a lower end of the second layer (9) than the second peak value (PB, 21B).

[B8] The semiconductor device (1A, 1B, 1C) according B7, wherein the first gentle gradient portion (22A) accounts for a thickness range of not less than 1/4 of the first region (14), and the second gentle gradient portion (22B) accounts for a thickness range of not less than 1/4 of the second region (15).

[B9] The semiconductor device (1A, 1B, 1C) according to any one of B2 to B8, wherein the first region (14) extends in a first extension direction (De1), and the second region (15) extends in a second extension direction (De2) different from the first extension direction (De1) and intersect the first region (14).

[B10] The semiconductor device (1A, 1B, 1C) according to B9, wherein the first extension direction (De1) is an m-axis direction or an a-axis direction among crystal orientations.

[B11] The semiconductor device (1A, 1B, 1C) according to B9, wherein the first extension direction (De1) is a direction other than an m-axis direction and an a-axis direction among crystal orientations.

[B12] The semiconductor device (1A, 1B, 1C) according to B11, wherein the second extension direction (De2) is a direction other than the m-axis direction and the a-axis direction among the crystal orientations.

[B13] The semiconductor device (1A, 1B, 1C) according to B9, wherein the second extension direction (De2) is orthogonal to the first extension direction (De1).

[B14] The semiconductor device (1A, 1B, 1C) according to B9, wherein the second extension direction (De2) is not orthogonal to the first extension direction (De1).

[B15] The semiconductor device (1A, 1B, 1C) according to any one of B2 to B8, wherein the first regions (14) extend in a first extension direction (De1), and the second regions (15) extend in a second extension direction (De2) matched with the first extension direction (De1) and overlap the first regions (14) in a thickness direction of the semiconductor layer (7).

[B16] The semiconductor device (1A, 1B, 1C) according to any one of B1 to B15, further comprising: at least one field region (38) that is formed in a surface layer portion of the main surface (3) in the outer peripheral region (11) and overlaps the column region (12) in a thickness direction of the semiconductor layer (7).

[B17] The semiconductor device (1A, 1B, 1C) according to B16, wherein the column region (12) having a three-dimensional lattice shape is formed by the impurity regions (14, 15), and the field region (38) is formed in a region on a side of the main surface (3) in the outer peripheral region (11) with respect to the column region (12) having the three-dimensional lattice shape.

[B18] The semiconductor device (1A, 1B, 1C) according to B16, wherein the column regions (12) having a stripe shape are formed by the impurity regions (14, 15), and the field region (38) is formed in the region on the side of the main surface (3) in the outer peripheral region (11) with respect to the column regions (12) having the stripe shape.

[B19] The semiconductor device (1A, 1B, 1C) according to any one of B16 to B18, wherein the field region (38) has a portion intersecting the impurity regions (14, 15) in plan view and a portion extending along the impurity regions (14, 15) in plan view.

[B20] The semiconductor device (1A, 1B, 1C) according to any one of B16 to B19, wherein the field regions (38) are formed at an interval.

[B21] The semiconductor device (1A, 1B, 1C) according to any one of B1 to B20, wherein the semiconductor layer (7) is an SiC layer (7) including an SiC monocrystal.

[C1] A semiconductor device (1A, 1B, 1C) comprising: a chip (2) having a side surface (5A to 5D); and an ornamental pattern (PT) formed in the side surface (5A to 5D).

[C2] The semiconductor device (1A, 1B, 1C) according to C1, wherein the chip (2) includes a semiconductor layer (7) of a first conductivity type (n-type), and the ornamental pattern (PT) includes a mark (Mk1, Mk2) of a second conductivity type (p-type) that is formed in a portion constituted of the semiconductor layer (7) in the side surface (5A to 5D).

[C3] The semiconductor device (1A, 1B, 1C) according to C2, wherein the ornamental pattern (PT) includes the marks (Mk1, Mk2).

[C4] The semiconductor device (1A, 1B, 1C) according to C2 or C3, wherein the side surface (5A to 5D) includes a first side surface (5A, 5C) extending in a first direction (X) in plan view and a second side surface (5B, 5D) extending in a second direction (Y) intersecting the first direction (X) in plan view, and the ornamental pattern (PT) includes at least one mark (Mk1, Mk2) formed in one or both of the first side surface (5A, 5C) and the second side surface (5B, 5D).

[C5] The semiconductor device (1A, 1B, 1C) according to C4, wherein the semiconductor layer (7) is constituted of a hexagonal crystal, the first direction (X) is one of an m-axis direction and an a-axis direction among crystal orientations of the semiconductor layer (7), and the second direction (Y) is the other of the m-axis direction and the a-axis direction among the crystal orientations.

[C6] The semiconductor device (1A, 1B, 1C) according to C4 or C5, wherein the marks (Mk1, Mk2) include a first mark (Mk1) formed in the first side surface (5A, 5C) and a second mark (Mk2) formed in the second side surface (5B, 5D).

[C7] The semiconductor device (1A, 1B, 1C) according to C6, wherein the first mark (Mk1) extends in a vertically long columnar shape in a thickness direction (Z) of the semiconductor layer (7), and the second mark (Mk2) extends in a vertically long columnar shape in the thickness direction (Z) of the semiconductor layer (7).

[C8] The semiconductor device (1A, 1B, 1C) according to C6 or C7, wherein the first mark (Mk1) is formed in a first thickness range in the first side surface (5A, 5C) on one side in the thickness direction (Z) of the semiconductor layer (7), and the second mark (Mk2) is formed in a second thickness range in the second side surface (5B, 5D) on the other side in the thickness direction (Z) of the semiconductor layer (7).

[C9] The semiconductor device (1A, 1B, 1C) according to any one of C6 to C8, wherein the first marks (Mk1) are arrayed in a line at an interval in the first direction (X), and the second marks (Mk2) are arrayed in a line at an interval in the second direction (Y).

[C10] The semiconductor device (1A, 1B, 1C) according to any one of C6 to C9, wherein the semiconductor layer (7) has a laminated structure including a first layer (8) of the first conductivity type (n-type) and a second layer (9) of the first conductivity type (n-type) that is laminated on the first layer (8), the first mark (Mk1) is formed in the first layer (8), and the second mark (Mk2) is formed in the second layer (9).

[C11] The semiconductor device (1A, 1B, 1C) according to C10, wherein the second mark (Mk2) has an extension portion that crosses a boundary portion between the first layer (8) and the second layer (9) and is positioned in the first layer (8).

[C12] The semiconductor device (1A, 1B, 1C) according to C10 or C11, wherein the first mark (Mk1) is formed at an interval from an upper end toward a lower end side of the first layer (8).

[C13] The semiconductor device (1A, 1B, 1C) according to any one of C10 to C12, wherein the first layer (8) has a first axis channel (CH1) oriented along a lamination direction, the second layer (9) has a second axis channel (CH2) oriented along the lamination direction, the first mark (Mk1) extends along the first axis channel (CH1) in a surface layer portion of the first side surface (5A, 5C), and the second mark (Mk2) extends along the second axis channel (CH2) in a surface layer portion of the second side surface (5B, 5D).

[C14] The semiconductor device (1A, 1B, 1C) according to C13, wherein the first mark (Mk1) crosses an intermediate portion of the first layer (8) along the first axis channel (CH1), and the second mark (Mk2) crosses an intermediate portion of the second layer (9) along the second axis channel (CH2).

[C15] The semiconductor device (1A, 1B, 1C) according to any one of C10 to C14, wherein the first mark (Mk1) includes a first peak value (PA, 21A) on an upper end side of the first layer (8) and a first gentle gradient portion (22A) in which an impurity concentration gradually decreases at a gentle decrease rate in a region closer to a lower end of the first layer (8) than the first peak value (PA, 21A), and the second mark (Mk2) includes a second peak value (PB, 21B) on an upper end side of the second layer (9) and a second gentle gradient portion (22B) in which an impurity concentration gradually decreases at a gentle decrease rate in a region closer to a lower end of the second layer (9) than the second peak value (PB, 21B).

[C16] The semiconductor device (1A, 1B, 1C) according to C15, wherein the first gentle gradient portion (22A) accounts for a thickness range of not less than 1/4 of the first mark (Mk1), and the second gentle gradient portion (22B) accounts for a thickness range of not less than 1/4 of the second mark (Mk2).

[C17] The semiconductor device (1A, 1B, 1C) according to any one of C6 to C16, wherein the ornamental pattern (PT) includes a first difference mark (Md1) of the second conductivity type (p-type) that is formed in the first side surface (5A, 5C) in a layout different from a layout of the first mark (Mk1).

[C18] The semiconductor device (1A, 1B, 1C) according to C17, wherein the first difference mark (Md1) extends as a band along the first direction (X) and overlaps the first mark (Mk1) in the thickness direction (Z) of the semiconductor layer (7).

[C19] The semiconductor device (1A, 1B, 1C) according to any one of C6 to C18, wherein the ornamental pattern (PT) includes a second difference mark (Md2) of the second conductivity type (p-type) that is formed in the second side surface (5B, 5D) in a layout different from a layout of the second mark (Mk2).

[C20] The semiconductor device (1A, 1B, 1C) according to C19, wherein the second difference mark (Md2) extends as a band along the second direction (Y) and overlaps the first mark (Mk1) in the thickness direction (Z) of the semiconductor layer (7).

[C21] The semiconductor device (1A, 1B, 1C) according to any one of C1 to C20, wherein the chip (2) is an SiC chip (2) including an SiC monocrystal.

[D1] A semiconductor device (1A, 1B, 1C) comprising: a semiconductor layer (9) of a first conductivity type (n-type) that includes a main surface (3) and has an axis channel (CH2) oriented along a thickness direction (Z); an impurity region (15) of a second conductivity type (p-type) that extends along the axis channel (CH2) in the semiconductor layer (9); a body region (32) of the second conductivity type (p-type) that is formed in a region on a side of the main surface (3) with respect to the impurity region (15); and a gate structure (35) that includes a trench (75) penetrating the body region (32) in the main surface (3), an embedded electrode (77) arranged closer to a bottom wall of the trench (75) than the main surface (3), and an embedded insulator (80) which is arranged closer to the bottom wall of the trench (75) than the main surface (3) and covers the embedded electrode (77).

[D2] The semiconductor device (1A, 1B, 1C) according to D1, wherein the impurity region (15) is constituted of a single region that crosses an intermediate portion of the semiconductor layer (9) along the axis channel (CH2), and the gate structure (35) is shallower than the impurity region (15).

[D3] The semiconductor device (1A, 1B, 1C) according to D1 or D2, wherein the impurity region (15) includes a peak value (PB, 21B) on an upper end side of the semiconductor layer (9) and a gentle gradient portion (22B) in which an impurity concentration gradually decreases at a gentle decrease rate in a region closer to a lower end of the semiconductor layer (9) than the peak value (PB, 21B).

[D4] The semiconductor device (1A, 1B, 1C) according to D3, wherein the gentle gradient portion (22B) accounts for a thickness range of not less than 1/4 of the impurity region (15).

[D5] The semiconductor device (1A, 1B, 1C) according to any one of D1 to D4, wherein the gate structure (35) extends as a band in plan view.

[D6] The semiconductor device (1A, 1B, 1C) according to D5, wherein the gate structure (35) extends in an a-axis direction among crystal orientations.

[D7] The semiconductor device (1A, 1B, 1C) according to D5 or D6, wherein the impurity region (15) extends as a band in plan view, and the gate structure (35) extends in an extension direction of the impurity region (15) and is formed at an interval from the impurity region (15).

[D8] The semiconductor device (1A, 1B, 1C) according to D5 or D6, wherein the impurity region (15) extends as a band in plan view, and the gate structure (35) extends in an extension direction of the impurity region (15) and overlaps the impurity region (15) in a thickness direction (Z) of the semiconductor layer (9).

[D9] The semiconductor device (1A, 1B, 1C) according to D5 or D6, wherein the impurity region (15) extends as a band in plan view, and the gate structure (35) extends in a direction other than an extension direction of the impurity region (15) and intersects the impurity region (15).

[D10] The semiconductor device (1A, 1B, 1C) according to any one of D1 to D9, wherein the embedded electrode (77) has a multi-electrode structure including electrodes (83, 84) arranged at an interval in a depth direction of the trench (75).

[D11] The semiconductor device (1A, 1B, 1C) according to any one of D1 to D10, further comprising: a lower semiconductor layer (8) having a lower axis channel (CH1) oriented along a thickness direction (Z); and a lower impurity region (14) of the second conductivity type (p-type) that extends along the lower axis channel (CH1) in the lower semiconductor layer (8); and wherein the semiconductor layer (9) is laminated on the lower semiconductor layer (8), and the impurity region (15) is formed in the semiconductor layer (9) such as to overlap the lower impurity region (14) in a lamination direction.

[D12] The semiconductor device (1A, 1B, 1C) according to D11, wherein the lower impurity region (14) is constituted of a single region that crosses an intermediate portion of the lower semiconductor layer (8) along the lower axis channel (CH1).

[D13] The semiconductor device (1A, 1B, 1C) according to D11 or D12, wherein the lower impurity region (14) includes a lower peak value (PA, 21A) on an upper end side of the lower semiconductor layer (8), and a lower gentle gradient portion (22A) in which an impurity concentration gradually decreases at a gentle decrease rate in a region closer to a lower end of the lower semiconductor layer (8) than the lower peak value (PA, 21A).

[D14] The semiconductor device (1A, 1B, 1C) according to D13, wherein the lower gentle gradient portion (22A) accounts for a thickness range of not less than 1/4 of the impurity region (15).

[D15] The semiconductor device (1A, 1B, 1C) according to any one of D11 to D14, wherein the lower impurity region (14) extends in a first extension direction (De1) in plan view, and the impurity region (15) extends in a second extension direction (De2) matched with the first extension direction (De1) in plan view.

[D16] The semiconductor device (1A, 1B, 1C) according to any one of D11 to D15, wherein the lower impurity region (14) extends in a first extension direction (De1) in plan view, and the impurity region (15) extends in a second extension direction (De2) other than the first extension direction (De1) in plan view and intersects the lower impurity region (14).

[D17] The semiconductor device (1A, 1B, 1C) according to any one of D1 to D16, further comprising: a source region (33) of the first conductivity type (n-type) that is formed along the gate structure (35) in a surface layer portion of the body region (32); and a source pad (47) that is electrically connected to the source region (33) on the main surface (3) and is electrically insulated from the embedded electrode (77) by the embedded insulator (80) in the trench (75).

[D18] The semiconductor device (1A, 1B, 1C) according to D17, wherein the source region (33) has a portion exposed from a side wall of the trench (75), and the source pad (47) is electrically connected to the portion of the source region (33) in the trench (75) exposed from the side wall of the trench (75).

[D19] The semiconductor device (1A, 1B, 1C) according to D17 or D18, wherein the gate structures (35) are formed on the main surface (3) at an interval, and the source region (33) is connected to two of the gate structures (35) adjacent to each other.

[D20] The semiconductor device (1A, 1B, 1C) according to any one of D17 to D19, further comprising: a contact region (34) of the second conductivity type (p-type) that is formed in a region different from the source region (33) along the gate structure (35) in the surface layer portion of the body region (32), wherein the source pad (47) is electrically connected to the contact region (34) on the main surface (3).

[D21] The semiconductor device (1A, 1B, 1C) according to any one of D1 to D20, wherein the semiconductor layer (9) is an SiC layer (9) including an SiC monocrystal.

[E1] An ion implantation processing system (100) comprising: an ion implantation device (103), wherein the ion implantation device (103) acquires, from a server (101), off-angle data (104) of a wafer (50) that is an ion implantation processing target and controls an ion implantation angle with respect to the wafer (50) based on the off-angle data (104).

[E2] The ion implantation processing system (100) according to E1, wherein the wafer (50) is a wide bandgap semiconductor.

[E3] The ion implantation processing system (100) according to E1 or E2, wherein the wafer (50) is a hexagonal crystal.

[E4] The ion implantation processing system (100) according to any one of E1 to E3, wherein the ion implantation device (103) is a channeling ion implantation device (103) that implants ions into the wafer (50) along an axis channel (CHB, CH1, CH2) of the wafer (50).

[E5] The ion implantation processing system (100) according to any one of E1 to E4, wherein the ion implantation devices (103) are provided.

[E6] The ion implantation processing system (100) according to any one of E1 to E5, wherein the ion implantation device (103) acquires the off-angle data (104) based on an ID (57) of the wafer (50) from the server (101) in which the off-angle data (104) associated with the ID (57) of the wafer (50) is stored.

[E7] The ion implantation processing system (100) according to E6, wherein the wafer (50) has a main surface (51) to which the ID (57) is provided, and the ion implantation device (103) includes an ID reading device (150) that reads the ID (57) from the main surface (51) of the wafer (50).

[E8] The ion implantation processing system (100) according to any one of E1 to E7, wherein the wafer (50) is an epitaxial wafer including an epitaxial layer (8, 9), the off-angle data (104) corresponds to an off angle (θoff) of the epitaxial layer (8, 9), and the ion implantation device (103) controls the ion implantation angle with respect to the epitaxial layer (8, 9) based on the off-angle data (104).

[E9] The ion implantation processing system (100) according to E8, wherein the ion implantation device (103) acquires the off-angle data (104) and specification data (136) from the server (101) in which the off-angle data (104) of the epitaxial layer (8, 9) and the specification data (136) of the epitaxial layer (8, 9) are stored.

[E10] The ion implantation processing system (100) according to E9, wherein the ion implantation device (103) adjusts an ion implantation processing condition for the epitaxial layer (8, 9) based on the off-angle data (104) and the specification data (136).

[E11] The ion implantation processing system (100) according to E9 or E10, wherein the specification data (136) includes at least one or both of thickness data of the epitaxial layer (8, 9) and impurity concentration data of the epitaxial layer (8, 9).

[E12] The ion implantation processing system (100) according to any one of E1 to E11, further comprising: an off-angle transfer device (102); wherein the off-angle transfer device (102) transfers, to the server (101), the off-angle data (104) of the wafer (50) before ion implantation processing.

[E13] The ion implantation processing system (100) according to E12, wherein the ion implantation device (103) is provided independently of the off-angle transfer device (102).

[E14] The ion implantation processing system (100) according to E12 or E13, wherein the off-angle transfer devices (102) are provided.

[E15] The ion implantation processing system (100) according to any one of E12 to E14, wherein the off-angle transfer device (102) transfers the off-angle data (104) of the wafer (50) in association with an ID (57) of the wafer (50) to the server (101), and the ion implantation device (103) acquires the off-angle data (104) from the server (101) based on the ID (57) of the wafer (50).

[E16] The ion implantation processing system (100) according to any one of E12 to E15, wherein the wafer (50) is an epitaxial wafer including an epitaxial layer (8, 9), the off-angle transfer device (102) transfers an off angle (θoff) of the epitaxial layer (8, 9) as the off-angle data (104) of the wafer (50) to the server (101), and the ion implantation device (103) controls the ion implantation angle with respect to the epitaxial layer (8, 9) based on the off-angle data (104).

[E17] The ion implantation processing system (100) according to E16, wherein the off-angle transfer device (102) includes an epitaxial growth device (121) that laminates the epitaxial layer (8, 9) on the wafer (50) and forms the epitaxial wafer.

[E18] The ion implantation processing system (100) according to E17, wherein the off-angle transfer device (102) generates specification data (136) of the epitaxial layer (8, 9) and transfers the specification data (136) to the server (101), and the ion implantation device (103) acquires the specification data (136) from the server (101).

[E19] The ion implantation processing system (100) according to any one of E12 to E18, wherein the off-angle transfer device (102) includes an X-ray diffraction device (123) that measures an off angle (θoff) of the wafer (50) with X-rays, and the off-angle transfer device (102) generates the off-angle data (104) of the wafer (50) based on a measurement result by the X-ray diffraction device (123) and transfers the off-angle data (104) to the server (101).

[E20] The ion implantation processing system (100) according to E19, wherein the X-ray diffraction device (123) includes an irradiation portion (128) that irradiates the wafer (50) with an X-ray and a detection portion (129) that detects a diffracted X-ray from the wafer (50), and the X-ray diffraction device (123) measures the off angle (θoff) of the wafer (50) by a rocking curve measurement method.

The ion implantation processing system (100) according to any one of [E1] to [E20] may be a system used in the manufacture of the semiconductor device (1A, 1B, 1C) according to any one of [A1] to [A21]. The ion implantation processing system (100) according to any one of [E1] to [E20] may be a system used in the manufacture of the semiconductor device (1A, 1B, 1C) according to any one of [B1] to [B21].

The ion implantation processing system (100) according to any one of [E1] to [E20] may be a system used in the manufacture of the semiconductor device (1A, 1B, 1C) according to any one of [C1] to [C21]. The ion implantation processing system (100) according to any one of [E1] to [E20] may be a system used in the manufacture of the semiconductor device (1A, 1B, 1C) according to any one of [D1] to [D21].

[F1] A manufacturing method of a semiconductor device (1A, 1B, 1C), comprising: a data acquisition step (S43) of acquiring off-angle data (104) of a wafer (50) which is an ion implantation processing target from a server (101); and an ion implantation step (S44, S45) of controlling an ion implantation angle with respect to the wafer (50) based on the off-angle data (104) and implanting ions into the wafer (50) by using an ion implantation device (103, 151).

[F2] The manufacturing method of a semiconductor device (1A, 1B, 1C) according to F1, wherein the data acquisition step (S43) is performed using the ion implantation device (103, 151).

[F3] The manufacturing method of a semiconductor device (1A, 1B, 1C) according to F1 or F2, wherein the wafer (50) is a wide bandgap semiconductor wafer (50).

[F4] The manufacturing method of a semiconductor device (1A, 1B, 1C) according to any one of F1 to F3, wherein the wafer (50) is constituted of a hexagonal crystal.

[F5] The manufacturing method of a semiconductor device (1A, 1B, 1C) according to any one of F1 to F4, wherein the ion implantation step (S44, S45) is a channeling ion implantation step (S44, S45) of implanting the ions into the wafer (50) along an axis channel (CHB, CH1, CH2) of the wafer (50) by a channeling ion implantation method.

[F6] The manufacturing method of a semiconductor device (1A, 1B, 1C) according to any one of F1 to F5, wherein the data acquisition step (S43) is performed using the ion implantation devices (103, 151), and the ion implantation step (S44, S45) is performed using the ion implantation devices (103, 151).

[F7] The manufacturing method of a semiconductor device (1A, 1B, 1C) according to any one of F1 to F6, wherein the data acquisition step (S43) includes a step of acquiring the off-angle data (104) from the server (101) based on an ID (57) of the wafer (50).

[F8] The manufacturing method of a semiconductor device (1A, 1B, 1C) according to F7, further comprising: a step (S41) of preparing the wafer (50) having a main surface (51) to which the ID (57) is provided; and a step (S42) of reading the ID (57) from the main surface (51) of the wafer (50); wherein the data acquisition step (S43) is performed after the reading step (S42) of the ID (57).

[F9] The manufacturing method of a semiconductor device (1A, 1B, 1C) according to any one of F1 to F8, wherein the wafer (50) is an epitaxial wafer (50) including an epitaxial layer (8, 9), the off-angle data (104) corresponds to an off angle (θoff) of the epitaxial layer (8, 9), and the ion implantation step (S44, S45) includes a step of controlling an ion implantation angle with respect to the epitaxial layer (8, 9) based on the off-angle data (104) and implanting the ions into the epitaxial layer (8, 9).

[F10] The manufacturing method of a semiconductor device (1A, 1B, 1C) according to F9, wherein the data acquisition step (S43) includes a step of acquiring specification data (136) of the epitaxial layer (8, 9) from the server (101).

[F11] The manufacturing method of a semiconductor device (1A, 1B, 1C) according to F10, wherein the ion implantation step (S44, S45) includes a step of adjusting a processing condition for the epitaxial layer (8, 9) based on the off-angle data (104) and the specification data (136).

[F12] The manufacturing method of a semiconductor device (1A, 1B, 1C) according to F10 or F11, wherein the specification data (136) includes at least one or both of thickness data of the epitaxial layer (8, 9) and impurity concentration data of the epitaxial layer (8, 9).

[F13] The manufacturing method of a semiconductor device (1A, 1B, 1C) according to any one of F1 to F12, further comprising: a data transfer step (S36) of transferring the off-angle data (104) of the wafer (50) to the server (101) by using an off-angle transfer device (102) before the data acquisition step (S43).

[F14] The manufacturing method of a semiconductor device (1A, 1B, 1C) according to F13, wherein the ion implantation device (103, 151) is provided independently of the off-angle transfer device (102).

[F15] The manufacturing method of a semiconductor device (1A, 1B, 1C) according to F13 or F14, wherein the data transfer step (S36) includes a step of transferring off-angle data (104) of the wafers (50) to the server (101) by using the off-angle transfer devices (102).

[F16] The manufacturing method of a semiconductor device (1A, 1B, 1C) according to any one of F13 to F15, wherein the data transfer step (S36) includes a step of transferring the off-angle data (104) of the wafer (50) in association with an ID (57) of the wafer (50) to the server

(101), and the data acquisition step (S43) includes a step of acquiring the off-angle data (104) from the server (101) based on the ID (57) of the wafer (50).

[F17] The manufacturing method of a semiconductor device (1A, 1B, 1C) according to any one of F13 to F16, further comprising: a step of forming an epitaxial layer (8, 9) on the wafer (50) by using an epitaxial growth device (121), before the data transfer step (S36); wherein the data transfer step (S36) includes a step of transferring, as the off-angle data (104) of the wafer (50), an off angle (θoff) of the epitaxial layer (8, 9) to the server (101), and the ion implantation step (S44, S45) includes a step of controlling the ion implantation angle with respect to the epitaxial layer (8, 9) based on the off-angle data (104) and implanting the ions into the epitaxial layer (8, 9).

[F18] The manufacturing method of a semiconductor device (1A, 1B, 1C) according to F17, wherein the off-angle transfer device (102) includes the epitaxial growth device (121).

[F19] The manufacturing method of a semiconductor device (1A, 1B, 1C) according to F17 or F18, wherein the data transfer step (S36) includes a step of transferring specification data (136) of the epitaxial layer (8, 9) to the server (101), and the data acquisition step (S43) includes a step of acquiring the specification data (136) from the server (101) at the same timing as or a different timing from a timing of the off-angle data (104).

[F20] The manufacturing method of a semiconductor device (1A, 1B, 1C) according to any one of F13 to F19, further comprising: a step of measuring an off angle (θoff) of the wafer (50) with X-rays by using an X-ray diffraction device (123), before the data transfer step (S36).

[F21] The manufacturing method of a semiconductor device (1A, 1B, 1C) according to F20, wherein the measurement step of the off angle (θoff) is performed by a rocking curve measurement method using the X-ray diffraction device (123).

[F22] The manufacturing method of a semiconductor device (1A, 1B, 1C) according to F20 or F21, wherein the off-angle transfer device (102) includes the X-ray diffraction device (123).

[F23] The manufacturing method of a semiconductor device (1A, 1B, 1C) according to any one of F1 to F22, wherein the ions are one or both of ions of a trivalent element and ions of a pentavalent element.

The manufacturing method of a semiconductor device (1A, 1B, 1C) according to any one of [F1] to [F23] may be a manufacturing method performed by the ion implantation processing system (100) according to any one of [E1] to [E20].

The manufacturing method of a semiconductor device (1A, 1B, 1C) according to any one of [F1] to [F23] may be a manufacturing method of the semiconductor device (1A, 1B, 1C) according to any one of [A1] to [A21]. The manufacturing method of a semiconductor device (1A, 1B, 1C) according to any one of [F1] to [F23] may be a manufacturing method of the semiconductor device (1A, 1B, 1C) according to any one of [B1] to [B21].

The manufacturing method of a semiconductor device (1A, 1B, 1C) according to any one of [F1] to [F23] may be a manufacturing method of the semiconductor device (1A, 1B, 1C) according to any one of [C1] to [C21]. The manufacturing method of a semiconductor device (1A, 1B, 1C) according to any one of [F1] to [F23] may be a manufacturing method of the semiconductor device (1A, 1B, 1C) according to any one of [D1] to [D21].

[G1] A manufacturing method of a semiconductor device (1A, 1B, 1C), comprising: an off angle acquisition step (S35) of acquiring an off angle (θoff, 104) of a wafer (50); and an ion implantation step (S44, S45) of controlling an ion implantation angle with respect to the wafer (50) based on the off angle (θoff, 104) and implanting ions into the wafer (50).

[G2] The manufacturing method of a semiconductor device (1A, 1B, 1C) according to G1, wherein the wafer (50) is a wide bandgap semiconductor wafer (50).

[G3] The manufacturing method of a semiconductor device (1A, 1B, 1C) according to G1 or G2, wherein the wafer (50) is constituted of a hexagonal crystal.

[G4] The manufacturing method of a semiconductor device (1A, 1B, 1C) according to any one of G1 to G3, wherein the ion implantation angle is controlled within a range of ±2° of the off angle (θoff, 104).

[G5] The manufacturing method of a semiconductor device (1A, 1B, 1C) according to any one of G1 to G4, wherein the ion implantation step (S44, S45) is a channeling ion implantation step (S44, S45) of implanting the ions into the wafer (50) along an axis channel (CHB, CH1, CH2) of the wafer (50) by a channeling ion implantation method.

[G6] The manufacturing method of a semiconductor device (1A, 1B, 1C) according to any one of G1 to G5, further including a cutting-out step (S31) of the wafer (50) from an ingot, wherein the off angle acquisition step (S35) is performed after the cutting-out step (S31) of the wafer (50).

[G7] The manufacturing method of a semiconductor device (1A, 1B, 1C) according to G6, wherein the cutting-out step (S31) of the wafer (50) includes a step of cutting out the wafer (50) having the off angle (θoff, 104).

[G8] The manufacturing method of a semiconductor device (1A, 1B, 1C) according to G6 or G7, wherein the cutting-out step (S31) of the wafer (50) includes a step of cutting the ingot with a cutting member and cutting out the wafer (50).

[G9] The manufacturing method of a semiconductor device (1A, 1B, 1C) according to G6 or G7, wherein the cutting-out step (S31) of the wafer (50) includes a step of selectively irradiating a predetermined depth position of the ingot with laser light and forming modified layers along a predetermined plane direction in the ingot, and a step of applying stress to the modified layers and separating the wafer (50) from the ingot with the modified layers as starting points.

[G10] The manufacturing method of a semiconductor device (1A, 1B, 1C) according to G9, wherein stress applied to the modified layers includes at least one of stress caused by a cutting member, stress caused by a pressing member, stress caused by ultrasonic vibrations, and stress caused by heating and cooling.

[G11] The manufacturing method of a semiconductor device (1A, 1B, 1C) according to G6 or G7, wherein the cutting-out step (S31) of the wafer (50) includes a step of cutting out the wafer (50) from the ingot by using a light ion irradiation method.

[G12] The manufacturing method of a semiconductor device (1A, 1B, 1C) according to G11, wherein the cutting-out step (S31) of the wafer (50) includes a step of selectively introducing light ions to a predetermined depth position of the ingot and forming an ion embrittlement portion along a predetermined plane direction in the ingot; and a step of applying a thermal load to the ion embrittlement portion and separating the wafer (50) from the ingot with the ion embrittlement portion as a starting point.

[G13] The manufacturing method of a semiconductor device (1A, 1B, 1C) according to any one of G1 to G12, further comprising: a preparation step of the wafer (50) having a main surface to which an ID (57) is provided; and a reading step (S32) of the ID (57) from the main surface of the wafer (50), wherein the off angle acquisition step (S35) is performed after the reading step (S32) of the ID (57).

[G14] The manufacturing method of a semiconductor device (1A, 1B, 1C) according to any one of G1 to G13, further comprising: a preparation step (S33) of the wafer (50) constituted of an epitaxial wafer including an epitaxial layer (8, 9) before the off angle acquisition step (S35); wherein, in the off angle acquisition step (S35), an off angle (θoff, 104) of the epitaxial layer (8, 9) is acquired as the off angle (θoff, 104) of the wafer (50), and the ion implantation step (S44, S45) includes a step of controlling an ion implantation angle with respect to the epitaxial layer (8, 9) based on the off angle (θoff, 104) and implanting the ions into the epitaxial layer (8, 9).

[G15] The manufacturing method of a semiconductor device (1A, 1B, 1C) according to G14, wherein the off angle acquisition step (S35) includes a step of acquiring a specification (136) of the epitaxial layer (8, 9) in addition to the off angle (θoff, 104).

[G16] The manufacturing method of a semiconductor device (1A, 1B, 1C) according to G15, wherein the ion implantation step (S44, S45) includes a step of adjusting a processing condition for the epitaxial layer (8, 9) based on the off angle (θoff, 104) and the specification (136).

[G17] The manufacturing method of a semiconductor device (1A, 1B, 1C) according to G15 or G16, wherein the specification (136) includes at least one or both of a thickness of the epitaxial layer (8, 9) and an impurity concentration of the epitaxial layer (8, 9).

[G18] The manufacturing method of a semiconductor device (1A, 1B, 1C) according to any one of G1 to G17, wherein the off angle acquisition step (S35) further includes a step of measuring the off angle (θoff, 104) with X-rays.

[G19] The manufacturing method of a semiconductor device (1A, 1B, 1C) according to G18, wherein the off angle acquisition step (S35) is performed using a rocking curve measurement method.

[G20] The manufacturing method of a semiconductor device (1A, 1B, 1C) according to any one of G1 to G19, wherein the ions are one or both of ions of a trivalent element and ions of a pentavalent element.

The manufacturing method of a semiconductor device (1A, 1B, 1C) according to any one of [G1] to [G20] may be a manufacturing method performed by the ion implantation processing system (100) according to any one of [E1] to [E20].

The manufacturing method of a semiconductor device (1A, 1B, 1C) according to any one of [G1] to [G20] may be a manufacturing method of the semiconductor device (1A, 1B, 1C) according to any one of [A1] to [A21]. The manufacturing method of a semiconductor device (1A, 1B, 1C) according to any one of [G1] to [G20] may be a manufacturing method of the semiconductor device (1A, 1B, 1C) according to any one of [B1] to [B21].

The manufacturing method of a semiconductor device (1A, 1B, 1C) according to any one of [G1] to [G20] may be a manufacturing method of the semiconductor device (1A, 1B, 1C) according to any one of [C1] to [C21]. The manufacturing method of a semiconductor device (1A, 1B, 1C) according to any one of [G1] to [G20] may be a manufacturing method of the semiconductor device (1A, 1B, 1C) according to any one of [D1] to [D21].

While the specific embodiments have been described in detail above, these are merely specific examples used to clarify the technical contents. The various technical ideas extracted from this Description can be combined as appropriate with each other without being limited by the order of description, the order of configuration examples, the order of modification examples, etc., in the Description.

### Reference Signs List

- 1A: SiC semiconductor device
- 1B: SiC semiconductor device
- 1C: SiC semiconductor device
- 8: first layer (epitaxial layer)
- 9: second layer (epitaxial layer)
- 50: wafer
- 51: first wafer main surface
- 57: wafer ID
- 100: ion implantation processing system
- 101: server device
- 102: off-angle transfer device
- 103: channeling ion implantation device
- 104: off-angle data
- 121: epitaxial growth device
- 123: X-ray diffraction device
- 128: irradiation unit
- 129: detection unit
- 136: specification data
- 150: second ID reading device
- CH1: first axis channel
- CH2: second axis channel
- CHB: base axis channel
- θoff: off angle

## Claims

1. An ion implantation processing system comprising an ion implantation device,
wherein the ion implantation device acquires, from a server, off-angle data of a wafer that is an ion implantation processing target and controls an ion implantation angle with respect to the wafer based on the off-angle data.

2. The ion implantation processing system according to Claim 1,
wherein the wafer is a wide bandgap semiconductor wafer.

3. The ion implantation processing system according to Claim 1 or 2,
wherein the wafer is constituted of a hexagonal crystal.

4. The ion implantation processing system according to any one of Claims 1 to 3,
wherein the ion implantation device is a channeling ion implantation device that implants ions into the wafer along an axis channel of the wafer.

5. The ion implantation processing system according to any one of Claims 1 to 4,
wherein the ion implantation devices are provided.

6. The ion implantation processing system according to any one of Claims 1 to 5,
wherein the ion implantation device acquires the off-angle data based on an ID of the wafer from the server in which the off-angle data associated with the ID of the wafer is stored.

7. The ion implantation processing system according to Claim 6,
wherein the wafer has a main surface to which the ID is provided, and
the ion implantation device includes an ID reading device that reads the ID from the main surface of the wafer.

8. The ion implantation processing system according to any one of Claims 1 to 7,
wherein the wafer is an epitaxial wafer including an epitaxial layer,
the off-angle data corresponds to an off angle of the epitaxial layer, and
the ion implantation device controls the ion implantation angle with respect to the epitaxial layer based on the off-angle data.

9. The ion implantation processing system according to Claim 8,
wherein the ion implantation device acquires the off-angle data and specification data from the server in which the off-angle data of the epitaxial layer and the specification data of the epitaxial layer are stored.

10. The ion implantation processing system according to Claim 9,
wherein the ion implantation device adjusts an ion implantation processing condition for the epitaxial layer based on the off-angle data and the specification data.

11. The ion implantation processing system according to Claim 9 or 10,
wherein the specification data includes at least one or both of thickness data of the epitaxial layer and impurity concentration data of the epitaxial layer.

12. The ion implantation processing system according to any one of Claims 1 to 11, further comprising:
an off-angle transfer device; and
wherein the off-angle transfer device transfers, to the server, the off-angle data of the wafer before ion implantation processing.

13. The ion implantation processing system according to Claim 12,
wherein the ion implantation device is provided independently of the off-angle transfer device.

14. The ion implantation processing system according to Claim 12 or 13,
wherein the off-angle transfer devices are provided.

15. The ion implantation processing system according to any one of Claims 12 to 14,
wherein the off-angle transfer device transfers the off-angle data of the wafer in association with an ID of the wafer to the server, and
the ion implantation device acquires the off-angle data from the server based on the ID of the wafer.

16. The ion implantation processing system according to any one of Claims 12 to 15,
wherein the wafer is an epitaxial wafer including an epitaxial layer,
the off-angle transfer device transfers an off angle of the epitaxial layer as the off-angle data of the wafer to the server, and
the ion implantation device controls the ion implantation angle with respect to the epitaxial layer based on the off-angle data.

17. The ion implantation processing system according to Claim 16,
wherein the off-angle transfer device includes an epitaxial growth device that laminates the epitaxial layer on the wafer and forms the epitaxial wafer.

18. The ion implantation processing system according to Claim 17,
wherein the off-angle transfer device generates specification data of the epitaxial layer and transfers the specification data to the server, and
the ion implantation device acquires the specification data from the server.

19. The ion implantation processing system according to any one of Claims 12 to 18,
wherein the off-angle transfer device includes an X-ray diffraction device that measures an off angle of the wafer with X-rays, and
the off-angle transfer device generates the off-angle data of the wafer based on a measurement result by the X-ray diffraction device and transfers the off-angle data to the server.

20. The ion implantation processing system according to Claim 19,
wherein the X-ray diffraction device includes an irradiation portion that irradiates the wafer with an X-ray and a detection portion that detects a diffracted X-ray from the wafer, and
the X-ray diffraction device measures the off angle of the wafer by a rocking curve measurement method.
